# EUROPEAN PATENT SPECIFICATION

(11) **EP 3 192 797 B1**
(45) Date of publication and mention of the grant of the patent: **10.04.2019**
(21) Application number: 16205919.0
(22) Date of filing: 13.02.2015
(51) Int. Cl.: C07F 15/00, H01L 51/00, C09K 11/06, H01L 51/50

(54) **ORGANIC ELECTROLUMINESCENT MATERIALS AND DEVICES**
ORGANISCHE ELEKTROLUMINESZENZMATERIALIEN UND VORRICHTUNGEN
MATÉRIAUX ET DISPOSITIFS ÉLECTROLUMINESCENTS ORGANIQUES

(30) Priority: 18.02.2014 US 201414183100
(43) Date of publication of application: 19.07.2017
(62) Divisional of application: 15000451.3
(73) Proprietor: Universal Display Corporation, Ewing, New Jersey 08618 (US)
(72) Inventor: BOUDREAULT, Pierre-Luc T, Ewing, NJ New Jersey 08618 (US); DYATKIN, Alexey Borisovich, Ewing, NJ New Jersey 08618 (US); XIA, Chuanjun, Ewing, NJ New Jersey 08618 (US); YAMAMOTO, Hitoshi, Ewing, NJ New Jersey 08618 (US)
(74) Representative: Hansen, Norbert

(56) References cited:
- US-A1- 2013 281 693

## Description

The claimed invention was made by, on behalf of, and/or in connection with one or more of the following parties to a joint university corporation research agreement: Regents of the University of Michigan, Princeton University, University of Southern California, and the Universal Display Corporation. The agreement was in effect on and before the date the claimed invention was made, and the claimed invention was made as a result of activities undertaken within the scope of the agreement.

### FIELD OF THE INVENTION

The present invention relates to compounds for use as emitters and devices, such as organic light emitting diodes, including the same.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745.

One application for phosphorescent emissive molecules is a full color display. Industry standards for such a display call for pixels adapted to emit particular colors, referred to as "saturated" colors. In particular, these standards call for saturated red, green, and blue pixels. Color may be measured using CIE coordinates, which are well known to the art.

One example of a green emissive molecule is tris(2-phenylpyridine) iridium, denoted Ir(ppy)₃, which has the following structure:

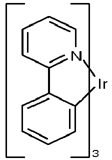

In this, and later figures herein, we depict the dative bond from nitrogen to metal (here, Ir) as a straight line.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

More details on OLEDs, and the definitions described above, can be found in US Pat. No. 7,279,704. Patent application US 2013/0281693 A1 relates to phosphorescent organometallic iridium complexes.

### SUMMARY OF THE INVENTION

The present invention is directed to OLEDs comprising a compound having a formula M(L_{A})ₓ(L_{B})_{y}(L_{C})_{z} is disclosed. In the formula, the ligand L_{A} is 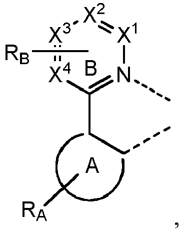 the ligand L_{B} is 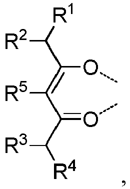 and the ligand Lc is 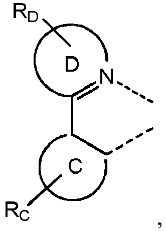 where:
M is a metal having an atomic number greater than 40;
x is 1, or 2;
y is 1, or 2;
z is 0, 1, or 2;
x+y+z is the oxidation state of the metal M;
X¹, X², X³, and X⁴ are C or N;
R¹, R², R³, and R⁴ are independently selected from group consisting of alkyl, cycloalkyl, aryl, and heteroaryl;
at least one of R¹, R², R³, and R⁴ has at least two C atoms;
R⁵ is selected from group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof;
rings A, C, and D are each independently a 5 or 6-membered carbocyclic or heterocyclic ring;
R_{A}, R_{C}, and R_{D} each independently represent mono, di, tri, or tetra-substitution, or no substitution;
R_{B} represents di, tri, or tetra-substitution;
two adjacent R_{B} form a six-member carbocyclic or heterocyclic ring E fused to ring B; wherein, when ring E is heterocyclic, the only heteroatom is nitrogen; and wherein ring E can be further substituted;
each of R_{A}, R_{B}, R_{C}, and R_{D} are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof;
any adjacent substitutents of R_{A}, R_{B}, R_{C}, and R_{D} are optionally joined to form a fused ring; and where (a) at least one of X¹, X², X³, and X⁴ is N, (b) ring E is heterocylic, or (c) both.

### BRIEF DESCRIPTION OF THE DRAWINGS

FIG. 1 shows an organic light emitting device.
FIG. 2 shows an inverted organic light emitting device that does not have a separate electron transport layer.
FIG. 3 shows Ligands L_{A}, L_{B} and L_{C} of the compounds described herein.

### DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"), which are incorporated by reference in their entireties. Phosphorescence is described in more detail in US Pat. No. 7,279,704 at cols. 5-6.

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10.

More examples for each of these layers are available. For example, a flexible and transparent substrate-anode combination is disclosed in U.S. Pat. No. 5,844,363. An example of a p-doped hole transport layer is m-MTDATA doped with F₄-TCNQ at a molar ratio of 50:1, as disclosed in U.S. Patent Application Publication No. 2003/0230980. Examples of emissive and host materials are disclosed in U.S. Pat. No. 6,303,238 to Thompson et al.,. An example of an n-doped electron transport layer is BPhen doped with Li at a molar ratio of 1:1, as disclosed in U.S. Patent Application Publication No. 2003/0230980. U.S. Pat. Nos. 5,703,436 and 5,707,745, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980. Examples of injection layers are provided in U.S. Patent Application Publication No. 2004/0174116. A description of protective layers may be found in U.S. Patent Application Publication No. 2004/0174116.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of nonlimiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al.,. By way of further example, OLEDs having a single organic layer may be used. OLEDs may be stacked, for example as described in U.S. Pat. No. 5,707,745 to Forrest et al. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al.,.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, organic vapor phase deposition (OVPD), such as described in U.S. Pat. No. 6,337,102 to Forrest et al., and deposition by organic vapor jet printing (OVJP), such as described in U.S. Pat. No. 7,431,968. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the invention may be incorporated into a wide variety of consumer products, including flat panel displays, computer monitors, medical monitors, televisions, billboards, lights for interior or exterior illumination and/or signaling, heads up displays, fully transparent displays, flexible displays, laser printers, telephones, cell phones, personal digital assistants (PDAs), laptop computers, digital cameras, camcorders, viewfinders, micro-displays, 3-D displays, vehicles, a large area wall, theater or stadium screen, or a sign. Various control mechanisms may be used to control devices fabricated in accordance with the present invention, including passive matrix and active matrix. Many of the devices are intended for use in a temperature range comfortable to humans, such as 18 degrees C. to 30 degrees C., and more preferably at room temperature (20-25 degrees C), but could be used outside this temperature range, for example, from -40 degree C to + 80 degree C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

The term "halo" or "halogen" as used herein includes fluorine, chlorine, bromine, and iodine.

The term "alkyl" as used herein contemplates both straight and branched chain alkyl radicals. Preferred alkyl groups are those containing from one to fifteen carbon atoms and includes methyl, ethyl, propyl, isopropyl, butyl, isobutyl, tert-butyl, and the like. Additionally, the alkyl group may be optionally substituted.

The term "cycloalkyl" as used herein contemplates cyclic alkyl radicals. Preferred cycloalkyl groups are those containing 3 to 7 carbon atoms and includes cyclopropyl, cyclopentyl, cyclohexyl, and the like. Additionally, the cycloalkyl group may be optionally substituted.

The term "alkenyl" as used herein contemplates both straight and branched chain alkene radicals. Preferred alkenyl groups are those containing two to fifteen carbon atoms. Additionally, the alkenyl group may be optionally substituted.

The term "alkynyl" as used herein contemplates both straight and branched chain alkyne radicals. Preferred alkynyl groups are those containing two to fifteen carbon atoms. Additionally, the alkynyl group may be optionally substituted.

The terms "aralkyl" or "arylalkyl" as used herein are used interchangeably and contemplate an alkyl group that has as a substituent an aromatic group. Additionally, the aralkyl group may be optionally substituted.

The term "heterocyclic group" as used herein contemplates non-aromatic cyclic radicals. Preferred heterocyclic groups are those containing 3 or 7 ring atoms which includes at least one hetero atom, and includes cyclic amines such as morpholino, piperdino, pyrrolidino, and the like, and cyclic ethers, such as tetrahydrofuran, tetrahydropyran, and the like. Additionally, the heterocyclic group may be optionally substituted.

The term "aryl" or "aromatic group" as used herein contemplates single-ring groups and polycyclic ring systems. The polycyclic rings may have two or more rings in which two carbons are common to two adjoining rings (the rings are "fused") wherein at least one of the rings is aromatic, e.g., the other rings can be cycloalkyls, cycloalkenyls, aryl, heterocycles, and/or heteroaryls. Additionally, the aryl group may be optionally substituted.

The term "heteroaryl" as used herein contemplates single-ring hetero-aromatic groups that may include from one to three heteroatoms, for example, pyrrole, furan, thiophene, imidazole, oxazole, thiazole, triazole, pyrazole, pyridine, pyrazine and pyrimidine, and the like. The term heteroaryl also includes polycyclic hetero-aromatic systems having two or more rings in which two atoms are common to two adjoining rings (the rings are "fused") wherein at least one of the rings is a heteroaryl, e.g., the other rings can be cycloalkyls, cycloalkenyls, aryl, heterocycles, and/or heteroaryls. Additionally, the heteroaryl group may be optionally substituted.

The alkyl, cycloalkyl, alkenyl, alkynyl, aralkyl, heterocyclic group, aryl, and heteroaryl may be optionally substituted with one or more substituents selected from the group consisting of hydrogen, deuterium, halogen, alkyl, cycloalkyl, heteroalkyl, arylalkyl, alkoxy, aryloxy, amino, cyclic amino, silyl, alkenyl, cycloalkenyl, heteroalkenyl, alkynyl, aryl, heteroaryl, acyl, carbonyl, carboxylic acid, ether, ester, nitrile, isonitrile, sulfanyl, sulfinyl, sulfonyl, phosphino, and combinations thereof.

As used herein, "substituted" indicates that a substituent other than H is bonded to the relevant position, such as carbon. Thus, for example, where R¹ is mono-substituted, then one R¹ must be other than H. Similarly, where R¹ is di-substituted, then two of R¹ must be other than H. Similarly, where R¹ is unsubstituted, R¹ is hydrogen for all available positions.

The "aza" designation in the fragments described herein, i.e. aza-dibenzofuran, azadibenzothiophene, etc. means that one or more of the C-H groups in the respective fragment can be replaced by a nitrogen atom, for example, and without any limitation, azatriphenylene encompasses both dibenzo[*f*,*h*]quinoxaline and dibenzo[*f*,*h*]quinoline. One of ordinary skill in the art can readily envision other nitrogen analogs of the aza-derivatives described above, and all such analogs are intended to be encompassed by the terms as set forth herein.

It is to be understood that when a molecular fragment is described as being a substituent or otherwise attached to another moiety, its name may be written as if it were a fragment (e.g. naphthyl, dibenzofuryl) or as if it were the whole molecule (e.g. naphthalene, dibenzofuran). As used herein, these different ways of designating a substituent or attached fragment are considered to be equivalent.

The claimed compounds are organometallic complexes that include both quinazoline-based ligands and ligands formed from branched acetylacetone (acac) derivatives. The combination of these ligands allows red phosphorescent materials with good external quantum efficiency (EQE), color, and lifetime.

According to one embodiment, a compound having the formula M(L_{A})ₓ(L_{B})_{y}(L_{C})_{z} is disclosed. In the formula M(L_{A})ₓ(L_{B})_{y}(L_{C})_{z}, ligand L_{A} is 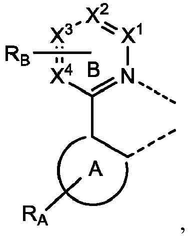 ligand L_{B} is 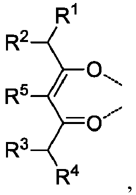 and ligand Lc is 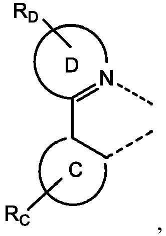 where:
M is a metal having an atomic number greater than 40;
x is 1, or 2;
y is 1, or 2;
z is 0, 1, or 2;
x+y+z is the oxidation state of the metal M;
X¹, X², X³, and X⁴ are C or N;
R¹, R², R³, and R⁴ are independently selected from group consisting of alkyl, cycloalkyl, aryl, and heteroaryl;
at least one of R¹, R², R³, and R⁴ has at least two C atoms;
R⁵ is selected from group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof;
rings A, C, and D are each independently a 5 or 6-membered carbocyclic or heterocyclic ring;
R_{A}, R_{C}, and R_{D} each independently represent mono, di, tri, or tetra-substitution, or no substitution;
R_{B} represents di, tri, or tetra-substitution;
two adjacent R_{B} form a six-member carbocyclic or heterocyclic ring E fused to ring B; wherein, when ring E is heterocyclic, the only heteroatom is nitrogen; and wherein ring E can be further substituted;
each of R_{A}, R_{B}, R_{C}, and R_{D} are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof;
any adjacent substitutents of R_{A}, R_{B}, R_{C}, and R_{D} are optionally joined to form a fused ring; and where (a) at least one of X¹, X², X³, and X⁴ is N, (b) ring E is heterocylic, or (c) both.

In some embodiments, at least one of R¹, R², R³, and R⁴ has at least three C atoms, while in other embodiments at least one of R¹, R², R³, and R⁴ has at least four C atoms. In some embodiments, at least one of R¹, R², R³, and R⁴ is a branched alkyl.

In some embodiments, the M can be selected from the group consisting of Ir, Rh, Re, Ru, Os, Pt, Au, and Cu.

In some embodiments, ring A is benzene. In some embodiments, ring C is benzene, and ring D is pyridine.

In some embodiments, R⁵ is selected from group consisting of hydrogen, deuterium, alkyl, cycloalkyl, and combinations thereof. In some embodiments, R⁵ is hydrogen.

In some embodiments, R¹, R², R³, and R⁴ are alkyl or cycloalkyl. In some more specific embodiments, R¹, R², R³, and R⁴ are independently selected from the group consisting of methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, cyclobutyl, cyclopentyl, cyclohexyl, partially or fully deuterated variants thereof, and combinations thereof.

In some embodiments, the compound is selected from the group consisting of: 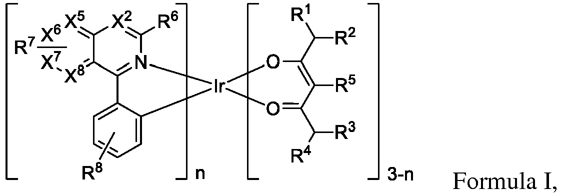 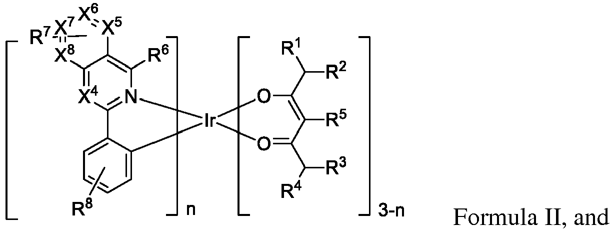 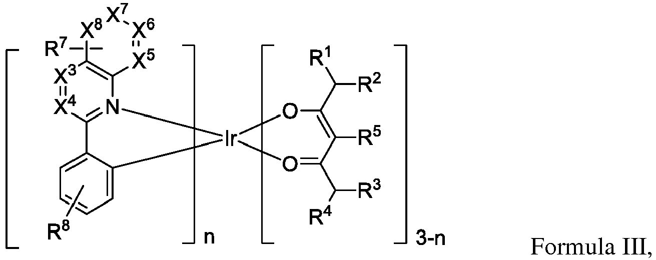
wherein X⁵, X⁶, X⁷, and X⁸ are C or N;
wherein R⁷, and R⁸ each independently represent mono, di, tri, or tetra-substitution, or no substitution;
wherein R⁶, R⁷, and R⁸ are independently selected from group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein n is 1 or 2.

In some embodiments, n is 2. In some embodiments, at least one of X⁵, X⁶, X⁷, and X⁸ is N. In other embodiments, at least two of X⁵, X⁶, X⁷, and X⁸ are N.

In some embodiments, R⁶ and R⁷ are independently selected from group consisting of hydrogen, deuterium, alkyl, cycloalkyl, and combinations thereof. In some embodiments, R⁶ is branched alkyl or cycloalkyl. In some embodiments, R⁷ is at least monosubstituted and is branched alkyl or cycloalkyl.

In some embodiments, R⁸ is selected from group consisting of hydrogen, deuterium, alkyl, cycloalkyl, halide, and combinations thereof. In some embodiments, R⁸ comprises at least one halide, at least one alkyl, or both. In some embodiments, R⁸ comprises at least one halide and at least two alkyls.

In some embodiments, the compound is selected from the group consisting of: 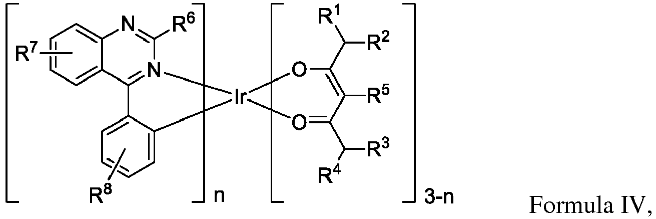 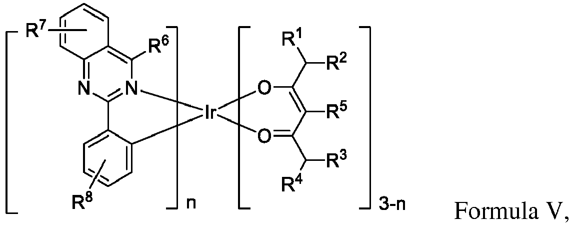 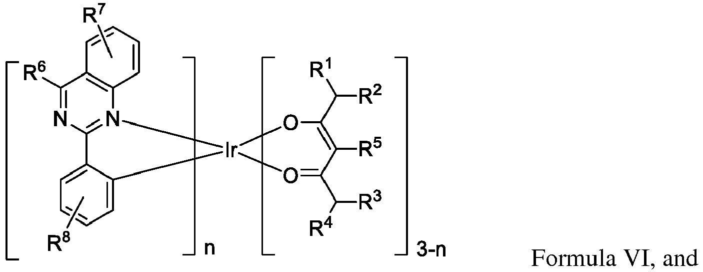 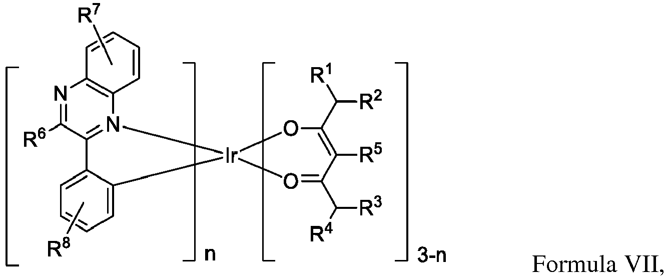
wherein R⁷, and R⁸ each independently represent mono, di, tri, or tetra-substitution, or no substitution;
wherein R⁶, R⁷, and R⁸ are independently selected from group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein n is 1 or 2.

In some embodiments, L_{A} is selected from the group consisting of L_{A1} to L_{A270} listed below:

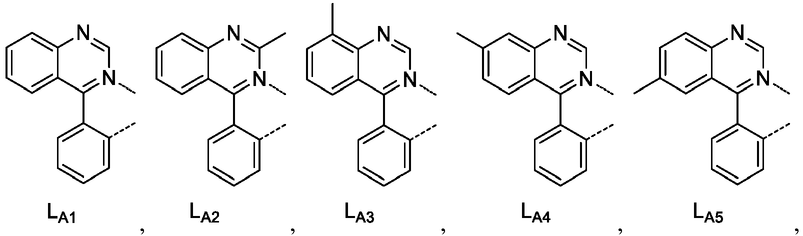

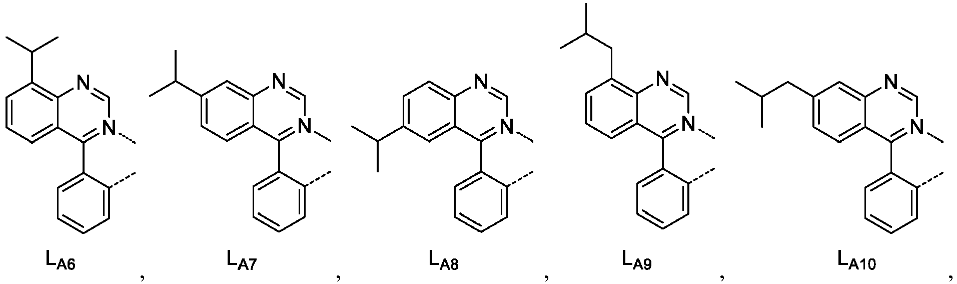

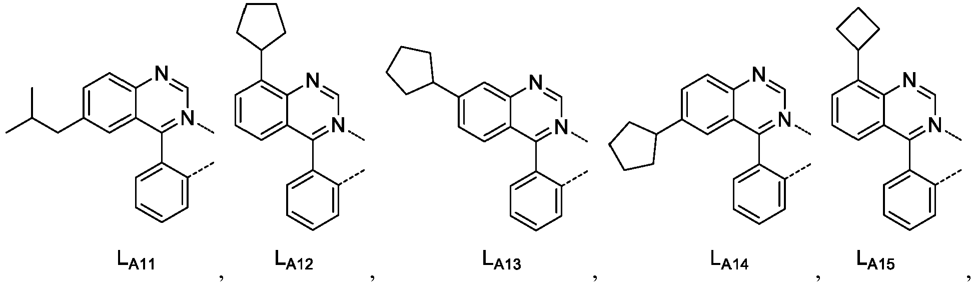

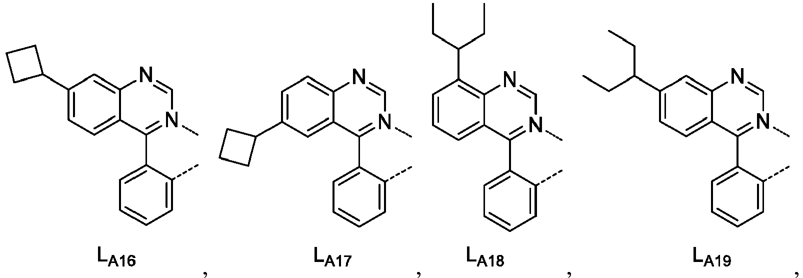

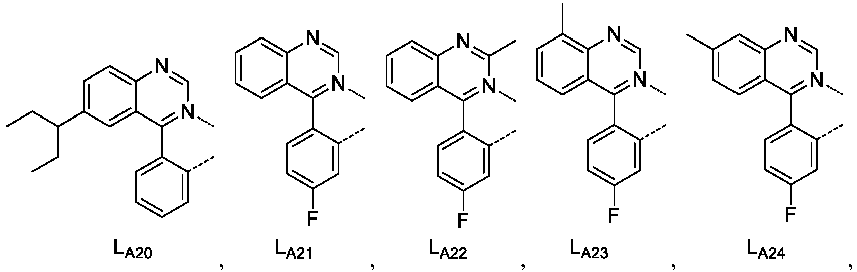

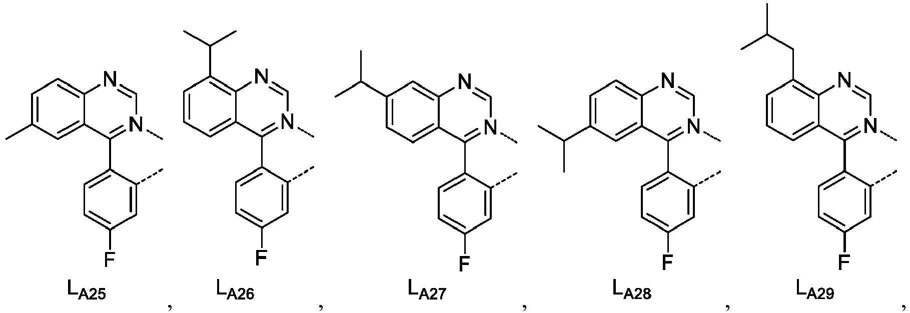

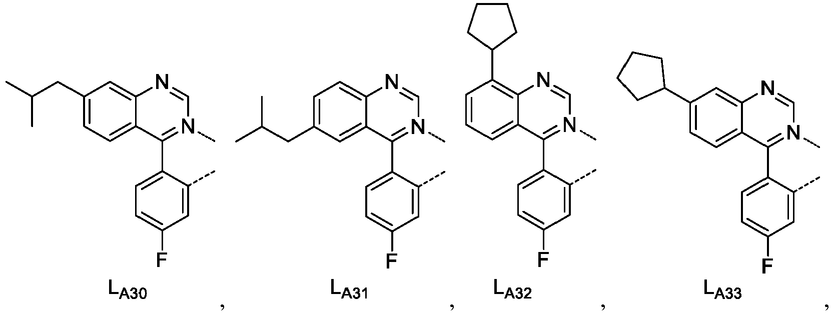

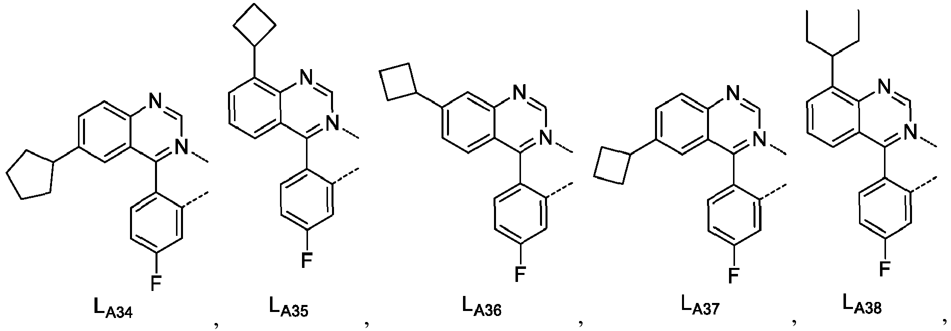

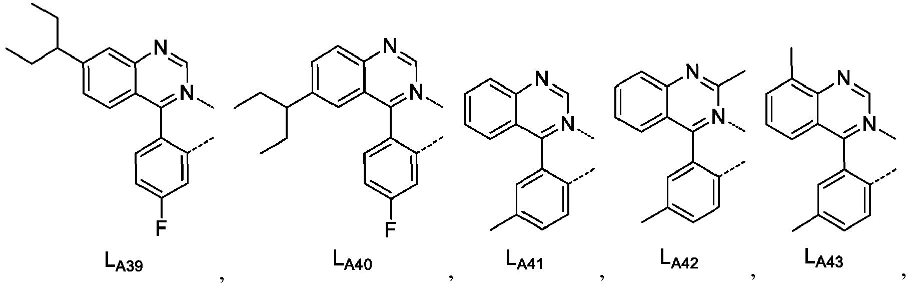

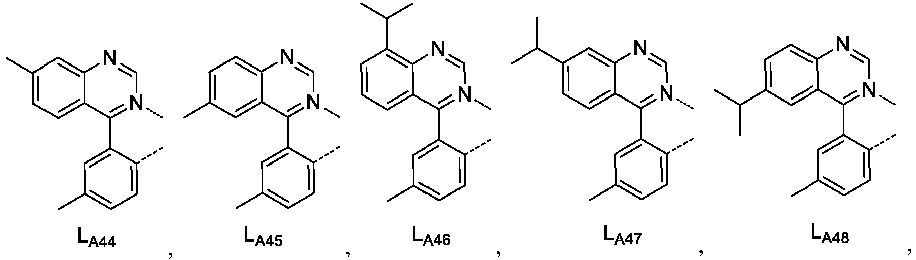

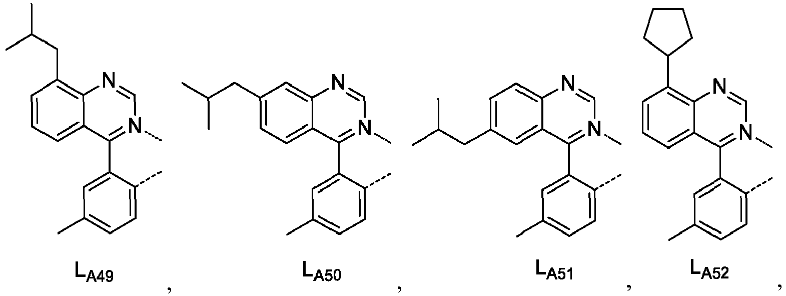

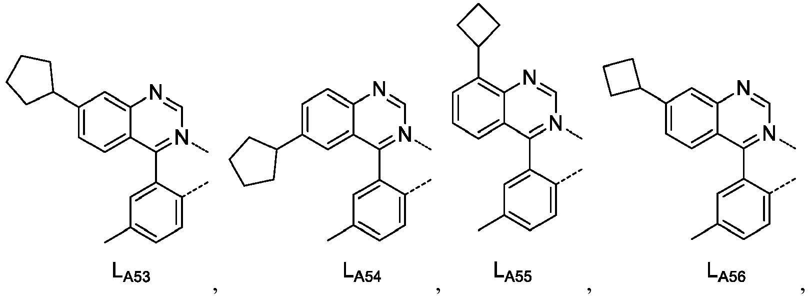

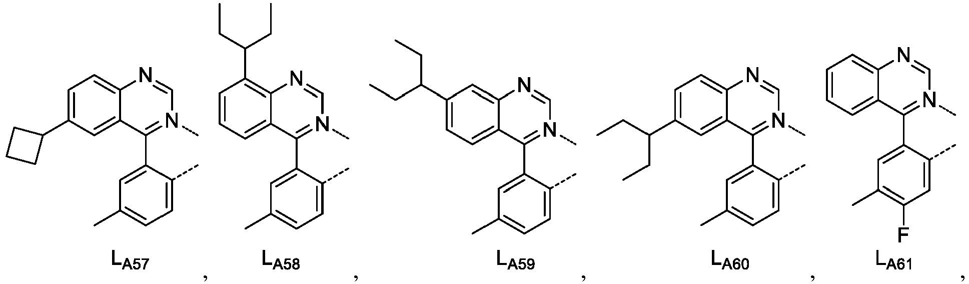

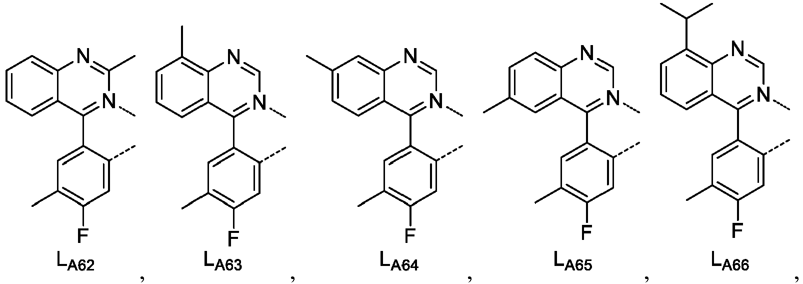

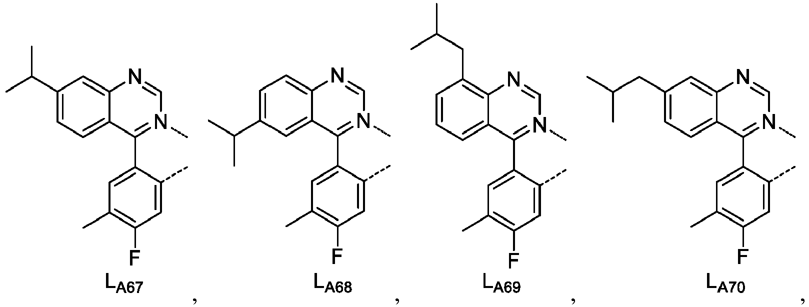

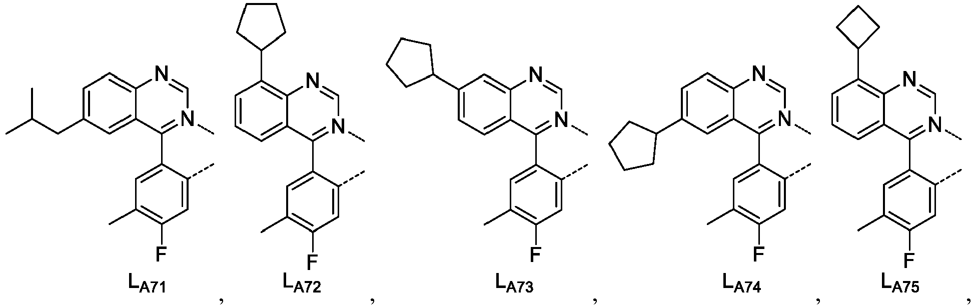

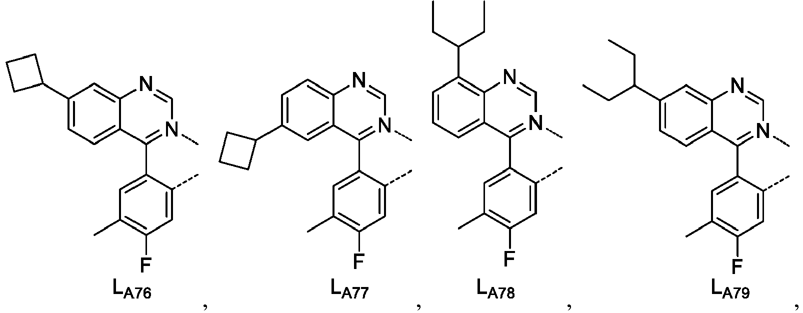

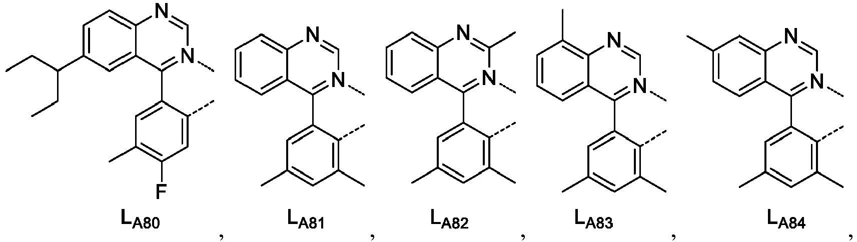

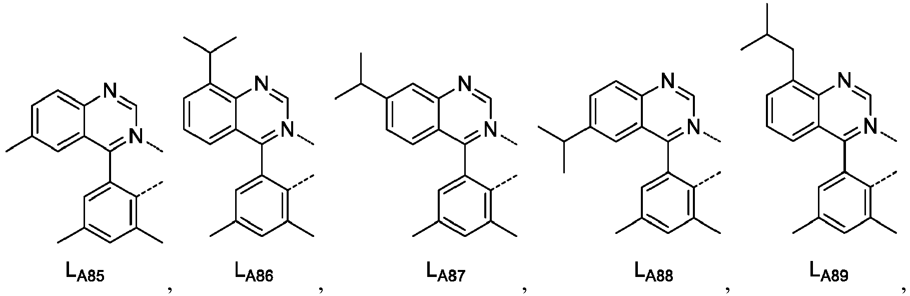

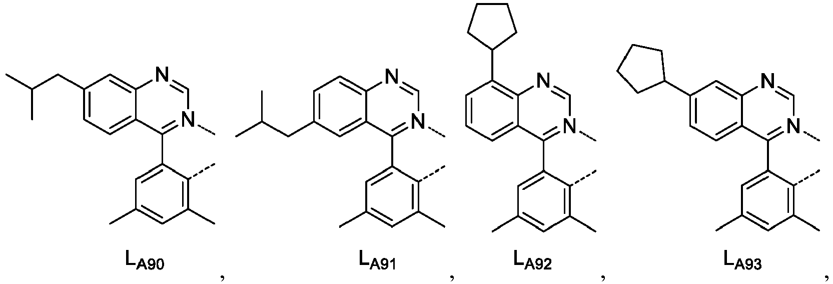

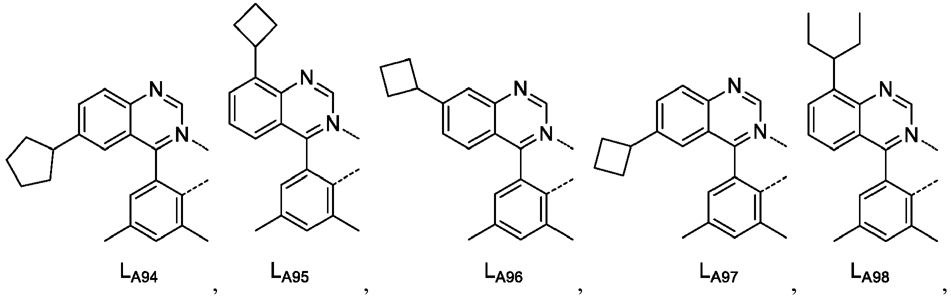

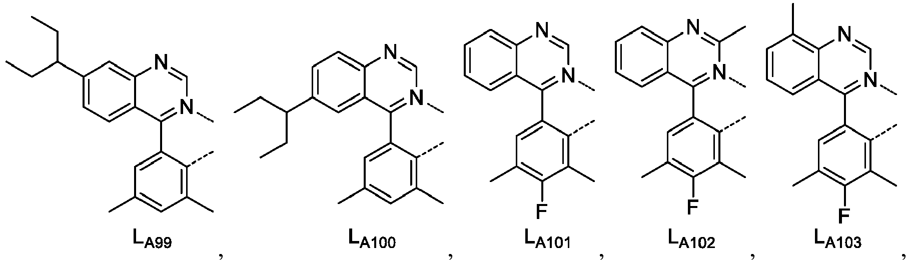

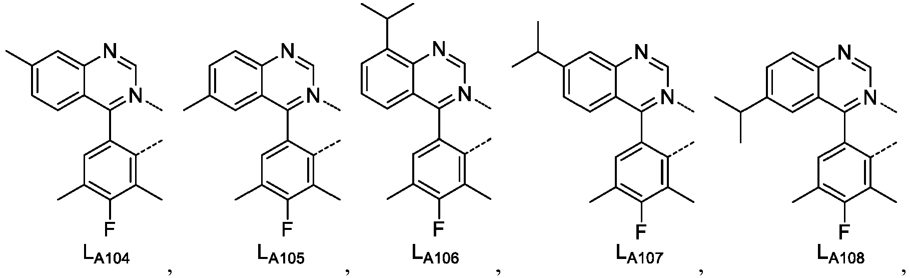

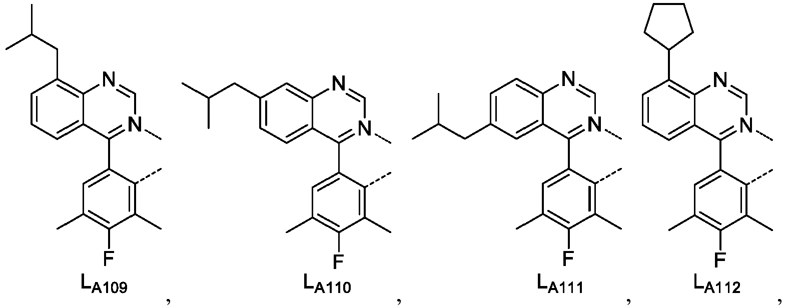

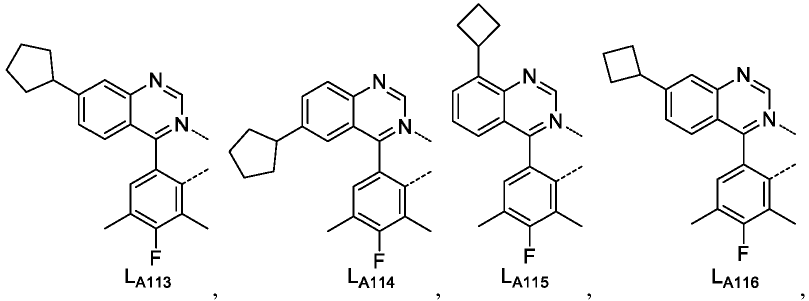

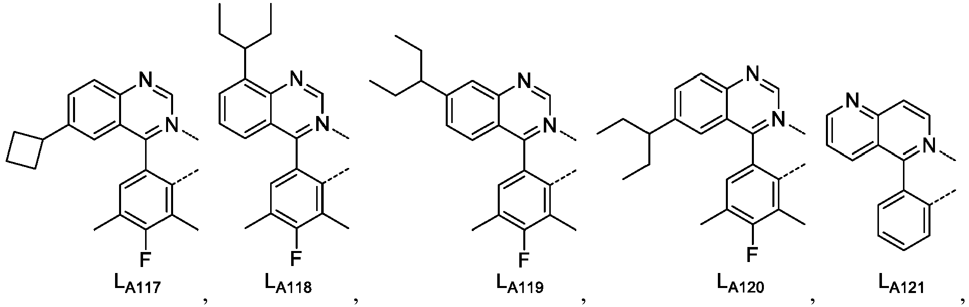

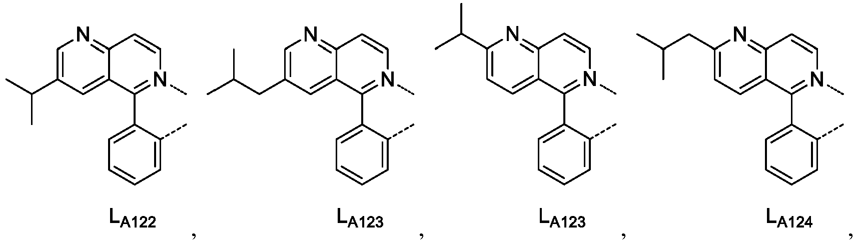

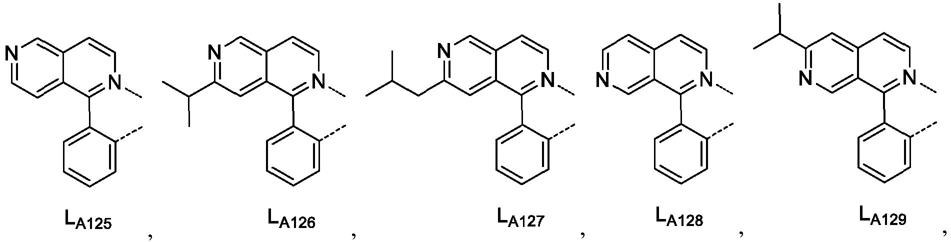

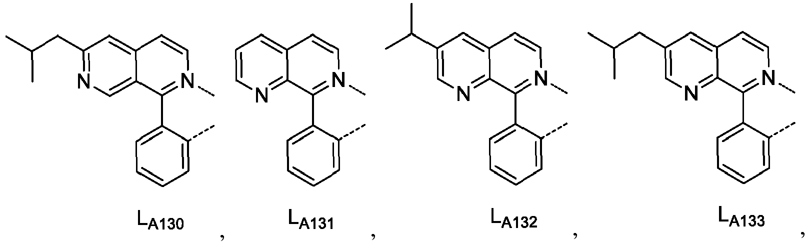

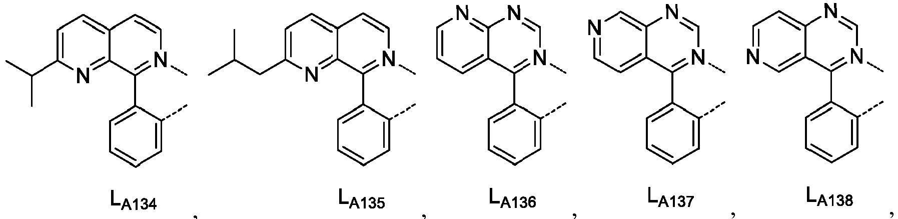

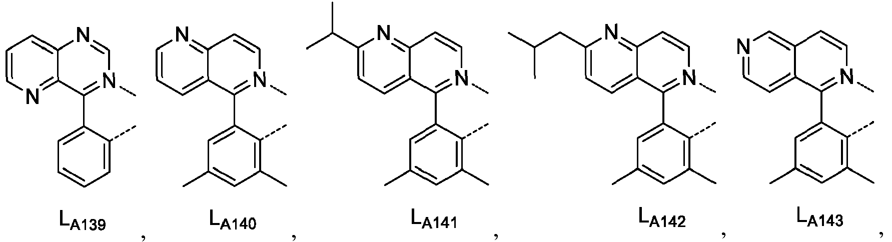

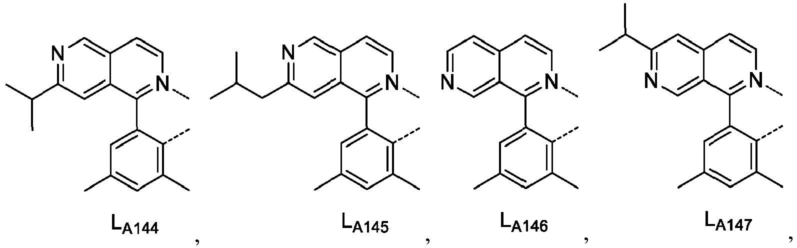

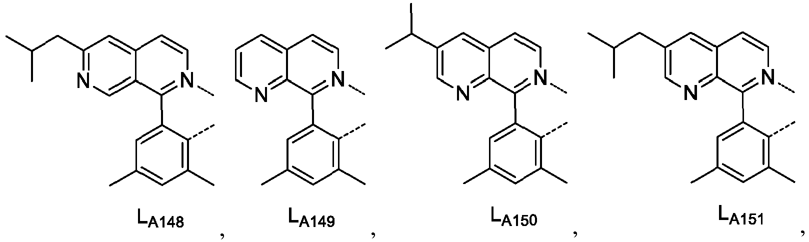

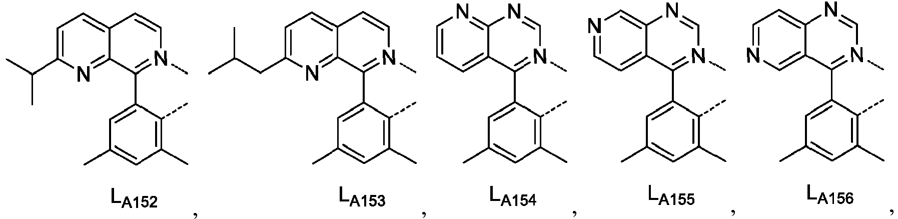

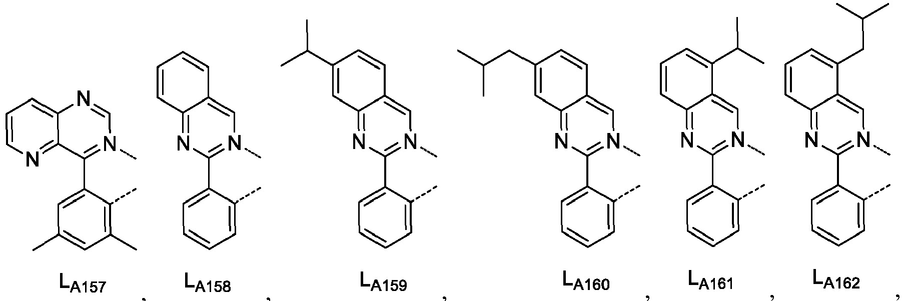

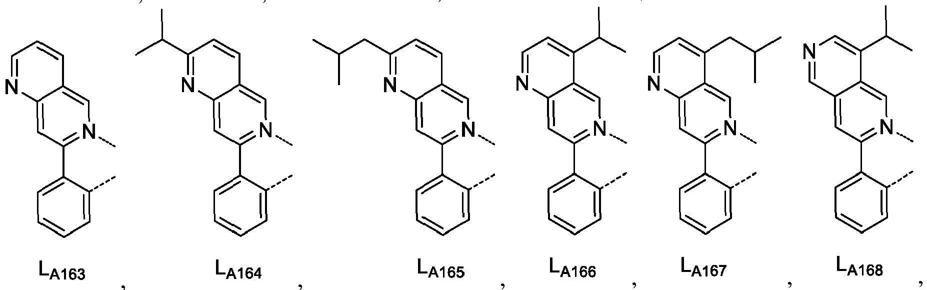

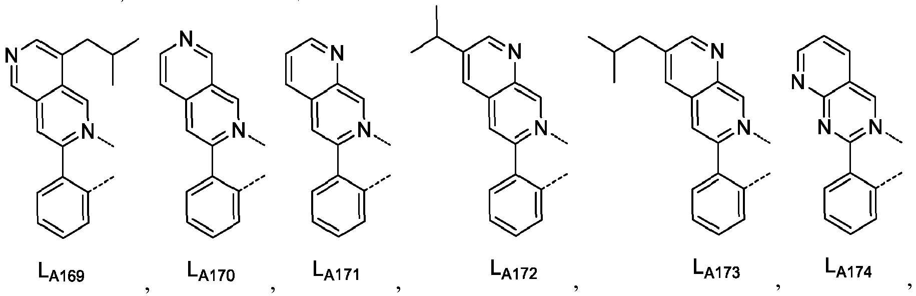

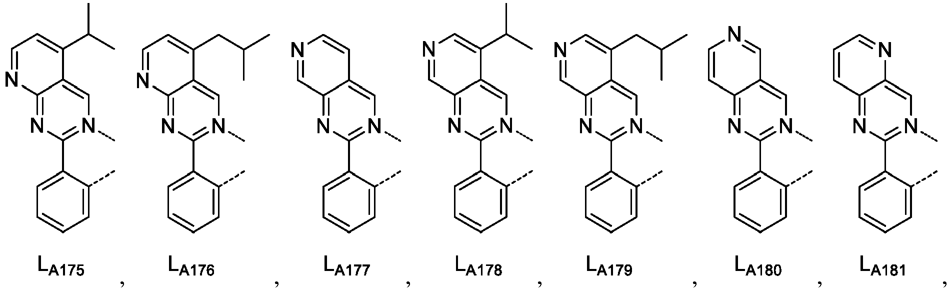

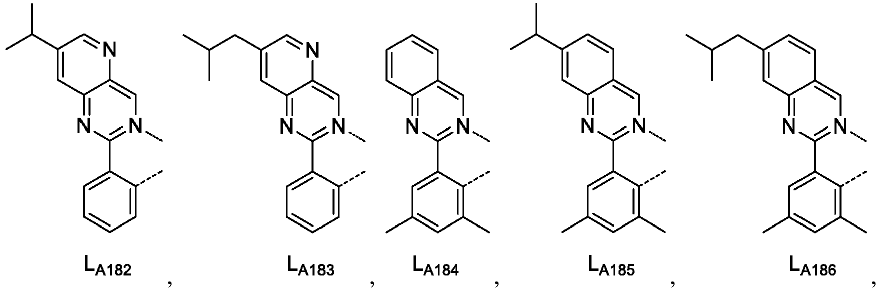

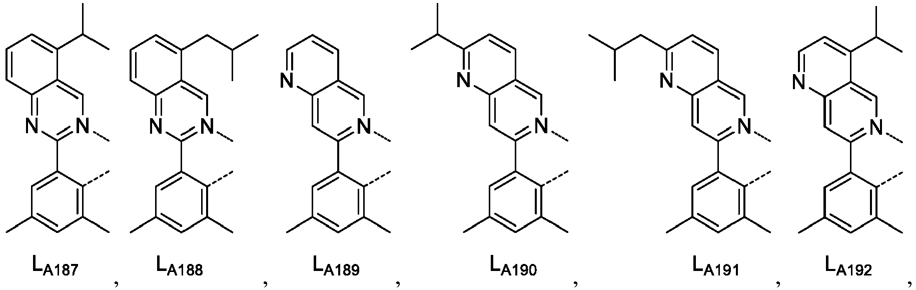

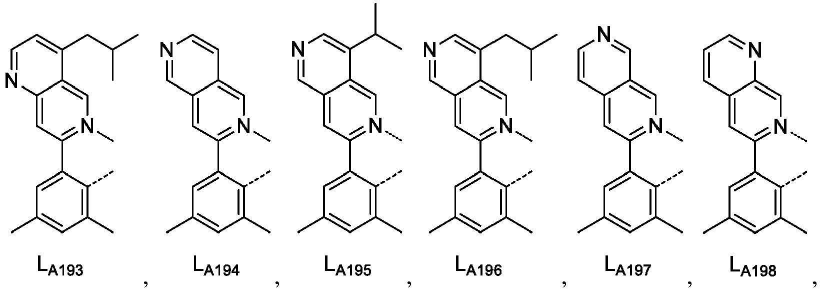

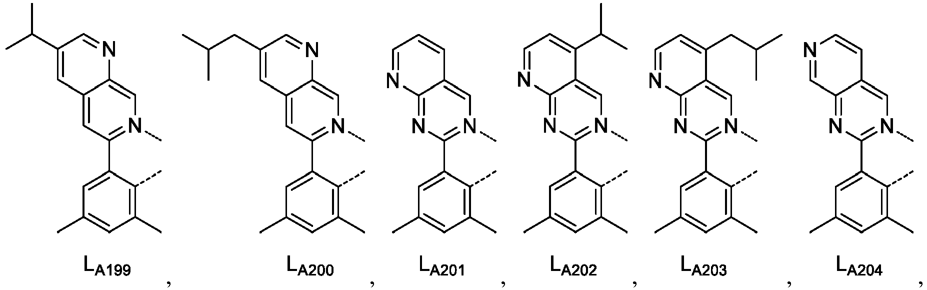

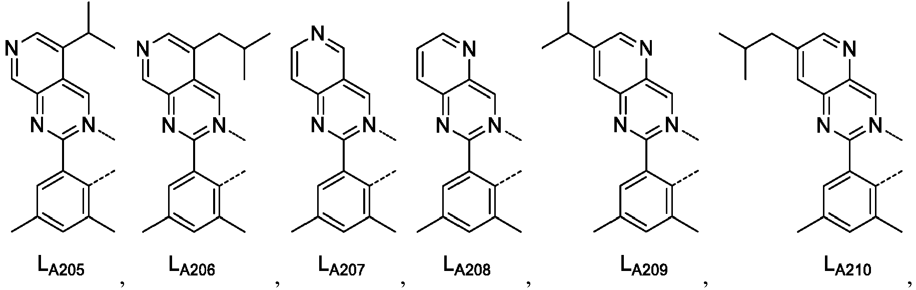

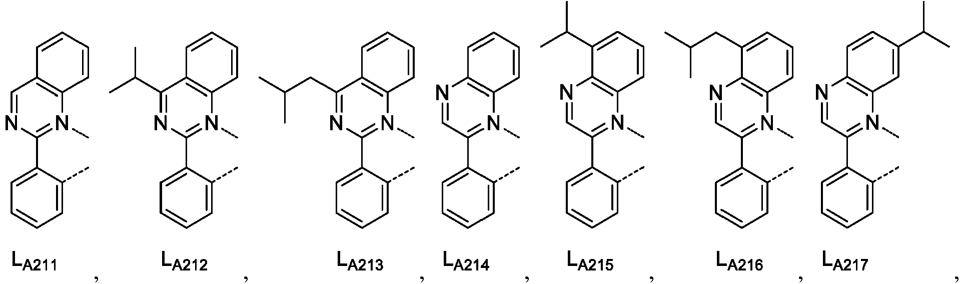

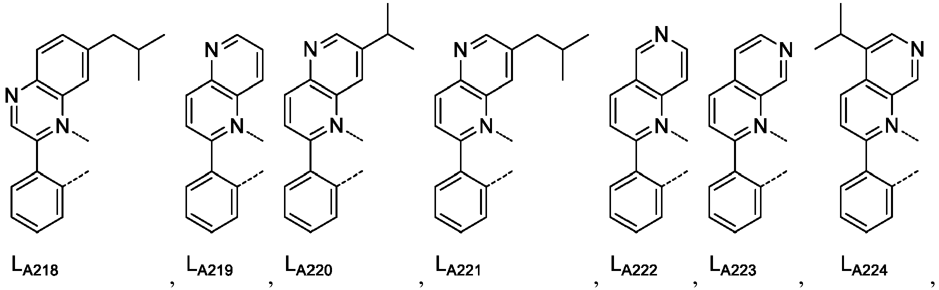

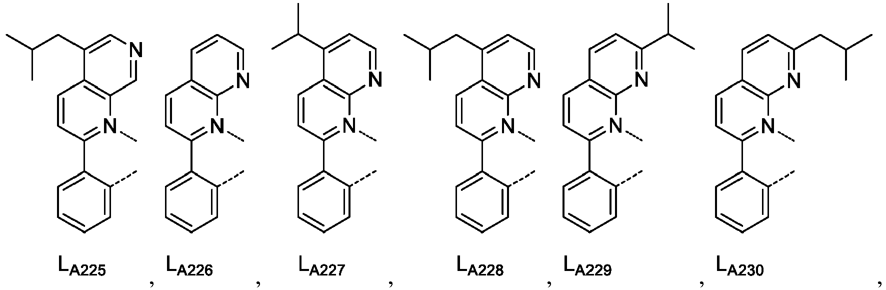

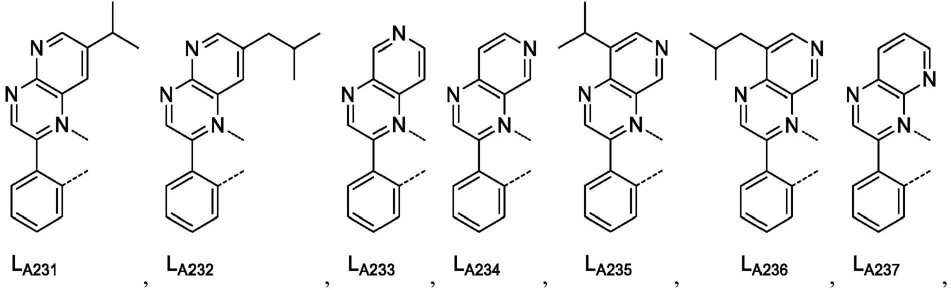

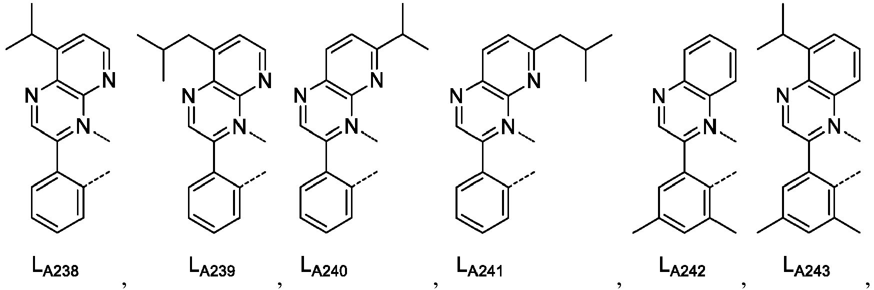

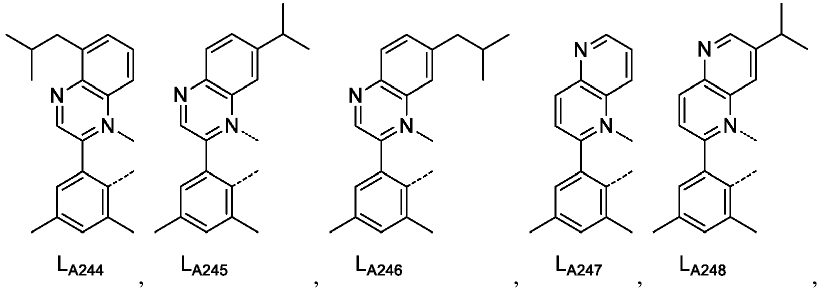

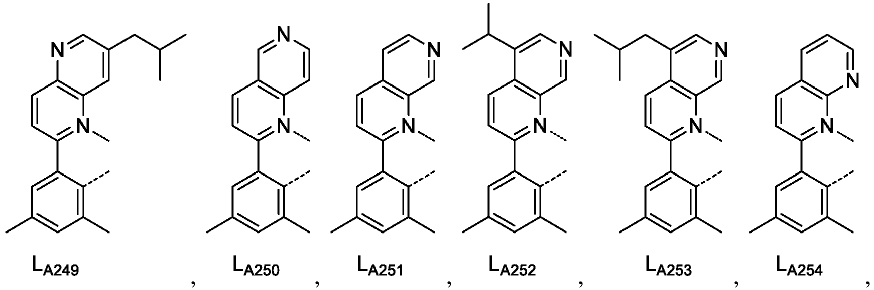

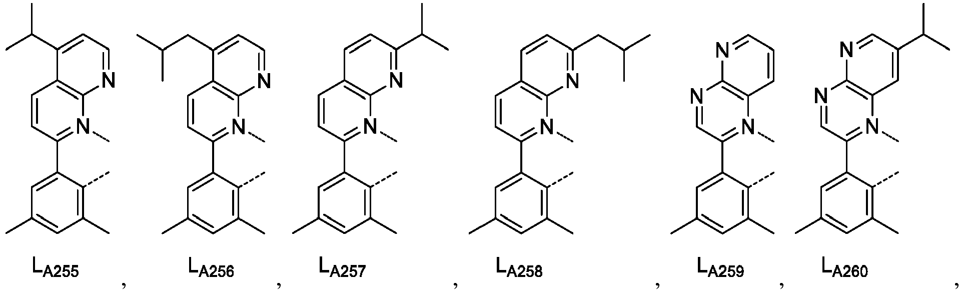

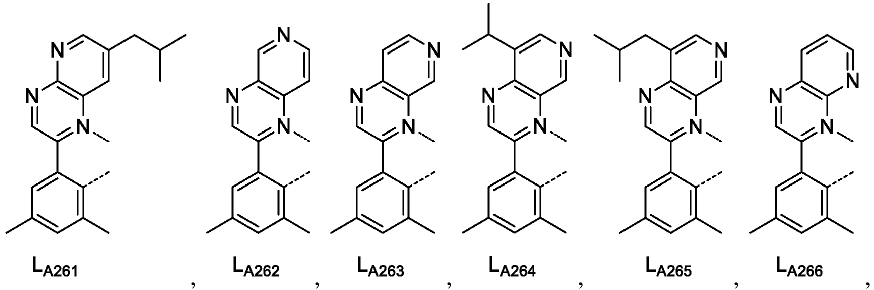

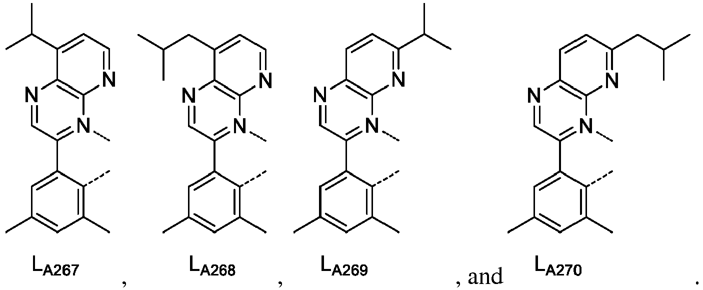

Some embodiments are drawn to compounds of formula M(L_{A})ₓ(L_{B})_{y}(L_{C})_{z}, where x=1 or 2, y=1 or 2, and z=0.

In some embodiments, L_{B} is selected from the group consisting of L_{B1}-L_{B13} listed below: 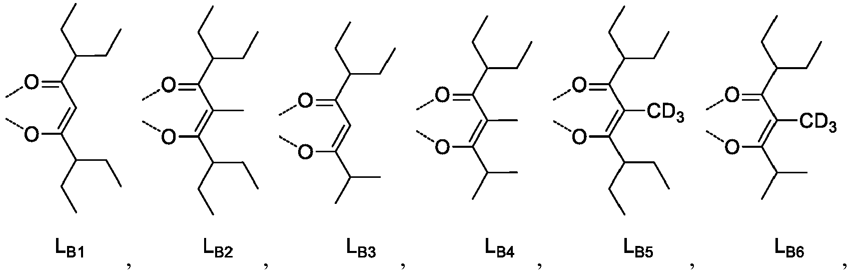 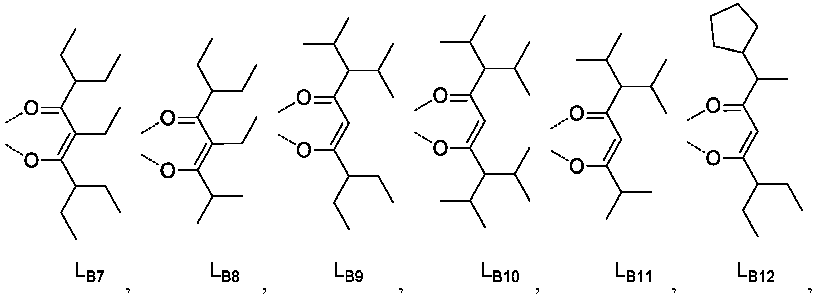 and

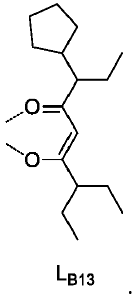

In some embodiments, z=0, x=1 or 2, y =1 or 2, and the compound having the formula of Ir(L_{A})ₓ(L_{B})_{y} is selected from the group consisting of Compound 1 to Compound 3510 listed in the table below:

| Compound Number | L_{A} | L_{B} | Compound Number | L_{A} | L_{B} | Compound Number | L_{A} | L_{B} |
|---|---|---|---|---|---|---|---|---|
| 1 | L_{A1} | L_{B1} | 1201 | L_{A121} | L_{B5} | 2401 | L_{A241} | L_{B9} |
| 2 | L_{A2} | L_{B1} | 1202 | L_{A122} | L_{B5} | 2402 | L_{A242} | L_{B9} |
| 3 | L_{A3} | L_{B1} | 1203 | L_{A123} | L_{B5} | 2403 | L_{A243} | L_{B9} |
| 4 | L_{A4} | L_{B1} | 1204 | L_{A124} | L_{B5} | 2404 | L_{A244} | L_{B9} |
| 5 | L_{A5} | L_{B1} | 1205 | L_{A125} | L_{B5} | 2405 | L_{A245} | L_{B9} |
| 6 | L_{A6} | L_{B1} | 1206 | L_{A126} | L_{B5} | 2406 | L_{A246} | L_{B9} |
| 7 | L_{A7} | L_{B1} | 1207 | L_{A127} | L_{B5} | 2407 | L_{A247} | L_{B9} |
| 8 | L_{A8} | L_{B1} | 1208 | L_{A128} | L_{B5} | 2408 | L_{A248} | L_{B9} |
| 9 | L_{A9} | L_{B1} | 1209 | L_{A129} | L_{B5} | 2409 | L_{A249} | L_{B9} |
| 10 | L_{A10} | L_{B1} | 1210 | L_{A130} | L_{B5} | 2410 | L_{A250} | L_{B9} |
| 11 | L_{A11} | L_{B1} | 1211 | L_{A131} | L_{B5} | 2411 | L_{A251} | L_{B9} |
| 12 | L_{A12} | L_{B1} | 1212 | L_{A132} | L_{B5} | 2412 | L_{A252} | L_{B9} |
| 13 | L_{A13} | L_{B1} | 1213 | L_{A133} | L_{B5} | 2413 | L_{A253} | L_{B9} |
| 14 | L_{A14} | L_{B1} | 1214 | L_{A134} | L_{B5} | 2414 | L_{A254} | L_{B9} |
| 15 | L_{A15} | L_{B1} | 1215 | L_{A135} | L_{B5} | 2415 | L_{A255} | L_{B9} |
| 16 | L_{A16} | L_{B1} | 1216 | L_{A136} | L_{B5} | 2416 | L_{A256} | L_{B9} |
| 17 | L_{A17} | L_{B1} | 1217 | L_{A137} | L_{B5} | 2417 | L_{A257} | L_{B9} |
| 18 | L_{A18} | L_{B1} | 1218 | L_{A138} | L_{B5} | 2418 | L_{A258} | L_{B9} |
| 19 | L_{A19} | L_{B1} | 1219 | L_{A139} | L_{B5} | 2419 | L_{A259} | L_{B9} |
| 20 | L_{A20} | L_{B1} | 1220 | L_{A140} | L_{B5} | 2420 | L_{A260} | L_{B9} |
| 21 | L_{A21} | L_{B1} | 1221 | L_{A141} | L_{B5} | 2421 | L_{A261} | L_{B9} |
| 22 | L_{A22} | L_{B1} | 1222 | L_{A142} | L_{B5} | 2422 | L_{A262} | L_{B9} |
| 23 | L_{A23} | L_{B1} | 1223 | L_{A143} | L_{B5} | 2423 | L_{A263} | L_{B9} |
| 24 | L_{A24} | L_{B1} | 1224 | L_{A144} | L_{B5} | 2424 | L_{A264} | L_{B9} |
| 25 | L_{A25} | L_{B1} | 1225 | L_{A145} | L_{B5} | 2425 | L_{A265} | L_{B9} |
| 26 | L_{A26} | L_{B1} | 1226 | L_{A146} | L_{B5} | 2426 | L_{A266} | L_{B9} |
| 27 | L_{A27} | L_{B1} | 1227 | L_{A147} | L_{B5} | 2427 | L_{A267} | L_{B9} |
| 28 | L_{A28} | L_{B1} | 1228 | L_{A148} | L_{B5} | 2428 | L_{A268} | L_{B9} |
| 29 | L_{A29} | L_{B1} | 1229 | L_{A149} | L_{B5} | 2429 | L_{A269} | L_{B9} |
| 30 | L_{A30} | L_{B1} | 1230 | L_{A150} | L_{B5} | 2430 | L_{A270} | L_{B9} |
| 31 | L_{A31} | L_{B1} | 1231 | L_{A151} | L_{B5} | 2431 | L_{A1} | L_{B10} |
| 32 | L_{A32} | L_{B1} | 1232 | L_{A152} | L_{B5} | 2432 | L_{A2} | L_{B10} |
| 33 | L_{A33} | L_{B1} | 1233 | L_{A153} | L_{B5} | 2433 | L_{A3} | L_{B10} |
| 34 | L_{A34} | L_{B1} | 1234 | L_{A154} | L_{B5} | 2434 | L_{A4} | L_{B10} |
| 35 | L_{A35} | L_{B1} | 1235 | L_{A155} | L_{B5} | 2435 | L_{A5} | L_{B10} |
| 36 | L_{A36} | L_{B1} | 1236 | L_{A156} | L_{B5} | 2436 | L_{A6} | L_{B10} |
| 37 | L_{A37} | L_{B1} | 1237 | L_{A157} | L_{B5} | 2437 | L_{A7} | L_{B10} |
| 38 | L_{A38} | L_{B1} | 1238 | L_{A158} | L_{B5} | 2438 | L_{A8} | L_{B10} |
| 39 | L_{A39} | L_{B1} | 1239 | L_{A159} | L_{B5} | 2439 | L_{A9} | L_{B10} |
| 40 | L_{A40} | L_{B1} | 1240 | L_{A160} | L_{B5} | 2440 | L_{A1} | L_{B10} |
| 41 | L_{A41} | L_{B1} | 1241 | L_{A161} | L_{B5} | 2441 | | L_{B10} |
| 42 | L_{A42} | L_{B1} | 1242 | L_{A162} | L_{B5} | 2442 | L_{A12} | L_{B10} |
| 43 | L_{A43} | L_{B1} | 1243 | L_{A163} | L_{B5} | 2443 | L_{A13} | L_{B10} |
| 44 | L_{A44} | L_{B1} | 1244 | L_{A164} | L_{B5} | 2444 | L_{A14} | L_{B10} |
| 45 | L_{A45} | L_{B1} | 1245 | L_{A165} | L_{B5} | 2445 | L_{A15} | L_{B10} |
| 46 | L_{A46} | L_{B1} | 1246 | L_{A166} | L_{B5} | 2446 | L_{A16} | L_{B10} |
| 47 | L_{A47} | L_{B1} | 1247 | L_{A167} | L_{B5} | 2447 | L_{A17} | L_{B10} |
| 48 | L_{A48} | L_{B1} | 1248 | L_{A168} | L_{B5} | 2448 | L_{A18} | L_{B10} |
| 49 | L_{A49} | L_{B1} | 1249 | L_{A169} | L_{B5} | 2449 | L_{A19} | L_{B10} |
| 50 | L_{A50} | L_{B1} | 1250 | L_{A170} | L_{B5} | 2450 | L_{A20} | L_{B10} |
| 51 | L_{A51} | L_{B1} | 1251 | L_{A171} | L_{B5} | 2451 | L_{A21} | L_{B10} |
| 52 | L_{A52} | L_{B1} | 1252 | L_{A172} | L_{B5} | 2452 | L_{A22} | L_{B10} |
| 53 | L_{A53} | L_{B1} | 1253 | L_{A173} | L_{B5} | 2453 | L_{A23} | L_{B10} |
| 54 | L_{A54} | L_{B1} | 1254 | L_{A174} | L_{B5} | 2454 | L_{A24} | L_{B10} |
| 55 | L_{A55} | L_{B1} | 1255 | L_{A175} | L_{B5} | 2455 | L_{A25} | L_{B10} |
| 56 | L_{A56} | L_{B1} | 1256 | L_{A176} | L_{B5} | 2456 | L_{A26} | L_{B10} |
| 57 | L_{A57} | L_{B1} | 1257 | L_{A177} | L_{B5} | 2457 | L_{A27} | L_{B10} |
| 58 | L_{A58} | L_{B1} | 1258 | L_{A178} | L_{B5} | 2458 | L_{A28} | L_{B10} |
| 59 | L_{A59} | L_{B1} | 1259 | L_{A179} | L_{B5} | 2459 | L_{A29} | L_{B10} |
| 60 | L_{A60} | L_{B1} | 1260 | L_{A180} | L_{B5} | 2460 | L_{A30} | L_{B10} |
| 61 | L_{A61} | L_{B1} | 1261 | L_{A181} | L_{B5} | 2461 | L_{A31} | L_{B10} |
| 62 | L_{A62} | L_{B1} | 1262 | L_{A182} | L_{B5} | 2462 | L_{A32} | L_{B10} |
| 63 | L_{A63} | L_{B1} | 1263 | L_{A183} | L_{B5} | 2463 | L_{A33} | L_{B10} |
| 64 | L_{A64} | L_{B1} | 1264 | L_{A184} | L_{B5} | 2464 | L_{A34} | L_{B10} |
| 65 | L_{A65} | L_{B1} | 1265 | L_{A185} | L_{B5} | 2465 | L_{A35} | L_{B10} |
| 66 | L_{A66} | L_{B1} | 1266 | L_{A186} | L_{B5} | 2466 | L_{A36} | L_{B10} |
| 67 | L_{A67} | L_{B1} | 1267 | L_{A187} | L_{B5} | 2467 | L_{A37} | L_{B10} |
| 68 | L_{A68} | L_{B1} | 1268 | L_{A188} | L_{B5} | 2468 | L_{A38} | L_{B10} |
| 69 | L_{A69} | L_{B1} | 1269 | L_{A189} | L_{B5} | 2469 | L_{A39} | L_{B10} |
| 70 | L_{A70} | L_{B1} | 1270 | L_{A190} | L_{B5} | 2470 | L_{A40} | L_{B10} |
| 71 | L_{A71} | L_{B1} | 1271 | L_{A191} | L_{B5} | 2471 | L_{A41} | L_{B10} |
| 72 | L_{A72} | L_{B1} | 1272 | L_{A192} | L_{B5} | 2472 | L_{A42} | L_{B10} |
| 73 | L_{A73} | L_{B1} | 1273 | L_{A193} | L_{B5} | 2473 | L_{A43} | L_{B10} |
| 74 | L_{A74} | L_{B1} | 1274 | L_{A194} | L_{B5} | 2474 | L_{A44} | L_{B10} |
| 75 | L_{A75} | L_{B1} | 1275 | L_{A195} | L_{B5} | 2475 | L_{A45} | L_{B10} |
| 76 | L_{A76} | L_{B1} | 1276 | L_{A196} | L_{B5} | 2476 | L_{A46} | L_{B10} |
| 77 | L_{A77} | L_{B1} | 1277 | L_{A197} | L_{B5} | 2477 | L_{A47} | L_{B10} |
| 78 | L_{A78} | L_{B1} | 1278 | L_{A198} | L_{B5} | 2478 | L_{A48} | L_{B10} |
| 79 | L_{A79} | L_{B1} | 1279 | L_{A199} | L_{B5} | 2479 | L_{A49} | L_{B10} |
| 80 | L_{A80} | L_{B1} | 1280 | L_{A200} | L_{B5} | 2480 | L_{A50} | L_{B10} |
| 81 | L_{A81} | L_{B1} | 1281 | L_{A201} | L_{B5} | 2481 | L_{A51} | L_{B10} |
| 82 | L_{A82} | L_{B1} | 1282 | L_{A202} | L_{B5} | 2482 | L_{A52} | L_{B10} |
| 83 | L_{A83} | L_{B1} | 1283 | L_{A203} | L_{B5} | 2483 | L_{A53} | L_{B10} |
| 84 | L_{A84} | L_{B1} | 1284 | L_{A204} | L_{B5} | 2484 | L_{A54} | L_{B10} |
| 85 | L_{A85} | L_{B1} | 1285 | L_{A205} | L_{B5} | 2485 | L_{A55} | L_{B10} |
| 86 | L_{A86} | L_{B1} | 1286 | L_{A206} | L_{B5} | 2486 | L_{A56} | L_{B10} |
| 87 | L_{A87} | L_{B1} | 1287 | L_{A207} | L_{B5} | 2487 | L_{A57} | L_{B10} |
| 88 | L_{A88} | L_{B1} | 1288 | L_{A208} | L_{B5} | 2488 | L_{A58} | L_{B10} |
| 89 | L_{A89} | L_{B1} | 1289 | L_{A209} | L_{B5} | 2489 | L_{A59} | L_{B10} |
| 90 | L_{A90} | L_{B1} | 1290 | L_{A210} | L_{B5} | 2490 | L_{A60} | L_{B10} |
| 91 | L_{A91} | L_{B1} | 1291 | L_{A211} | L_{B5} | 2491 | L_{A61} | L_{B10} |
| 92 | L_{A92} | L_{B1} | 1292 | L_{A212} | L_{B5} | 2492 | L_{A62} | L_{B10} |
| 93 | L_{A93} | L_{B1} | 1293 | L_{A213} | L_{B5} | 2493 | L_{A63} | L_{B10} |
| 94 | L_{A94} | L_{B1} | 1294 | L_{A214} | L_{B5} | 2494 | L_{A64} | L_{B10} |
| 95 | L_{A95} | L_{B1} | 1295 | L_{A215} | L_{B5} | 2495 | L_{A65} | L_{B10} |
| 96 | L_{A96} | L_{B1} | 1296 | L_{A216} | L_{B5} | 2496 | L_{A66} | L_{B10} |
| 97 | L_{A97} | L_{B1} | 1297 | L_{A217} | L_{B5} | 2497 | L_{A67} | L_{B10} |
| 98 | L_{A98} | L_{B1} | 1298 | L_{A218} | L_{B5} | 2498 | L_{A68} | L_{B10} |
| 99 | L_{A99} | L_{B1} | 1299 | L_{A219} | L_{B5} | 2499 | L_{A69} | L_{B10} |
| 100 | L_{A100} | L_{B1} | 1300 | L_{A220} | L_{B5} | 2500 | L_{A70} | L_{B10} |
| 101 | L_{A101} | L_{B1} | 1301 | L_{A221} | L_{B5} | 2501 | L_{A71} | L_{B10} |
| 102 | L_{A102} | L_{B1} | 1302 | L_{A222} | L_{B5} | 2502 | L_{A72} | L_{B10} |
| 103 | L_{A103} | L_{B1} | 1303 | L_{A223} | L_{B5} | 2503 | L_{A73} | L_{B10} |
| 104 | L_{A104} | L_{B1} | 1304 | L_{A224} | L_{B5} | 2504 | L_{A74} | L_{B10} |
| 105 | L_{A105} | L_{B1} | 1305 | L_{A225} | L_{B5} | 2505 | L_{A75} | L_{B10} |
| 106 | L_{A106} | L_{B1} | 1306 | L_{A226} | L_{B5} | 2506 | L_{A76} | L_{B10} |
| 107 | L_{A107} | L_{B1} | 1307 | L_{A227} | L_{B5} | 2507 | L_{A77} | L_{B10} |
| 108 | L_{A108} | L_{B1} | 1308 | L_{A228} | L_{B5} | 2508 | L_{A78} | L_{B10} |
| 109 | L_{A109} | L_{B1} | 1309 | L_{A229} | L_{B5} | 2509 | L_{A79} | L_{B10} |
| 110 | L_{A110} | L_{B1} | 1310 | L_{A230} | L_{B5} | 2510 | L_{A80} | L_{B10} |
| 111 | L_{A111} | L_{B1} | 1311 | L_{A231} | L_{B5} | 2511 | L_{A81} | L_{B10} |
| 112 | L_{A112} | L_{B1} | 1312 | L_{A232} | L_{B5} | 2512 | L_{A82} | L_{B10} |
| 113 | L_{A13} | L_{B1} | 1313 | L_{A233} | L_{B5} | 2513 | L_{A83} | L_{B10} |
| 114 | L_{A114} | L_{B1} | 1314 | L_{A234} | L_{B5} | 2514 | L_{A84} | L_{B10} |
| 115 | L_{A115} | L_{B1} | 1315 | L_{A235} | L_{B5} | 2515 | L_{A85} | L_{B10} |
| 116 | L_{A116} | L_{B1} | 1316 | L_{A236} | L_{B5} | 2516 | L_{A86} | L_{B10} |
| 117 | L_{A117} | L_{B1} | 1317 | L_{A237} | L_{B5} | 2517 | L_{A87} | L_{B10} |
| 118 | L_{A118} | L_{B1} | 1318 | L_{A238} | L_{B5} | 2518 | L_{A88} | L_{B10} |
| 119 | L_{A119} | L_{B1} | 1319 | L_{A239} | L_{B5} | 2519 | L_{A89} | L_{B10} |
| 120 | L_{A120} | L_{B1} | 1320 | L_{A240} | L_{B5} | 2520 | L_{A90} | L_{B10} |
| 121 | L_{A121} | L_{B1} | 1321 | L_{A241} | L_{B5} | 2521 | L_{A91} | L_{B10} |
| 122 | L_{A122} | L_{B1} | 1322 | L_{A242} | L_{B5} | 2522 | L_{A92} | L_{B10} |
| 123 | L_{A123} | L_{B1} | 1323 | L_{A243} | L_{B5} | 2523 | L_{A93} | L_{B10} |
| 124 | L_{A124} | L_{B1} | 1324 | L_{A244} | L_{B5} | 2524 | L_{A94} | L_{B10} |
| 125 | L_{A125} | L_{B1} | 1325 | L_{A245} | L_{B5} | 2525 | L_{A95} | L_{B10} |
| 126 | L_{A126} | L_{B1} | 1326 | L_{A246} | L_{B5} | 2526 | L_{A96} | L_{B10} |
| 127 | L_{A127} | L_{B1} | 1327 | L_{A247} | L_{B5} | 2527 | L_{A97} | L_{B10} |
| 128 | L_{A128} | L_{B1} | 1328 | L_{A248} | L_{B5} | 2528 | L_{A98} | L_{B10} |
| 129 | L_{A129} | L_{B1} | 1329 | L_{A249} | L_{B5} | 2529 | L_{A99} | L_{B10} |
| 130 | L_{A130} | L_{B1} | 1330 | L_{A250} | L_{B5} | 2530 | L_{A100} | L_{B10} |
| 131 | L_{A131} | L_{B1} | 1331 | L_{A251} | L_{B5} | 2531 | L_{A101} | L_{B10} |
| 132 | L_{A132} | L_{B1} | 1332 | L_{A252} | L_{B5} | 2532 | L_{A102} | L_{B10} |
| 133 | L_{A133} | L_{B1} | 1333 | L_{A253} | L_{B5} | 2533 | L_{A103} | L_{B10} |
| 134 | L_{A134} | L_{B1} | 1334 | L_{A254} | L_{B5} | 2534 | L_{A104} | L_{B10} |
| 135 | L_{A135} | L_{B1} | 1335 | L_{A255} | L_{B5} | 2535 | L_{A105} | L_{B10} |
| 136 | L_{A136} | L_{B1} | 1336 | L_{A256} | L_{B5} | 2536 | L_{A106} | L_{B10} |
| 137 | L_{A137} | L_{B1} | 1337 | L_{A257} | L_{B5} | 2537 | L_{A107} | L_{B10} |
| 138 | L_{A138} | L_{B1} | 1338 | L_{A258} | L_{B5} | 2538 | L_{A108} | L_{B10} |
| 139 | L_{A139} | L_{B1} | 1339 | L_{A259} | L_{B5} | 2539 | L_{A109} | L_{B10} |
| 140 | L_{A140} | L_{B1} | 1340 | L_{A260} | L_{B5} | 2540 | L_{A110} | L_{B10} |
| 141 | L_{A141} | L_{B1} | 1341 | L_{A261} | L_{B5} | 2541 | L_{A111} | L_{B10} |
| 142 | L_{A142} | L_{B1} | 1342 | L_{A262} | L_{B5} | 2542 | L_{A112} | L_{B10} |
| 143 | L_{A143} | L_{B1} | 1343 | L_{A263} | L_{B5} | 2543 | L_{A113} | L_{B10} |
| 144 | L_{A144} | L_{B1} | 1344 | L_{A264} | L_{B5} | 2544 | L_{A114} | L_{B10} |
| 145 | L_{A145} | L_{B1} | 1345 | L_{A265} | L_{B5} | 2545 | L_{A115} | L_{B10} |
| 146 | L_{A146} | L_{B1} | 1346 | L_{A266} | L_{B5} | 2546 | L_{A116} | L_{B10} |
| 147 | L_{A147} | L_{B1} | 1347 | L_{A267} | L_{B5} | 2547 | L_{A117} | L_{B10} |
| 148 | L_{A148} | L_{B1} | 1348 | L_{A268} | L_{B5} | 2548 | L_{A118} | L_{B10} |
| 149 | L_{A149} | L_{B1} | 1349 | L_{A269} | L_{B5} | 2549 | L_{A119} | L_{B10} |
| 150 | L_{A150} | L_{B1} | 1350 | L_{A270} | L_{B5} | 2550 | L_{A120} | L_{B10} |
| 151 | L_{A151} | L_{B1} | 1351 | L_{A1} | L_{B6} | 2551 | L_{A121} | L_{B10} |
| 152 | L_{A152} | L_{B1} | 1352 | L_{A2} | L_{B6} | 2552 | L_{A122} | L_{B10} |
| 153 | L_{A153} | L_{B1} | 1353 | L_{A3} | L_{B6} | 2553 | L_{A123} | L_{B10} |
| 154 | L_{A154} | L_{B1} | 1354 | L_{A4} | L_{B6} | 2554 | L_{A124} | L_{B10} |
| 155 | L_{A155} | L_{B1} | 1355 | L_{A5} | L_{B6} | 2555 | L_{A125} | L_{B10} |
| 156 | L_{A156} | L_{B1} | 1356 | L_{A6} | L_{B6} | 2556 | L_{A126} | L_{B10} |
| 157 | L_{A157} | L_{B1} | 1357 | L_{A7} | L_{B6} | 2557 | L_{A127} | L_{B10} |
| 158 | L_{A158} | L_{B1} | 1358 | L_{A8} | L_{B6} | 2558 | L_{A128} | L_{B10} |
| 159 | L_{A159} | L_{B1} | 1359 | L_{A9} | L_{B6} | 2559 | L_{A129} | L_{B10} |
| 160 | L_{A160} | L_{B1} | 1360 | L_{A10} | L_{B6} | 2560 | L_{A130} | L_{B10} |
| 161 | L_{A161} | L_{B1} | 1361 | L_{A11} | L_{B6} | 2561 | L_{A131} | L_{B10} |
| 162 | L_{A162} | L_{B1} | 1362 | L_{A12} | L_{B6} | 2562 | L_{A132} | L_{B10} |
| 163 | L_{A163} | L_{B1} | 1363 | L_{A13} | L_{B6} | 2563 | L_{A133} | L_{B10} |
| 164 | L_{A164} | L_{B1} | 1364 | L_{A14} | L_{B6} | 2564 | L_{A134} | L_{B10} |
| 165 | L_{A165} | L_{B1} | 1365 | L_{A15} | L_{B6} | 2565 | L_{A135} | L_{B10} |
| 166 | L_{A166} | L_{B1} | 1366 | L_{A16} | L_{B6} | 2566 | L_{A136} | L_{B10} |
| 167 | L_{A167} | L_{B1} | 1367 | L_{A17} | L_{B6} | 2567 | L_{A137} | L_{B10} |
| 168 | L_{A168} | L_{B1} | 1368 | L_{A18} | L_{B6} | 2568 | L_{A138} | L_{B10} |
| 169 | L_{A169} | L_{B1} | 1369 | L_{A19} | L_{B6} | 2569 | L_{A139} | L_{B10} |
| 170 | L_{A170} | L_{B1} | 1370 | L_{A20} | L_{B6} | 2570 | L_{A140} | L_{B10} |
| 171 | L_{A171} | L_{B1} | 1371 | L_{A21} | L_{B6} | 2571 | L_{A141} | L_{B10} |
| 172 | L_{A172} | L_{B1} | 1372 | L_{A22} | L_{B6} | 2572 | L_{A142} | L_{B10} |
| 173 | L_{A173} | L_{B1} | 1373 | L_{A23} | L_{B6} | 2573 | L_{A143} | L_{B10} |
| 174 | L_{A174} | L_{B1} | 1374 | L_{A24} | L_{B6} | 2574 | L_{A144} | L_{B10} |
| 175 | L_{A175} | L_{B1} | 1375 | L_{A25} | L_{B6} | 2575 | L_{A145} | L_{B10} |
| 176 | L_{A176} | L_{B1} | 1376 | L_{A26} | L_{B6} | 2576 | L_{A146} | L_{B10} |
| 177 | L_{A177} | L_{B1} | 1377 | L_{A27} | L_{B6} | 2577 | L_{A147} | L_{B10} |
| 178 | L_{A178} | L_{B1} | 1378 | L_{A28} | L_{B6} | 2578 | L_{A148} | L_{B10} |
| 179 | L_{A179} | L_{B1} | 1379 | L_{A29} | L_{B6} | 2579 | L_{A149} | L_{B10} |
| 180 | L_{A180} | L_{B1} | 1380 | L_{A30} | L_{B6} | 2580 | L_{A150} | L_{B10} |
| 181 | L_{A181} | L_{B1} | 1381 | L_{A31} | L_{B6} | 2581 | L_{A151} | L_{B10} |
| 182 | L_{A182} | L_{B1} | 1382 | L_{A32} | L_{B6} | 2582 | L_{A152} | L_{B10} |
| 183 | L_{A183} | L_{B1} | 1383 | L_{A33} | L_{B6} | 2583 | L_{A153} | L_{B10} |
| 184 | L_{A184} | L_{B1} | 1384 | L_{A34} | L_{B6} | 2584 | L_{A154} | L_{B10} |
| 185 | L_{A185} | L_{B1} | 1385 | L_{A35} | L_{B6} | 2585 | L_{A155} | L_{B10} |
| 186 | L_{A186} | L_{B1} | 1386 | L_{A36} | L_{B6} | 2586 | L_{A156} | L_{B10} |
| 187 | L_{A187} | L_{B1} | 1387 | L_{A37} | L_{B6} | 2587 | L_{A157} | L_{B10} |
| 188 | L_{A188} | L_{B1} | 1388 | L_{A38} | L_{B6} | 2588 | L_{A158} | L_{B10} |
| 189 | L_{A189} | L_{B1} | 1389 | L_{A39} | L_{B6} | 2589 | L_{A159} | L_{B10} |
| 190 | L_{A190} | L_{B1} | 1390 | L_{A40} | L_{B6} | 2590 | L_{A160} | L_{B10} |
| 191 | L_{A191} | L_{B1} | 1391 | L_{A41} | L_{B6} | 2591 | L_{A161} | L_{B10} |
| 192 | L_{A192} | L_{B1} | 1392 | L_{A42} | L_{B6} | 2592 | L_{A162} | L_{B10} |
| 193 | L_{A193} | L_{B1} | 1393 | L_{A43} | L_{B6} | 2593 | L_{A163} | L_{B10} |
| 194 | L_{A194} | L_{B1} | 1394 | L_{A44} | L_{B6} | 2594 | L_{A164} | L_{B10} |
| 195 | L_{A195} | L_{B1} | 1395 | L_{A45} | L_{B6} | 2595 | L_{A165} | L_{B10} |
| 196 | L_{A196} | L_{B1} | 1396 | L_{A46} | L_{B6} | 2596 | L_{A166} | L_{B10} |
| 197 | L_{A197} | L_{B1} | 1397 | L_{A47} | L_{B6} | 2597 | L_{A167} | L_{B10} |
| 198 | L_{A198} | L_{B1} | 1398 | L_{A48} | L_{B6} | 2598 | L_{A168} | L_{B10} |
| 199 | L_{A199} | L_{B1} | 1399 | L_{A49} | L_{B6} | 2599 | L_{A169} | L_{B10} |
| 200 | L_{A200} | L_{B1} | 1400 | L_{A50} | L_{B6} | 2600 | L_{A170} | L_{B10} |
| 201 | L_{A201} | L_{B1} | 1401 | L_{A51} | L_{B6} | 2601 | L_{A171} | L_{B10} |
| 202 | L_{A202} | L_{B1} | 1402 | L_{A52} | L_{B6} | 2602 | L_{A172} | L_{B10} |
| 203 | L_{A203} | L_{B1} | 1403 | L_{A53} | L_{B6} | 2603 | L_{A173} | L_{B10} |
| 204 | L_{A204} | L_{B1} | 1404 | L_{A54} | L_{B6} | 2604 | L_{A174} | L_{B10} |
| 205 | L_{A205} | L_{B1} | 1405 | L_{A55} | L_{B6} | 2605 | L_{A175} | L_{B10} |
| 206 | L_{A206} | L_{B1} | 1406 | L_{A56} | L_{B6} | 2606 | L_{A176} | L_{B10} |
| 207 | L_{A207} | L_{B1} | 1407 | L_{A57} | L_{B6} | 2607 | L_{A177} | L_{B10} |
| 208 | L_{A208} | L_{B1} | 1408 | L_{A58} | L_{B6} | 2608 | L_{A178} | L_{B10} |
| 209 | L_{A209} | L_{B1} | 1409 | L_{A59} | L_{B6} | 2609 | L_{A179} | L_{B10} |
| 210 | L_{A210} | L_{B1} | 1410 | L_{A60} | L_{B6} | 2610 | L_{A180} | L_{B10} |
| 211 | L_{A211} | L_{B1} | 1411 | L_{A61} | L_{B6} | 2611 | L_{A181} | L_{B10} |
| 212 | L_{A212} | L_{B1} | 1412 | L_{A62} | L_{B6} | 2612 | L_{A182} | L_{B10} |
| 213 | L_{A213} | L_{B1} | 1413 | L_{A63} | L_{B6} | 2613 | L_{A183} | L_{B10} |
| 214 | L_{A214} | L_{B1} | 1414 | L_{A64} | L_{B6} | 2614 | L_{A184} | L_{B10} |
| 215 | L_{A215} | L_{B1} | 1415 | L_{A65} | L_{B6} | 2615 | L_{A185} | L_{B10} |
| 216 | L_{A216} | L_{B1} | 1416 | L_{A66} | L_{B6} | 2616 | L_{A186} | L_{B10} |
| 217 | L_{A217} | L_{B1} | 1417 | L_{A67} | L_{B6} | 2617 | L_{A187} | L_{B10} |
| 218 | L_{A218} | L_{B1} | 1418 | L_{A68} | L_{B6} | 2618 | L_{A188} | L_{B10} |
| 219 | L_{A219} | L_{B1} | 1419 | L_{A69} | L_{B6} | 2619 | L_{A189} | L_{B10} |
| 220 | L_{A220} | L_{B1} | 1420 | L_{A70} | L_{B6} | 2620 | L_{A190} | L_{B10} |
| 221 | L_{A221} | L_{B1} | 1421 | L_{A71} | L_{B6} | 2621 | L_{A191} | L_{B10} |
| 222 | L_{A222} | L_{B1} | 1422 | L_{A72} | L_{B6} | 2622 | L_{A192} | L_{B10} |
| 223 | L_{A223} | L_{B1} | 1423 | L_{A73} | L_{B6} | 2623 | L_{A193} | L_{B10} |
| 224 | L_{A224} | L_{B1} | 1424 | L_{A74} | L_{B6} | 2624 | L_{A194} | L_{B10} |
| 225 | L_{A225} | L_{B1} | 1425 | L_{A75} | L_{B6} | 2625 | L_{A195} | L_{B10} |
| 226 | L_{A226} | L_{B1} | 1426 | L_{A76} | L_{B6} | 2626 | L_{A196} | L_{B10} |
| 227 | L_{A227} | L_{B1} | 1427 | L_{A77} | L_{B6} | 2627 | L_{A197} | L_{B10} |
| 228 | L_{A228} | L_{B1} | 1428 | L_{A78} | L_{B6} | 2628 | L_{A198} | L_{B10} |
| 229 | L_{A229} | L_{B1} | 1429 | L_{A79} | L_{B6} | 2629 | L_{A199} | L_{B10} |
| 230 | L_{A230} | L_{B1} | 1430 | L_{A80} | L_{B6} | 2630 | L_{A200} | L_{B10} |
| 231 | L_{A231} | L_{B1} | 1431 | L_{A81} | L_{B6} | 2631 | L_{A201} | L_{B10} |
| 232 | L_{A232} | L_{B1} | 1432 | L_{A82} | L_{B6} | 2632 | L_{A202} | L_{B10} |
| 233 | L_{A233} | L_{B1} | 1433 | L_{A83} | L_{B6} | 2633 | L_{A203} | L_{B10} |
| 234 | L_{A234} | L_{B1} | 1434 | L_{A84} | L_{B6} | 2634 | L_{A204} | L_{B10} |
| 235 | L_{A235} | L_{B1} | 1435 | L_{A85} | L_{B6} | 2635 | L_{A205} | L_{B10} |
| 236 | L_{A236} | L_{B1} | 1436 | L_{A86} | L_{B6} | 2636 | L_{A206} | L_{B10} |
| 237 | L_{A237} | L_{B1} | 1437 | L_{A87} | L_{B6} | 2637 | L_{A207} | L_{B10} |
| 238 | L_{A238} | L_{B1} | 1438 | L_{A88} | L_{B6} | 2638 | L_{A208} | L_{B10} |
| 239 | L_{A239} | L_{B1} | 1439 | L_{A89} | L_{B6} | 2639 | L_{A209} | L_{B10} |
| 240 | L_{A240} | L_{B1} | 1440 | L_{A90} | L_{B6} | 2640 | L_{A210} | L_{B10} |
| 241 | L_{A241} | L_{B1} | 1441 | L_{A91} | L_{B6} | 2641 | L_{A211} | L_{B10} |
| 242 | L_{A242} | L_{B1} | 1442 | L_{A92} | L_{B6} | 2642 | L_{A212} | L_{B10} |
| 243 | L_{A243} | L_{B1} | 1443 | L_{A93} | L_{B6} | 2643 | L_{A213} | L_{B10} |
| 244 | L_{A244} | L_{B1} | 1444 | L_{A94} | L_{B6} | 2644 | L_{A214} | L_{B10} |
| 245 | L_{A245} | L_{B1} | 1445 | L_{A95} | L_{B6} | 2645 | L_{A215} | L_{B10} |
| 246 | L_{A246} | L_{B1} | 1446 | L_{A96} | L_{B6} | 2646 | L_{A216} | L_{B10} |
| 247 | L_{A247} | L_{B1} | 1447 | L_{A97} | L_{B6} | 2647 | L_{A217} | L_{B10} |
| 248 | L_{A248} | L_{B1} | 1448 | L_{A98} | L_{B6} | 2648 | L_{A218} | L_{B10} |
| 249 | L_{A249} | L_{B1} | 1449 | L_{A99} | L_{B6} | 2649 | L_{A219} | L_{B10} |
| 250 | L_{A250} | L_{B1} | 1450 | L_{A100} | L_{B6} | 2650 | L_{A220} | L_{B10} |
| 251 | L_{A251} | L_{B1} | 1451 | L_{A101} | L_{B6} | 2651 | L_{A221} | L_{B10} |
| 252 | L_{A252} | L_{B1} | 1452 | L_{A102} | L_{B6} | 2652 | L_{A222} | L_{B10} |
| 253 | L_{A253} | L_{B1} | 1453 | L_{A103} | L_{B6} | 2653 | L_{A223} | L_{B10} |
| 254 | L_{A254} | L_{B1} | 1454 | L_{A104} | L_{B6} | 2654 | L_{A224} | L_{B10} |
| 255 | L_{A255} | L_{B1} | 1455 | L_{A105} | L_{B6} | 2655 | L_{A225} | L_{B10} |
| 256 | L_{A256} | L_{B1} | 1456 | L_{A106} | L_{B6} | 2656 | L_{A226} | L_{B10} |
| 257 | L_{A257} | L_{B1} | 1457 | L_{A107} | L_{B6} | 2657 | L_{A227} | L_{B10} |
| 258 | L_{A258} | L_{B1} | 1458 | L_{A108} | L_{B6} | 2658 | L_{A228} | L_{B10} |
| 259 | L_{A259} | L_{B1} | 1459 | L_{A109} | L_{B6} | 2659 | L_{A229} | L_{B10} |
| 260 | L_{A260} | L_{B1} | 1460 | L_{A110} | L_{B6} | 2660 | L_{A230} | L_{B10} |
| 261 | L_{A261} | L_{B1} | 1461 | L_{A111} | L_{B6} | 2661 | L_{A231} | L_{B10} |
| 262 | L_{A262} | L_{B1} | 1462 | L_{A112} | L_{B6} | 2662 | L_{A232} | L_{B10} |
| 263 | L_{A263} | L_{B1} | 1463 | L_{A113} | L_{B6} | 2663 | L_{A233} | L_{B10} |
| 264 | L_{A264} | L_{B1} | 1464 | L_{A114} | L_{B6} | 2664 | L_{A234} | L_{B10} |
| 265 | L_{A265} | L_{B1} | 1465 | L_{A115} | L_{B6} | 2665 | L_{A235} | L_{B10} |
| 266 | L_{A266} | L_{B1} | 1466 | L_{A116} | L_{B6} | 2666 | L_{A236} | L_{B10} |
| 267 | L_{A267} | L_{B1} | 1467 | L_{A117} | L_{B6} | 2667 | L_{A237} | L_{B10} |
| 268 | L_{A268} | L_{B1} | 1468 | L_{A118} | L_{B6} | 2668 | L_{A238} | L_{B10} |
| 269 | L_{A269} | L_{B1} | 1469 | L_{A119} | L_{B6} | 2669 | L_{A239} | L_{B10} |
| 270 | L_{A270} | L_{B1} | 1470 | L_{A120} | L_{B6} | 2670 | L_{A240} | L_{B10} |
| 271 | L_{A1} | L_{B2} | 1471 | L_{A121} | L_{B6} | 2671 | L_{A241} | L_{B10} |
| 272 | L_{A2} | L_{B2} | 1472 | L_{A122} | L_{B6} | 2672 | L_{A242} | L_{B10} |
| 273 | L_{A3} | L_{B2} | 1473 | L_{A123} | L_{B6} | 2673 | L_{A243} | L_{B10} |
| 274 | L_{A4} | L_{B2} | 1474 | L_{A124} | L_{B6} | 2674 | L_{A244} | L_{B10} |
| 275 | L_{A5} | L_{B2} | 1475 | L_{A125} | L_{B6} | 2675 | L_{A245} | L_{B10} |
| 276 | L_{A6} | L_{B2} | 1476 | L_{A126} | L_{B6} | 2676 | L_{A246} | L_{B10} |
| 277 | L_{A7} | L_{B2} | 1477 | L_{A127} | L_{B6} | 2677 | L_{A247} | L_{B10} |
| 278 | L_{A8} | L_{B2} | 1478 | L_{A128} | L_{B6} | 2678 | L_{A248} | L_{B10} |
| 279 | L_{A9} | L_{B2} | 1479 | L_{A129} | L_{B6} | 2679 | L_{A249} | L_{B10} |
| 280 | L_{A10} | L_{B2} | 1480 | L_{A130} | L_{B6} | 2680 | L_{A250} | L_{B10} |
| 281 | L_{A11} | L_{B2} | 1481 | L_{A131} | L_{B6} | 2681 | L_{A251} | L_{B10} |
| 282 | L_{A12} | L_{B2} | 1482 | L_{A132} | L_{B6} | 2682 | L_{A252} | L_{B10} |
| 283 | L_{A13} | L_{B2} | 1483 | L_{A133} | L_{B6} | 2683 | L_{A253} | L_{B10} |
| 284 | L_{A14} | L_{B2} | 1484 | L_{A134} | L_{B6} | 2684 | L_{A254} | L_{B10} |
| 285 | L_{A15} | L_{B2} | 1485 | L_{A135} | L_{B6} | 2685 | L_{A255} | L_{B10} |
| 286 | L_{A16} | L_{B2} | 1486 | L_{A136} | L_{B6} | 2686 | L_{A256} | L_{B10} |
| 287 | L_{A17} | L_{B2} | 1487 | L_{A137} | L_{B6} | 2687 | L_{A257} | L_{B10} |
| 288 | L_{A18} | L_{B2} | 1488 | L_{A138} | L_{B6} | 2688 | L_{A258} | L_{B10} |
| 289 | L_{A19} | L_{B2} | 1489 | L_{A139} | L_{B6} | 2689 | L_{A259} | L_{B10} |
| 290 | L_{A20} | L_{B2} | 1490 | L_{A140} | L_{B6} | 2690 | L_{A260} | L_{B10} |
| 291 | L_{A21} | L_{B2} | 1491 | L_{A141} | L_{B6} | 2691 | L_{A261} | L_{B10} |
| 292 | L_{A22} | L_{B2} | 1492 | L_{A142} | L_{B6} | 2692 | L_{A262} | L_{B10} |
| 293 | L_{A23} | L_{B2} | 1493 | L_{A143} | L_{B6} | 2693 | L_{A263} | L_{B10} |
| 294 | L_{A24} | L_{B2} | 1494 | L_{A144} | L_{B6} | 2694 | L_{A264} | L_{B10} |
| 295 | L_{A25} | L_{B2} | 1495 | L_{A145} | L_{B6} | 2695 | L_{A265} | L_{B10} |
| 296 | L_{A26} | L_{B2} | 1496 | L_{A146} | L_{B6} | 2696 | L_{A266} | L_{B10} |
| 297 | L_{A27} | L_{B2} | 1497 | L_{A147} | L_{B6} | 2697 | L_{A267} | L_{B10} |
| 298 | L_{A28} | L_{B2} | 1498 | L_{A148} | L_{B6} | 2698 | L_{A268} | L_{B10} |
| 299 | L_{A29} | L_{B2} | 1499 | L_{A149} | L_{B6} | 2699 | L_{A269} | L_{B10} |
| 300 | L_{A30} | L_{B2} | 1500 | L_{A150} | L_{B6} | 2700 | L_{A270} | L_{B10} |
| 301 | L_{A31} | L_{B2} | 1501 | L_{A151} | L_{B6} | 2701 | L_{A1} | L_{B11} |
| 302 | L_{A32} | L_{B2} | 1502 | L_{A152} | L_{B6} | 2702 | L_{A2} | L_{B11} |
| 303 | L_{A33} | L_{B2} | 1503 | L_{A153} | L_{B6} | 2703 | L_{A3} | L_{B11} |
| 304 | L_{A34} | L_{B2} | 1504 | L_{A154} | L_{B6} | 2704 | L_{A4} | L_{B11} |
| 305 | L_{A35} | L_{B2} | 1505 | L_{A155} | L_{B6} | 2705 | L_{A5} | L_{B11} |
| 306 | L_{A36} | L_{B2} | 1506 | L_{A156} | L_{B6} | 2706 | L_{A6} | L_{B11} |
| 307 | L_{A37} | L_{B2} | 1507 | L_{A157} | L_{B6} | 2707 | L_{A7} | L_{B11} |
| 308 | L_{A38} | L_{B2} | 1508 | L_{A158} | L_{B6} | 2708 | L_{A8} | L_{B11} |
| 309 | L_{A39} | L_{B2} | 1509 | L_{A159} | L_{B6} | 2709 | L_{A9} | L_{B11} |
| 310 | L_{A40} | L_{B2} | 1510 | L_{A160} | L_{B6} | 2710 | L_{A10} | L_{B11} |
| 311 | L_{A41} | L_{B2} | 1511 | L_{A161} | L_{B6} | 2711 | L_{A11} | L_{B11} |
| 312 | L_{A42} | L_{B2} | 1512 | L_{A162} | L_{B6} | 2712 | L_{A12} | L_{B11} |
| 313 | L_{A43} | L_{B2} | 1513 | L_{A163} | L_{B6} | 2713 | L_{A13} | L_{B11} |
| 314 | L_{A44} | L_{B2} | 1514 | L_{A164} | L_{B6} | 2714 | L_{A14} | L_{B11} |
| 315 | L_{A45} | L_{B2} | 1515 | L_{A165} | L_{B6} | 2715 | L_{A15} | L_{B11} |
| 316 | L_{A46} | L_{B2} | 1516 | L_{A166} | L_{B6} | 2716 | L_{A16} | L_{B11} |
| 317 | L_{A47} | L_{B2} | 1517 | L_{A167} | L_{B6} | 2717 | L_{A17} | L_{B11} |
| 318 | L_{A48} | L_{B2} | 1518 | L_{A168} | L_{B6} | 2718 | L_{A18} | L_{B11} |
| 319 | L_{A49} | L_{B2} | 1519 | L_{A169} | L_{B6} | 2719 | L_{A19} | L_{B11} |
| 320 | L_{A50} | L_{B2} | 1520 | L_{A170} | L_{B6} | 2720 | L_{A20} | L_{B11} |
| 321 | L_{A51} | L_{B2} | 1521 | L_{A171} | L_{B6} | 2721 | L_{A21} | L_{B11} |
| 322 | L_{A52} | L_{B2} | 1522 | L_{A172} | L_{B6} | 2722 | L_{A22} | L_{B11} |
| 323 | L_{A53} | L_{B2} | 1523 | L_{A173} | L_{B6} | 2723 | L_{A23} | L_{B11} |
| 324 | L_{A54} | L_{B2} | 1524 | L_{A174} | L_{B6} | 2724 | L_{A24} | L_{B11} |
| 325 | L_{A55} | L_{B2} | 1525 | L_{A175} | L_{B6} | 2725 | L_{A25} | L_{B11} |
| 326 | L_{A56} | L_{B2} | 1526 | L_{A176} | L_{B6} | 2726 | L_{A26} | L_{B11} |
| 327 | L_{A57} | L_{B2} | 1527 | L_{A177} | L_{B6} | 2727 | L_{A27} | L_{B11} |
| 328 | L_{A58} | L_{B2} | 1528 | L_{A178} | L_{B6} | 2728 | L_{A28} | L_{B11} |
| 329 | L_{A59} | L_{B2} | 1529 | L_{A179} | L_{B6} | 2729 | L_{A29} | L_{B11} |
| 330 | L_{A60} | L_{B2} | 1530 | L_{A180} | L_{B6} | 2730 | L_{A30} | L_{B11} |
| 331 | L_{A61} | L_{B2} | 1531 | L_{A181} | L_{B6} | 2731 | L_{A31} | L_{B11} |
| 332 | L_{A62} | L_{B2} | 1532 | L_{A182} | L_{B6} | 2732 | L_{A32} | L_{B11} |
| 333 | L_{A63} | L_{B2} | 1533 | L_{A183} | L_{B6} | 2733 | L_{A33} | L_{B11} |
| 334 | L_{A64} | L_{B2} | 1534 | L_{A184} | L_{B6} | 2734 | L_{A34} | L_{B11} |
| 335 | L_{A65} | L_{B2} | 1535 | L_{A185} | L_{B6} | 2735 | L_{A35} | L_{B11} |
| 336 | L_{A66} | L_{B2} | 1536 | L_{A186} | L_{B6} | 2736 | L_{A36} | L_{B11} |
| 337 | L_{A67} | L_{B2} | 1537 | L_{A187} | L_{B6} | 2737 | L_{A37} | L_{B11} |
| 338 | L_{A68} | L_{B2} | 1538 | L_{A188} | L_{B6} | 2738 | L_{A38} | L_{B11} |
| 339 | L_{A69} | L_{B2} | 1539 | L_{A189} | L_{B6} | 2739 | L_{A39} | L_{B11} |
| 340 | L_{A70} | L_{B2} | 1540 | L_{A190} | L_{B6} | 2740 | L_{A40} | L_{B11} |
| 341 | L_{A71} | L_{B2} | 1541 | L_{A191} | L_{B6} | 2741 | L_{A41} | L_{B11} |
| 342 | L_{A72} | L_{B2} | 1542 | L_{A192} | L_{B6} | 2742 | L_{A42} | L_{B11} |
| 343 | L_{A73} | L_{B2} | 1543 | L_{A193} | L_{B6} | 2743 | L_{A43} | L_{B11} |
| 344 | L_{A74} | L_{B2} | 1544 | L_{A194} | L_{B6} | 2744 | L_{A44} | L_{B11} |
| 345 | L_{A75} | L_{B2} | 1545 | L_{A195} | L_{B6} | 2745 | L_{A45} | L_{B11} |
| 346 | L_{A76} | L_{B2} | 1546 | L_{A196} | L_{B6} | 2746 | L_{A46} | L_{B11} |
| 347 | L_{A77} | L_{B2} | 1547 | L_{A197} | L_{B6} | 2747 | L_{A47} | L_{B11} |
| 348 | L_{A78} | L_{B2} | 1548 | L_{A198} | L_{B6} | 2748 | L_{A48} | L_{B11} |
| 349 | L_{A79} | L_{B2} | 1549 | L_{A199} | L_{B6} | 2749 | L_{A49} | L_{B11} |
| 350 | L_{A80} | L_{B2} | 1550 | L_{A200} | L_{B6} | 2750 | L_{A50} | L_{B11} |
| 351 | L_{A81} | L_{B2} | 1551 | L_{A201} | L_{B6} | 2751 | L_{A51} | L_{B11} |
| 352 | L_{A82} | L_{B2} | 1552 | L_{A202} | L_{B6} | 2752 | L_{A52} | L_{B11} |
| 353 | L_{A83} | L_{B2} | 1553 | L_{A203} | L_{B6} | 2753 | L_{A53} | L_{B11} |
| 354 | L_{A84} | L_{B2} | 1554 | L_{A204} | L_{B6} | 2754 | L_{A54} | L_{B11} |
| 355 | L_{A85} | L_{B2} | 1555 | L_{A205} | L_{B6} | 2755 | L_{A55} | L_{B11} |
| 356 | L_{A86} | L_{B2} | 1556 | L_{A206} | L_{B6} | 2756 | L_{A56} | L_{B11} |
| 357 | L_{A87} | L_{B2} | 1557 | L_{A207} | L_{B6} | 2757 | L_{A57} | L_{B11} |
| 358 | L_{A88} | L_{B2} | 1558 | L_{A208} | L_{B6} | 2758 | L_{A58} | L_{B11} |
| 359 | L_{A89} | L_{B2} | 1559 | L_{A209} | L_{B6} | 2759 | L_{A59} | L_{B11} |
| 360 | L_{A90} | L_{B2} | 1560 | L_{A210} | L_{B6} | 2760 | L_{A60} | L_{B11} |
| 361 | L_{A91} | L_{B2} | 1561 | L_{A211} | L_{B6} | 2761 | L_{A61} | L_{B11} |
| 362 | L_{A92} | L_{B2} | 1562 | L_{A212} | L_{B6} | 2762 | L_{A62} | L_{B11} |
| 363 | L_{A93} | L_{B2} | 1563 | L_{A213} | L_{B6} | 2763 | L_{A63} | L_{B11} |
| 364 | L_{A94} | L_{B2} | 1564 | L_{A214} | L_{B6} | 2764 | L_{A64} | L_{B11} |
| 365 | L_{A95} | L_{B2} | 1565 | L_{A215} | L_{B6} | 2765 | L_{A65} | L_{B11} |
| 366 | L_{A96} | L_{B2} | 1566 | L_{A216} | L_{B6} | 2766 | L_{A66} | L_{B11} |
| 367 | L_{A97} | L_{B2} | 1567 | L_{A217} | L_{B6} | 2767 | L_{A67} | L_{B11} |
| 368 | L_{A98} | L_{B2} | 1568 | L_{A218} | L_{B6} | 2768 | L_{A68} | L_{B11} |
| 369 | L_{A99} | L_{B2} | 1569 | L_{A219} | L_{B6} | 2769 | L_{A69} | L_{B11} |
| 370 | L_{A100} | L_{B2} | 1570 | L_{A220} | L_{B6} | 2770 | L_{A70} | L_{B11} |
| 371 | L_{A101} | L_{B2} | 1571 | L_{A221} | L_{B6} | 2771 | L_{A71} | L_{B11} |
| 372 | L_{A102} | L_{B2} | 1572 | L_{A222} | L_{B6} | 2772 | L_{A72} | L_{B11} |
| 373 | L_{A103} | L_{B2} | 1573 | L_{A223} | L_{B6} | 2773 | L_{A73} | L_{B11} |
| 374 | L_{A104} | L_{B2} | 1574 | L_{A224} | L_{B6} | 2774 | L_{A74} | L_{B11} |
| 375 | L_{A105} | L_{B2} | 1575 | L_{A225} | L_{B6} | 2775 | L_{A75} | L_{B11} |
| 376 | L_{A106} | L_{B2} | 1576 | L_{A226} | L_{B6} | 2776 | L_{A76} | L_{B11} |
| 377 | L_{A107} | L_{B2} | 1577 | L_{A227} | L_{B6} | 2777 | L_{A77} | L_{B11} |
| 378 | L_{A108} | L_{B2} | 1578 | L_{A228} | L_{B6} | 2778 | L_{A78} | L_{B11} |
| 379 | L_{A109} | L_{B2} | 1579 | L_{A229} | L_{B6} | 2779 | L_{A79} | L_{B11} |
| 380 | L_{A110} | L_{B2} | 1580 | L_{A230} | L_{B6} | 2780 | L_{A80} | L_{B11} |
| 381 | L_{A111} | L_{B2} | 1581 | L_{A231} | L_{B6} | 2781 | L_{A81} | L_{B11} |
| 382 | L_{A112} | L_{B2} | 1582 | L_{A232} | L_{B6} | 2782 | L_{A82} | L_{B11} |
| 383 | L_{A13} | L_{B2} | 1583 | L_{A233} | L_{B6} | 2783 | L_{A83} | L_{B11} |
| 384 | L_{A114} | L_{B2} | 1584 | L_{A234} | L_{B6} | 2784 | L_{A84} | L_{B11} |
| 385 | L_{A115} | L_{B2} | 1585 | L_{A235} | L_{B6} | 2785 | L_{A85} | L_{B11} |
| 386 | L_{A116} | L_{B2} | 1586 | L_{A236} | L_{B6} | 2786 | L_{A86} | L_{B11} |
| 387 | L_{A117} | L_{B2} | 1587 | L_{A237} | L_{B6} | 2787 | L_{A87} | L_{B11} |
| 388 | L_{A118} | L_{B2} | 1588 | L_{A238} | L_{B6} | 2788 | L_{A88} | L_{B11} |
| 389 | L_{A119} | L_{B2} | 1589 | L_{A239} | L_{B6} | 2789 | L_{A89} | L_{B11} |
| 390 | L_{A120} | L_{B2} | 1590 | L_{A240} | L_{B6} | 2790 | L_{A90} | L_{B11} |
| 391 | L_{A121} | L_{B2} | 1591 | L_{A241} | L_{B6} | 2791 | L_{A91} | L_{B11} |
| 392 | L_{A122} | L_{B2} | 1592 | L_{A242} | L_{B6} | 2792 | L_{A92} | L_{B11} |
| 393 | L_{A123} | L_{B2} | 1593 | L_{A243} | L_{B6} | 2793 | L_{A93} | L_{B11} |
| 394 | L_{A124} | L_{B2} | 1594 | L_{A244} | L_{B6} | 2794 | L_{A94} | L_{B11} |
| 395 | L_{A125} | L_{B2} | 1595 | L_{A245} | L_{B6} | 2795 | L_{A95} | L_{B11} |
| 396 | L_{A126} | L_{B2} | 1596 | L_{A246} | L_{B6} | 2796 | L_{A96} | L_{B11} |
| 397 | L_{A127} | L_{B2} | 1597 | L_{A247} | L_{B6} | 2797 | L_{A97} | L_{B11} |
| 398 | L_{A128} | L_{B2} | 1598 | L_{A248} | L_{B6} | 2798 | L_{A98} | L_{B11} |
| 399 | L_{A129} | L_{B2} | 1599 | L_{A249} | L_{B6} | 2799 | L_{A99} | L_{B11} |
| 400 | L_{A130} | L_{B2} | 1600 | L_{A250} | L_{B6} | 2800 | L_{A100} | L_{B11} |
| 401 | L_{A131} | L_{B2} | 1601 | L_{A251} | L_{B6} | 2801 | L_{A101} | L_{B11} |
| 402 | L_{A132} | L_{B2} | 1602 | L_{A252} | L_{B6} | 2802 | L_{A102} | L_{B11} |
| 403 | L_{A133} | L_{B2} | 1603 | L_{A253} | L_{B6} | 2803 | L_{A103} | L_{B11} |
| 404 | L_{A134} | L_{B2} | 1604 | L_{A254} | L_{B6} | 2804 | L_{A104} | L_{B11} |
| 405 | L_{A135} | L_{B2} | 1605 | L_{A255} | L_{B6} | 2805 | L_{A105} | L_{B11} |
| 406 | L_{A136} | L_{B2} | 1606 | L_{A256} | L_{B6} | 2806 | L_{A106} | L_{B11} |
| 407 | L_{A137} | L_{B2} | 1607 | L_{A257} | L_{B6} | 2807 | L_{A107} | L_{B11} |
| 408 | L_{A138} | L_{B2} | 1608 | L_{A258} | L_{B6} | 2808 | L_{A108} | L_{B11} |
| 409 | L_{A139} | L_{B2} | 1609 | L_{A259} | L_{B6} | 2809 | L_{A109} | L_{B11} |
| 410 | L_{A140} | L_{B2} | 1610 | L_{A260} | L_{B6} | 2810 | L_{A110} | L_{B11} |
| 411 | L_{A141} | L_{B2} | 1611 | L_{A261} | L_{B6} | 2811 | L_{A111} | L_{B11} |
| 412 | L_{A142} | L_{B2} | 1612 | L_{A262} | L_{B6} | 2812 | L_{A112} | L_{B11} |
| 413 | L_{A143} | L_{B2} | 1613 | L_{A263} | L_{B6} | 2813 | L_{A113} | L_{B11} |
| 414 | L_{A144} | L_{B2} | 1614 | L_{A264} | L_{B6} | 2814 | L_{A114} | L_{B11} |
| 415 | L_{A145} | L_{B2} | 1615 | L_{A265} | L_{B6} | 2815 | L_{A115} | L_{B11} |
| 416 | L_{A146} | L_{B2} | 1616 | L_{A266} | L_{B6} | 2816 | L_{A116} | L_{B11} |
| 417 | L_{A147} | L_{B2} | 1617 | L_{A267} | L_{B6} | 2817 | L_{A117} | L_{B11} |
| 418 | L_{A148} | L_{B2} | 1618 | L_{A268} | L_{B6} | 2818 | L_{A118} | L_{B11} |
| 419 | L_{A149} | L_{B2} | 1619 | L_{A269} | L_{B6} | 2819 | L_{A119} | L_{B11} |
| 420 | L_{A150} | L_{B2} | 1620 | L_{A270} | L_{B6} | 2820 | L_{A120} | L_{B11} |
| 421 | L_{A151} | L_{B2} | 1621 | L_{A1} | L_{B7} | 2821 | L_{A121} | L_{B11} |
| 422 | L_{A152} | L_{B2} | 1622 | L_{A2} | L_{B7} | 2822 | L_{A122} | L_{B11} |
| 423 | L_{A153} | L_{B2} | 1623 | L_{A3} | L_{B7} | 2823 | L_{A123} | L_{B11} |
| 424 | L_{A154} | L_{B2} | 1624 | L_{A4} | L_{B7} | 2824 | L_{A124} | L_{B11} |
| 425 | L_{A155} | L_{B2} | 1625 | L_{A5} | L_{B7} | 2825 | L_{A125} | L_{B11} |
| 426 | L_{A156} | L_{B2} | 1626 | L_{A6} | L_{B7} | 2826 | L_{A126} | L_{B11} |
| 427 | L_{A157} | L_{B2} | 1627 | L_{A7} | L_{B7} | 2827 | L_{A127} | L_{B11} |
| 428 | L_{A158} | L_{B2} | 1628 | L_{A8} | L_{B7} | 2828 | L_{A128} | L_{B11} |
| 429 | L_{A159} | L_{B2} | 1629 | L_{A9} | L_{B7} | 2829 | L_{A129} | L_{B11} |
| 430 | L_{A160} | L_{B2} | 1630 | L_{A10} | L_{B7} | 2830 | L_{A130} | L_{B11} |
| 431 | L_{A161} | L_{B2} | 1631 | L_{A11} | L_{B7} | 2831 | L_{A131} | L_{B11} |
| 432 | L_{A162} | L_{B2} | 1632 | L_{A12} | L_{B7} | 2832 | L_{A132} | L_{B11} |
| 433 | L_{A163} | L_{B2} | 1633 | L_{A13} | L_{B7} | 2833 | L_{A133} | L_{B11} |
| 434 | L_{A164} | L_{B2} | 1634 | L_{A14} | L_{B7} | 2834 | L_{A134} | L_{B11} |
| 435 | L_{A165} | L_{B2} | 1635 | L_{A15} | L_{B7} | 2835 | L_{A135} | L_{B11} |
| 436 | L_{A166} | L_{B2} | 1636 | L_{A16} | L_{B7} | 2836 | L_{A136} | L_{B11} |
| 437 | L_{A167} | L_{B2} | 1637 | L_{A17} | L_{B7} | 2837 | L_{A137} | L_{B11} |
| 438 | L_{A168} | L_{B2} | 1638 | L_{A18} | L_{B7} | 2838 | L_{A138} | L_{B11} |
| 439 | L_{A169} | L_{B2} | 1639 | L_{A19} | L_{B7} | 2839 | L_{A139} | L_{B11} |
| 440 | L_{A170} | L_{B2} | 1640 | L_{A20} | L_{B7} | 2840 | L_{A140} | L_{B11} |
| 441 | L_{A171} | L_{B2} | 1641 | L_{A21} | L_{B7} | 2841 | L_{A141} | L_{B11} |
| 442 | L_{A172} | L_{B2} | 1642 | L_{A22} | L_{B7} | 2842 | L_{A142} | L_{B11} |
| 443 | L_{A173} | L_{B2} | 1643 | L_{A23} | L_{B7} | 2843 | L_{A143} | L_{B11} |
| 444 | L_{A174} | L_{B2} | 1644 | L_{A24} | L_{B7} | 2844 | L_{A144} | L_{B11} |
| 445 | L_{A175} | L_{B2} | 1645 | L_{A25} | L_{B7} | 2845 | L_{A145} | L_{B11} |
| 446 | L_{A176} | L_{B2} | 1646 | L_{A26} | L_{B7} | 2846 | L_{A146} | L_{B11} |
| 447 | L_{A177} | L_{B2} | 1647 | L_{A27} | L_{B7} | 2847 | L_{A147} | L_{B11} |
| 448 | L_{A178} | L_{B2} | 1648 | L_{A28} | L_{B7} | 2848 | L_{A148} | L_{B11} |
| 449 | L_{A179} | L_{B2} | 1649 | L_{A29} | L_{B7} | 2849 | L_{A149} | L_{B11} |
| 450 | L_{A180} | L_{B2} | 1650 | L_{A30} | L_{B7} | 2850 | L_{A150} | L_{B11} |
| 451 | L_{A181} | L_{B2} | 1651 | L_{A31} | L_{B7} | 2851 | L_{A151} | L_{B11} |
| 452 | L_{A182} | L_{B2} | 1652 | L_{A32} | L_{B7} | 2852 | L_{A152} | L_{B11} |
| 453 | L_{A183} | L_{B2} | 1653 | L_{A33} | L_{B7} | 2853 | L_{A153} | L_{B11} |
| 454 | L_{A184} | L_{B2} | 1654 | L_{A34} | L_{B7} | 2854 | L_{A154} | L_{B11} |
| 455 | L_{A185} | L_{B2} | 1655 | L_{A35} | L_{B7} | 2855 | L_{A155} | L_{B11} |
| 456 | L_{A186} | L_{B2} | 1656 | L_{A36} | L_{B7} | 2856 | L_{A156} | L_{B11} |
| 457 | L_{A187} | L_{B2} | 1657 | L_{A37} | L_{B7} | 2857 | L_{A157} | L_{B11} |
| 458 | L_{A188} | L_{B2} | 1658 | L_{A38} | L_{B7} | 2858 | L_{A158} | L_{B11} |
| 459 | L_{A189} | L_{B2} | 1659 | L_{A39} | L_{B7} | 2859 | L_{A159} | L_{B11} |
| 460 | L_{A190} | L_{B2} | 1660 | L_{A40} | L_{B7} | 2860 | L_{A160} | L_{B11} |
| 461 | L_{A191} | L_{B2} | 1661 | L_{A41} | L_{B7} | 2861 | L_{A161} | L_{B11} |
| 462 | L_{A192} | L_{B2} | 1662 | L_{A42} | L_{B7} | 2862 | L_{A162} | L_{B11} |
| 463 | L_{A193} | L_{B2} | 1663 | L_{A43} | L_{B7} | 2863 | L_{A163} | L_{B11} |
| 464 | L_{A194} | L_{B2} | 1664 | L_{A44} | L_{B7} | 2864 | L_{A164} | L_{B11} |
| 465 | L_{A195} | L_{B2} | 1665 | L_{A45} | L_{B7} | 2865 | L_{A165} | L_{B11} |
| 466 | L_{A196} | L_{B2} | 1666 | L_{A46} | L_{B7} | 2866 | L_{A166} | L_{B11} |
| 467 | L_{A197} | L_{B2} | 1667 | L_{A47} | L_{B7} | 2867 | L_{A167} | L_{B11} |
| 468 | L_{A198} | L_{B2} | 1668 | L_{A48} | L_{B7} | 2868 | L_{A168} | L_{B11} |
| 469 | L_{A199} | L_{B2} | 1669 | L_{A49} | L_{B7} | 2869 | L_{A169} | L_{B11} |
| 470 | L_{A200} | L_{B2} | 1670 | L_{A50} | L_{B7} | 2870 | L_{A170} | L_{B11} |
| 471 | L_{A201} | L_{B2} | 1671 | L_{A51} | L_{B7} | 2871 | L_{A171} | L_{B11} |
| 472 | L_{A202} | L_{B2} | 1672 | L_{A52} | L_{B7} | 2872 | L_{A172} | L_{B11} |
| 473 | L_{A203} | L_{B2} | 1673 | L_{A53} | L_{B7} | 2873 | L_{A173} | L_{B11} |
| 474 | L_{A204} | L_{B2} | 1674 | L_{A54} | L_{B7} | 2874 | L_{A174} | L_{B11} |
| 475 | L_{A205} | L_{B2} | 1675 | L_{A55} | L_{B7} | 2875 | L_{A175} | L_{B11} |
| 476 | L_{A206} | L_{B2} | 1676 | L_{A56} | L_{B7} | 2876 | L_{A176} | L_{B11} |
| 477 | L_{A207} | L_{B2} | 1677 | L_{A57} | L_{B7} | 2877 | L_{A177} | L_{B11} |
| 478 | L_{A208} | L_{B2} | 1678 | L_{A58} | L_{B7} | 2878 | L_{A178} | L_{B11} |
| 479 | L_{A209} | L_{B2} | 1679 | L_{A59} | L_{B7} | 2879 | L_{A179} | L_{B11} |
| 480 | L_{A210} | L_{B2} | 1680 | L_{A60} | L_{B7} | 2880 | L_{A180} | L_{B11} |
| 481 | L_{A211} | L_{B2} | 1681 | L_{A61} | L_{B7} | 2881 | L_{A181} | L_{B11} |
| 482 | L_{A212} | L_{B2} | 1682 | L_{A62} | L_{B7} | 2882 | L_{A182} | L_{B11} |
| 483 | L_{A213} | L_{B2} | 1683 | L_{A63} | L_{B7} | 2883 | L_{A183} | L_{B11} |
| 484 | L_{A214} | L_{B2} | 1684 | L_{A64} | L_{B7} | 2884 | L_{A184} | L_{B11} |
| 485 | L_{A215} | L_{B2} | 1685 | L_{A65} | L_{B7} | 2885 | L_{A185} | L_{B11} |
| 486 | L_{A216} | L_{B2} | 1686 | L_{A66} | L_{B7} | 2886 | L_{A186} | L_{B11} |
| 487 | L_{A217} | L_{B2} | 1687 | L_{A67} | L_{B7} | 2887 | L_{A187} | L_{B11} |
| 488 | L_{A218} | L_{B2} | 1688 | L_{A68} | L_{B7} | 2888 | L_{A188} | L_{B11} |
| 489 | L_{A219} | L_{B2} | 1689 | L_{A69} | L_{B7} | 2889 | L_{A189} | L_{B11} |
| 490 | L_{A220} | L_{B2} | 1690 | L_{A70} | L_{B7} | 2890 | L_{A190} | L_{B11} |
| 491 | L_{A221} | L_{B2} | 1691 | L_{A71} | L_{B7} | 2891 | L_{A191} | L_{B11} |
| 492 | L_{A222} | L_{B2} | 1692 | L_{A72} | L_{B7} | 2892 | L_{A192} | L_{B11} |
| 493 | L_{A223} | L_{B2} | 1693 | L_{A73} | L_{B7} | 2893 | L_{A193} | L_{B11} |
| 494 | L_{A224} | L_{B2} | 1694 | L_{A74} | L_{B7} | 2894 | L_{A194} | L_{B11} |
| 495 | L_{A225} | L_{B2} | 1695 | L_{A75} | L_{B7} | 2895 | L_{A195} | L_{B11} |
| 496 | L_{A226} | L_{B2} | 1696 | L_{A76} | L_{B7} | 2896 | L_{A196} | L_{B11} |
| 497 | L_{A227} | L_{B2} | 1697 | L_{A77} | L_{B7} | 2897 | L_{A197} | L_{B11} |
| 498 | L_{A228} | L_{B2} | 1698 | L_{A78} | L_{B7} | 2898 | L_{A198} | L_{B11} |
| 499 | L_{A229} | L_{B2} | 1699 | L_{A79} | L_{B7} | 2899 | L_{A199} | L_{B11} |
| 500 | L_{A230} | L_{B2} | 1700 | L_{A80} | L_{B7} | 2900 | L_{A200} | L_{B11} |
| 501 | L_{A231} | L_{B2} | 1701 | L_{A81} | L_{B7} | 2901 | L_{A201} | L_{B11} |
| 502 | L_{A232} | L_{B2} | 1702 | L_{A82} | L_{B7} | 2902 | L_{A202} | L_{B11} |
| 503 | L_{A233} | L_{B2} | 1703 | L_{A83} | L_{B7} | 2903 | L_{A203} | L_{B11} |
| 504 | L_{A234} | L_{B2} | 1704 | L_{A84} | L_{B7} | 2904 | L_{A204} | L_{B11} |
| 505 | L_{A235} | L_{B2} | 1705 | L_{A85} | L_{B7} | 2905 | L_{A205} | L_{B11} |
| 506 | L_{A236} | L_{B2} | 1706 | L_{A86} | L_{B7} | 2906 | L_{A206} | L_{B11} |
| 507 | L_{A237} | L_{B2} | 1707 | L_{A87} | L_{B7} | 2907 | L_{A207} | L_{B11} |
| 508 | L_{A238} | L_{B2} | 1708 | L_{A88} | L_{B7} | 2908 | L_{A208} | L_{B11} |
| 509 | L_{A239} | L_{B2} | 1709 | L_{A89} | L_{B7} | 2909 | L_{A209} | L_{B11} |
| 510 | L_{A240} | L_{B2} | 1710 | L_{A90} | L_{B7} | 2910 | L_{A210} | L_{B11} |
| 511 | L_{A241} | L_{B2} | 1711 | L_{A91} | L_{B7} | 2911 | L_{A211} | L_{B11} |
| 512 | L_{A242} | L_{B2} | 1712 | L_{A92} | L_{B7} | 2912 | L_{A212} | L_{B11} |
| 513 | L_{A243} | L_{B2} | 1713 | L_{A93} | L_{B7} | 2913 | L_{A213} | L_{B11} |
| 514 | L_{A244} | L_{B2} | 1714 | L_{A94} | L_{B7} | 2914 | L_{A214} | L_{B11} |
| 515 | L_{A245} | L_{B2} | 1715 | L_{A95} | L_{B7} | 2915 | L_{A215} | L_{B11} |
| 516 | L_{A246} | L_{B2} | 1716 | L_{A96} | L_{B7} | 2916 | L_{A216} | L_{B11} |
| 517 | L_{A247} | L_{B2} | 1717 | L_{A97} | L_{B7} | 2917 | L_{A217} | L_{B11} |
| 518 | L_{A248} | L_{B2} | 1718 | L_{A98} | L_{B7} | 2918 | L_{A218} | L_{B11} |
| 519 | L_{A249} | L_{B2} | 1719 | L_{A99} | L_{B7} | 2919 | L_{A219} | L_{B11} |
| 520 | L_{A250} | L_{B2} | 1720 | L_{A100} | L_{B7} | 2920 | L_{A220} | L_{B11} |
| 521 | L_{A251} | L_{B2} | 1721 | L_{A101} | L_{B7} | 2921 | L_{A221} | L_{B11} |
| 522 | L_{A252} | L_{B2} | 1722 | L_{A102} | L_{B7} | 2922 | L_{A222} | L_{B11} |
| 523 | L_{A253} | L_{B2} | 1723 | L_{A103} | L_{B7} | 2923 | L_{A223} | L_{B11} |
| 524 | L_{A254} | L_{B2} | 1724 | L_{A104} | L_{B7} | 2924 | L_{A224} | L_{B11} |
| 525 | L_{A255} | L_{B2} | 1725 | L_{A105} | L_{B7} | 2925 | L_{A225} | L_{B11} |
| 526 | L_{A256} | L_{B2} | 1726 | L_{A106} | L_{B7} | 2926 | L_{A226} | L_{B11} |
| 527 | L_{A257} | L_{B2} | 1727 | L_{A107} | L_{B7} | 2927 | L_{A227} | L_{B11} |
| 528 | L_{A258} | L_{B2} | 1728 | L_{A108} | L_{B7} | 2928 | L_{A228} | L_{B11} |
| 529 | L_{A259} | L_{B2} | 1729 | L_{A109} | L_{B7} | 2929 | L_{A229} | L_{B11} |
| 530 | L_{A260} | L_{B2} | 1730 | L_{A110} | L_{B7} | 2930 | L_{A230} | L_{B11} |
| 531 | L_{A261} | L_{B2} | 1731 | L_{A111} | L_{B7} | 2931 | L_{A231} | L_{B11} |
| 532 | L_{A262} | L_{B2} | 1732 | L_{A112} | L_{B7} | 2932 | L_{A232} | L_{B11} |
| 533 | L_{A263} | L_{B2} | 1733 | L_{A113} | L_{B7} | 2933 | L_{A233} | L_{B11} |
| 534 | L_{A264} | L_{B2} | 1734 | L_{A114} | L_{B7} | 2934 | L_{A234} | L_{B11} |
| 535 | L_{A265} | L_{B2} | 1735 | L_{A115} | L_{B7} | 2935 | L_{A235} | L_{B11} |
| 536 | L_{A266} | L_{B2} | 1736 | L_{A116} | L_{B7} | 2936 | L_{A236} | L_{B11} |
| 537 | L_{A267} | L_{B2} | 1737 | L_{A117} | L_{B7} | 2937 | L_{A237} | L_{B11} |
| 538 | L_{A268} | L_{B2} | 1738 | L_{A118} | L_{B7} | 2938 | L_{A238} | L_{B11} |
| 539 | L_{A269} | L_{B2} | 1739 | L_{A119} | L_{B7} | 2939 | L_{A239} | L_{B11} |
| 540 | L_{A270} | L_{B2} | 1740 | L_{A120} | L_{B7} | 2940 | L_{A240} | L_{B11} |
| 541 | L_{A1} | L_{B3} | 1741 | L_{A121} | L_{B7} | 2941 | L_{A241} | L_{B11} |
| 542 | L_{A2} | L_{B3} | 1742 | L_{A122} | L_{B7} | 2942 | L_{A242} | L_{B11} |
| 543 | L_{A3} | L_{B3} | 1743 | L_{A123} | L_{B7} | 2943 | L_{A243} | L_{B11} |
| 544 | L_{A4} | L_{B3} | 1744 | L_{A124} | L_{B7} | 2944 | L_{A244} | L_{B11} |
| 545 | L_{A5} | L_{B3} | 1745 | L_{A125} | L_{B7} | 2945 | L_{A245} | L_{B11} |
| 546 | L_{A6} | L_{B3} | 1746 | L_{A126} | L_{B7} | 2946 | L_{A246} | L_{B11} |
| 547 | L_{A7} | L_{B3} | 1747 | L_{A127} | L_{B7} | 2947 | L_{A247} | L_{B11} |
| 548 | L_{A8} | L_{B3} | 1748 | L_{A128} | L_{B7} | 2948 | L_{A248} | L_{B11} |
| 549 | L_{A9} | L_{B3} | 1749 | L_{A129} | L_{B7} | 2949 | L_{A249} | L_{B11} |
| 550 | L_{A1} | L_{B3} | 1750 | L_{A130} | L_{B7} | 2950 | L_{A250} | L_{B11} |
| 551 | L_{A11} | L_{B3} | 1751 | L_{A131} | L_{B7} | 2951 | L_{A251} | L_{B11} |
| 552 | L_{A12} | L_{B3} | 1752 | L_{A132} | L_{B7} | 2952 | L_{A252} | L_{B11} |
| 553 | L_{A13} | L_{B3} | 1753 | L_{A133} | L_{B7} | 2953 | L_{A253} | L_{B11} |
| 554 | L_{A14} | L_{B3} | 1754 | L_{A134} | L_{B7} | 2954 | L_{A254} | L_{B11} |
| 555 | L_{A15} | L_{B3} | 1755 | L_{A135} | L_{B7} | 2955 | L_{A255} | L_{B11} |
| 556 | L_{A16} | L_{B3} | 1756 | L_{A136} | L_{B7} | 2956 | L_{A256} | L_{B11} |
| 557 | L_{A17} | L_{B3} | 1757 | L_{A137} | L_{B7} | 2957 | L_{A257} | L_{B11} |
| 558 | L_{A18} | L_{B3} | 1758 | L_{A138} | L_{B7} | 2958 | L_{A258} | L_{B11} |
| 559 | L_{A19} | L_{B3} | 1759 | L_{A139} | L_{B7} | 2959 | L_{A259} | L_{B11} |
| 560 | L_{A20} | L_{B3} | 1760 | L_{A140} | L_{B7} | 2960 | L_{A260} | L_{B11} |
| 561 | L_{A21} | L_{B3} | 1761 | L_{A141} | L_{B7} | 2961 | L_{A261} | L_{B11} |
| 562 | L_{A22} | L_{B3} | 1762 | L_{A142} | L_{B7} | 2962 | L_{A262} | L_{B11} |
| 563 | L_{A23} | L_{B3} | 1763 | L_{A143} | L_{B7} | 2963 | L_{A263} | L_{B11} |
| 564 | L_{A24} | L_{B3} | 1764 | L_{A144} | L_{B7} | 2964 | L_{A264} | L_{B11} |
| 565 | L_{A25} | L_{B3} | 1765 | L_{A145} | L_{B7} | 2965 | L_{A265} | L_{B11} |
| 566 | L_{A26} | L_{B3} | 1766 | L_{A146} | L_{B7} | 2966 | L_{A266} | L_{B11} |
| 567 | L_{A27} | L_{B3} | 1767 | L_{A147} | L_{B7} | 2967 | L_{A267} | L_{B11} |
| 568 | L_{A28} | L_{B3} | 1768 | L_{A148} | L_{B7} | 2968 | L_{A268} | L_{B11} |
| 569 | L_{A29} | L_{B3} | 1769 | L_{A149} | L_{B7} | 2969 | L_{A269} | L_{B11} |
| 570 | L_{A30} | L_{B3} | 1770 | L_{A150} | L_{B7} | 2970 | L_{A270} | L_{B11} |
| 571 | L_{A31} | L_{B3} | 1771 | L_{A151} | L_{B7} | 2971 | L_{A1} | L_{B12} |
| 572 | L_{A32} | L_{B3} | 1772 | L_{A152} | L_{B7} | 2972 | L_{A2} | L_{B12} |
| 573 | L_{A33} | L_{B3} | 1773 | L_{A153} | L_{B7} | 2973 | L_{A3} | L_{B12} |
| 574 | L_{A34} | L_{B3} | 1774 | L_{A154} | L_{B7} | 2974 | L_{A4} | L_{B12} |
| 575 | L_{A35} | L_{B3} | 1775 | L_{A155} | L_{B7} | 2975 | L_{A5} | L_{B12} |
| 576 | L_{A36} | L_{B3} | 1776 | L_{A156} | L_{B7} | 2976 | L_{A6} | L_{B12} |
| 577 | L_{A37} | L_{B3} | 1777 | L_{A157} | L_{B7} | 2977 | L_{A7} | L_{B12} |
| 578 | L_{A38} | L_{B3} | 1778 | L_{A158} | L_{B7} | 2978 | L_{A8} | L_{B12} |
| 579 | L_{A39} | L_{B3} | 1779 | L_{A159} | L_{B7} | 2979 | L_{A9} | L_{B12} |
| 580 | L_{A40} | L_{B3} | 1780 | L_{A160} | L_{B7} | 2980 | L_{A10} | L_{B12} |
| 581 | L_{A41} | L_{B3} | 1781 | L_{A161} | L_{B7} | 2981 | L_{A11} | L_{B12} |
| 582 | L_{A42} | L_{B3} | 1782 | L_{A162} | L_{B7} | 2982 | L_{A12} | L_{B12} |
| 583 | L_{A43} | L_{B3} | 1783 | L_{A163} | L_{B7} | 2983 | L_{A13} | L_{B12} |
| 584 | L_{A44} | L_{B3} | 1784 | L_{A164} | L_{B7} | 2984 | L_{A14} | L_{B12} |
| 585 | L_{A45} | L_{B3} | 1785 | L_{A165} | L_{B7} | 2985 | L_{A15} | L_{B12} |
| 586 | L_{A46} | L_{B3} | 1786 | L_{A166} | L_{B7} | 2986 | L_{A16} | L_{B12} |
| 587 | L_{A47} | L_{B3} | 1787 | L_{A167} | L_{B7} | 2987 | L_{A17} | L_{B12} |
| 588 | L_{A48} | L_{B3} | 1788 | L_{A168} | L_{B7} | 2988 | L_{A18} | L_{B12} |
| 589 | L_{A49} | L_{B3} | 1789 | L_{A169} | L_{B7} | 2989 | L_{A19} | L_{B12} |
| 590 | L_{A50} | L_{B3} | 1790 | L_{A170} | L_{B7} | 2990 | L_{A20} | L_{B12} |
| 591 | L_{A51} | L_{B3} | 1791 | L_{A171} | L_{B7} | 2991 | L_{A21} | L_{B12} |
| 592 | L_{A52} | L_{B3} | 1792 | L_{A172} | L_{B7} | 2992 | L_{A22} | L_{B12} |
| 593 | L_{A53} | L_{B3} | 1793 | L_{A173} | L_{B7} | 2993 | L_{A23} | L_{B12} |
| 594 | L_{A54} | L_{B3} | 1794 | L_{A174} | L_{B7} | 2994 | L_{A24} | L_{B12} |
| 595 | L_{A55} | L_{B3} | 1795 | L_{A175} | L_{B7} | 2995 | L_{A25} | L_{B12} |
| 596 | L_{A56} | L_{B3} | 1796 | L_{A176} | L_{B7} | 2996 | L_{A26} | L_{B12} |
| 597 | L_{A57} | L_{B3} | 1797 | L_{A177} | L_{B7} | 2997 | L_{A27} | L_{B12} |
| 598 | L_{A58} | L_{B3} | 1798 | L_{A178} | L_{B7} | 2998 | L_{A28} | L_{B12} |
| 599 | L_{A59} | L_{B3} | 1799 | L_{A179} | L_{B7} | 2999 | L_{A29} | L_{B12} |
| 600 | L_{A60} | L_{B3} | 1800 | L_{A180} | L_{B7} | 3000 | L_{A30} | L_{B12} |
| 601 | L_{A61} | L_{B3} | 1801 | L_{A181} | L_{B7} | 3001 | L_{A31} | L_{B12} |
| 602 | L_{A62} | L_{B3} | 1802 | L_{A182} | L_{B7} | 3002 | L_{A32} | L_{B12} |
| 603 | L_{A63} | L_{B3} | 1803 | L_{A183} | L_{B7} | 3003 | L_{A33} | L_{B12} |
| 604 | L_{A64} | L_{B3} | 1804 | L_{A184} | L_{B7} | 3004 | L_{A34} | L_{B12} |
| 605 | L_{A65} | L_{B3} | 1805 | L_{A185} | L_{B7} | 3005 | L_{A35} | L_{B12} |
| 606 | L_{A66} | L_{B3} | 1806 | L_{A186} | L_{B7} | 3006 | L_{A36} | L_{B12} |
| 607 | L_{A67} | L_{B3} | 1807 | L_{A187} | L_{B7} | 3007 | L_{A37} | L_{B12} |
| 608 | L_{A68} | L_{B3} | 1808 | L_{A188} | L_{B7} | 3008 | L_{A38} | L_{B12} |
| 609 | L_{A69} | L_{B3} | 1809 | L_{A189} | L_{B7} | 3009 | L_{A39} | L_{B12} |
| 610 | L_{A70} | L_{B3} | 1810 | L_{A190} | L_{B7} | 3010 | L_{A40} | L_{B12} |
| 611 | L_{A71} | L_{B3} | 1811 | L_{A191} | L_{B7} | 3011 | L_{A41} | L_{B12} |
| 612 | L_{A72} | L_{B3} | 1812 | L_{A192} | L_{B7} | 3012 | L_{A42} | L_{B12} |
| 613 | L_{A73} | L_{B3} | 1813 | L_{A193} | L_{B7} | 3013 | L_{A43} | L_{B12} |
| 614 | L_{A74} | L_{B3} | 1814 | L_{A194} | L_{B7} | 3014 | L_{A44} | L_{B12} |
| 615 | L_{A75} | L_{B3} | 1815 | L_{A195} | L_{B7} | 3015 | L_{A45} | L_{B12} |
| 616 | L_{A76} | L_{B3} | 1816 | L_{A196} | L_{B7} | 3016 | L_{A46} | L_{B12} |
| 617 | L_{A77} | L_{B3} | 1817 | L_{A197} | L_{B7} | 3017 | L_{A47} | L_{B12} |
| 618 | L_{A78} | L_{B3} | 1818 | L_{A198} | L_{B7} | 3018 | L_{A48} | L_{B12} |
| 619 | L_{A79} | L_{B3} | 1819 | L_{A199} | L_{B7} | 3019 | L_{A49} | L_{B12} |
| 620 | L_{A80} | L_{B3} | 1820 | L_{A200} | L_{B7} | 3020 | L_{A50} | L_{B12} |
| 621 | L_{A81} | L_{B3} | 1821 | L_{A201} | L_{B7} | 3021 | L_{A51} | L_{B12} |
| 622 | L_{A82} | L_{B3} | 1822 | L_{A202} | L_{B7} | 3022 | L_{A52} | L_{B12} |
| 623 | L_{A83} | L_{B3} | 1823 | L_{A203} | L_{B7} | 3023 | L_{A53} | L_{B12} |
| 624 | L_{A84} | L_{B3} | 1824 | L_{A204} | L_{B7} | 3024 | L_{A54} | L_{B12} |
| 625 | L_{A85} | L_{B3} | 1825 | L_{A205} | L_{B7} | 3025 | L_{A55} | L_{B12} |
| 626 | L_{A86} | L_{B3} | 1826 | L_{A206} | L_{B7} | 3026 | L_{A56} | L_{B12} |
| 627 | L_{A87} | L_{B3} | 1827 | L_{A207} | L_{B7} | 3027 | L_{A57} | L_{B12} |
| 628 | L_{A88} | L_{B3} | 1828 | L_{A208} | L_{B7} | 3028 | L_{A58} | L_{B12} |
| 629 | L_{A89} | L_{B3} | 1829 | L_{A209} | L_{B7} | 3029 | L_{A59} | L_{B12} |
| 630 | L_{A90} | L_{B3} | 1830 | L_{A210} | L_{B7} | 3030 | L_{A60} | L_{B12} |
| 631 | L_{A91} | L_{B3} | 1831 | L_{A211} | L_{B7} | 3031 | L_{A61} | L_{B12} |
| 632 | L_{A92} | L_{B3} | 1832 | L_{A212} | L_{B7} | 3032 | L_{A62} | L_{B12} |
| 633 | L_{A93} | L_{B3} | 1833 | L_{A213} | L_{B7} | 3033 | L_{A63} | L_{B12} |
| 634 | L_{A94} | L_{B3} | 1834 | L_{A214} | L_{B7} | 3034 | L_{A64} | L_{B12} |
| 635 | L_{A95} | L_{B3} | 1835 | L_{A215} | L_{B7} | 3035 | L_{A65} | L_{B12} |
| 636 | L_{A96} | L_{B3} | 1836 | L_{A216} | L_{B7} | 3036 | L_{A66} | L_{B12} |
| 637 | L_{A97} | L_{B3} | 1837 | L_{A217} | L_{B7} | 3037 | L_{A67} | L_{B12} |
| 638 | L_{A98} | L_{B3} | 1838 | L_{A218} | L_{B7} | 3038 | L_{A68} | L_{B12} |
| 639 | L_{A99} | L_{B3} | 1839 | L_{A219} | L_{B7} | 3039 | L_{A69} | L_{B12} |
| 640 | L_{A100} | L_{B3} | 1840 | L_{A220} | L_{B7} | 3040 | L_{A70} | L_{B12} |
| 641 | L_{A101} | L_{B3} | 1841 | L_{A221} | L_{B7} | 3041 | L_{A71} | L_{B12} |
| 642 | L_{A102} | L_{B3} | 1842 | L_{A222} | L_{B7} | 3042 | L_{A72} | L_{B12} |
| 643 | L_{A103} | L_{B3} | 1843 | L_{A223} | L_{B7} | 3043 | L_{A73} | L_{B12} |
| 644 | L_{A104} | L_{B3} | 1844 | L_{A224} | L_{B7} | 3044 | L_{A74} | L_{B12} |
| 645 | L_{A105} | L_{B3} | 1845 | L_{A225} | L_{B7} | 3045 | L_{A75} | L_{B12} |
| 646 | L_{A106} | L_{B3} | 1846 | L_{A226} | L_{B7} | 3046 | L_{A76} | L_{B12} |
| 647 | L_{A107} | L_{B3} | 1847 | L_{A227} | L_{B7} | 3047 | L_{A77} | L_{B12} |
| 648 | L_{A108} | L_{B3} | 1848 | L_{A228} | L_{B7} | 3048 | L_{A78} | L_{B12} |
| 649 | L_{A109} | L_{B3} | 1849 | L_{A229} | L_{B7} | 3049 | L_{A79} | L_{B12} |
| 650 | L_{A110} | L_{B3} | 1850 | L_{A230} | L_{B7} | 3050 | L_{A80} | L_{B12} |
| 651 | L_{A111} | L_{B3} | 1851 | L_{A231} | L_{B7} | 3051 | L_{A81} | L_{B12} |
| 652 | L_{A112} | L_{B3} | 1852 | L_{A232} | L_{B7} | 3052 | L_{A82} | L_{B12} |
| 653 | L_{A113} | L_{B3} | 1853 | L_{A233} | L_{B7} | 3053 | L_{A83} | L_{B12} |
| 654 | L_{A114} | L_{B3} | 1854 | L_{A234} | L_{B7} | 3054 | L_{A84} | L_{B12} |
| 655 | L_{A115} | L_{B3} | 1855 | L_{A235} | L_{B7} | 3055 | L_{A85} | L_{B12} |
| 656 | L_{A116} | L_{B3} | 1856 | L_{A236} | L_{B7} | 3056 | L_{A86} | L_{B12} |
| 657 | L_{A117} | L_{B3} | 1857 | L_{A237} | L_{B7} | 3057 | L_{A87} | L_{B12} |
| 658 | L_{A118} | L_{B3} | 1858 | L_{A238} | L_{B7} | 3058 | L_{A88} | L_{B12} |
| 659 | L_{A119} | L_{B3} | 1859 | L_{A239} | L_{B7} | 3059 | L_{A89} | L_{B12} |
| 660 | L_{A120} | L_{B3} | 1860 | L_{A240} | L_{B7} | 3060 | L_{A90} | L_{B12} |
| 661 | L_{A121} | L_{B3} | 1861 | L_{A241} | L_{B7} | 3061 | L_{A91} | L_{B12} |
| 662 | L_{A122} | L_{B3} | 1862 | L_{A242} | L_{B7} | 3062 | L_{A92} | L_{B12} |
| 663 | L_{A123} | L_{B3} | 1863 | L_{A243} | L_{B7} | 3063 | L_{A93} | L_{B12} |
| 664 | L_{A124} | L_{B3} | 1864 | L_{A244} | L_{B7} | 3064 | L_{A94} | L_{B12} |
| 665 | L_{A125} | L_{B3} | 1865 | L_{A245} | L_{B7} | 3065 | L_{A95} | L_{B12} |
| 666 | L_{A126} | L_{B3} | 1866 | L_{A246} | L_{B7} | 3066 | L_{A96} | L_{B12} |
| 667 | L_{A127} | L_{B3} | 1867 | L_{A247} | L_{B7} | 3067 | L_{A97} | L_{B12} |
| 668 | L_{A128} | L_{B3} | 1868 | L_{A248} | L_{B7} | 3068 | L_{A98} | L_{B12} |
| 669 | L_{A129} | L_{B3} | 1869 | L_{A249} | L_{B7} | 3069 | L_{A99} | L_{B12} |
| 670 | L_{A130} | L_{B3} | 1870 | L_{A250} | L_{B7} | 3070 | L_{A100} | L_{B12} |
| 671 | L_{A131} | L_{B3} | 1871 | L_{A251} | L_{B7} | 3071 | L_{A101} | L_{B12} |
| 672 | L_{A132} | L_{B3} | 1872 | L_{A252} | L_{B7} | 3072 | L_{A102} | L_{B12} |
| 673 | L_{A133} | L_{B3} | 1873 | L_{A253} | L_{B7} | 3073 | L_{A103} | L_{B12} |
| 674 | L_{A134} | L_{B3} | 1874 | L_{A254} | L_{B7} | 3074 | L_{A104} | L_{B12} |
| 675 | L_{A135} | L_{B3} | 1875 | L_{A255} | L_{B7} | 3075 | L_{A105} | L_{B12} |
| 676 | L_{A136} | L_{B3} | 1876 | L_{A256} | L_{B7} | 3076 | L_{A106} | L_{B12} |
| 677 | L_{A137} | L_{B3} | 1877 | L_{A257} | L_{B7} | 3077 | L_{A107} | L_{B12} |
| 678 | L_{A138} | L_{B3} | 1878 | L_{A258} | L_{B7} | 3078 | L_{A108} | L_{B12} |
| 679 | L_{A139} | L_{B3} | 1879 | L_{A259} | L_{B7} | 3079 | L_{A109} | L_{B12} |
| 680 | L_{A140} | L_{B3} | 1880 | L_{A260} | L_{B7} | 3080 | L_{A110} | L_{B12} |
| 681 | L_{A141} | L_{B3} | 1881 | L_{A261} | L_{B7} | 3081 | L_{A111} | L_{B12} |
| 682 | L_{A142} | L_{B3} | 1882 | L_{A262} | L_{B7} | 3082 | L_{A112} | L_{B12} |
| 683 | L_{A143} | L_{B3} | 1883 | L_{A263} | L_{B7} | 3083 | L_{A113} | L_{B12} |
| 684 | L_{A144} | L_{B3} | 1884 | L_{A264} | L_{B7} | 3084 | L_{A114} | L_{B12} |
| 685 | L_{A145} | L_{B3} | 1885 | L_{A265} | L_{B7} | 3085 | L_{A115} | L_{B12} |
| 686 | L_{A146} | L_{B3} | 1886 | L_{A266} | L_{B7} | 3086 | L_{A116} | L_{B12} |
| 687 | L_{A147} | L_{B3} | 1887 | L_{A267} | L_{B7} | 3087 | L_{A117} | L_{B12} |
| 688 | L_{A148} | L_{B3} | 1888 | L_{A268} | L_{B7} | 3088 | L_{A118} | L_{B12} |
| 689 | L_{A149} | L_{B3} | 1889 | L_{A269} | L_{B7} | 3089 | L_{A119} | L_{B12} |
| 690 | L_{A150} | L_{B3} | 1890 | L_{A270} | L_{B7} | 3090 | L_{A120} | L_{B12} |
| 691 | L_{A151} | L_{B3} | 1891 | L_{A1} | L_{B8} | 3091 | L_{A121} | L_{B12} |
| 692 | L_{A152} | L_{B3} | 1892 | L_{A2} | L_{B8} | 3092 | L_{A122} | L_{B12} |
| 693 | L_{A153} | L_{B3} | 1893 | L_{A3} | L_{B8} | 3093 | L_{A123} | L_{B12} |
| 694 | L_{A154} | L_{B3} | 1894 | L_{A4} | L_{B8} | 3094 | L_{A124} | L_{B12} |
| 695 | L_{A155} | L_{B3} | 1895 | L_{A5} | L_{B8} | 3095 | L_{A125} | L_{B12} |
| 696 | L_{A156} | L_{B3} | 1896 | L_{A6} | L_{B8} | 3096 | L_{A126} | L_{B12} |
| 697 | L_{A157} | L_{B3} | 1897 | L_{A7} | L_{B8} | 3097 | L_{A127} | L_{B12} |
| 698 | L_{A158} | L_{B3} | 1898 | L_{A8} | L_{B8} | 3098 | L_{A128} | L_{B12} |
| 699 | L_{A159} | L_{B3} | 1899 | L_{A9} | L_{B8} | 3099 | L_{A129} | L_{B12} |
| 700 | L_{A160} | L_{B3} | 1900 | L_{A10} | L_{B8} | 3100 | L_{A130} | L_{B12} |
| 701 | L_{A161} | L_{B3} | 1901 | L_{A11} | L_{B8} | 3101 | L_{A131} | L_{B12} |
| 702 | L_{A162} | L_{B3} | 1902 | L_{A12} | L_{B8} | 3102 | L_{A132} | L_{B12} |
| 703 | L_{A163} | L_{B3} | 1903 | L_{A13} | L_{B8} | 3103 | L_{A133} | L_{B12} |
| 704 | L_{A164} | L_{B3} | 1904 | L_{A14} | L_{B8} | 3104 | L_{A134} | L_{B12} |
| 705 | L_{A165} | L_{B3} | 1905 | L_{A15} | L_{B8} | 3105 | L_{A135} | L_{B12} |
| 706 | L_{A166} | L_{B3} | 1906 | L_{A16} | L_{B8} | 3106 | L_{A136} | L_{B12} |
| 707 | L_{A167} | L_{B3} | 1907 | L_{A17} | L_{B8} | 3107 | L_{A137} | L_{B12} |
| 708 | L_{A168} | L_{B3} | 1908 | L_{A18} | L_{B8} | 3108 | L_{A138} | L_{B12} |
| 709 | L_{A169} | L_{B3} | 1909 | L_{A19} | L_{B8} | 3109 | L_{A139} | L_{B12} |
| 710 | L_{A170} | L_{B3} | 1910 | L_{A20} | L_{B8} | 3110 | L_{A140} | L_{B12} |
| 711 | L_{A171} | L_{B3} | 1911 | L_{A21} | L_{B8} | 3111 | L_{A141} | L_{B12} |
| 712 | L_{A172} | L_{B3} | 1912 | L_{A22} | L_{B8} | 3112 | L_{A142} | L_{B12} |
| 713 | L_{A173} | L_{B3} | 1913 | L_{A23} | L_{B8} | 3113 | L_{A143} | L_{B12} |
| 714 | L_{A174} | L_{B3} | 1914 | L_{A24} | L_{B8} | 3114 | L_{A144} | L_{B12} |
| 715 | L_{A175} | L_{B3} | 1915 | L_{A25} | L_{B8} | 3115 | L_{A145} | L_{B12} |
| 716 | L_{A176} | L_{B3} | 1916 | L_{A26} | L_{B8} | 3116 | L_{A146} | L_{B12} |
| 717 | L_{A177} | L_{B3} | 1917 | L_{A27} | L_{B8} | 3117 | L_{A147} | L_{B12} |
| 718 | L_{A178} | L_{B3} | 1918 | L_{A28} | L_{B8} | 3118 | L_{A148} | L_{B12} |
| 719 | L_{A179} | L_{B3} | 1919 | L_{A29} | L_{B8} | 3119 | L_{A149} | L_{B12} |
| 720 | L_{A180} | L_{B3} | 1920 | L_{A30} | L_{B8} | 3120 | L_{A150} | L_{B12} |
| 721 | L_{A181} | L_{B3} | 1921 | L_{A31} | L_{B8} | 3121 | L_{A151} | L_{B12} |
| 722 | L_{A182} | L_{B3} | 1922 | L_{A32} | L_{B8} | 3122 | L_{A152} | L_{B12} |
| 723 | L_{A183} | L_{B3} | 1923 | L_{A33} | L_{B8} | 3123 | L_{A153} | L_{B12} |
| 724 | L_{A184} | L_{B3} | 1924 | L_{A34} | L_{B8} | 3124 | L_{A154} | L_{B12} |
| 725 | L_{A185} | L_{B3} | 1925 | L_{A35} | L_{B8} | 3125 | L_{A155} | L_{B12} |
| 726 | L_{A186} | L_{B3} | 1926 | L_{A36} | L_{B8} | 3126 | L_{A156} | L_{B12} |
| 727 | L_{A187} | L_{B3} | 1927 | L_{A37} | L_{B8} | 3127 | L_{A157} | L_{B12} |
| 728 | L_{A188} | L_{B3} | 1928 | L_{A38} | L_{B8} | 3128 | L_{A158} | L_{B12} |
| 729 | L_{A189} | L_{B3} | 1929 | L_{A39} | L_{B8} | 3129 | L_{A159} | L_{B12} |
| 730 | L_{A190} | L_{B3} | 1930 | L_{A40} | L_{B8} | 3130 | L_{A160} | L_{B12} |
| 731 | L_{A191} | L_{B3} | 1931 | L_{A41} | L_{B8} | 3131 | L_{A161} | L_{B12} |
| 732 | L_{A192} | L_{B3} | 1932 | L_{A42} | L_{B8} | 3132 | L_{A162} | L_{B12} |
| 733 | L_{A193} | L_{B3} | 1933 | L_{A43} | L_{B8} | 3133 | L_{A163} | L_{B12} |
| 734 | L_{A194} | L_{B3} | 1934 | L_{A44} | L_{B8} | 3134 | L_{A164} | L_{B12} |
| 735 | L_{A195} | L_{B3} | 1935 | L_{A45} | L_{B8} | 3135 | L_{A165} | L_{B12} |
| 736 | L_{A196} | L_{B3} | 1936 | L_{A46} | L_{B8} | 3136 | L_{A166} | L_{B12} |
| 737 | L_{A197} | L_{B3} | 1937 | L_{A47} | L_{B8} | 3137 | L_{A167} | L_{B12} |
| 738 | L_{A198} | L_{B3} | 1938 | L_{A48} | L_{B8} | 3138 | L_{A168} | L_{B12} |
| 739 | L_{A199} | L_{B3} | 1939 | L_{A49} | L_{B8} | 3139 | L_{A169} | L_{B12} |
| 740 | L_{A200} | L_{B3} | 1940 | L_{A50} | L_{B8} | 3140 | L_{A170} | L_{B12} |
| 741 | L_{A201} | L_{B3} | 1941 | L_{A51} | L_{B8} | 3141 | L_{A171} | L_{B12} |
| 742 | L_{A202} | L_{B3} | 1942 | L_{A52} | L_{B8} | 3142 | L_{A172} | L_{B12} |
| 743 | L_{A203} | L_{B3} | 1943 | L_{A53} | L_{B8} | 3143 | L_{A173} | L_{B12} |
| 744 | L_{A204} | L_{B3} | 1944 | L_{A54} | L_{B8} | 3144 | L_{A174} | L_{B12} |
| 745 | L_{A205} | L_{B3} | 1945 | L_{A55} | L_{B8} | 3145 | L_{A175} | L_{B12} |
| 746 | L_{A206} | L_{B3} | 1946 | L_{A56} | L_{B8} | 3146 | L_{A176} | L_{B12} |
| 747 | L_{A207} | L_{B3} | 1947 | L_{A57} | L_{B8} | 3147 | L_{A177} | L_{B12} |
| 748 | L_{A208} | L_{B3} | 1948 | L_{A58} | L_{B8} | 3148 | L_{A178} | L_{B12} |
| 749 | L_{A209} | L_{B3} | 1949 | L_{A59} | L_{B8} | 3149 | L_{A179} | L_{B12} |
| 750 | L_{A210} | L_{B3} | 1950 | L_{A60} | L_{B8} | 3150 | L_{A180} | L_{B12} |
| 751 | L_{A211} | L_{B3} | 1951 | L_{A61} | L_{B8} | 3151 | L_{A181} | L_{B12} |
| 752 | L_{A212} | L_{B3} | 1952 | L_{A62} | L_{B8} | 3152 | L_{A182} | L_{B12} |
| 753 | L_{A213} | L_{B3} | 1953 | L_{A63} | L_{B8} | 3153 | L_{A183} | L_{B12} |
| 754 | L_{A214} | L_{B3} | 1954 | L_{A64} | L_{B8} | 3154 | L_{A184} | L_{B12} |
| 755 | L_{A215} | L_{B3} | 1955 | L_{A65} | L_{B8} | 3155 | L_{A185} | L_{B12} |
| 756 | L_{A216} | L_{B3} | 1956 | L_{A66} | L_{B8} | 3156 | L_{A186} | L_{B12} |
| 757 | L_{A217} | L_{B3} | 1957 | L_{A67} | L_{B8} | 3157 | L_{A187} | L_{B12} |
| 758 | L_{A218} | L_{B3} | 1958 | L_{A68} | L_{B8} | 3158 | L_{A188} | L_{B12} |
| 759 | L_{A219} | L_{B3} | 1959 | L_{A69} | L_{B8} | 3159 | L_{A189} | L_{B12} |
| 760 | L_{A220} | L_{B3} | 1960 | L_{A70} | L_{B8} | 3160 | L_{A190} | L_{B12} |
| 761 | L_{A221} | L_{B3} | 1961 | L_{A71} | L_{B8} | 3161 | L_{A191} | L_{B12} |
| 762 | L_{A222} | L_{B3} | 1962 | L_{A72} | L_{B8} | 3162 | L_{A192} | L_{B12} |
| 763 | L_{A223} | L_{B3} | 1963 | L_{A73} | L_{B8} | 3163 | L_{A193} | L_{B12} |
| 764 | L_{A224} | L_{B3} | 1964 | L_{A74} | L_{B8} | 3164 | L_{A194} | L_{B12} |
| 765 | L_{A225} | L_{B3} | 1965 | L_{A75} | L_{B8} | 3165 | L_{A195} | L_{B12} |
| 766 | L_{A226} | L_{B3} | 1966 | L_{A76} | L_{B8} | 3166 | L_{A196} | L_{B12} |
| 767 | L_{A227} | L_{B3} | 1967 | L_{A77} | L_{B8} | 3167 | L_{A197} | L_{B12} |
| 768 | L_{A228} | L_{B3} | 1968 | L_{A78} | L_{B8} | 3168 | L_{A198} | L_{B12} |
| 769 | L_{A229} | L_{B3} | 1969 | L_{A79} | L_{B8} | 3169 | L_{A199} | L_{B12} |
| 770 | L_{A230} | L_{B3} | 1970 | L_{A80} | L_{B8} | 3170 | L_{A200} | L_{B12} |
| 771 | L_{A231} | L_{B3} | 1971 | L_{A81} | L_{B8} | 3171 | L_{A201} | L_{B12} |
| 772 | L_{A232} | L_{B3} | 1972 | L_{A82} | L_{B8} | 3172 | L_{A202} | L_{B12} |
| 773 | L_{A233} | L_{B3} | 1973 | L_{A83} | L_{B8} | 3173 | L_{A203} | L_{B12} |
| 774 | L_{A234} | L_{B3} | 1974 | L_{A84} | L_{B8} | 3174 | L_{A204} | L_{B12} |
| 775 | L_{A235} | L_{B3} | 1975 | L_{A85} | L_{B8} | 3175 | L_{A205} | L_{B12} |
| 776 | L_{A236} | L_{B3} | 1976 | L_{A86} | L_{B8} | 3176 | L_{A206} | L_{B12} |
| 777 | L_{A237} | L_{B3} | 1977 | L_{A87} | L_{B8} | 3177 | L_{A207} | L_{B12} |
| 778 | L_{A238} | L_{B3} | 1978 | L_{A88} | L_{B8} | 3178 | L_{A208} | L_{B12} |
| 779 | L_{A239} | L_{B3} | 1979 | L_{A89} | L_{B8} | 3179 | L_{A209} | L_{B12} |
| 780 | L_{A240} | L_{B3} | 1980 | L_{A90} | L_{B8} | 3180 | L_{A210} | L_{B12} |
| 781 | L_{A241} | L_{B3} | 1981 | L_{A91} | L_{B8} | 3181 | L_{A211} | L_{B12} |
| 782 | L_{A242} | L_{B3} | 1982 | L_{A92} | L_{B8} | 3182 | L_{A212} | L_{B12} |
| 783 | L_{A243} | L_{B3} | 1983 | L_{A93} | L_{B8} | 3183 | L_{A213} | L_{B12} |
| 784 | L_{A244} | L_{B3} | 1984 | L_{A94} | L_{B8} | 3184 | L_{A214} | L_{B12} |
| 785 | L_{A245} | L_{B3} | 1985 | L_{A95} | L_{B8} | 3185 | L_{A215} | L_{B12} |
| 786 | L_{A246} | L_{B3} | 1986 | L_{A96} | L_{B8} | 3186 | L_{A216} | L_{B12} |
| 787 | L_{A247} | L_{B3} | 1987 | L_{A97} | L_{B8} | 3187 | L_{A217} | L_{B12} |
| 788 | L_{A248} | L_{B3} | 1988 | L_{A98} | L_{B8} | 3188 | L_{A218} | L_{B12} |
| 789 | L_{A249} | L_{B3} | 1989 | L_{A99} | L_{B8} | 3189 | L_{A219} | L_{B12} |
| 790 | L_{A250} | L_{B3} | 1990 | L_{A100} | L_{B8} | 3190 | L_{A220} | L_{B12} |
| 791 | L_{A251} | L_{B3} | 1991 | L_{A101} | L_{B8} | 3191 | L_{A221} | L_{B12} |
| 792 | L_{A252} | L_{B3} | 1992 | L_{A102} | L_{B8} | 3192 | L_{A222} | L_{B12} |
| 793 | L_{A253} | L_{B3} | 1993 | L_{A103} | L_{B8} | 3193 | L_{A223} | L_{B12} |
| 794 | L_{A254} | L_{B3} | 1994 | L_{A104} | L_{B8} | 3194 | L_{A224} | L_{B12} |
| 795 | L_{A255} | L_{B3} | 1995 | L_{A105} | L_{B8} | 3195 | L_{A225} | L_{B12} |
| 796 | L_{A256} | L_{B3} | 1996 | L_{A106} | L_{B8} | 3196 | L_{A226} | L_{B12} |
| 797 | L_{A257} | L_{B3} | 1997 | L_{A107} | L_{B8} | 3197 | L_{A227} | L_{B12} |
| 798 | L_{A258} | L_{B3} | 1998 | L_{A108} | L_{B8} | 3198 | L_{A228} | L_{B12} |
| 799 | L_{A259} | L_{B3} | 1999 | L_{A109} | L_{B8} | 3199 | L_{A229} | L_{B12} |
| 800 | L_{A260} | L_{B3} | 2000 | L_{A110} | L_{B8} | 3200 | L_{A230} | L_{B12} |
| 801 | L_{A261} | L_{B3} | 2001 | L_{A111} | L_{B8} | 3201 | L_{A231} | L_{B12} |
| 802 | L_{A262} | L_{B3} | 2002 | L_{A112} | L_{B8} | 3202 | L_{A232} | L_{B12} |
| 803 | L_{A263} | L_{B3} | 2003 | L_{A113} | L_{B8} | 3203 | L_{A233} | L_{B12} |
| 804 | L_{A264} | L_{B3} | 2004 | L_{A114} | L_{B8} | 3204 | L_{A234} | L_{B12} |
| 805 | L_{A265} | L_{B3} | 2005 | L_{A115} | L_{B8} | 3205 | L_{A235} | L_{B12} |
| 806 | L_{A266} | L_{B3} | 2006 | L_{A116} | L_{B8} | 3206 | L_{A236} | L_{B12} |
| 807 | L_{A267} | L_{B3} | 2007 | L_{A117} | L_{B8} | 3207 | L_{A237} | L_{B12} |
| 808 | L_{A268} | L_{B3} | 2008 | L_{A118} | L_{B8} | 3208 | L_{A238} | L_{B12} |
| 809 | L_{A269} | L_{B3} | 2009 | L_{A119} | L_{B8} | 3209 | L_{A239} | L_{B12} |
| 810 | L_{A270} | L_{B3} | 2010 | L_{A120} | L_{B8} | 3210 | L_{A240} | L_{B12} |
| 811 | L_{A1} | L_{B4} | 2011 | L_{A121} | L_{B8} | 3211 | L_{A241} | L_{B12} |
| 812 | L_{A2} | L_{B4} | 2012 | L_{A122} | L_{B8} | 3212 | L_{A242} | L_{B12} |
| 813 | L_{A3} | L_{B4} | 2013 | L_{A123} | L_{B8} | 3213 | L_{A243} | L_{B12} |
| 814 | L_{A4} | L_{B4} | 2014 | L_{A124} | L_{B8} | 3214 | L_{A244} | L_{B12} |
| 815 | L_{A5} | L_{B4} | 2015 | L_{A125} | L_{B8} | 3215 | L_{A245} | L_{B12} |
| 816 | L_{A6} | L_{B4} | 2016 | L_{A126} | L_{B8} | 3216 | L_{A246} | L_{B12} |
| 817 | L_{A7} | L_{B4} | 2017 | L_{A127} | L_{B8} | 3217 | L_{A247} | L_{B12} |
| 818 | L_{A8} | L_{B4} | 2018 | L_{A128} | L_{B8} | 3218 | L_{A248} | L_{B12} |
| 819 | L_{A9} | L_{B4} | 2019 | L_{A129} | L_{B8} | 3219 | L_{A249} | L_{B12} |
| 820 | L_{A10} | L_{B4} | 2020 | L_{A130} | L_{B8} | 3220 | L_{A250} | L_{B12} |
| 821 | L_{A11} | L_{B4} | 2021 | L_{A131} | L_{B8} | 3221 | L_{A251} | L_{B12} |
| 822 | L_{A12} | L_{B4} | 2022 | L_{A132} | L_{B8} | 3222 | L_{A252} | L_{B12} |
| 823 | L_{A13} | L_{B4} | 2023 | L_{A133} | L_{B8} | 3223 | L_{A253} | L_{B12} |
| 824 | L_{A14} | L_{B4} | 2024 | L_{A134} | L_{B8} | 3224 | L_{A254} | L_{B12} |
| 825 | L_{A15} | L_{B4} | 2025 | L_{A135} | L_{B8} | 3225 | L_{A255} | L_{B12} |
| 826 | L_{A16} | L_{B4} | 2026 | L_{A136} | L_{B8} | 3226 | L_{A256} | L_{B12} |
| 827 | L_{A17} | L_{B4} | 2027 | L_{A137} | L_{B8} | 3227 | L_{A257} | L_{B12} |
| 828 | L_{A18} | L_{B4} | 2028 | L_{A138} | L_{B8} | 3228 | L_{A258} | L_{B12} |
| 829 | L_{A19} | L_{B4} | 2029 | L_{A139} | L_{B8} | 3229 | L_{A259} | L_{B12} |
| 830 | L_{A20} | L_{B4} | 2030 | L_{A140} | L_{B8} | 3230 | L_{A260} | L_{B12} |
| 831 | L_{A21} | L_{B4} | 2031 | L_{A141} | L_{B8} | 3231 | L_{A261} | L_{B12} |
| 832 | L_{A22} | L_{B4} | 2032 | L_{A142} | L_{B8} | 3232 | L_{A262} | L_{B12} |
| 833 | L_{A23} | L_{B4} | 2033 | L_{A143} | L_{B8} | 3233 | L_{A263} | L_{B12} |
| 834 | L_{A24} | L_{B4} | 2034 | L_{A144} | L_{B8} | 3234 | L_{A264} | L_{B12} |
| 835 | L_{A25} | L_{B4} | 2035 | L_{A145} | L_{B8} | 3235 | L_{A265} | L_{B12} |
| 836 | L_{A26} | L_{B4} | 2036 | L_{A146} | L_{B8} | 3236 | L_{A266} | L_{B12} |
| 837 | L_{A27} | L_{B4} | 2037 | L_{A147} | L_{B8} | 3237 | L_{A267} | L_{B12} |
| 838 | L_{A28} | L_{B4} | 2038 | L_{A148} | L_{B8} | 3238 | L_{A268} | L_{B12} |
| 839 | L_{A29} | L_{B4} | 2039 | L_{A149} | L_{B8} | 3239 | L_{A269} | L_{B12} |
| 840 | L_{A30} | L_{B4} | 2040 | L_{A150} | L_{B8} | 3240 | L_{A270} | L_{B12} |
| 841 | L_{A31} | L_{B4} | 2041 | L_{A151} | L_{B8} | 3241 | L_{A1} | L_{B13} |
| 842 | L_{A32} | L_{B4} | 2042 | L_{A152} | L_{B8} | 3242 | L_{A2} | L_{B13} |
| 843 | L_{A33} | L_{B4} | 2043 | L_{A153} | L_{B8} | 3243 | L_{A3} | L_{B13} |
| 844 | L_{A34} | L_{B4} | 2044 | L_{A154} | L_{B8} | 3244 | L_{A4} | L_{B13} |
| 845 | L_{A35} | L_{B4} | 2045 | L_{A155} | L_{B8} | 3245 | L_{A5} | L_{B13} |
| 846 | L_{A36} | L_{B4} | 2046 | L_{A156} | L_{B8} | 3246 | L_{A6} | L_{B13} |
| 847 | L_{A37} | L_{B4} | 2047 | L_{A157} | L_{B8} | 3247 | L_{A7} | L_{B13} |
| 848 | L_{A38} | L_{B4} | 2048 | L_{A158} | L_{B8} | 3248 | L_{A8} | L_{B13} |
| 849 | L_{A39} | L_{B4} | 2049 | L_{A159} | L_{B8} | 3249 | L_{A9} | L_{B13} |
| 850 | L_{A40} | L_{B4} | 2050 | L_{A160} | L_{B8} | 3250 | L_{A10} | L_{B13} |
| 851 | L_{A41} | L_{B4} | 2051 | L_{A161} | L_{B8} | 3251 | L_{A11} | L_{B13} |
| 852 | L_{A42} | L_{B4} | 2052 | L_{A162} | L_{B8} | 3252 | L_{A12} | L_{B13} |
| 853 | L_{A43} | L_{B4} | 2053 | L_{A163} | L_{B8} | 3253 | L_{A13} | L_{B13} |
| 854 | L_{A44} | L_{B4} | 2054 | L_{A164} | L_{B8} | 3254 | L_{A14} | L_{B13} |
| 855 | L_{A45} | L_{B4} | 2055 | L_{A165} | L_{B8} | 3255 | L_{A15} | L_{B13} |
| 856 | L_{A46} | L_{B4} | 2056 | L_{A166} | L_{B8} | 3256 | L_{A16} | L_{B13} |
| 857 | L_{A47} | L_{B4} | 2057 | L_{A167} | L_{B8} | 3257 | L_{A17} | L_{B13} |
| 858 | L_{A48} | L_{B4} | 2058 | L_{A168} | L_{B8} | 3258 | L_{A18} | L_{B13} |
| 859 | L_{A49} | L_{B4} | 2059 | L_{A169} | L_{B8} | 3259 | L_{A19} | L_{B13} |
| 860 | L_{A50} | L_{B4} | 2060 | L_{A170} | L_{B8} | 3260 | L_{A20} | L_{B13} |
| 861 | L_{A51} | L_{B4} | 2061 | L_{A171} | L_{B8} | 3261 | L_{A21} | L_{B13} |
| 862 | L_{A52} | L_{B4} | 2062 | L_{A172} | L_{B8} | 3262 | L_{A22} | L_{B13} |
| 863 | L_{A53} | L_{B4} | 2063 | L_{A173} | L_{B8} | 3263 | L_{A23} | L_{B13} |
| 864 | L_{A54} | L_{B4} | 2064 | L_{A174} | L_{B8} | 3264 | L_{A24} | L_{B13} |
| 865 | L_{A55} | L_{B4} | 2065 | L_{A175} | L_{B8} | 3265 | L_{A25} | L_{B13} |
| 866 | L_{A56} | L_{B4} | 2066 | L_{A176} | L_{B8} | 3266 | L_{A26} | L_{B13} |
| 867 | L_{A57} | L_{B4} | 2067 | L_{A177} | L_{B8} | 3267 | L_{A27} | L_{B13} |
| 868 | L_{A58} | L_{B4} | 2068 | L_{A178} | L_{B8} | 3268 | L_{A28} | L_{B13} |
| 869 | L_{A59} | L_{B4} | 2069 | L_{A179} | L_{B8} | 3269 | L_{A29} | L_{B13} |
| 870 | L_{A60} | L_{B4} | 2070 | L_{A180} | L_{B8} | 3270 | L_{A30} | L_{B13} |
| 871 | L_{A61} | L_{B4} | 2071 | L_{A181} | L_{B8} | 3271 | L_{A31} | L_{B13} |
| 872 | L_{A62} | L_{B4} | 2072 | L_{A182} | L_{B8} | 3272 | L_{A32} | L_{B13} |
| 873 | L_{A63} | L_{B4} | 2073 | L_{A183} | L_{B8} | 3273 | L_{A33} | L_{B13} |
| 874 | L_{A64} | L_{B4} | 2074 | L_{A184} | L_{B8} | 3274 | L_{A34} | L_{B13} |
| 875 | L_{A65} | L_{B4} | 2075 | L_{A185} | L_{B8} | 3275 | L_{A35} | L_{B13} |
| 876 | L_{A66} | L_{B4} | 2076 | L_{A186} | L_{B8} | 3276 | L_{A36} | L_{B13} |
| 877 | L_{A67} | L_{B4} | 2077 | L_{A187} | L_{B8} | 3277 | L_{A37} | L_{B13} |
| 878 | L_{A68} | L_{B4} | 2078 | L_{A188} | L_{B8} | 3278 | L_{A38} | L_{B13} |
| 879 | L_{A69} | L_{B4} | 2079 | L_{A189} | L_{B8} | 3279 | L_{A39} | L_{B13} |
| 880 | L_{A70} | L_{B4} | 2080 | L_{A190} | L_{B8} | 3280 | L_{A40} | L_{B13} |
| 881 | L_{A71} | L_{B4} | 2081 | L_{A191} | L_{B8} | 3281 | L_{A41} | L_{B13} |
| 882 | L_{A72} | L_{B4} | 2082 | L_{A192} | L_{B8} | 3282 | L_{A42} | L_{B13} |
| 883 | L_{A73} | L_{B4} | 2083 | L_{A193} | L_{B8} | 3283 | L_{A43} | L_{B13} |
| 884 | L_{A74} | L_{B4} | 2084 | L_{A194} | L_{B8} | 3284 | L_{A44} | L_{B13} |
| 885 | L_{A75} | L_{B4} | 2085 | L_{A195} | L_{B8} | 3285 | L_{A45} | L_{B13} |
| 886 | L_{A76} | L_{B4} | 2086 | L_{A196} | L_{B8} | 3286 | L_{A46} | L_{B13} |
| 887 | L_{A77} | L_{B4} | 2087 | L_{A197} | L_{B8} | 3287 | L_{A47} | L_{B13} |
| 888 | L_{A78} | L_{B4} | 2088 | L_{A198} | L_{B8} | 3288 | L_{A48} | L_{B13} |
| 889 | L_{A79} | L_{B4} | 2089 | L_{A199} | L_{B8} | 3289 | L_{A49} | L_{B13} |
| 890 | L_{A80} | L_{B4} | 2090 | L_{A200} | L_{B8} | 3290 | L_{A50} | L_{B13} |
| 891 | L_{A81} | L_{B4} | 2091 | L_{A201} | L_{B8} | 3291 | L_{A51} | L_{B13} |
| 892 | L_{A82} | L_{B4} | 2092 | L_{A202} | L_{B8} | 3292 | L_{A52} | L_{B13} |
| 893 | L_{A83} | L_{B4} | 2093 | L_{A203} | L_{B8} | 3293 | L_{A53} | L_{B13} |
| 894 | L_{A84} | L_{B4} | 2094 | L_{A204} | L_{B8} | 3294 | L_{A54} | L_{B13} |
| 895 | L_{A85} | L_{B4} | 2095 | L_{A205} | L_{B8} | 3295 | L_{A55} | L_{B13} |
| 896 | L_{A86} | L_{B4} | 2096 | L_{A206} | L_{B8} | 3296 | L_{A56} | L_{B13} |
| 897 | L_{A87} | L_{B4} | 2097 | L_{A207} | L_{B8} | 3297 | L_{A57} | L_{B13} |
| 898 | L_{A88} | L_{B4} | 2098 | L_{A208} | L_{B8} | 3298 | L_{A58} | L_{B13} |
| 899 | L_{A89} | L_{B4} | 2099 | L_{A209} | L_{B8} | 3299 | L_{A59} | L_{B13} |
| 900 | L_{A90} | L_{B4} | 2100 | L_{A210} | L_{B8} | 3300 | L_{A60} | L_{B13} |
| 901 | L_{A91} | L_{B4} | 2101 | L_{A211} | L_{B8} | 3301 | L_{A61} | L_{B13} |
| 902 | L_{A92} | L_{B4} | 2102 | L_{A212} | L_{B8} | 3302 | L_{A62} | L_{B13} |
| 903 | L_{A93} | L_{B4} | 2103 | L_{A213} | L_{B8} | 3303 | L_{A63} | L_{B13} |
| 904 | L_{A94} | L_{B4} | 2104 | L_{A214} | L_{B8} | 3304 | L_{A64} | L_{B13} |
| 905 | L_{A95} | L_{B4} | 2105 | L_{A215} | L_{B8} | 3305 | L_{A65} | L_{B13} |
| 906 | L_{A96} | L_{B4} | 2106 | L_{A216} | L_{B8} | 3306 | L_{A66} | L_{B13} |
| 907 | L_{A97} | L_{B4} | 2107 | L_{A217} | L_{B8} | 3307 | L_{A67} | L_{B13} |
| 908 | L_{A98} | L_{B4} | 2108 | L_{A218} | L_{B8} | 3308 | L_{A68} | L_{B13} |
| 909 | L_{A99} | L_{B4} | 2109 | L_{A219} | L_{B8} | 3309 | L_{A69} | L_{B13} |
| 910 | L_{A100} | L_{B4} | 2110 | L_{A220} | L_{B8} | 3310 | L_{A70} | L_{B13} |
| 911 | L_{A101} | L_{B4} | 2111 | L_{A221} | L_{B8} | 3311 | L_{A71} | L_{B13} |
| 912 | L_{A102} | L_{B4} | 2112 | L_{A222} | L_{B8} | 3312 | L_{A72} | L_{B13} |
| 913 | L_{A103} | L_{B4} | 2113 | L_{A223} | L_{B8} | 3313 | L_{A73} | L_{B13} |
| 914 | L_{A104} | L_{B4} | 2114 | L_{A224} | L_{B8} | 3314 | L_{A74} | L_{B13} |
| 915 | L_{A105} | L_{B4} | 2115 | L_{A225} | L_{B8} | 3315 | L_{A75} | L_{B13} |
| 916 | L_{A106} | L_{B4} | 2116 | L_{A226} | L_{B8} | 3316 | L_{A76} | L_{B13} |
| 917 | L_{A107} | L_{B4} | 2117 | L_{A227} | L_{B8} | 3317 | L_{A77} | L_{B13} |
| 918 | L_{A108} | L_{B4} | 2118 | L_{A228} | L_{B8} | 3318 | L_{A78} | L_{B13} |
| 919 | L_{A109} | L_{B4} | 2119 | L_{A229} | L_{B8} | 3319 | L_{A79} | L_{B13} |
| 920 | L_{A110} | L_{B4} | 2120 | L_{A230} | L_{B8} | 3320 | L_{A80} | L_{B13} |
| 921 | L_{A111} | L_{B4} | 2121 | L_{A231} | L_{B8} | 3321 | L_{A81} | L_{B13} |
| 922 | L_{A112} | L_{B4} | 2122 | L_{A232} | L_{B8} | 3322 | L_{A82} | L_{B13} |
| 923 | L_{A113} | L_{B4} | 2123 | L_{A233} | L_{B8} | 3323 | L_{A83} | L_{B13} |
| 924 | L_{A114} | L_{B4} | 2124 | L_{A234} | L_{B8} | 3324 | L_{A84} | L_{B13} |
| 925 | L_{A115} | L_{B4} | 2125 | L_{A235} | L_{B8} | 3325 | L_{A85} | L_{B13} |
| 926 | L_{A116} | L_{B4} | 2126 | L_{A236} | L_{B8} | 3326 | L_{A86} | L_{B13} |
| 927 | L_{A117} | L_{B4} | 2127 | L_{A237} | L_{B8} | 3327 | L_{A87} | L_{B13} |
| 928 | L_{A118} | L_{B4} | 2128 | L_{A238} | L_{B8} | 3328 | L_{A88} | L_{B13} |
| 929 | L_{A119} | L_{B4} | 2129 | L_{A239} | L_{B8} | 3329 | L_{A89} | L_{B13} |
| 930 | L_{A120} | L_{B4} | 2130 | L_{A240} | L_{B8} | 3330 | L_{A90} | L_{B13} |
| 931 | L_{A121} | L_{B4} | 2131 | L_{A241} | L_{B8} | 3331 | L_{A91} | L_{B13} |
| 932 | L_{A122} | L_{B4} | 2132 | L_{A242} | L_{B8} | 3332 | L_{A92} | L_{B13} |
| 933 | L_{A123} | L_{B4} | 2133 | L_{A243} | L_{B8} | 3333 | L_{A93} | L_{B13} |
| 934 | L_{A124} | L_{B4} | 2134 | L_{A244} | L_{B8} | 3334 | L_{A94} | L_{B13} |
| 935 | L_{A125} | L_{B4} | 2135 | L_{A245} | L_{B8} | 3335 | L_{A95} | L_{B13} |
| 936 | L_{A126} | L_{B4} | 2136 | L_{A246} | L_{B8} | 3336 | L_{A96} | L_{B13} |
| 937 | L_{A127} | L_{B4} | 2137 | L_{A247} | L_{B8} | 3337 | L_{A97} | L_{B13} |
| 938 | L_{A128} | L_{B4} | 2138 | L_{A248} | L_{B8} | 3338 | L_{A98} | L_{B13} |
| 939 | L_{A129} | L_{B4} | 2139 | L_{A249} | L_{B8} | 3339 | L_{A99} | L_{B13} |
| 940 | L_{A130} | L_{B4} | 2140 | L_{A250} | L_{B8} | 3340 | L_{A100} | L_{B13} |
| 941 | L_{A131} | L_{B4} | 2141 | L_{A251} | L_{B8} | 3341 | L_{A101} | L_{B13} |
| 942 | L_{A132} | L_{B4} | 2142 | L_{A252} | L_{B8} | 3342 | L_{A102} | L_{B13} |
| 943 | L_{A133} | L_{B4} | 2143 | L_{A253} | L_{B8} | 3343 | L_{A103} | L_{B13} |
| 944 | L_{A134} | L_{B4} | 2144 | L_{A254} | L_{B8} | 3344 | L_{A104} | L_{B13} |
| 945 | L_{A135} | L_{B4} | 2145 | L_{A255} | L_{B8} | 3345 | L_{A105} | L_{B13} |
| 946 | L_{A136} | L_{B4} | 2146 | L_{A256} | L_{B8} | 3346 | L_{A106} | L_{B13} |
| 947 | L_{A137} | L_{B4} | 2147 | L_{A257} | L_{B8} | 3347 | L_{A107} | L_{B13} |
| 948 | L_{A138} | L_{B4} | 2148 | L_{A258} | L_{B8} | 3348 | L_{A108} | L_{B13} |
| 949 | L_{A139} | L_{B4} | 2149 | L_{A259} | L_{B8} | 3349 | L_{A109} | L_{B13} |
| 950 | L_{A140} | L_{B4} | 2150 | L_{A260} | L_{B8} | 3350 | L_{A110} | L_{B13} |
| 951 | L_{A141} | L_{B4} | 2151 | L_{A261} | L_{B8} | 3351 | L_{A111} | L_{B13} |
| 952 | L_{A142} | L_{B4} | 2152 | L_{A262} | L_{B8} | 3352 | L_{A112} | L_{B13} |
| 953 | L_{A143} | L_{B4} | 2153 | L_{A263} | L_{B8} | 3353 | L_{A113} | L_{B13} |
| 954 | L_{A144} | L_{B4} | 2154 | L_{A264} | L_{B8} | 3354 | L_{A114} | L_{B13} |
| 955 | L_{A145} | L_{B4} | 2155 | L_{A265} | L_{B8} | 3355 | L_{A115} | L_{B13} |
| 956 | L_{A146} | L_{B4} | 2156 | L_{A266} | L_{B8} | 3356 | L_{A116} | L_{B13} |
| 957 | L_{A147} | L_{B4} | 2157 | L_{A267} | L_{B8} | 3357 | L_{A117} | L_{B13} |
| 958 | L_{A148} | L_{B4} | 2158 | L_{A268} | L_{B8} | 3358 | L_{A118} | L_{B13} |
| 959 | L_{A149} | L_{B4} | 2159 | L_{A269} | L_{B8} | 3359 | L_{A119} | L_{B13} |
| 960 | L_{A150} | L_{B4} | 2160 | L_{A270} | L_{B8} | 3360 | L_{A120} | L_{B13} |
| 961 | L_{A151} | L_{B4} | 2161 | L_{A1} | L_{B9} | 3361 | L_{A121} | L_{B13} |
| 962 | L_{A152} | L_{B4} | 2162 | L_{A2} | L_{B9} | 3362 | L_{A122} | L_{B13} |
| 963 | L_{A153} | L_{B4} | 2163 | L_{A3} | L_{B9} | 3363 | L_{A123} | L_{B13} |
| 964 | L_{A154} | L_{B4} | 2164 | L_{A4} | L_{B9} | 3364 | L_{A124} | L_{B13} |
| 965 | L_{A155} | L_{B4} | 2165 | L_{A5} | L_{B9} | 3365 | L_{A125} | L_{B13} |
| 966 | L_{A156} | L_{B4} | 2166 | L_{A6} | L_{B9} | 3366 | L_{A126} | L_{B13} |
| 967 | L_{A157} | L_{B4} | 2167 | L_{A7} | L_{B9} | 3367 | L_{A127} | L_{B13} |
| 968 | L_{A158} | L_{B4} | 2168 | L_{A8} | L_{B9} | 3368 | L_{A128} | L_{B13} |
| 969 | L_{A159} | L_{B4} | 2169 | L_{A9} | L_{B9} | 3369 | L_{A129} | L_{B13} |
| 970 | L_{A160} | L_{B4} | 2170 | L_{A10} | L_{B9} | 3370 | L_{A130} | L_{B13} |
| 971 | L_{A161} | L_{B4} | 2171 | L_{A11} | L_{B9} | 3371 | L_{A131} | L_{B13} |
| 972 | L_{A162} | L_{B4} | 2172 | L_{A12} | L_{B9} | 3372 | L_{A132} | L_{B13} |
| 973 | L_{A163} | L_{B4} | 2173 | L_{A13} | L_{B9} | 3373 | L_{A133} | L_{B13} |
| 974 | L_{A164} | L_{B4} | 2174 | L_{A14} | L_{B9} | 3374 | L_{A134} | L_{B13} |
| 975 | L_{A165} | L_{B4} | 2175 | L_{A15} | L_{B9} | 3375 | L_{A135} | L_{B13} |
| 976 | L_{A166} | L_{B4} | 2176 | L_{A16} | L_{B9} | 3376 | L_{A136} | L_{B13} |
| 977 | L_{A167} | L_{B4} | 2177 | L_{A17} | L_{B9} | 3377 | L_{A137} | L_{B13} |
| 978 | L_{A168} | L_{B4} | 2178 | L_{A18} | L_{B9} | 3378 | L_{A138} | L_{B13} |
| 979 | L_{A169} | L_{B4} | 2179 | L_{A19} | L_{B9} | 3379 | L_{A139} | L_{B13} |
| 980 | L_{A170} | L_{B4} | 2180 | L_{A20} | L_{B9} | 3380 | L_{A140} | L_{B13} |
| 981 | L_{A171} | L_{B4} | 2181 | L_{A21} | L_{B9} | 3381 | L_{A141} | L_{B13} |
| 982 | L_{A172} | L_{B4} | 2182 | L_{A22} | L_{B9} | 3382 | L_{A142} | L_{B13} |
| 983 | L_{A173} | L_{B4} | 2183 | L_{A23} | L_{B9} | 3383 | L_{A143} | L_{B13} |
| 984 | L_{A174} | L_{B4} | 2184 | L_{A24} | L_{B9} | 3384 | L_{A144} | L_{B13} |
| 985 | L_{A175} | L_{B4} | 2185 | L_{A25} | L_{B9} | 3385 | L_{A145} | L_{B13} |
| 986 | L_{A176} | L_{B4} | 2186 | L_{A26} | L_{B9} | 3386 | L_{A146} | L_{B13} |
| 987 | L_{A177} | L_{B4} | 2187 | L_{A27} | L_{B9} | 3387 | L_{A147} | L_{B13} |
| 988 | L_{A178} | L_{B4} | 2188 | L_{A28} | L_{B9} | 3388 | L_{A148} | L_{B13} |
| 989 | L_{A179} | L_{B4} | 2189 | L_{A29} | L_{B9} | 3389 | L_{A149} | L_{B13} |
| 990 | L_{A180} | L_{B4} | 2190 | L_{A30} | L_{B9} | 3390 | L_{A150} | L_{B13} |
| 991 | L_{A181} | L_{B4} | 2191 | L_{A31} | L_{B9} | 3391 | L_{A151} | L_{B13} |
| 992 | L_{A182} | L_{B4} | 2192 | L_{A32} | L_{B9} | 3392 | L_{A152} | L_{B13} |
| 993 | L_{A183} | L_{B4} | 2193 | L_{A33} | L_{B9} | 3393 | L_{A153} | L_{B13} |
| 994 | L_{A184} | L_{B4} | 2194 | L_{A34} | L_{B9} | 3394 | L_{A154} | L_{B13} |
| 995 | L_{A185} | L_{B4} | 2195 | L_{A35} | L_{B9} | 3395 | L_{A155} | L_{B13} |
| 996 | L_{A186} | L_{B4} | 2196 | L_{A36} | L_{B9} | 3396 | L_{A156} | L_{B13} |
| 997 | L_{A187} | L_{B4} | 2197 | L_{A37} | L_{B9} | 3397 | L_{A157} | L_{B13} |
| 998 | L_{A188} | L_{B4} | 2198 | L_{A38} | L_{B9} | 3398 | L_{A158} | L_{B13} |
| 999 | L_{A189} | L_{B4} | 2199 | L_{A39} | L_{B9} | 3399 | L_{A159} | L_{B13} |
| 1000 | L_{A190} | L_{B4} | 2200 | L_{A40} | L_{B9} | 3400 | L_{A160} | L_{B13} |
| 1001 | L_{A191} | L_{B4} | 2201 | L_{A41} | L_{B9} | 3401 | L_{A161} | L_{B13} |
| 1002 | L_{A192} | L_{B4} | 2202 | L_{A42} | L_{B9} | 3402 | L_{A162} | L_{B13} |
| 1003 | L_{A193} | L_{B4} | 2203 | L_{A43} | L_{B9} | 3403 | L_{A163} | L_{B13} |
| 1004 | L_{A194} | L_{B4} | 2204 | L_{A44} | L_{B9} | 3404 | L_{A164} | L_{B13} |
| 1005 | L_{A195} | L_{B4} | 2205 | L_{A45} | L_{B9} | 3405 | L_{A165} | L_{B13} |
| 1006 | L_{A196} | L_{B4} | 2206 | L_{A46} | L_{B9} | 3406 | L_{A166} | L_{B13} |
| 1007 | L_{A197} | L_{B4} | 2207 | L_{A47} | L_{B9} | 3407 | L_{A167} | L_{B13} |
| 1008 | L_{A198} | L_{B4} | 2208 | L_{A48} | L_{B9} | 3408 | L_{A168} | L_{B13} |
| 1009 | L_{A199} | L_{B4} | 2209 | L_{A49} | L_{B9} | 3409 | L_{A169} | L_{B13} |
| 1010 | L_{A200} | L_{B4} | 2210 | L_{A50} | L_{B9} | 3410 | L_{A170} | L_{B13} |
| 1011 | L_{A201} | L_{B4} | 2211 | L_{A51} | L_{B9} | 3411 | L_{A171} | L_{B13} |
| 1012 | L_{A202} | L_{B4} | 2212 | L_{A52} | L_{B9} | 3412 | L_{A172} | L_{B13} |
| 1013 | L_{A203} | L_{B4} | 2213 | L_{A53} | L_{B9} | 3413 | L_{A173} | L_{B13} |
| 1014 | L_{A204} | L_{B4} | 2214 | L_{A54} | L_{B9} | 3414 | L_{A174} | L_{B13} |
| 1015 | L_{A205} | L_{B4} | 2215 | L_{A55} | L_{B9} | 3415 | L_{A175} | L_{B13} |
| 1016 | L_{A206} | L_{B4} | 2216 | L_{A56} | L_{B9} | 3416 | L_{A176} | L_{B13} |
| 1017 | L_{A207} | L_{B4} | 2217 | L_{A57} | L_{B9} | 3417 | L_{A177} | L_{B13} |
| 1018 | L_{A208} | L_{B4} | 2218 | L_{A58} | L_{B9} | 3418 | L_{A178} | L_{B13} |
| 1019 | L_{A209} | L_{B4} | 2219 | L_{A59} | L_{B9} | 3419 | L_{A179} | L_{B13} |
| 1020 | L_{A210} | L_{B4} | 2220 | L_{A60} | L_{B9} | 3420 | L_{A180} | L_{B13} |
| 1021 | L_{A211} | L_{B4} | 2221 | L_{A61} | L_{B9} | 3421 | L_{A181} | L_{B13} |
| 1022 | L_{A212} | L_{B4} | 2222 | L_{A62} | L_{B9} | 3422 | L_{A182} | L_{B13} |
| 1023 | L_{A213} | L_{B4} | 2223 | L_{A63} | L_{B9} | 3423 | L_{A183} | L_{B13} |
| 1024 | L_{A214} | L_{B4} | 2224 | L_{A64} | L_{B9} | 3424 | L_{A184} | L_{B13} |
| 1025 | L_{A215} | L_{B4} | 2225 | L_{A65} | L_{B9} | 3425 | L_{A185} | L_{B13} |
| 1026 | L_{A216} | L_{B4} | 2226 | L_{A66} | L_{B9} | 3426 | L_{A186} | L_{B13} |
| 1027 | L_{A217} | L_{B4} | 2227 | L_{A67} | L_{B9} | 3427 | L_{A187} | L_{B13} |
| 1028 | L_{A218} | L_{B4} | 2228 | L_{A68} | L_{B9} | 3428 | L_{A188} | L_{B13} |
| 1029 | L_{A219} | L_{B4} | 2229 | L_{A69} | L_{B9} | 3429 | L_{A189} | L_{B13} |
| 1030 | L_{A220} | L_{B4} | 2230 | L_{A70} | L_{B9} | 3430 | L_{A190} | L_{B13} |
| 1031 | L_{A221} | L_{B4} | 2231 | L_{A71} | L_{B9} | 3431 | L_{A191} | L_{B13} |
| 1032 | L_{A222} | L_{B4} | 2232 | L_{A72} | L_{B9} | 3432 | L_{A192} | L_{B13} |
| 1033 | L_{A223} | L_{B4} | 2233 | L_{A73} | L_{B9} | 3433 | L_{A193} | L_{B13} |
| 1034 | L_{A224} | L_{B4} | 2234 | L_{A74} | L_{B9} | 3434 | L_{A194} | L_{B13} |
| 1035 | L_{A225} | L_{B4} | 2235 | L_{A75} | L_{B9} | 3435 | L_{A195} | L_{B13} |
| 1036 | L_{A226} | L_{B4} | 2236 | L_{A76} | L_{B9} | 3436 | L_{A196} | L_{B13} |
| 1037 | L_{A227} | L_{B4} | 2237 | L_{A77} | L_{B9} | 3437 | L_{A197} | L_{B13} |
| 1038 | L_{A228} | L_{B4} | 2238 | L_{A78} | L_{B9} | 3438 | L_{A198} | L_{B13} |
| 1039 | L_{A229} | L_{B4} | 2239 | L_{A79} | L_{B9} | 3439 | L_{A199} | L_{B13} |
| 1040 | L_{A230} | L_{B4} | 2240 | L_{A80} | L_{B9} | 3440 | L_{A200} | L_{B13} |
| 1041 | L_{A231} | L_{B4} | 2241 | L_{A81} | L_{B9} | 3441 | L_{A201} | L_{B13} |
| 1042 | L_{A232} | L_{B4} | 2242 | L_{A82} | L_{B9} | 3442 | L_{A202} | L_{B13} |
| 1043 | L_{A233} | L_{B4} | 2243 | L_{A83} | L_{B9} | 3443 | L_{A203} | L_{B13} |
| 1044 | L_{A234} | L_{B4} | 2244 | L_{A84} | L_{B9} | 3444 | L_{A204} | L_{B13} |
| 1045 | L_{A235} | L_{B4} | 2245 | L_{A85} | L_{B9} | 3445 | L_{A205} | L_{B13} |
| 1046 | L_{A236} | L_{B4} | 2246 | L_{A86} | L_{B9} | 3446 | L_{A206} | L_{B13} |
| 1047 | L_{A237} | L_{B4} | 2247 | L_{A87} | L_{B9} | 3447 | L_{A207} | L_{B13} |
| 1048 | L_{A238} | L_{B4} | 2248 | L_{A88} | L_{B9} | 3448 | L_{A208} | L_{B13} |
| 1049 | L_{A239} | L_{B4} | 2249 | L_{A89} | L_{B9} | 3449 | L_{A209} | L_{B13} |
| 1050 | L_{A240} | L_{B4} | 2250 | L_{A90} | L_{B9} | 3450 | L_{A210} | L_{B13} |
| 1051 | L_{A241} | L_{B4} | 2251 | L_{A91} | L_{B9} | 3451 | L_{A211} | L_{B13} |
| 1052 | L_{A242} | L_{B4} | 2252 | L_{A92} | L_{B9} | 3452 | L_{A212} | L_{B13} |
| 1053 | L_{A243} | L_{B4} | 2253 | L_{A93} | L_{B9} | 3453 | L_{A213} | L_{B13} |
| 1054 | L_{A244} | L_{B4} | 2254 | L_{A94} | L_{B9} | 3454 | L_{A214} | L_{B13} |
| 1055 | L_{A245} | L_{B4} | 2255 | L_{A95} | L_{B9} | 3455 | L_{A215} | L_{B13} |
| 1056 | L_{A246} | L_{B4} | 2256 | L_{A96} | L_{B9} | 3456 | L_{A216} | L_{B13} |
| 1057 | L_{A247} | L_{B4} | 2257 | L_{A97} | L_{B9} | 3457 | L_{A217} | L_{B13} |
| 1058 | L_{A248} | L_{B4} | 2258 | L_{A98} | L_{B9} | 3458 | L_{A218} | L_{B13} |
| 1059 | L_{A249} | L_{B4} | 2259 | L_{A99} | L_{B9} | 3459 | L_{A219} | L_{B13} |
| 1060 | L_{A250} | L_{B4} | 2260 | L_{A100} | L_{B9} | 3460 | L_{A220} | L_{B13} |
| 1061 | L_{A251} | L_{B4} | 2261 | L_{A101} | L_{B9} | 3461 | L_{A221} | L_{B13} |
| 1062 | L_{A252} | L_{B4} | 2262 | L_{A102} | L_{B9} | 3462 | L_{A222} | L_{B13} |
| 1063 | L_{A253} | L_{B4} | 2263 | L_{A103} | L_{B9} | 3463 | L_{A223} | L_{B13} |
| 1064 | L_{A254} | L_{B4} | 2264 | L_{A104} | L_{B9} | 3464 | L_{A224} | L_{B13} |
| 1065 | L_{A255} | L_{B4} | 2265 | L_{A105} | L_{B9} | 3465 | L_{A225} | L_{B13} |
| 1066 | L_{A256} | L_{B4} | 2266 | L_{A106} | L_{B9} | 3466 | L_{A226} | L_{B13} |
| 1067 | L_{A257} | L_{B4} | 2267 | L_{A107} | L_{B9} | 3467 | L_{A227} | L_{B13} |
| 1068 | L_{A258} | L_{B4} | 2268 | L_{A108} | L_{B9} | 3468 | L_{A228} | L_{B13} |
| 1069 | L_{A259} | L_{B4} | 2269 | L_{A109} | L_{B9} | 3469 | L_{A229} | L_{B13} |
| 1070 | L_{A260} | L_{B4} | 2270 | L_{A110} | L_{B9} | 3470 | L_{A230} | L_{B13} |
| 1071 | L_{A261} | L_{B4} | 2271 | L_{A111} | L_{B9} | 3471 | L_{A231} | L_{B13} |
| 1072 | L_{A262} | L_{B4} | 2272 | L_{A112} | L_{B9} | 3472 | L_{A232} | L_{B13} |
| 1073 | L_{A263} | L_{B4} | 2273 | L_{A113} | L_{B9} | 3473 | L_{A233} | L_{B13} |
| 1074 | L_{A264} | L_{B4} | 2274 | L_{A114} | L_{B9} | 3474 | L_{A234} | L_{B13} |
| 1075 | L_{A265} | L_{B4} | 2275 | L_{A115} | L_{B9} | 3475 | L_{A235} | L_{B13} |
| 1076 | L_{A266} | L_{B4} | 2276 | L_{A116} | L_{B9} | 3476 | L_{A236} | L_{B13} |
| 1077 | L_{A267} | L_{B4} | 2277 | L_{A117} | L_{B9} | 3477 | L_{A237} | L_{B13} |
| 1078 | L_{A268} | L_{B4} | 2278 | L_{A118} | L_{B9} | 3478 | L_{A238} | L_{B13} |
| 1079 | L_{A269} | L_{B4} | 2279 | L_{A119} | L_{B9} | 3479 | L_{A239} | L_{B13} |
| 1080 | L_{A270} | L_{B4} | 2280 | L_{A120} | L_{B9} | 3480 | L_{A240} | L_{B13} |
| 1081 | L_{A1} | L_{B5} | 2281 | L_{A121} | L_{B9} | 3481 | L_{A241} | L_{B13} |
| 1082 | L_{A2} | L_{B5} | 2282 | L_{A122} | L_{B9} | 3482 | L_{A242} | L_{B13} |
| 1083 | L_{A3} | L_{B5} | 2283 | L_{A123} | L_{B9} | 3483 | L_{A243} | L_{B13} |
| 1084 | L_{A4} | L_{B5} | 2284 | L_{A124} | L_{B9} | 3484 | L_{A244} | L_{B13} |
| 1085 | L_{A5} | L_{B5} | 2285 | L_{A125} | L_{B9} | 3485 | L_{A245} | L_{B13} |
| 1086 | L_{A6} | L_{B5} | 2286 | L_{A126} | L_{B9} | 3486 | L_{A246} | L_{B13} |
| 1087 | L_{A7} | L_{B5} | 2287 | L_{A127} | L_{B9} | 3487 | L_{A247} | L_{B13} |
| 1088 | L_{A8} | L_{B5} | 2288 | L_{A128} | L_{B9} | 3488 | L_{A248} | L_{B13} |
| 1089 | L_{A9} | L_{B5} | 2289 | L_{A129} | L_{B9} | 3489 | L_{A249} | L_{B13} |
| 1090 | L_{A10} | L_{B5} | 2290 | L_{A130} | L_{B9} | 3490 | L_{A250} | L_{B13} |
| 1091 | L_{A11} | L_{B5} | 2291 | L_{A131} | L_{B9} | 3491 | L_{A251} | L_{B13} |
| 1092 | L_{A12} | L_{B5} | 2292 | L_{A132} | L_{B9} | 3492 | L_{A252} | L_{B13} |
| 1093 | L_{A13} | L_{B5} | 2293 | L_{A133} | L_{B9} | 3493 | L_{A253} | L_{B13} |
| 1094 | L_{A14} | L_{B5} | 2294 | L_{A134} | L_{B9} | 3494 | L_{A254} | L_{B13} |
| 1095 | L_{A15} | L_{B5} | 2295 | L_{A135} | L_{B9} | 3495 | L_{A255} | L_{B13} |
| 1096 | L_{A16} | L_{B5} | 2296 | L_{A136} | L_{B9} | 3496 | L_{A256} | L_{B13} |
| 1097 | L_{A17} | L_{B5} | 2297 | L_{A137} | L_{B9} | 3497 | L_{A257} | L_{B13} |
| 1098 | L_{A18} | L_{B5} | 2298 | L_{A138} | L_{B9} | 3498 | L_{A258} | L_{B13} |
| 1099 | L_{A19} | L_{B5} | 2299 | L_{A139} | L_{B9} | 3499 | L_{A259} | L_{B13} |
| 1100 | L_{A20} | L_{B5} | 2300 | L_{A140} | L_{B9} | 3500 | L_{A260} | L_{B13} |
| 1101 | L_{A21} | L_{B5} | 2301 | L_{A141} | L_{B9} | 3501 | L_{A261} | L_{B13} |
| 1102 | L_{A22} | L_{B5} | 2302 | L_{A142} | L_{B9} | 3502 | L_{A262} | L_{B13} |
| 1103 | L_{A23} | L_{B5} | 2303 | L_{A143} | L_{B9} | 3503 | L_{A263} | L_{B13} |
| 1104 | L_{A24} | L_{B5} | 2304 | L_{A144} | L_{B9} | 3504 | L_{A264} | L_{B13} |
| 1105 | L_{A25} | L_{B5} | 2305 | L_{A145} | L_{B9} | 3505 | L_{A265} | L_{B13} |
| 1106 | L_{A26} | L_{B5} | 2306 | L_{A146} | L_{B9} | 3506 | L_{A266} | L_{B13} |
| 1107 | L_{A27} | L_{B5} | 2307 | L_{A147} | L_{B9} | 3507 | L_{A267} | L_{B13} |
| 1108 | L_{A28} | L_{B5} | 2308 | L_{A148} | L_{B9} | 3508 | L_{A268} | L_{B13} |
| 1109 | L_{A29} | L_{B5} | 2309 | L_{A149} | L_{B9} | 3509 | L_{A269} | L_{B13} |
| 1110 | L_{A30} | L_{B5} | 2310 | L_{A150} | L_{B9} | 3510 | L_{A270} | L_{B13} |
| 1111 | L_{A31} | L_{B5} | 2311 | L_{A151} | L_{B9} | | | |
| 1112 | L_{A32} | L_{B5} | 2312 | L_{A152} | L_{B9} | | | |
| 1113 | L_{A33} | L_{B5} | 2313 | L_{A153} | L_{B9} | | | |
| 1114 | L_{A34} | L_{B5} | 2314 | L_{A154} | L_{B9} | | | |
| 1115 | L_{A35} | L_{B5} | 2315 | L_{A155} | L_{B9} | | | |
| 1116 | L_{A36} | L_{B5} | 2316 | L_{A156} | L_{B9} | | | |
| 1117 | L_{A37} | L_{B5} | 2317 | L_{A157} | L_{B9} | | | |
| 1118 | L_{A38} | L_{B5} | 2318 | L_{A158} | L_{B9} | | | |
| 1119 | L_{A39} | L_{B5} | 2319 | L_{A159} | L_{B9} | | | |
| 1120 | L_{A40} | L_{B5} | 2320 | L_{A160} | L_{B9} | | | |
| 1121 | L_{A41} | L_{B5} | 2321 | L_{A161} | L_{B9} | | | |
| 1122 | L_{A42} | L_{B5} | 2322 | L_{A162} | L_{B9} | | | |
| 1123 | L_{A43} | L_{B5} | 2323 | L_{A163} | L_{B9} | | | |
| 1124 | L_{A44} | L_{B5} | 2324 | L_{A164} | L_{B9} | | | |
| 1125 | L_{A45} | L_{B5} | 2325 | L_{A165} | L_{B9} | | | |
| 1126 | L_{A46} | L_{B5} | 2326 | L_{A166} | L_{B9} | | | |
| 1127 | L_{A47} | L_{B5} | 2327 | L_{A167} | L_{B9} | | | |
| 1128 | L_{A48} | L_{B5} | 2328 | L_{A168} | L_{B9} | | | |
| 1129 | L_{A49} | L_{B5} | 2329 | L_{A169} | L_{B9} | | | |
| 1130 | L_{A50} | L_{B5} | 2330 | L_{A170} | L_{B9} | | | |
| 1131 | L_{A51} | L_{B5} | 2331 | L_{A171} | L_{B9} | | | |
| 1132 | L_{A52} | L_{B5} | 2332 | L_{A172} | L_{B9} | | | |
| 1133 | L_{A53} | L_{B5} | 2333 | L_{A173} | L_{B9} | | | |
| 1134 | L_{A54} | L_{B5} | 2334 | L_{A174} | L_{B9} | | | |
| 1135 | L_{A55} | L_{B5} | 2335 | L_{A175} | L_{B9} | | | |
| 1136 | L_{A56} | L_{B5} | 2336 | L_{A176} | L_{B9} | | | |
| 1137 | L_{A57} | L_{B5} | 2337 | L_{A177} | L_{B9} | | | |
| 1138 | L_{A58} | L_{B5} | 2338 | L_{A178} | L_{B9} | | | |
| 1139 | L_{A59} | L_{B5} | 2339 | L_{A179} | L_{B9} | | | |
| 1140 | L_{A60} | L_{B5} | 2340 | L_{A180} | L_{B9} | | | |
| 1141 | L_{A61} | L_{B5} | 2341 | L_{A181} | L_{B9} | | | |
| 1142 | L_{A62} | L_{B5} | 2342 | L_{A182} | L_{B9} | | | |
| 1143 | L_{A63} | L_{B5} | 2343 | L_{A183} | L_{B9} | | | |
| 1144 | L_{A64} | L_{B5} | 2344 | L_{A184} | L_{B9} | | | |
| 1145 | L_{A65} | L_{B5} | 2345 | L_{A185} | L_{B9} | | | |
| 1146 | L_{A66} | L_{B5} | 2346 | L_{A186} | L_{B9} | | | |
| 1147 | L_{A67} | L_{B5} | 2347 | L_{A187} | L_{B9} | | | |
| 1148 | L_{A68} | L_{B5} | 2348 | L_{A188} | L_{B9} | | | |
| 1149 | L_{A69} | L_{B5} | 2349 | L_{A189} | L_{B9} | | | |
| 1150 | L_{A70} | L_{B5} | 2350 | L_{A190} | L_{B9} | | | |
| 1151 | L_{A71} | L_{B5} | 2351 | L_{A191} | L_{B9} | | | |
| 1152 | L_{A72} | L_{B5} | 2352 | L_{A192} | L_{B9} | | | |
| 1153 | L_{A73} | L_{B5} | 2353 | L_{A193} | L_{B9} | | | |
| 1154 | L_{A74} | L_{B5} | 2354 | L_{A194} | L_{B9} | | | |
| 1155 | L_{A75} | L_{B5} | 2355 | L_{A195} | L_{B9} | | | |
| 1156 | L_{A76} | L_{B5} | 2356 | L_{A196} | L_{B9} | | | |
| 1157 | L_{A77} | L_{B5} | 2357 | L_{A197} | L_{B9} | | | |
| 1158 | L_{A78} | L_{B5} | 2358 | L_{A198} | L_{B9} | | | |
| 1159 | L_{A79} | L_{B5} | 2359 | L_{A199} | L_{B9} | | | |
| 1160 | L_{A80} | L_{B5} | 2360 | L_{A200} | L_{B9} | | | |
| 1161 | L_{A81} | L_{B5} | 2361 | L_{A201} | L_{B9} | | | |
| 1162 | L_{A82} | L_{B5} | 2362 | L_{A202} | L_{B9} | | | |
| 1163 | L_{A83} | L_{B5} | 2363 | L_{A203} | L_{B9} | | | |
| 1164 | L_{A84} | L_{B5} | 2364 | L_{A204} | L_{B9} | | | |
| 1165 | L_{A85} | L_{B5} | 2365 | L_{A205} | L_{B9} | | | |
| 1166 | L_{A86} | L_{B5} | 2366 | L_{A206} | L_{B9} | | | |
| 1167 | L_{A87} | L_{B5} | 2367 | L_{A207} | L_{B9} | | | |
| 1168 | L_{A88} | L_{B5} | 2368 | L_{A28} | L_{B9} | | | |
| 1169 | L_{A89} | L_{B5} | 2369 | L_{A209} | L_{B9} | | | |
| 1170 | L_{A90} | L_{B5} | 2370 | L_{A210} | L_{B9} | | | |
| 1171 | L_{A91} | L_{B5} | 2371 | L_{A211} | L_{B9} | | | |
| 1172 | L_{A92} | L_{B5} | 2372 | L_{A212} | L_{B9} | | | |
| 1173 | L_{A93} | L_{B5} | 2373 | L_{A213} | L_{B9} | | | |
| 1174 | L_{A94} | L_{B5} | 2374 | L_{A214} | L_{B9} | | | |
| 1175 | L_{A95} | L_{B5} | 2375 | L_{A215} | L_{B9} | | | |
| 1176 | L_{A96} | L_{B5} | 2376 | L_{A216} | L_{B9} | | | |
| 1177 | L_{A97} | L_{B5} | 2377 | L_{A217} | L_{B9} | | | |
| 1178 | L_{A98} | L_{B5} | 2378 | L_{A218} | L_{B9} | | | |
| 1179 | L_{A99} | L_{B5} | 2379 | L_{A219} | L_{B9} | | | |
| 1180 | L_{A100} | L_{B5} | 2380 | L_{A220} | L_{B9} | | | |
| 1181 | L_{A101} | L_{B5} | 2381 | L_{A221} | L_{B9} | | | |
| 1182 | L_{A102} | L_{B5} | 2382 | L_{A222} | L_{B9} | | | |
| 1183 | L_{A103} | L_{B5} | 2383 | L_{A223} | L_{B9} | | | |
| 1184 | L_{A104} | L_{B5} | 2384 | L_{A224} | L_{B9} | | | |
| 1185 | L_{A105} | L_{B5} | 2385 | L_{A225} | L_{B9} | | | |
| 1186 | L_{A106} | L_{B5} | 2386 | L_{A226} | L_{B9} | | | |
| 1187 | L_{A107} | L_{B5} | 2387 | L_{A227} | L_{B9} | | | |
| 1188 | L_{A108} | L_{B5} | 2388 | L_{A228} | L_{B9} | | | |
| 1189 | L_{A109} | L_{B5} | 2389 | L_{A229} | L_{B9} | | | |
| 1190 | L_{A110} | L_{B5} | 2390 | L_{A230} | L_{B9} | | | |
| 1191 | L_{A111} | L_{B5} | 2391 | L_{A231} | L_{B9} | | | |
| 1192 | L_{A112} | L_{B5} | 2392 | L_{A232} | L_{B9} | | | |
| 1193 | L_{A13} | L_{B5} | 2393 | L_{A233} | L_{B9} | | | |
| 1194 | L_{A114} | L_{B5} | 2394 | L_{A234} | L_{B9} | | | |
| 1195 | L_{A115} | L_{B5} | 2395 | L_{A235} | L_{B9} | | | |
| 1196 | L_{A116} | L_{B5} | 2396 | L_{A236} | L_{B9} | | | |
| 1197 | L_{A117} | L_{B5} | 2397 | L_{A237} | L_{B9} | | | |
| 1198 | L_{A118} | L_{B5} | 2398 | L_{A238} | L_{B9} | | | |
| 1199 | L_{A119} | L_{B5} | 2399 | L_{A239} | L_{B9} | | | |
| 1200 | L_{A120} | L_{B5} | 2400 | L_{A240} | L_{B9} | | | |

In some embodiments, the compound is selected from the group consisting of: 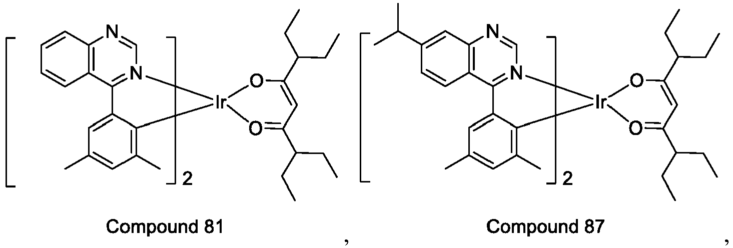 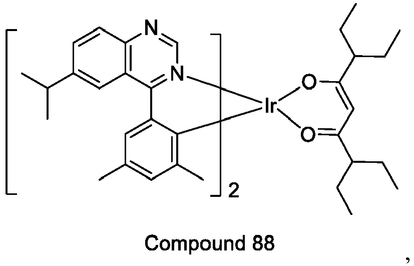 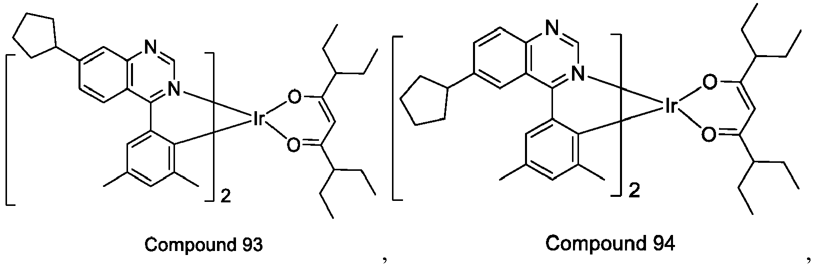 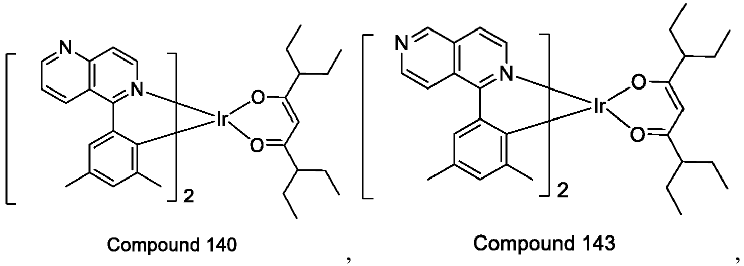 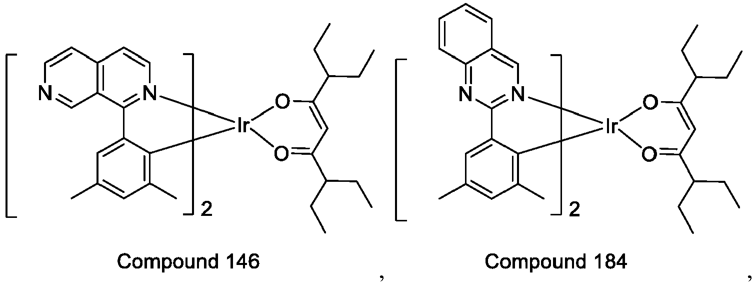 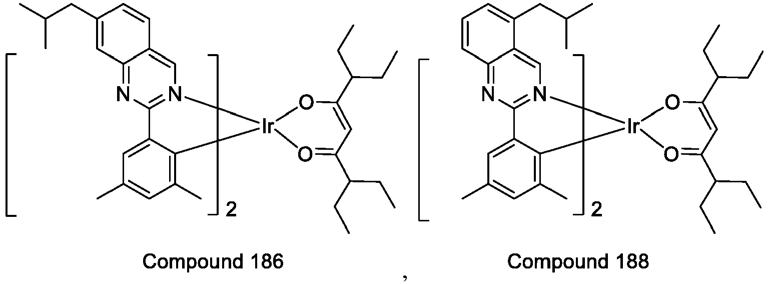 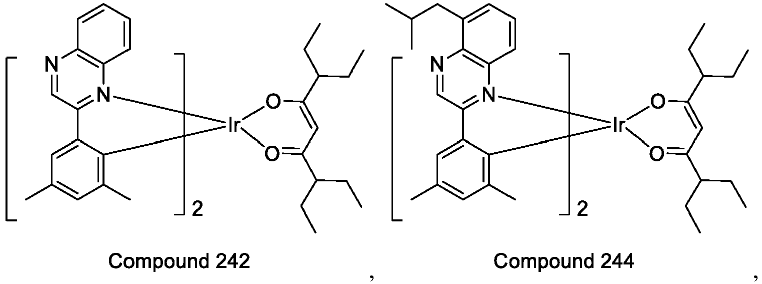 and

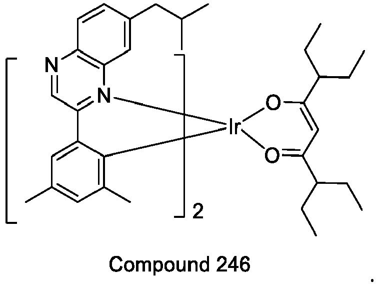

According to another aspect of the present disclosure, a first device is also provided. The first device includes a first organic light emitting device, that includes an anode, a cathode, and an organic layer disposed between the anode and the cathode. The organic layer can include a compound according to the formula M(L_{A})ₓ(L_{B})_{y}(L_{C})_{z}, and its variations as described herein.

The first device can be one or more of a consumer product, an organic light-emitting device and a lighting panel. The organic layer can be an emissive layer and the compound can be an emissive dopant in some embodiments, while the compound can be a non-emissive dopant in other embodiments.

The organic layer can also include a host. In some embodiments, the host can include a metal complex. The host can be a triphenylene containing benzo-fused thiophene or benzo-fused furan. Any substituent in the host can be an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡C-CₙH₂ₙ₊₁, Ar₁, Ar₁-Ar₂, CₙH₂ₙ-Ar₁, or no substitution. In the preceding substituents n can range from 1 to 10; and Ar₁ and Ar₂ can be independently selected from the group consisting of benzene, biphenyl, naphthalene, triphenylene, carbazole, and heteroaromatic analogs thereof.

The host can be a compound selected from the group consisting of carbazole, dibenzothiphene, dibenzofuran, dibenzoselenophene, azacarbazole, aza-dibenzothiophene, aza-dibenzofuran, and aza-dibenzoselenophene. The host can include a metal complex. The host can be a specific compound selected from the group consisting of: 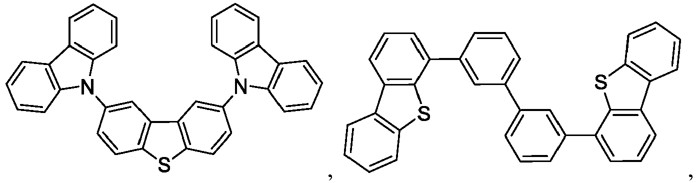 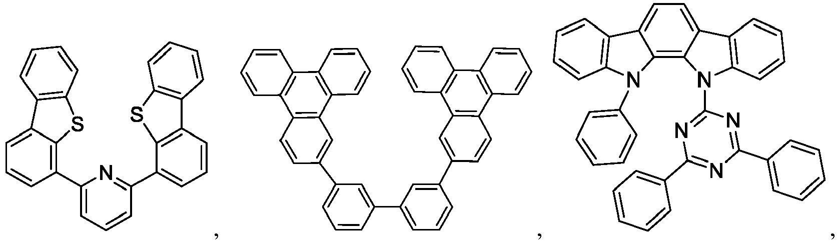 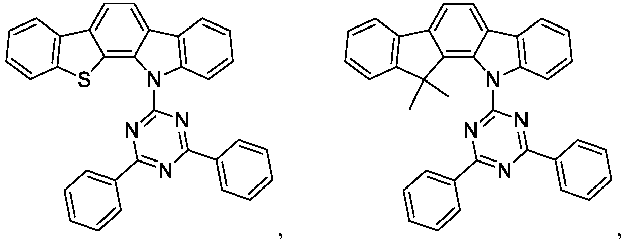 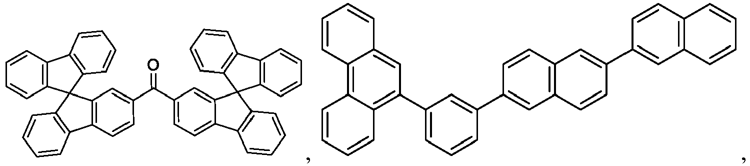 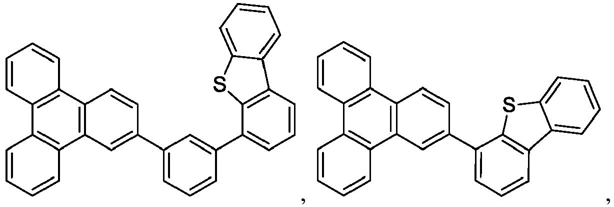 and combinations thereof.

In yet another aspect of the present disclsoure, a formulation that comprises a compound according to the formula M(L_{A})ₓ(L_{B})_{y}(L_{C})_{z} is described. The formulation can include one or more components selected from the group consisting of a solvent, a host, a hole injection material, hole transport material, and an electron transport layer material, disclosed herein.

### COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

### HIL/HTL:

A hole injecting/transporting material to be used in the present invention is not particularly limited, and any compound may be used as long as the compound is typically used as a hole injecting/transporting material. Examples of the material include, but not limit to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

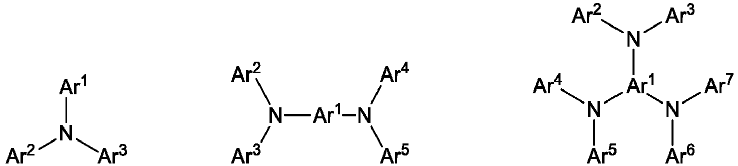

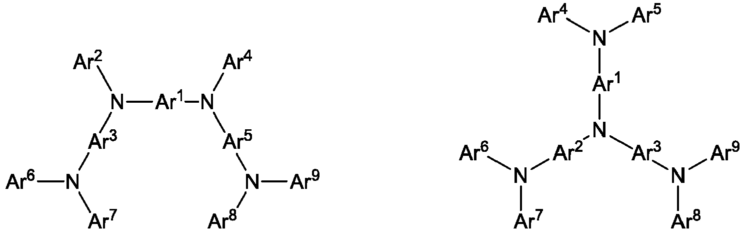

Each of Ar¹ to Ar⁹ is selected from the group consisting aromatic hydrocarbon cyclic compounds such as benzene, biphenyl, triphenyl, triphenylene, naphthalene, anthracene, phenalene, phenanthrene, fluorene, pyrene, chrysene, perylene, azulene; group consisting aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and group consisting 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Wherein each Ar is further substituted by a substituent selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, Ar¹ to Ar⁹ is independently selected from the group consisting of: 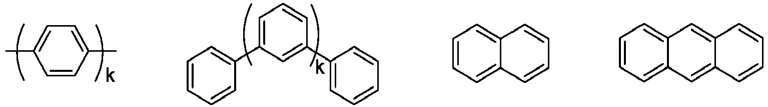 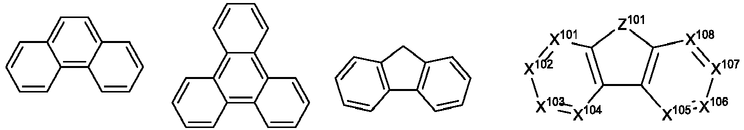 wherein k is an integer from 1 to 20; X¹⁰¹ to X¹⁰⁸ is C (including CH) or N; Z¹⁰¹ is NAr¹, O, or S; Ar¹ has the same group defined above.

Examples of metal complexes used in HIL or HTL include, but not limit to the following general formula: 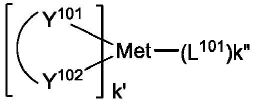 wherein Met is a metal, which can have an atomic weight greater than 40; (Y¹⁰¹-Y¹⁰²) is a bidentate ligand, Y¹⁰¹ and Y¹⁰² are independently selected from C, N, O, P, and S; L¹⁰¹ is an ancillary ligand; k' is an integer value from 1 to the maximum number of ligands that may be attached to the metal; and k'+k" is the maximum number of ligands that may be attached to the metal.

In one aspect, (Y¹⁰¹-Y¹⁰²) is a 2-phenylpyridine derivative. In another aspect, (Y¹⁰¹-Y¹⁰²) is a carbene ligand. In another aspect, Met is selected from Ir, Pt, Os, and Zn. In a further aspect, the metal complex has a smallest oxidation potential in solution vs. Fc⁺/Fc couple less than about 0.6 V.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. While the Table below categorizes host materials as preferred for devices that emit various colors, any host material may be used with any dopant so long as the triplet criteria is satisfied.

Examples of metal complexes used as host are preferred to have the following general formula: 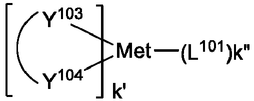 wherein Met is a metal; (Y¹⁰³-Y¹⁰⁴) is a bidentate ligand, Y¹⁰³ and Y¹⁰⁴ are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In one aspect, the metal complexes are: 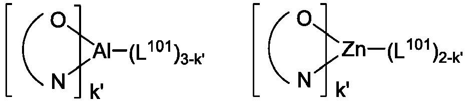 wherein (O-N) is a bidentate ligand, having metal coordinated to atoms O and N.

In another aspect, Met is selected from Ir and Pt. In a further aspect, (Y¹⁰³-Y¹⁰⁴) is a carbene ligand.

Examples of organic compounds used as host are selected from the group consisting aromatic hydrocarbon cyclic compounds such as benzene, biphenyl, triphenyl, triphenylene, naphthalene, anthracene, phenalene, phenanthrene, fluorene, pyrene, chrysene, perylene, azulene; group consisting aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and group consisting 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Wherein each group is further substituted by a substituent selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, host compound contains at least one of the following groups in the molecule: 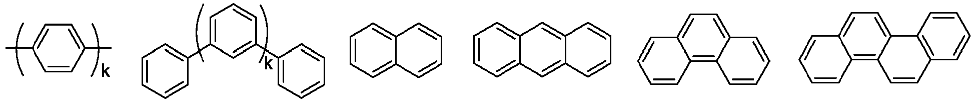 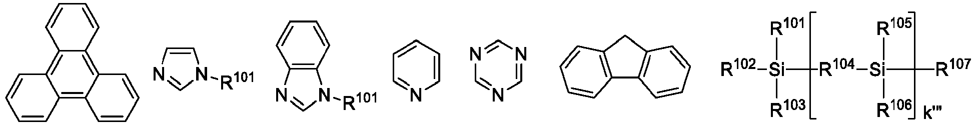 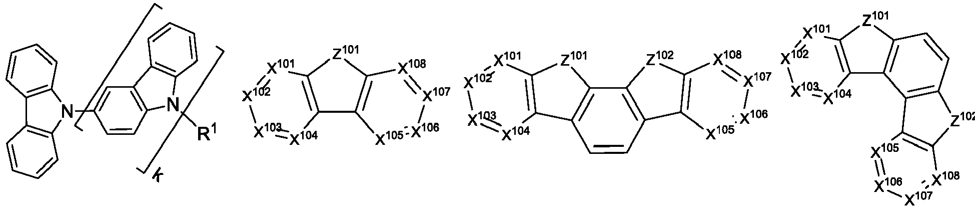 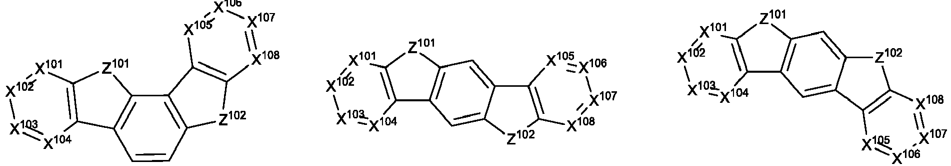
wherein R¹⁰¹ to R¹⁰⁷ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, when it is aryl or heteroaryl, it has the similar definition as Ar's mentioned above. k is an integer from 0 to 20 or 1 to 20; k'" is an integer from 0 to 20. X¹⁰¹ to X¹⁰⁸ is selected from C (including CH) or N.
Z¹⁰¹ and Z¹⁰² is selected from NR¹⁰¹, O, or S.

### HBL:

A hole blocking layer (HBL) may be used to reduce the number of holes and/or excitons that leave the emissive layer. The presence of such a blocking layer in a device may result in substantially higher efficiencies as compared to a similar device lacking a blocking layer. Also, a blocking layer may be used to confine emission to a desired region of an OLED.

In one aspect, compound used in HBL contains the same molecule or the same functional groups used as host described above.

In another aspect, compound used in HBL contains at least one of the following groups in the molecule: 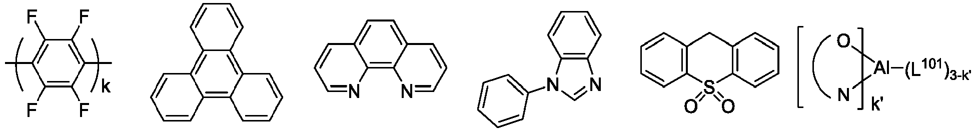 wherein k is an integer from 1 to 20; L¹⁰¹ is an another ligand, k' is an integer from 1 to 3.

### ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule: 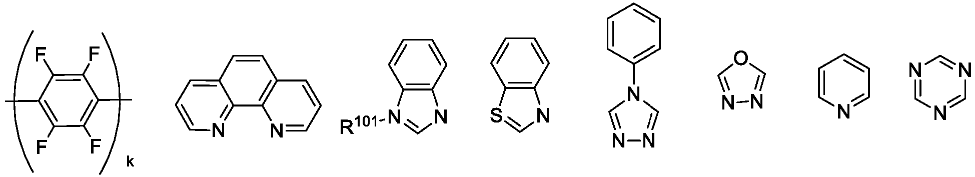 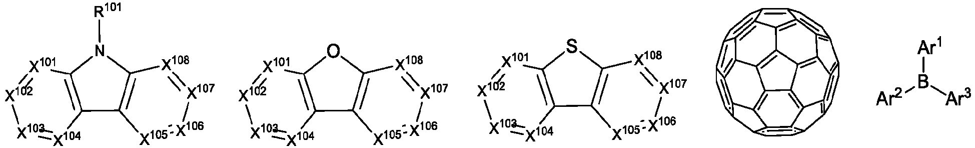 wherein R¹⁰¹ is selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, when it is aryl or heteroaryl, it has the similar definition as Ar's mentioned above. Ar¹ to Ar³ has the similar definition as Ar's mentioned above. k is an integer from 1 to 20. X¹⁰¹ to X¹⁰⁸ is selected from C (including CH) or N.

In another aspect, the metal complexes used in ETL contains, but not limit to the following general formula: 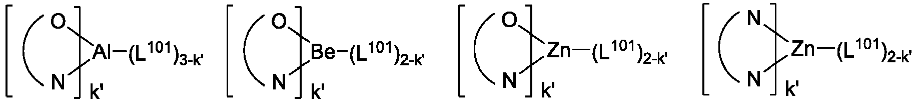 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

In any above-mentioned compounds used in each layer of the OLED device, the hydrogen atoms can be partially or fully deuterated. Thus, any specifically listed substituent, such as, without limitation, methyl, phenyl, pyridyl, etc. encompasses undeuterated, partially deuterated, and fully deuterated versions thereof. Similarly, classes of substituents such as, without limitation, alkyl, aryl, cycloalkyl, heteroaryl, etc. also encompass undeuterated, partially deuterated, and fully deuterated versions thereof.

In addition to and / or in combination with the materials disclosed herein, many hole injection materials, hole transporting materials, host materials, dopant materials, exiton/hole blocking layer materials, electron transporting and electron injecting materials may be used in an OLED. Non-limiting examples of the materials that may be used in an OLED in combination with materials disclosed herein are listed in Table 1 below. Table 1 lists non-limiting classes of materials, non-limiting examples of compounds for each class, and references that disclose the materials.

**TABLE 1**

| **MATERIAL** | **EXAMPLES OF MATERIAL** | **PUBLICATIONS** |
|---|---|---|
| **Hole injection materials** | | |
| Phthalocyanine and porphyrin compounds | 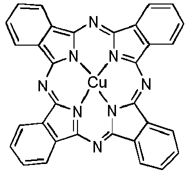 | Appl. Phys. Lett. 69, 2160 (1996) |
| Starburst triarylamines | 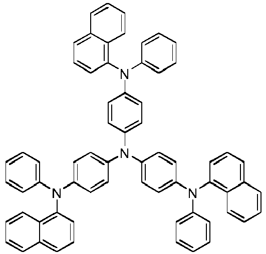 | J. Lumin. 72-74, 985 (1997) |
| CFₓ Fluorohydrocarbon polymer | 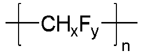 | Appl. Phys. Lett. 78, 673 (2001) |
| Conducting polymers (e.g., PEDOT:PSS, polyaniline, polythiophene) | 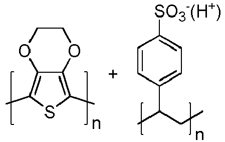 | Synth. Met. 87, 171 (1997) |
| | | WO2007002683 |
| Phosphonic acid and silane SAMs | 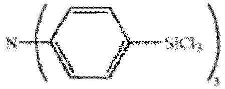 | US20030162053 |
| Triarylamine or polythiophene polymers with conductivity dopants | 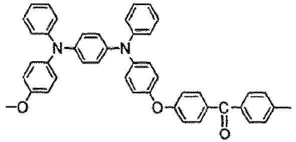 and | EP1725079A1 |
| | 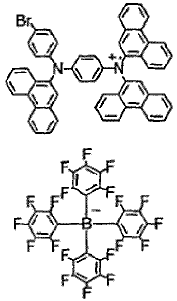 | |
| Organic compounds with conductive inorganic compounds, such as molybdenum and tungsten oxides | 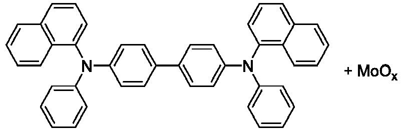 | US20050123751 SID Symposium Digest, 37, 923 (2006) WO2009018009 |
| n-type semiconducting organic complexes | 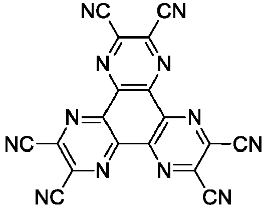 | US20020158242 |
| Metal organometallic complexes | 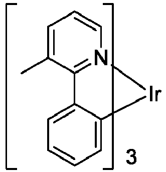 | US20060240279 |
| Cross-linkable compounds | 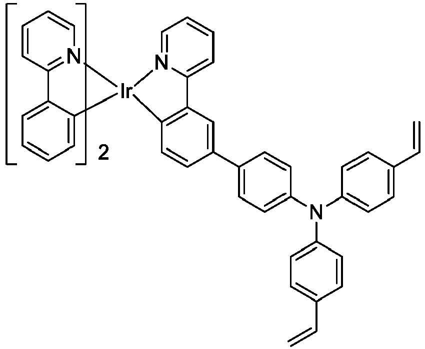 | US20080220265 |
| Polythiophene based polymers and copolymers | 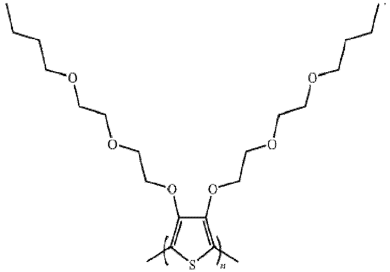 | WO 2011075644 |
| | | EP2350216 |

| **Hole transporting materials** | | |
|---|---|---|
| Triarylamines (e.g., TPD, α-NPD) | 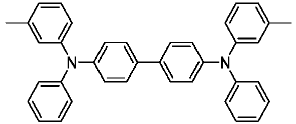 | Appl. Phys. Lett. 51, 913 (1987) |
| | 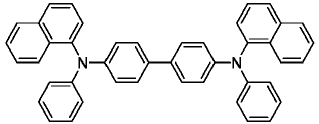 | US5061569 |
| | 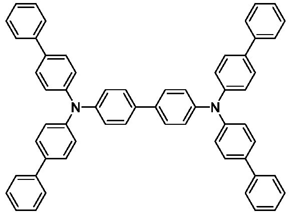 | EP650955 |
| | 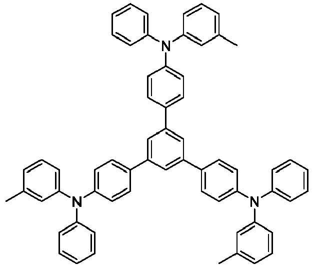 | J. Mater. Chem. 3, 319 (1993) |
| | 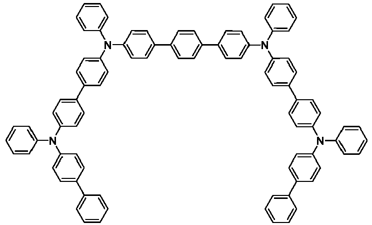 | Appl. Phys. Lett. 90, 183503 (2007) |
| | 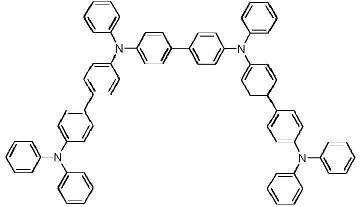 | Appl. Phys. Lett. 90, 183503 (2007) |
| Triarylamine on spirofluorene core | 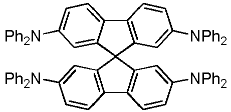 | Synth. Met. 91, 209 (1997) |
| Arylamine carbazole compounds | 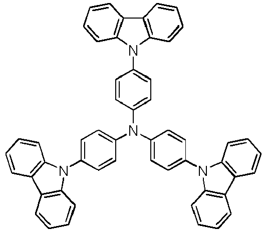 | Adv. Mater. 6, 677 (1994), US20080124572 |
| Triarylamine with (di)benzothiophene/(di)ben zofuran | 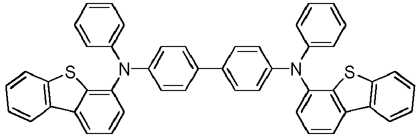 | US20070278938, US20080106190 |
| | | US20110163302 |
| Indolocarbazoles | 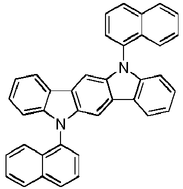 | Synth. Met. 111, 421 (2000) |
| Isoindole compounds | 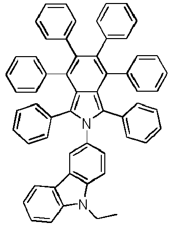 | Chem. Mater. 15, 3148 (2003) |
| Metal carbene complexes | 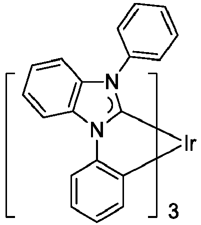 | US20080018221 |

| **Phosphorescent OLED host materials** | | |
|---|---|---|
| **Red hosts** | | |
| Arylcarbazoles | 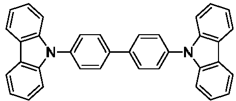 | Appl. Phys. Lett. 78, 1622 (2001) |
| Metal 8-hydroxyquinolates (e.g., Alq₃, BAlq) | 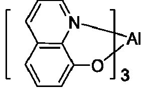 | Nature 395, 151 (1998) |
| | 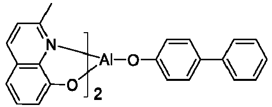 | US20060202194 |
| | 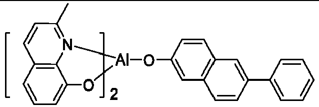 | WO2005014551 |
| | 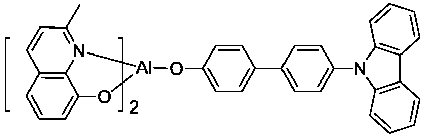 | WO2006072002 |
| Metal phenoxybenzothiazole compounds | 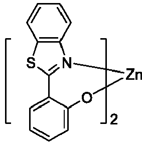 | Appl. Phys. Lett. 90, 123509 (2007) |
| Conjugated oligomers and polymers (e.g., polyfluorene) | 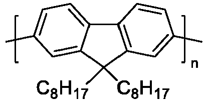 | Org. Electron. 1, 15 (2000) |
| Aromatic fused rings | 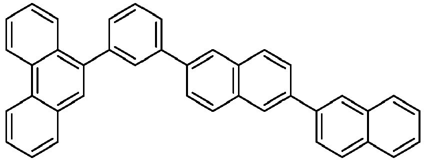 | WO2009066779, WO2009066778, WO2009063833, US20090045731, US20090045730, WO2009008311, US20090008605, US20090009065 |
| Zinc complexes | 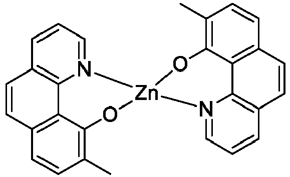 | WO2010056066 |
| Chrysene based compounds | 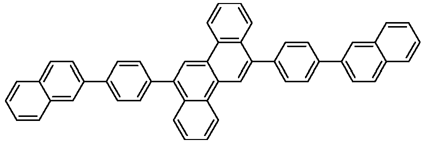 | WO2011086863 |

| **Green hosts** | | |
|---|---|---|
| Arylcarbazoles | 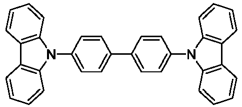 | Appl. Phys. Lett. 78, 1622 (2001) |
| | 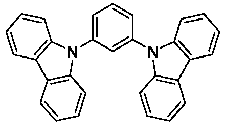 | US20030175553 |
| | 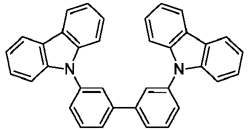 | WO2001039234 |
| Aryltriphenylene compounds | 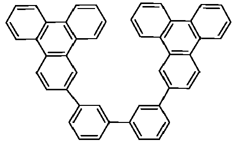 | US20060280965 |
| | 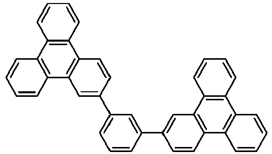 | US20060280965 |
| | 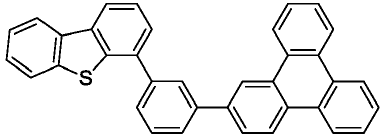 | WO2009021126 |
| Poly-fused heteroaryl compounds | 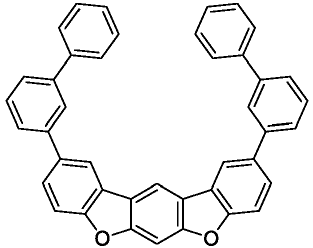 | US20090309488 |
| | | US20090302743 |
| | | US20100012931 |
| | | |
| Donor acceptor type molecules | 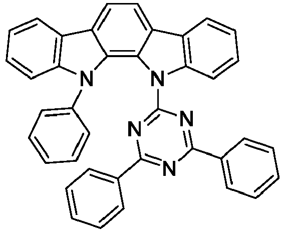 | WO2008056746 |
| | 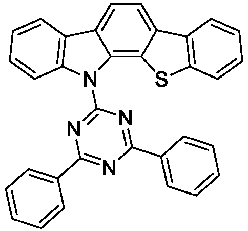 | WO2010107244 |
| Aza-carbazole/DBT/DBF | 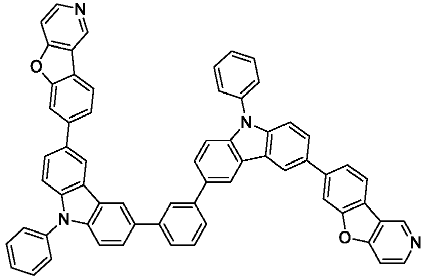 | JP2008074939 |
| | 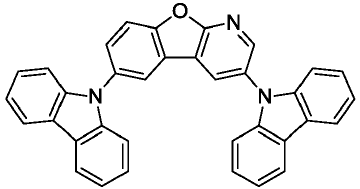 | US20100187984 |
| Polymers (e.g., PVK) | 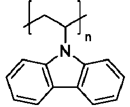 | Appl. Phys. Lett. 77, 2280 (2000) |
| Spirofluorene compounds | 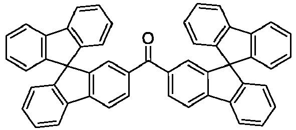 | WO2004093207 |
| Metal phenoxybenzooxazole compounds | 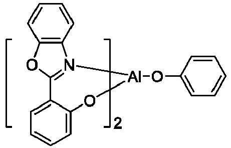 | WO2005089025 |
| | 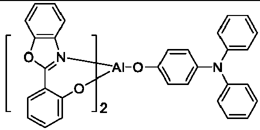 | WO2006132173 |
| | 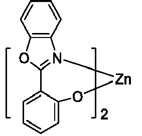 | JP200511610 |
| Spirofluorene-carbazole compounds | 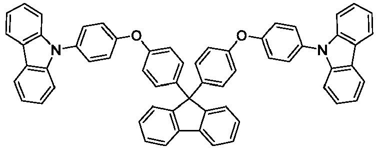 | JP2007254297 |
| | 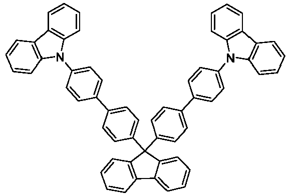 | JP2007254297 |
| Indolocarbazoles | 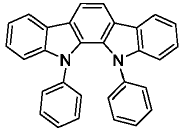 | WO2007063796 |
| | 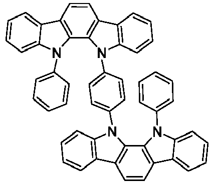 | WO2007063754 |
| 5-member ring electron deficient heterocycles (e.g., triazole, oxadiazole) | 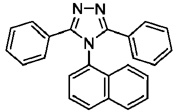 | J. Appl. Phys. 90, 5048 (2001) |
| | 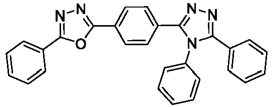 | WO2004107822 |
| Tetraphenylene complexes | 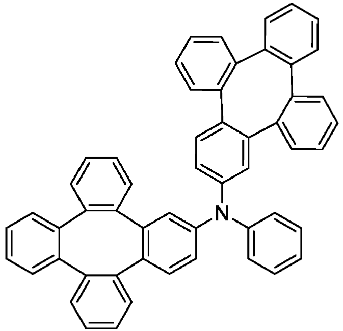 | US20050112407 |
| Metal phenoxypyridine compounds | 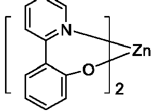 | WO2005030900 |
| Metal coordination complexes (e.g., Zn, Al with N^N ligands) | 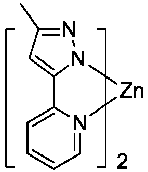 | US20040137268, US20040137267 |

| **Blue hosts** | | |
|---|---|---|
| Arylcarbazoles | 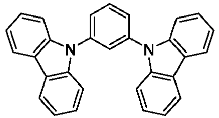 | Appl. Phys. Lett, 82, 2422 (2003) |
| | 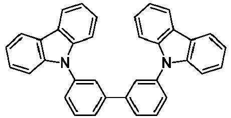 | US20070190359 |
| Dibenzothiophene/Dibenz ofuran-carbazole compounds | 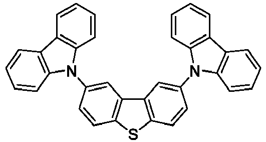 | WO2006114966, US20090167162 |
| | 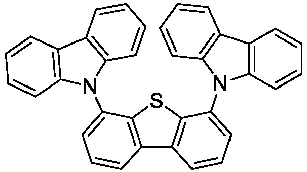 | US20090167162 |
| | 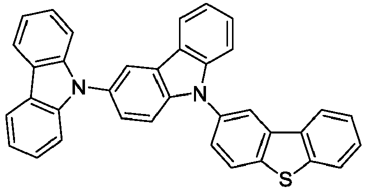 | WO2009086028 |
| | 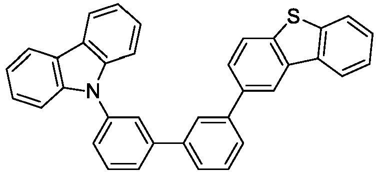 | US20090030202, US20090017330 |
| | 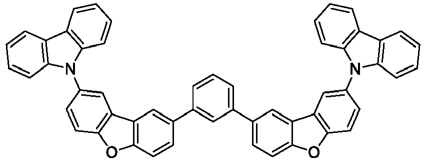 | US20100084966 |
| Silicon aryl compounds | 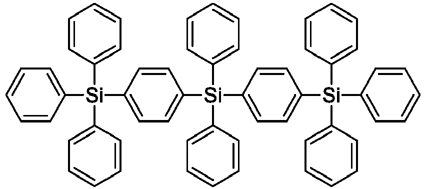 | US20050238919 |
| | 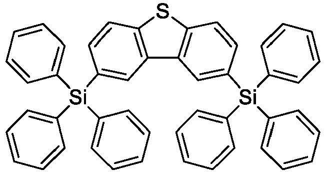 | WO2009003898 |
| Silicon/Germanium aryl compounds | 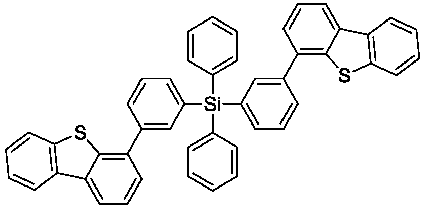 | EP2034538A |
| Aryl benzoyl ester | 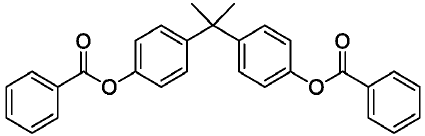 | WO2006100298 |
| Carbazole linked by nonconjugated groups | 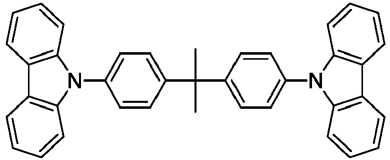 | US20040115476 |
| Aza-carbazoles | 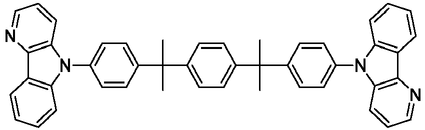 | US20060121308 |
| High triplet metal organometallic complex | 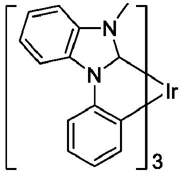 | US7154114 |

| **Phosphorescent dopants** | | |
|---|---|---|
| **Red dopants** | | |
| Heavy metal porphyrins (e.g., PtOEP) | 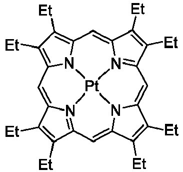 | Nature 395, 151 (1998) |
| Iridium(III) organometallic complexes | 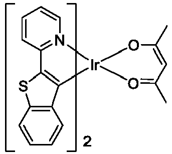 | Appl. Phys. Lett. 78, 1622 (2001) |
| | 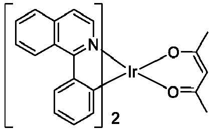 | US2006835469 |
| | 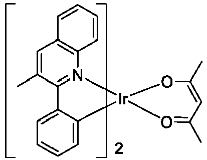 | US2006835469 |
| | 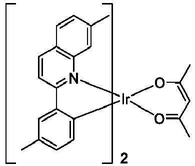 | US20060202194 |
| | 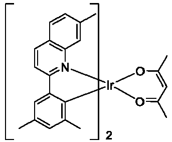 | US20060202194 |
| | 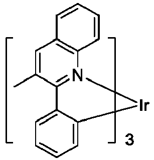 | US20070087321 |
| | 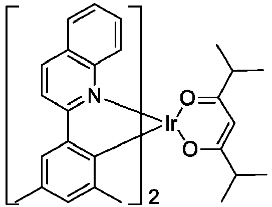 | US20080261 076 US20100090591 |
| | 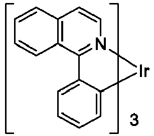 | US20070087321 |
| | 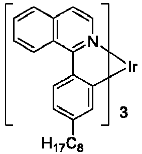 | Adv. Mater. 19, 739 (2007) |
| | 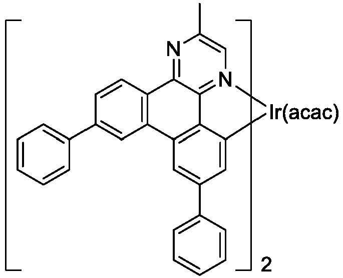 | WO2009100991 |
| | 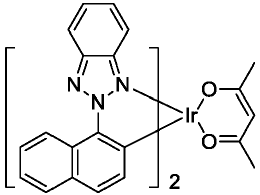 | WO2008101842 |
| | 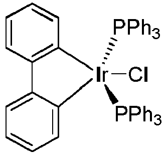 | US7232618 |
| Platinum(II) organometallic complexes | 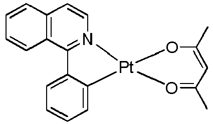 | WO2003040257 |
| | 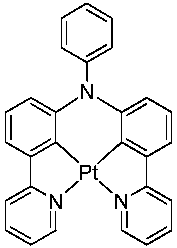 | US20070103060 |
| Osmium(III) complexes | 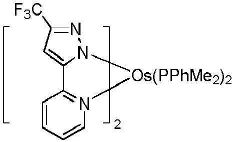 | Chem. Mater. 17, 3532 (2005) |
| Ruthenium(II) complexes | 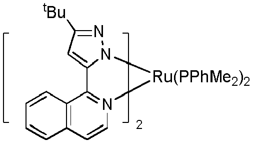 | Adv. Mater. 17, 1059 (2005) |
| Rhenium (I), (II), and (III) complexes | 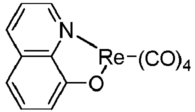 | US20050244673 |

| **Green dopants** | | |
|---|---|---|
| Iridium(III) organometallic complexes | 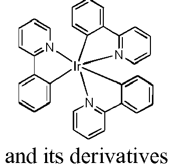 | Inorg. Chem. 40, 1704 (2001) |
| | 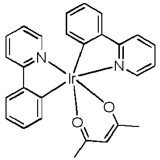 | US20020034656 |
| | 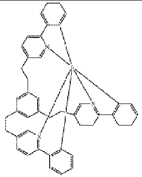 | US7332232 |
| | 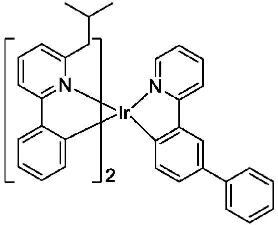 | US20090108737 |
| | 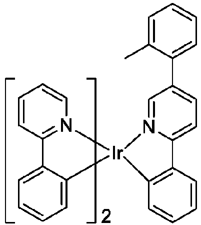 | WO2010028151 |
| | 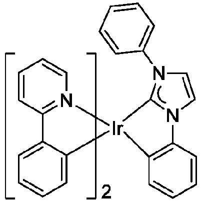 | EP1841834B |
| | 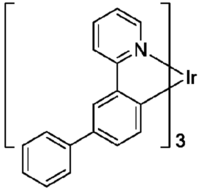 | US20060127696 |
| | 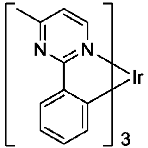 | US20090039776 |
| | 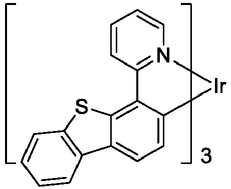 | US6921915 |
| | 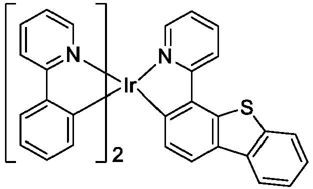 | US20100244004 |
| | 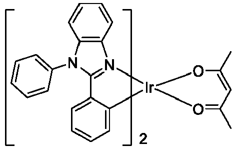 | US6687266 |
| | 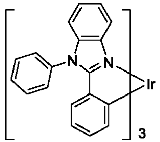 | Chem. Mater. 16, 2480 (2004) |
| | 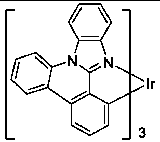 | US20070190359 |
| | 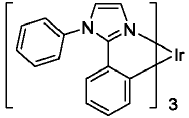 | US 20060008670 JP2007123392 |
| | 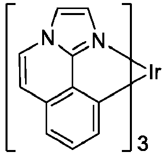 | WO2010086089, WO2011044988 |
| | 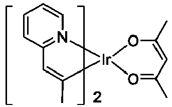 | Adv. Mater. 16, 2003 (2004) |
| | 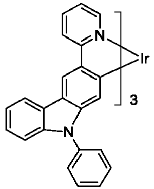 | Angew. Chem. Int. Ed. 2006, 45, 7800 |
| | 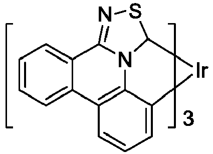 | WO2009050290 |
| | 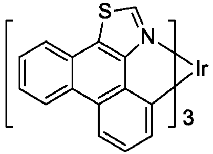 | US20090165846 |
| | 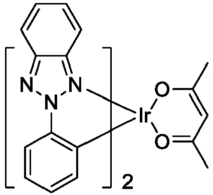 | US20080015355 |
| | 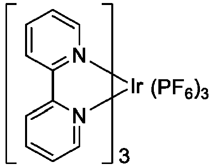 | US20010015432 |
| | 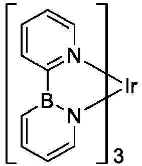 | US20100295032 |
| Monomer for polymeric metal organometallic compounds | 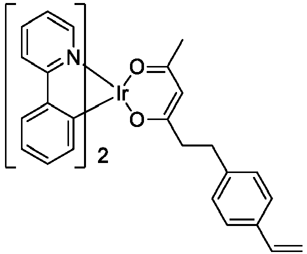 | US7250226, US7396598 |
| Pt(II) organometallic complexes, including polydentated ligands | 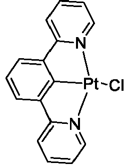 | Appl. Phys. Lett. 86, 153505 (2005) |
| | 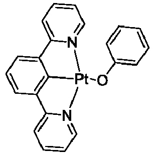 | Appl. Phys. Lett. 86, 153505 (2005) |
| | 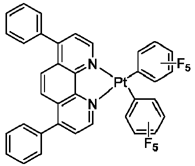 | Chem. Lett. 34, 592 (2005) |
| | 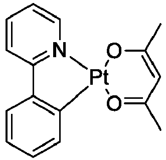 | WO2002015645 |
| | 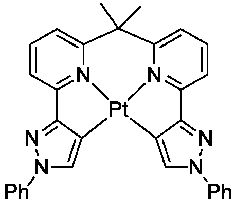 | US20060263635 |
| | 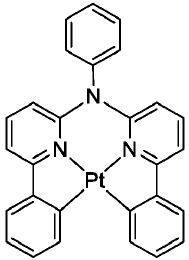 | US20060182992 US20070103060 |
| Cu complexes | 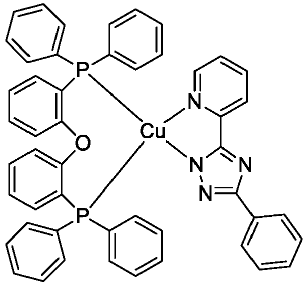 | WO2009000673 |
| | 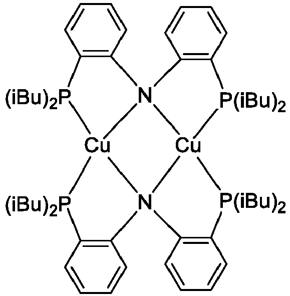 | US20070111026 |
| Gold complexes | 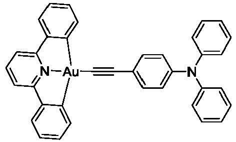 | Chem. Commun. 2906 (2005) |
| Rhenium(III) complexes | 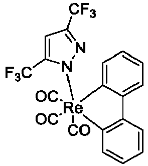 | Inorg. Chem. 42, 1248 (2003) |
| Osmium(II) complexes | 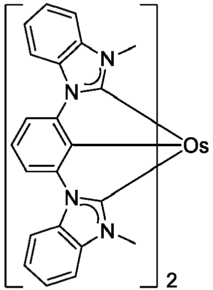 | US7279704 |
| Deuterated organometallic complexes | 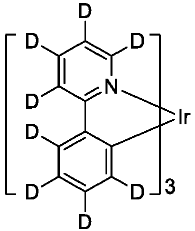 | US20030138657 |
| Organometallic complexes with two or more metal centers | 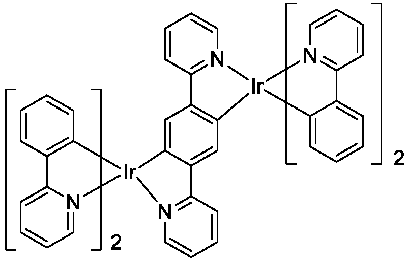 | US20030152802 |
| | 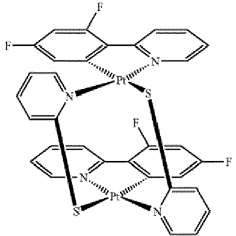 | US7090928 |

| Blue dopants | | |
|---|---|---|
| Iridium(III) organometallic complexes | 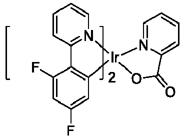 | WO2002002714 |
| | 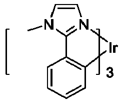 | WO2006009024 |
| | 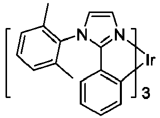 | US20060251923 |
| | | US20110057559 |
| | | US20110204333 |
| | 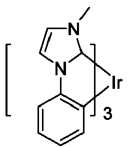 | US7393599, WO2006056418, US20050260441, WO2005019373 |
| | 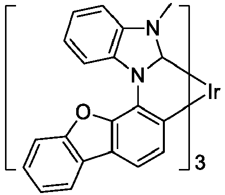 | US7534505 |
| | 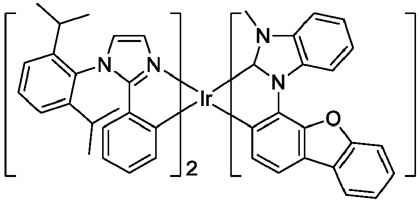 | WO2011051404 |
| | 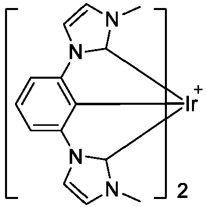 | US7445855 |
| | 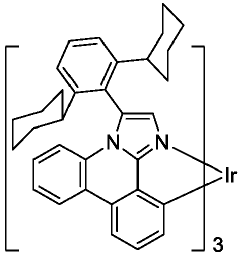 | US20070190359, US20080297033 |
| | | US20100148663 |
| | 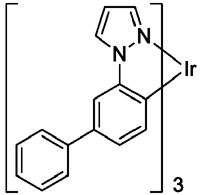 | US7338722 |
| | 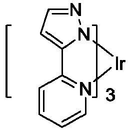 | US20020134984 |
| | 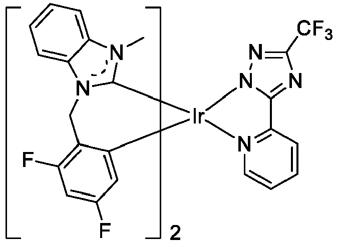 | Angew. Chem. Int. Ed. 47, 4542 (2008) |
| | 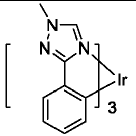 | Chem. Mater. 18, 5119 (2006) |
| | 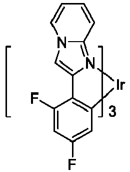 | Inorg. Chem. 46, 4308 (2007) |
| | 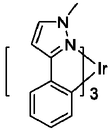 | WO2005123873 |
| | 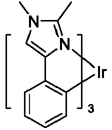 | WO2005123873 |
| | 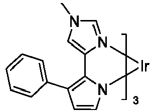 | WO2007004380 |
| | 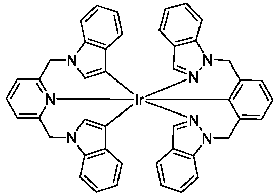 | WO2006082742 |
| Osmium(II) complexes | 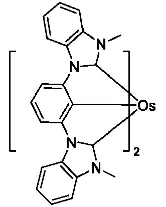 | US7279704 |
| | 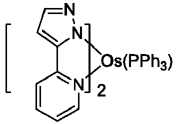 | Organometallics 23, 3745 (2004) |
| Gold complexes | 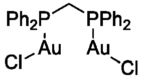 | Appl. Phys. Lett.74,1361 (1999) |
| Platinum(II) complexes | 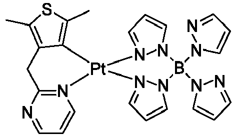 | WO2006098120, WO2006103874 |
| Pt tetradentate complexes with at least one metal-carbene bond | 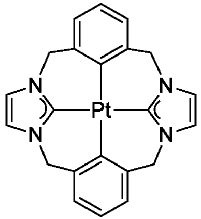 | US7655323 |

| **Exciton/hole blocking layer materials** | | |
|---|---|---|
| Bathocuprine compounds (e.g., BCP, BPhen) | 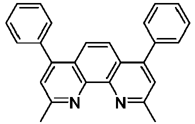 | Appl. Phys. Lett. 75, 4 (1999) |
| | 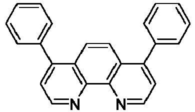 | Appl. Phys. Lett. 79, 449 (2001) |
| Metal 8-hydroxyquinolates (e.g., BAlq) | 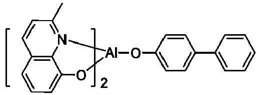 | Appl. Phys. Lett. 81, 162 (2002) |
| 5-member ring electron deficient heterocycles such as triazole, oxadiazole, imidazole, benzoimidazole | 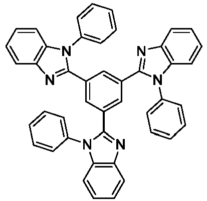 | Appl. Phys. Lett. 81, 162 (2002) |
| Triphenylene compounds | 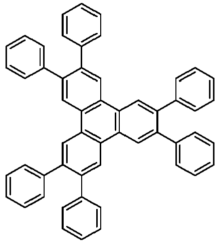 | US20050025993 |
| Fluorinated aromatic compounds | 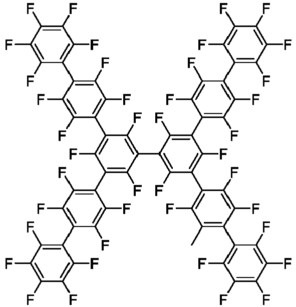 | Appl. Phys. Lett. 79, 156 (2001) |
| Phenothiazine-S-oxide | 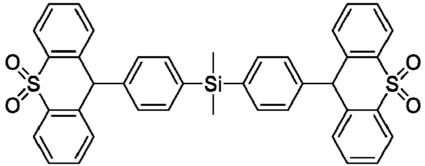 | WO2008132085 |
| Silylated five-membered nitrogen, oxygen, sulfur or phosphorus dibenzoheterocycles | 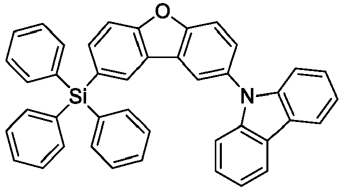 | WO2010079051 |
| Aza-carbazoles | 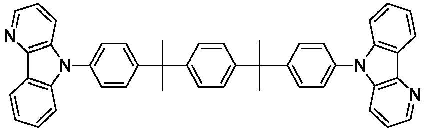 | US20060121308 |

| **Electron transporting materials** | | |
|---|---|---|
| Anthracene-benzoimidazole compounds | 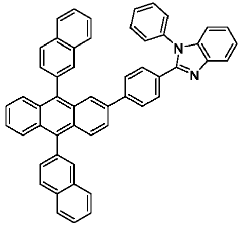 | WO2003060956 |
| | | US20090179554 |
| Aza triphenylene derivatives | 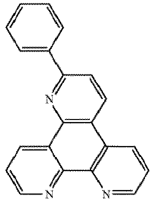 | US20090115316 |
| Anthracene-benzothiazole compounds | 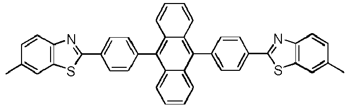 | Appl. Phys. Lett. 89, 063504 (2006) |
| Metal 8-hydroxyquinolates (e.g., Alq₃, Zrq₄) | 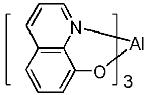 | Appl. Phys. Lett. 51, 913 (1987) US7230107 |
| Metal hydroxybenzoquinolates | 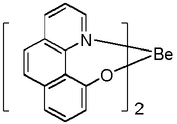 | Chem. Lett. 5, 905 (1993) |
| Bathocuprine compounds such as BCP, BPhen, etc | 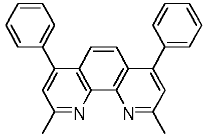 | Appl. Phys. Lett. 91, 263503 (2007) |
| | 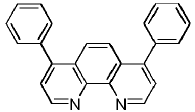 | Appl. Phys. Lett. 79, 449 (2001) |
| 5-member ring electron deficient heterocycles (e.g.,triazole, oxadiazole, imidazole, benzoimidazole) | 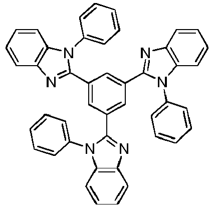 | Appl. Phys. Lett. 74, 865 (1999) |
| | 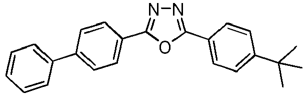 | Appl. Phys. Lett. 55, 1489 (1989) |
| | 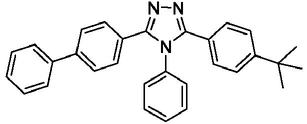 | Jpn. J. Apply. Phys. 32, L917 (1993) |
| Silole compounds | 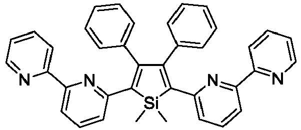 | Org. Electron. 4, 113 (2003) |
| Arylborane compounds | 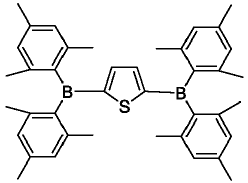 | J. Am. Chem. Soc. 120, 9714 (1998) |
| Fluorinated aromatic compounds | 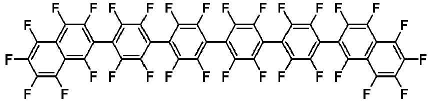 | J. Am. Chem. Soc. 122, 1832 (2000) |
| Fullerene (e.g., C60) | 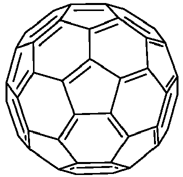 | US20090101870 |
| Triazine complexes | 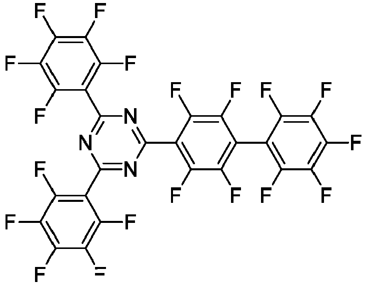 | US20040036077 |
| Zn (N^N) complexes | 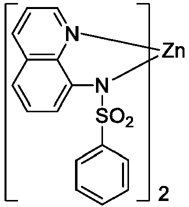 | US6528187 |

### EXPERIMENTAL

All reactions were carried out under nitrogen protections unless specified otherwise. All solvents for reactions are anhydrous and used as received from commercial sources.

### Synthesis of Compound 81

### Synthesis of 4-(3,5-dimethylphenyl)quinazoline

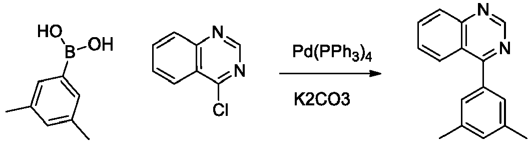

(3,5-Dimethylphenyl)boronic acid (5.75 g, 38.4 mmol), 4-chloroquinazoline (5.05 g, 30.7 mmol), and K₂CO₃ (8.48 g, 61.4 mmol) were dissolved in toluene (150 mL) and water (30 mL). The mixture was degassed by bubbling it with nitrogen for 30 minutes and adding tetrakis(triphenylphosphine)palladium (Pd(PPh₃)₄) (1.78 g, 1.53 mmol). The mixture was then held at 100°C overnight. Upon completion of the reaction, the mixture was cooled to room temperature, extracted with toluene, and washed with brine and water. The organic solution was filtered and evaporated. The crude product was purified by column chromatography using a gradient mixture of ethyl acetate (EA) (from 20 to 65%) in heptanes. The white powder product was recrystallized three times from heptanes to give colorless crystals (5.0 g, 70% yield).

### Synthesis of Ir(III) Dimer

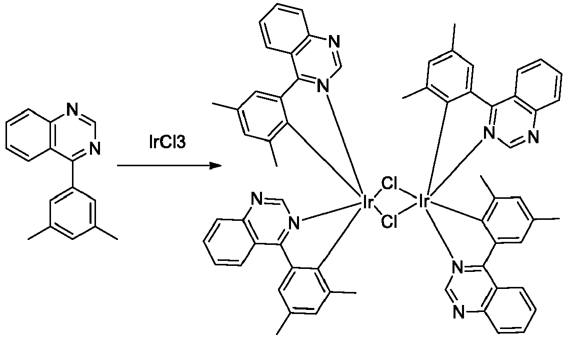

The 4-(3,5-Dimethylphenyl)quinazoline (2.50 g, 10.7 mmol) was solubilized in ethoxyethanol (30 mL) and water (10 mL) and degassed by bubbling with nitrogen for 30 minutes. Iridium chloride (1.32 g, 3.56 mmol) was then added to the mixture and the reaction was refluxed under nitrogen for 24 h. After cooling down to room temperature, the solid product was filtered, washed with methanol, and dried to give the Ir(III) dimer (2.40 g, 97 % yield).

### Synthesis of Compound 81

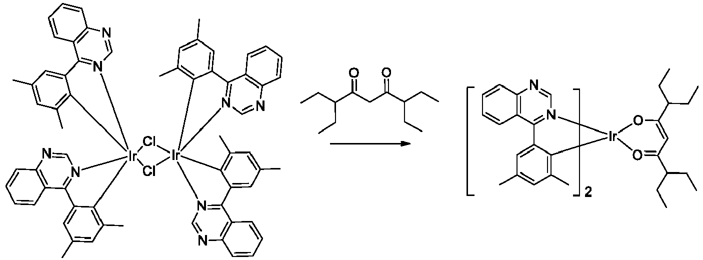

Ir(III) Dimer (2.00 g, 1.15 mmol) and 3,7-diethylnonane-4,6-dione (1.84 g, 8.64 mmol) were suspended in 2-ethoxyethanol (35 mL) and degassed by bubbling nitrogen. Potassium carbonate (1.19 g, 8.64 mmol) was then added, and the mixture was stirred at room temperature for 48 h. The solvent was evaporated under vacuum, methanol was added and the solid was filtered. The crude red solid was purified by column chromatography starting with 100% heptanes and slowly adding 15% of dichloromethane in heptanes. The solid obtained were recrystallized from dichloromethane and methanol. The target compound is obtained as a red solid (0.45 g, 22 % yield).

### Synthesis of Comparative Compound 1

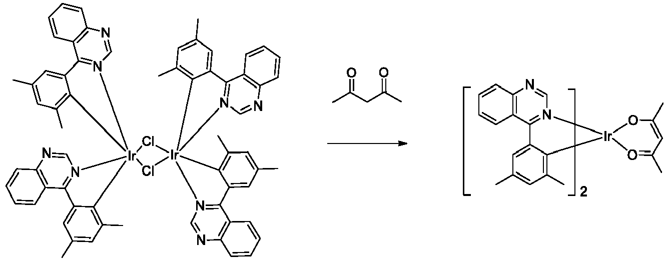

The Ir(III) Dimer (2.50 g, 1.44 mmol)(see above) and pentane-2,4-dione (1.48 g, 14.4 mmol) were diluted in 2-ethoxyethanol (48 mL) and degassed by bubbling nitrogen. Potassium carbonate (1.99 g, 14.4 mmol) was then added to the mixture, which was then stirred at room temperature for 24 h. The solvent was evaporated under vacuum. The crude oil was dissolved in DCM and filtered through a plug of triethylamine-treated silica. The solvent was then evaporated. Methanol (25 mL) was added to the solid and the product was recrystallized in a freezer. The target compound was obtained as a dark red solid (0.52 g, 22 % yield). Device Examples

All example devices were fabricated by high vacuum (<10⁻⁷ (Torr (wherein 1 Torr = 133,322 Pa)) thermal evaporation. The anode electrode was 1200 Å of indium tin oxide (ITO). The cathode consisted of 10 Å of LiF followed by 1,000 Å of Al. All devices are encapsulated with a glass lid sealed with an epoxy resin in a nitrogen glove box (<1 ppm of H₂O and O₂) immediately after fabrication, and a moisture getter was incorporated inside the package.

The organic stack of the device examples consisted of sequentially, from the ITO surface, 100 Å of LG101 (purchased from LG Chem) as a hole injection layer (HIL), 400 Å of 4,4'-bis[N-(1-naphthyl)-N-phenylamino]biphenyl (NPD) as a hole transporting layer (HTL), 400 Å of the inventive compound or comparative compound doped in BAlq as a host and compound H as a stability dopant (SD) with as an emissive layer (EML), 100Å of BAlq as a blocking layer (BL), and 450 Å of Alq₃ (tris-8-hydroxyquinoline aluminum) as an electron transport layer (ETL).

The device results and data are summarized in Tables 2 and 3 from those devices. As used herein, NPD, Alq₃, BAlq, SD have the following structures:

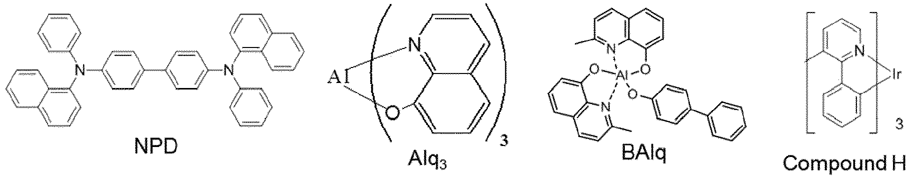

**Table 2 Device structures of inventive compounds**

| | **HIL** | **HTL** | **EML (400 Å, doping %)** | | | **BL** | **ETL** |
|---|---|---|---|---|---|---|---|
| Device Example | LG101 100Å | NPD 400Å | BAlq | Compound **H** 9% | Compound **81** 3% | BAlq 100Å | Alq 450Å |
| Comparative Example | LG101 100Å | NPD 400Å | BAlq | Compound **H** 9% | Comparative compound **1** 3% | BAlq 100Å | Alq 450Å |

**Table 3 VTE device results**

| | **1931 CIE** | | | | **At 1,000 nits** | | |
|---|---|---|---|---|---|---|---|
| | **CIE x** | **CIE y** | **λ max [nm]** | **FWHM [nm]** | **Voltage [%]** | **LE [%]** | **EQE [%]** |
| **Device Example** | 0.71 | 0.29 | 668 | 62 | 99 | 129 | 119 |
| **Comparative Example** | 0.71 | 0.29 | 672 | 72 | 100 | 100 | 100 |

Table 3 summarizes the performance of the devices. The driving voltage (V), luminous efficiency (LE), and external quantum efficiency (EQE) were measured at 1000 nits. The EL spectra were measured at 10 mA/cm². Both device example and comparative example devices showed very deep red color with a CIE of (0.71, 0.29). Example device and comparative example one has 668nm and 672nm of peak wavelength, respectively and the example device has 10 nm narrower full width at half maximum (FWHM) than the comparative example. Example device has 29% higher LE and 19% higher EQE than comparative example.

## Claims

1. An organic light emitting device comprising:
an anode;
a cathode; and
at least one organic layer, disposed between the anode and the cathode, the organic layer comprising a host and a dopant, the dopant comprising a compound having a formula M(L_{A})ₓ(L_{B})_{y}(L_{C})_{z}:
wherein the ligand L_{A} is 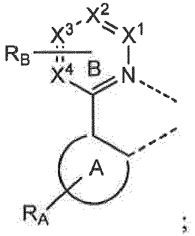
wherein the ligand L_{B} is 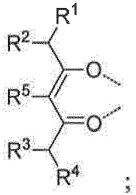
wherein the ligand Lc is 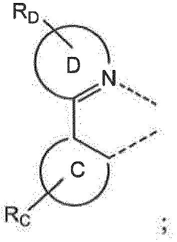
wherein M is a metal having an atomic number greater than 40;
wherein x is 1, or 2;
wherein y is 1, or 2;
wherein z is 0, 1, or 2;
wherein x+y+z is the oxidation state of the metal M;
wherein X¹, X², X³, and X⁴ are C or N;
wherein R¹, R², R³, and R⁴ are independently selected from group consisting of alkyl, cycloalkyl, aryl, and heteroaryl;
wherein at least one of R¹, R², R³, and R⁴ has at least two C atoms;
wherein R⁵ is selected from group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof;
wherein rings A, C, and D are each independently a 5 or 6-membered carbocyclic or heterocyclic ring;
wherein R_{A}, R_{C}, and R_{D} each independently represent mono, di, tri, or tetra-substitution, or no substitution;
wherein R_{B} represents di, tri, or tetra-substitution;
wherein two adjacent R_{B} form a six-member carbocyclic or heterocyclic ring E fused to ring B; wherein, when ring E is heterocyclic, the only heteroatom is nitrogen; and wherein ring E can be further substituted;
wherein
(a) at least one of X¹, X², X³, and X⁴ is N,
(b) ring E is heterocylic, or
(c) both;
wherein each of R_{A}, R_{B}, R_{C}, and R_{D} are independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein any adjacent substitutents of R_{A}, R_{B}, R_{C}, and R_{D} are optionally joined to form a fused ring.

2. The device of claim 1, wherein the organic layer is an emissive layer and the compound is an emissive dopant.

3. The device of claim 1, wherein the compound is a non-emissive dopant.

4. The device of any one of Claims 1 to 3, wherein M is selected from the group consisting of Ir, Rh, Re, Ru, Os, Pt, Au, and Cu, preferably
wherein M is Ir.

5. The device of Claim 1, wherein ring A is benzene, and/or wherein ring C is benzene, and ring D is pyridine.

6. The device of Claim 1, wherein R⁵ is selected from group consisting of hydrogen, deuterium, alkyl, cycloalkyl, and combinations thereof, preferably wherein R⁵ is hydrogen.

7. The device of Claim 1, wherein R¹, R², R³, and R⁴ are alkyl or cycloalkyl, preferably
wherein R¹, R², R³, and R⁴ are independently selected from the group consisting of methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, cyclobutyl, cyclopentyl, cyclohexyl, partially or fully deuterated variants thereof, and combinations thereof.

8. The device of claim 1, wherein the compound is selected from the group consisting of: 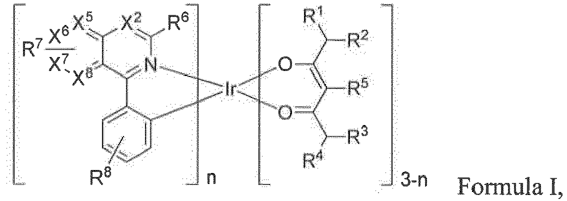 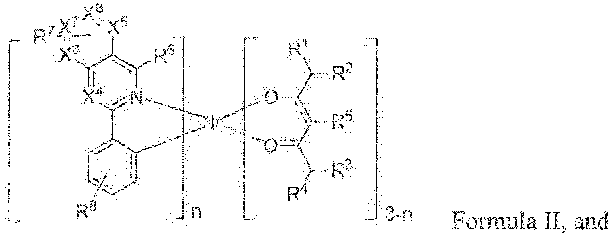 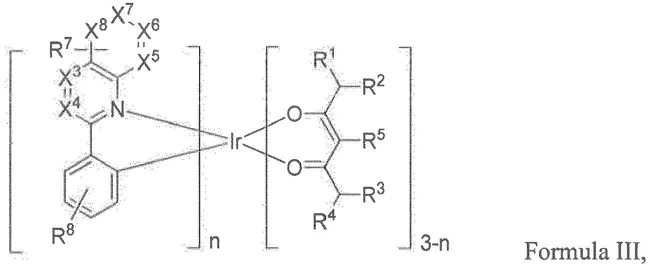
wherein X⁵, X⁶, X⁷, and X⁸ are C or N;
wherein R⁷, and R⁸ each independently represent mono, di, tri, or tetra-substitution, or no substitution;
wherein R⁶, R⁷, and R⁸ are independently selected from group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein n is 1 or 2, preferably wherein n is 2.

9. The device of Claim 8, wherein R⁶, and R⁷ are independently selected from the group consisting of hydrogen, deuterium, alkyl, cycloalkyl, and combinations thereof.

10. The device of Claim 8, wherein R⁸ is selected from group consisting of hydrogen, deuterium, alkyl, cycloalkyl, halide, and combinations thereof.

11. The device of claim 1, wherein the compound is selected from the group consisting of: 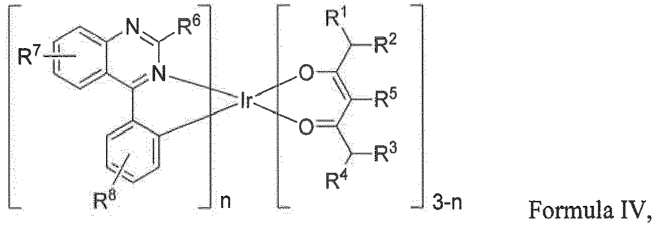 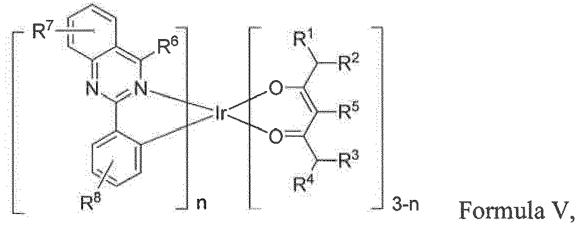 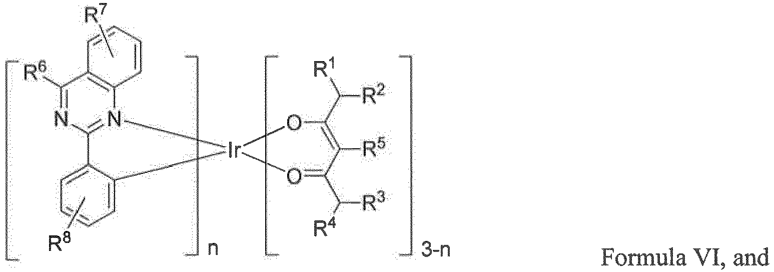 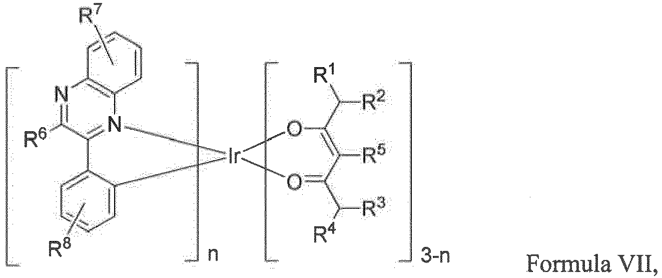
wherein R⁷, and R⁸ each independently represent mono, di, tri, or tetra-substitution, or no substitution;
wherein R⁶, R⁷, and R⁸ are independently selected from group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof; and
wherein n is 1 or 2.

12. The device of Claim 1, wherein L_{A} is selected from the group consisting of L_{A1} to L_{A270} listed below:

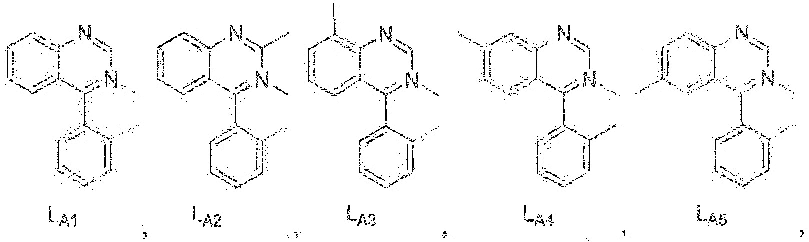

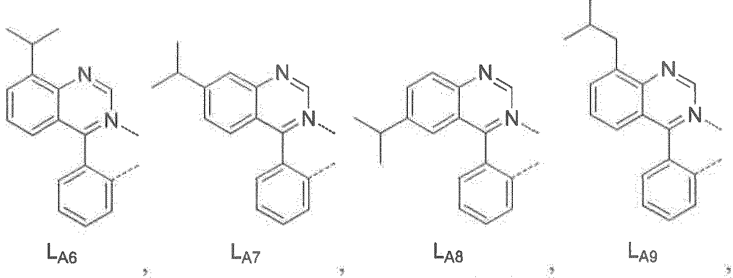

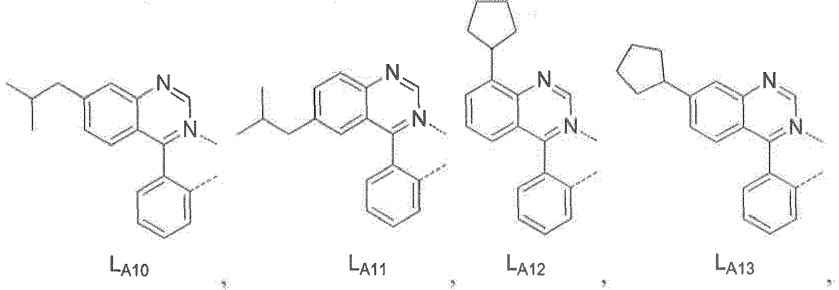

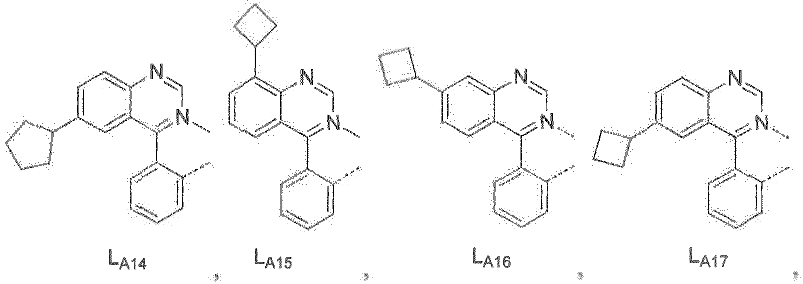

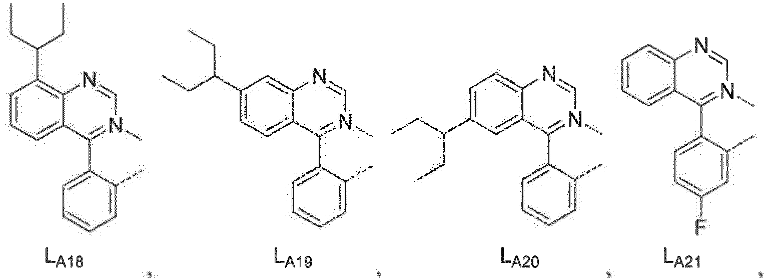

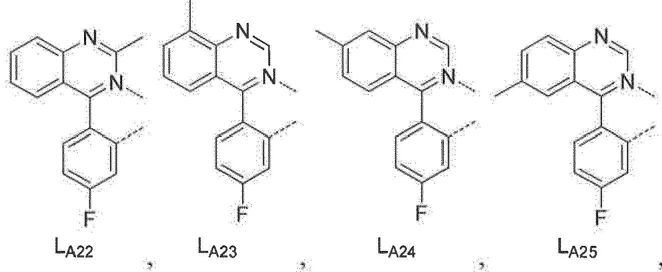

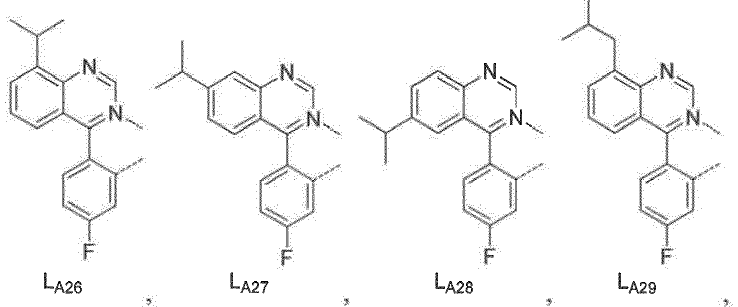

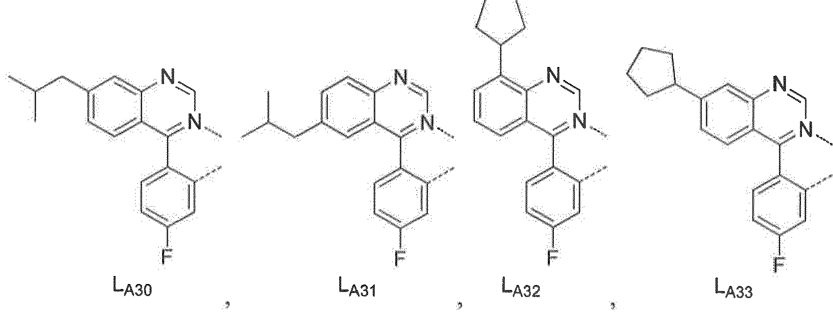

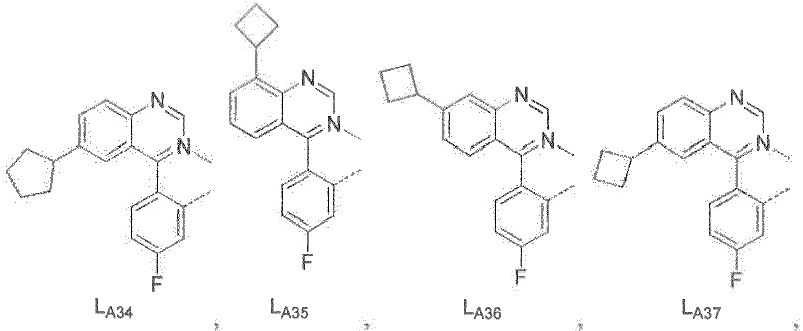

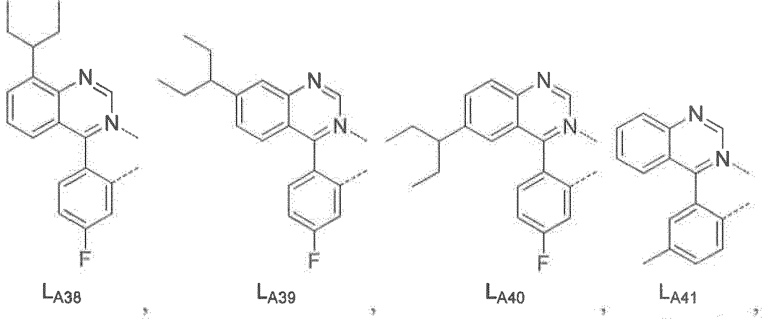

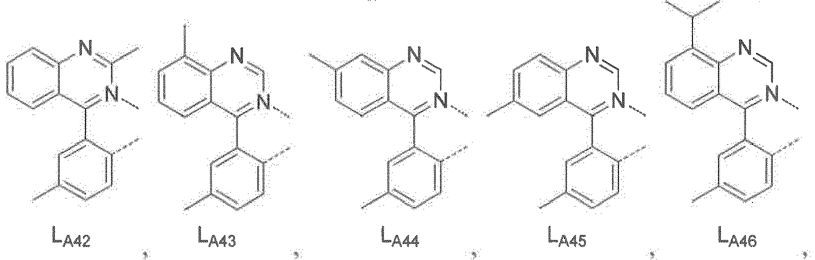

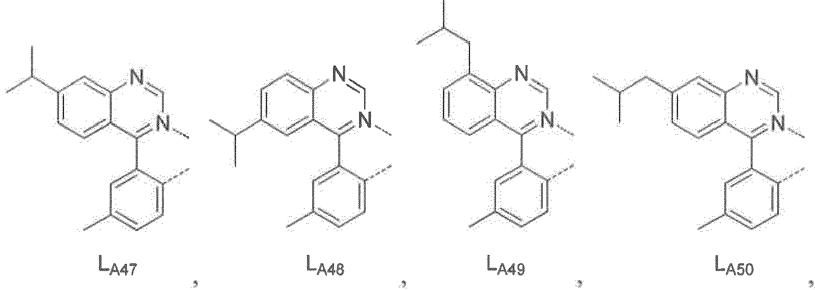

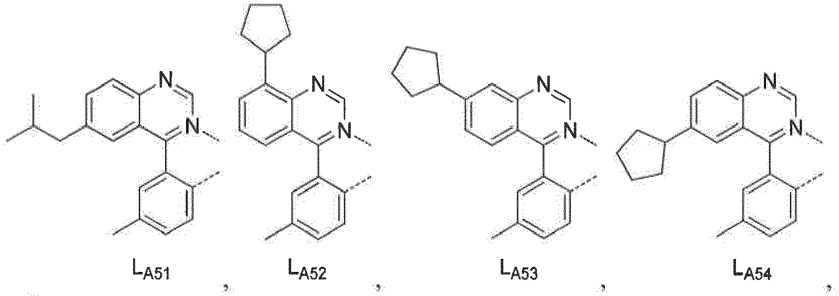

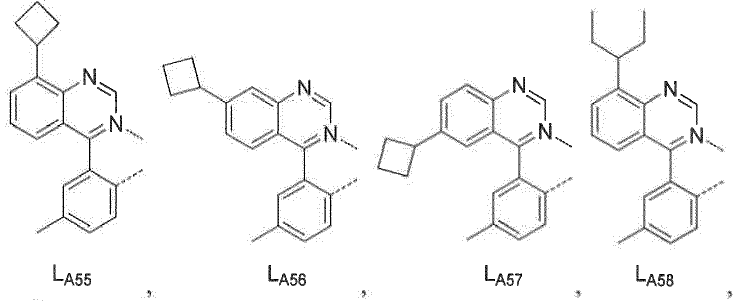

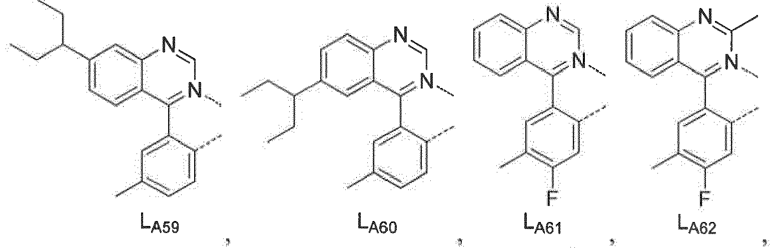

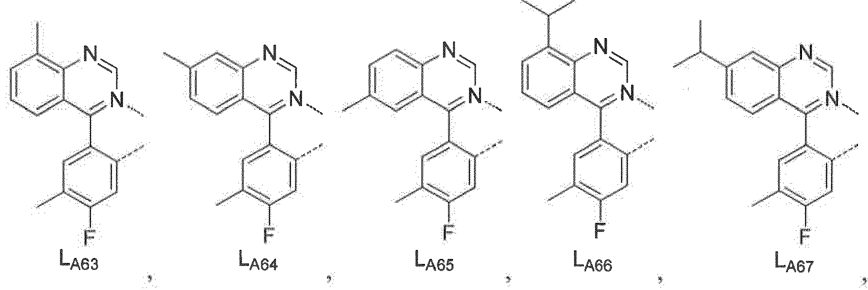

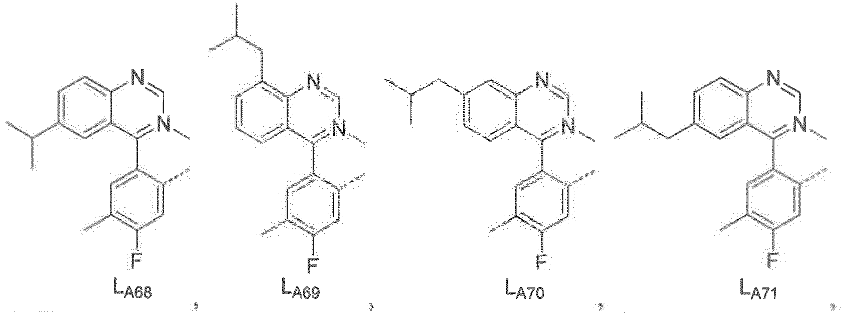

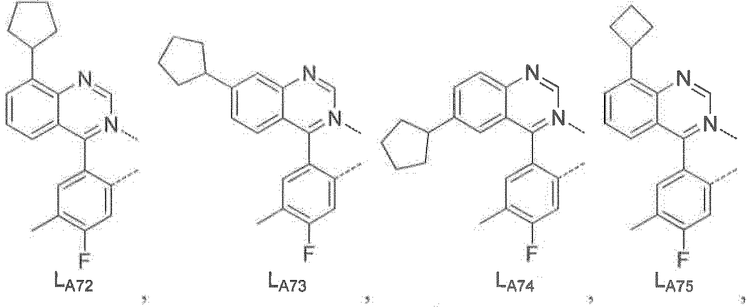

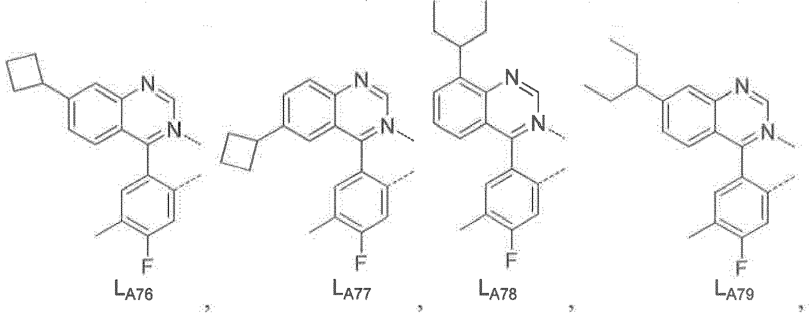

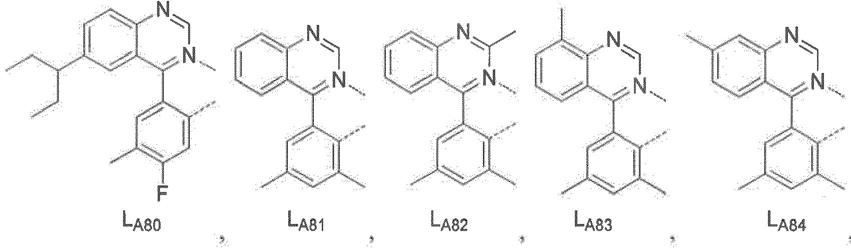

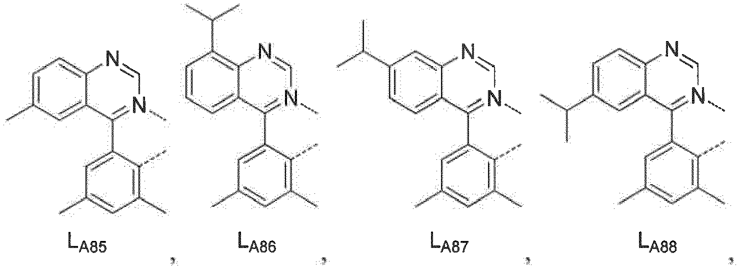

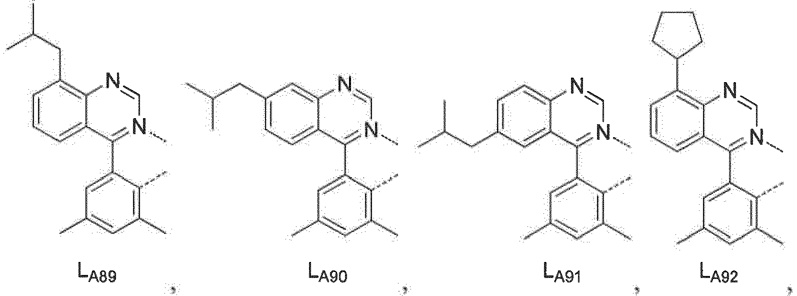

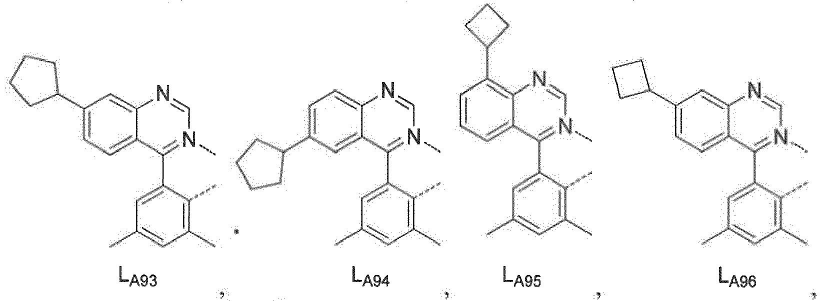

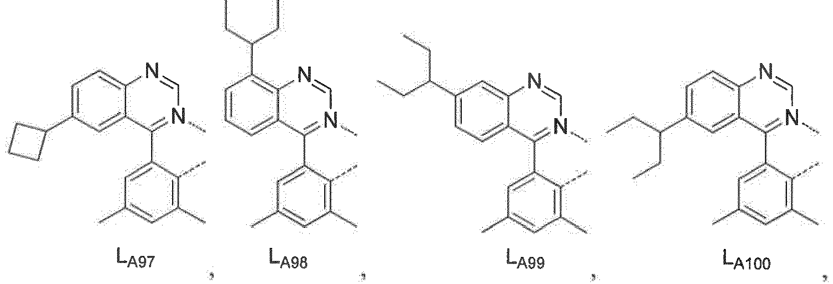

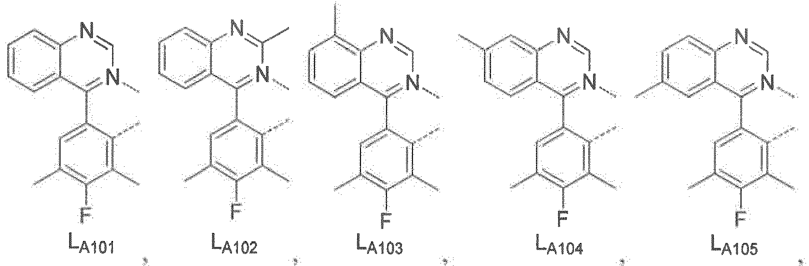

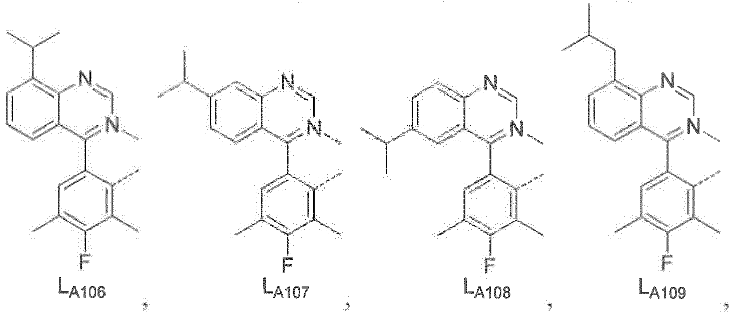

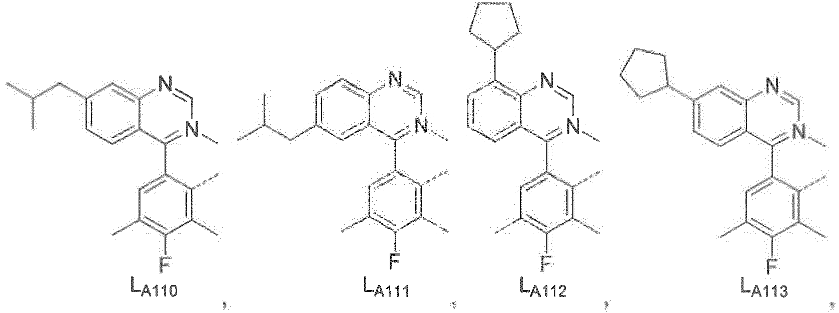

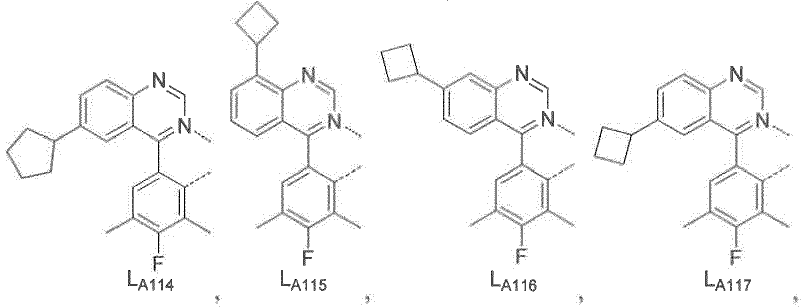

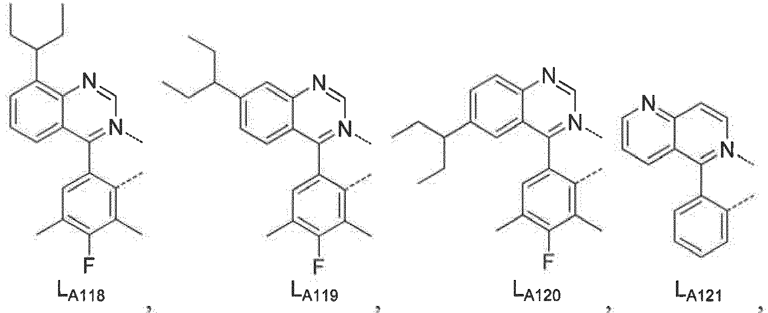

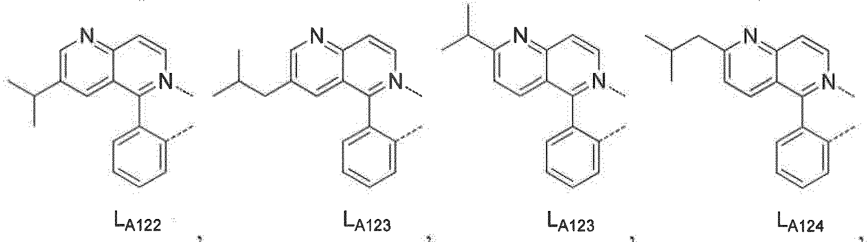

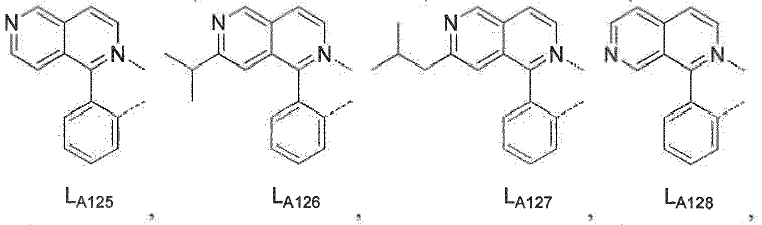

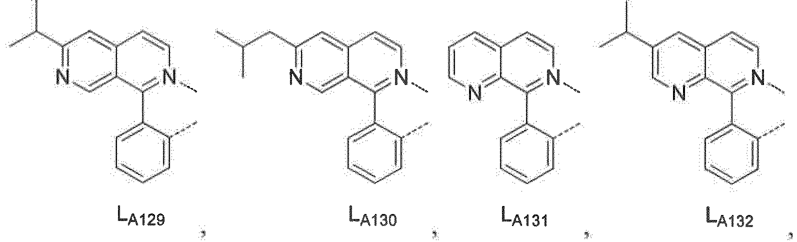

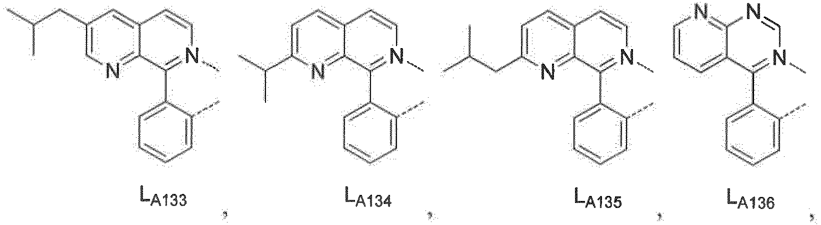

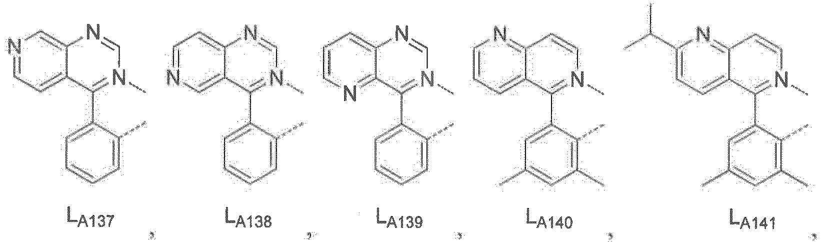

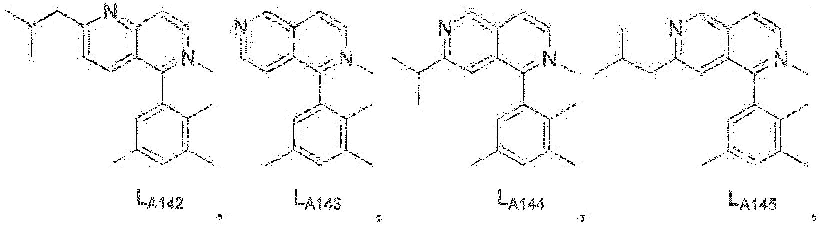

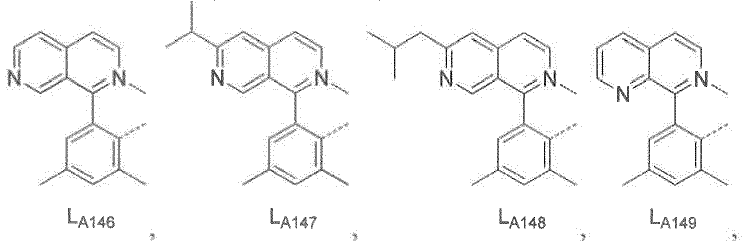

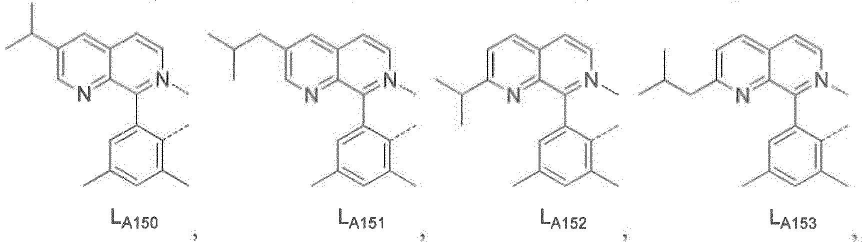

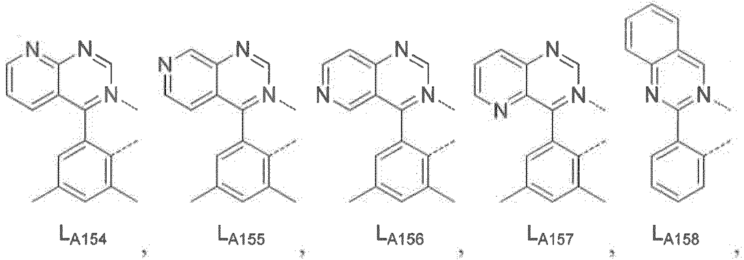

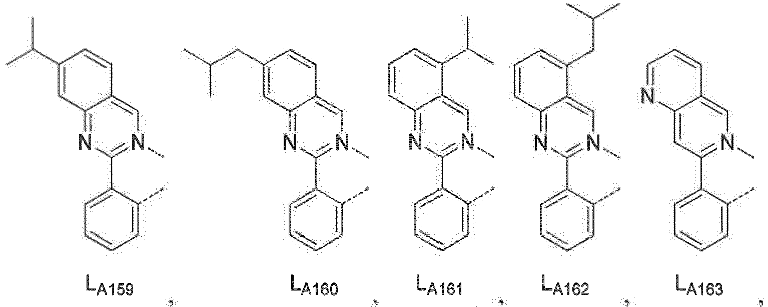

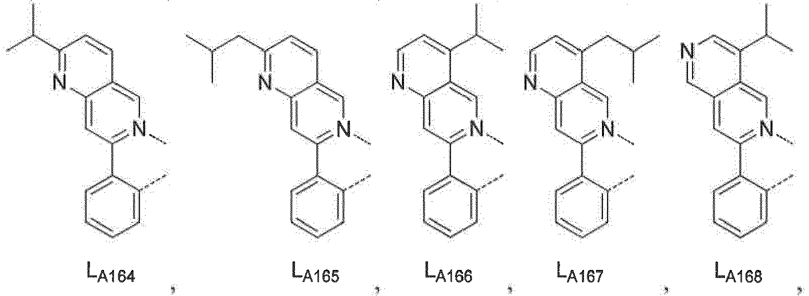

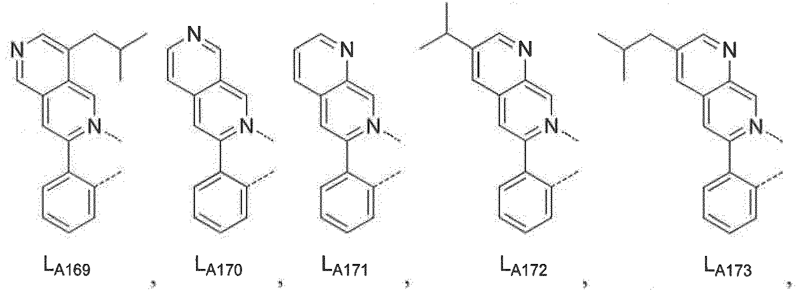

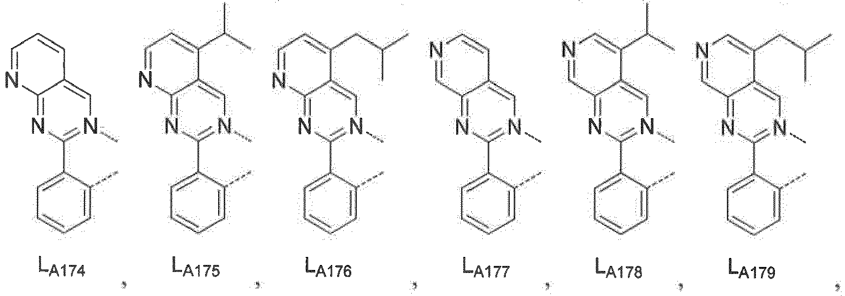

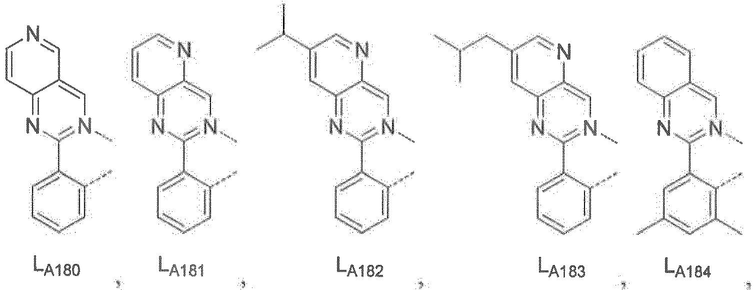

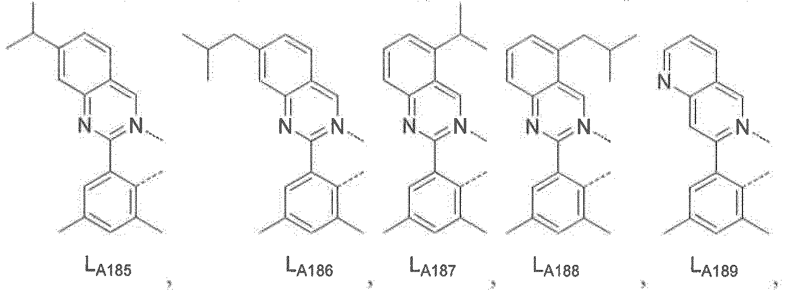

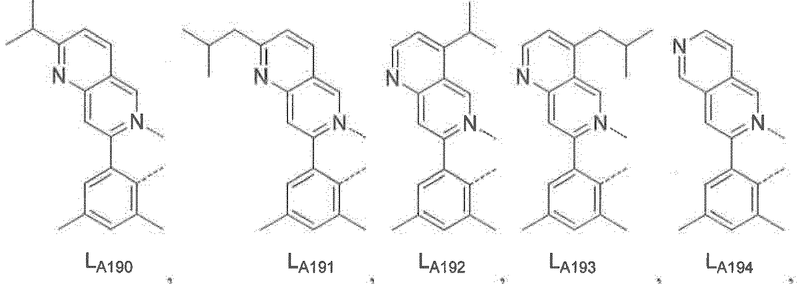

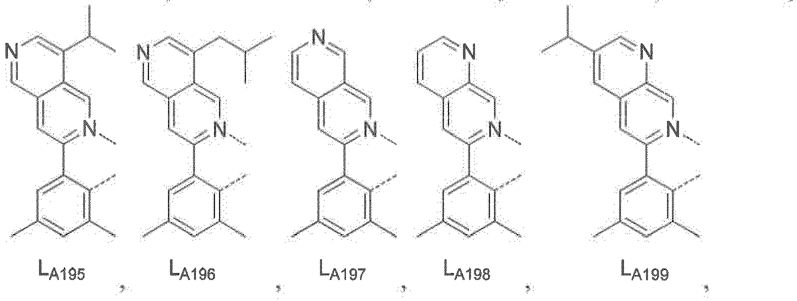

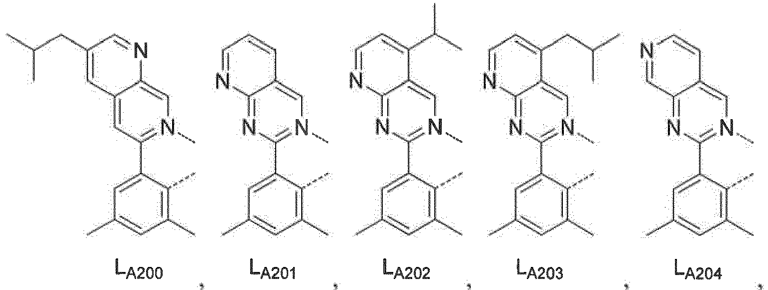

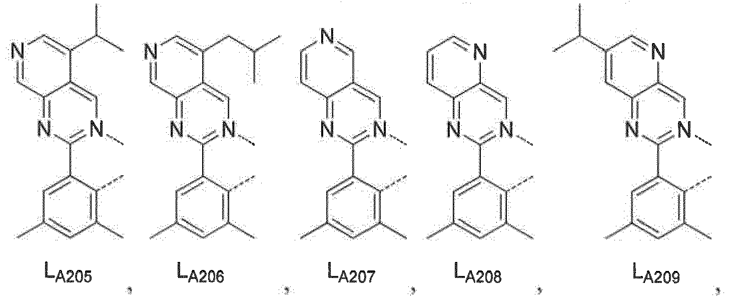

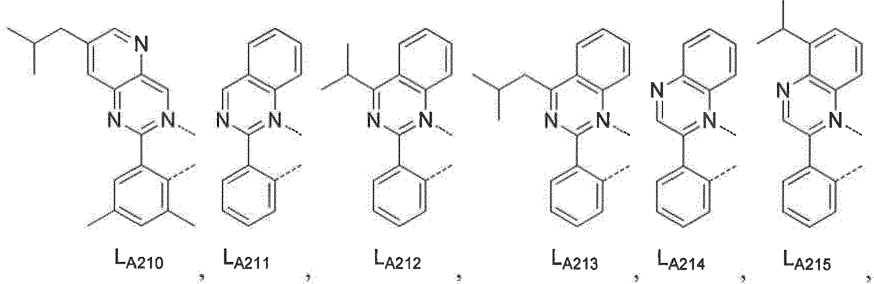

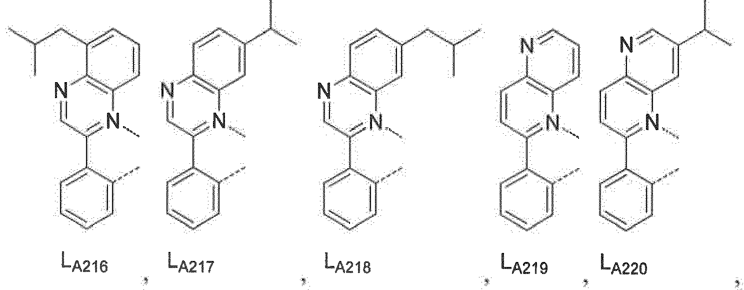

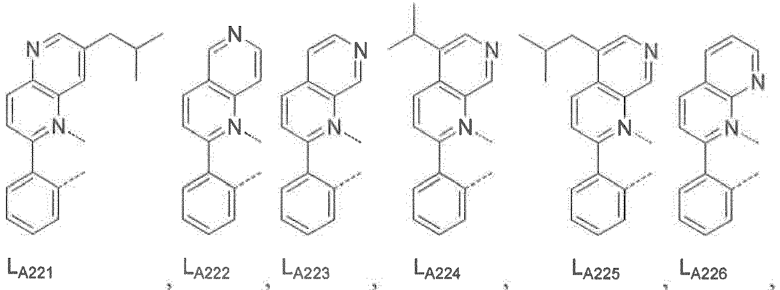

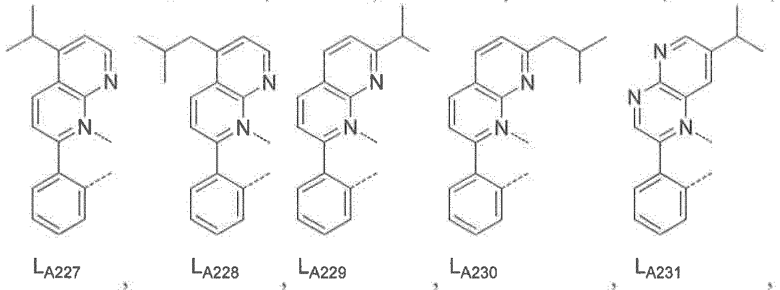

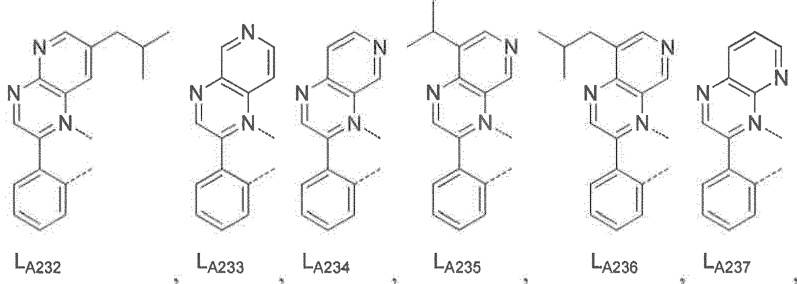

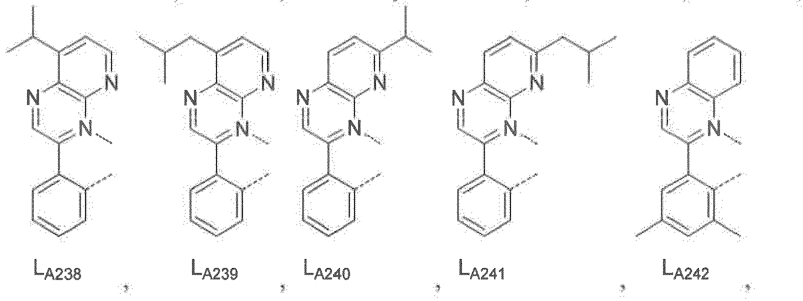

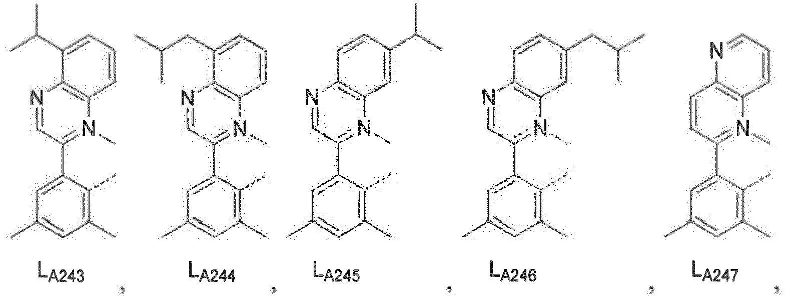

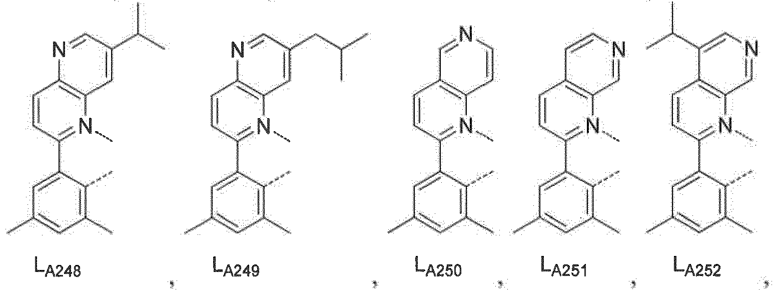

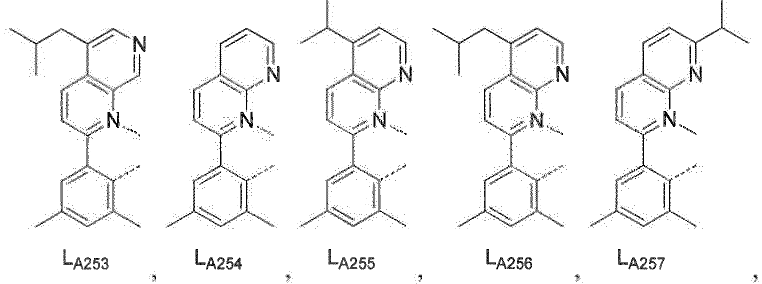

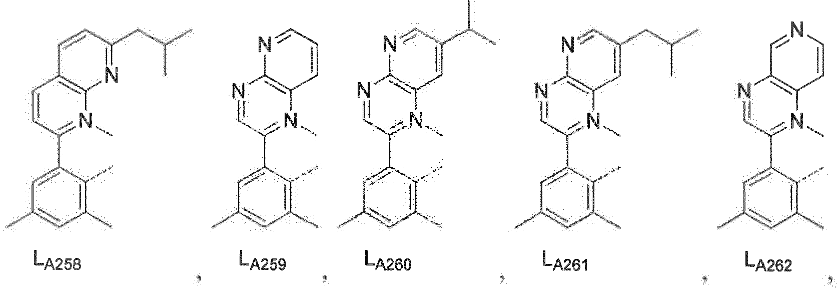

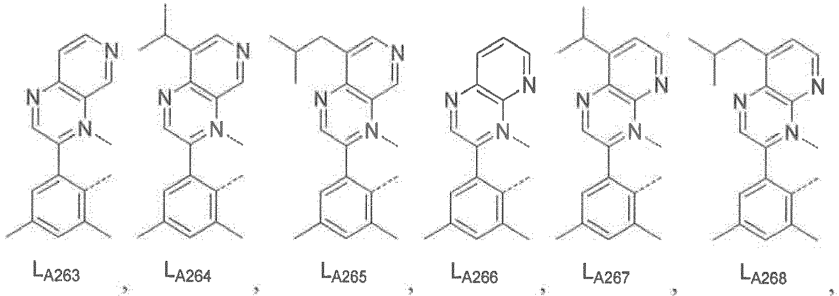

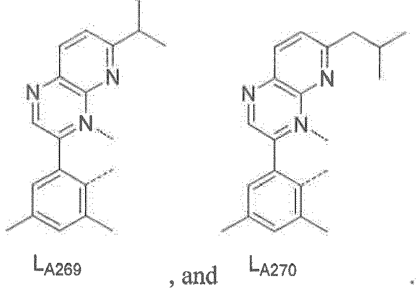

13. The device of Claim 12, wherein x=1 or 2, y=1 or 2, and z=0, and wherein L_{B} is selected from the group consisting of L_{B1}-L_{B13} listed below: 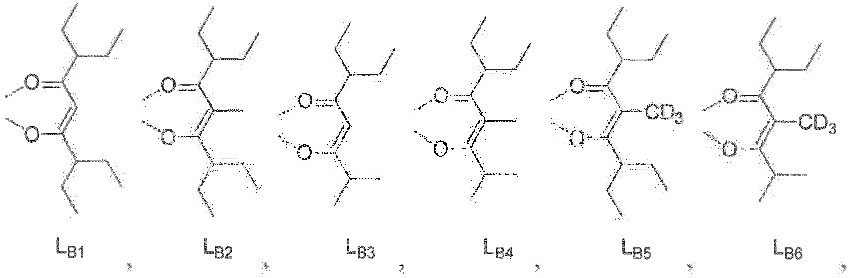 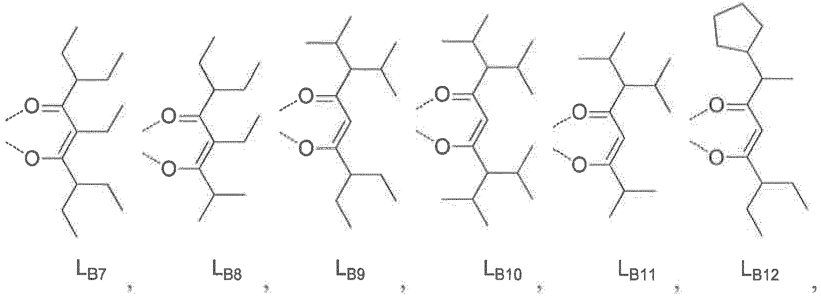 and

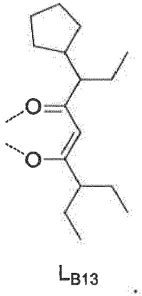

14. The device of claim 1, wherein L_{B} is selected from the group consisting of L_{B1}-L_{B13} listed below: 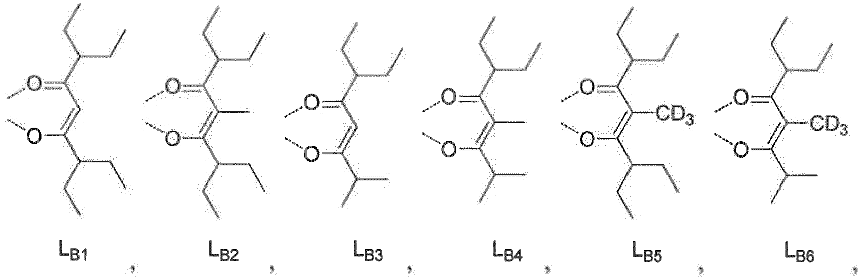 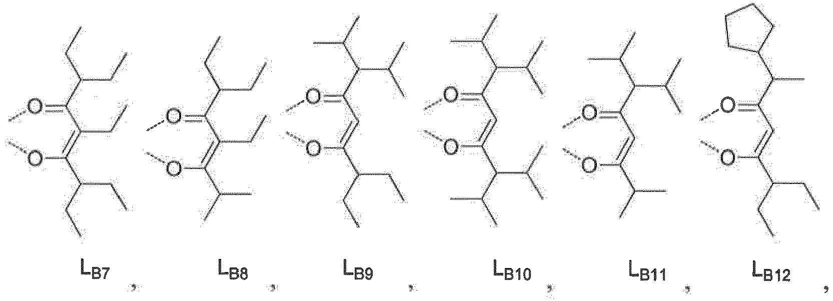 and

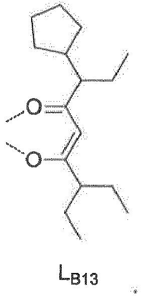

15. The device of Claim 1, wherein the compound is selected from the group consisting of: 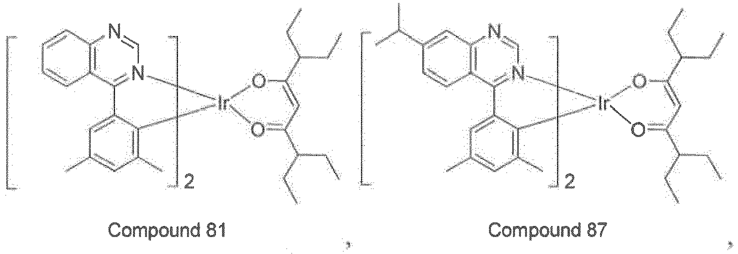 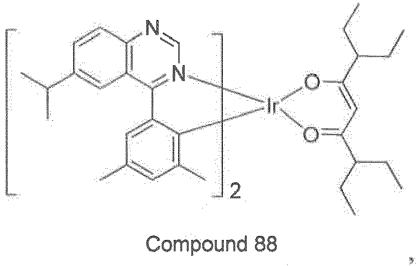 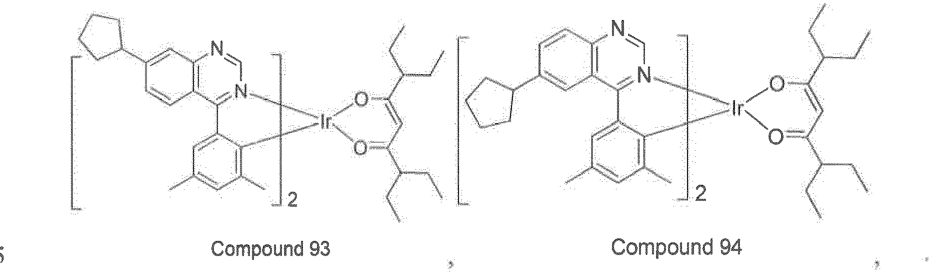 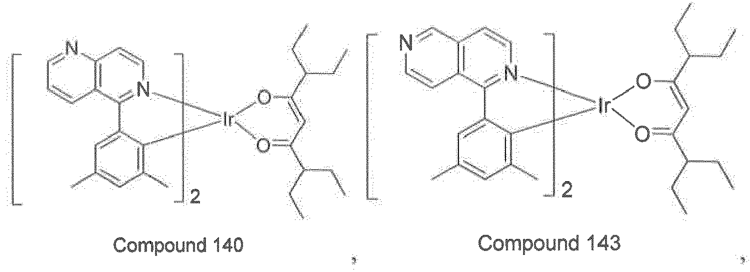 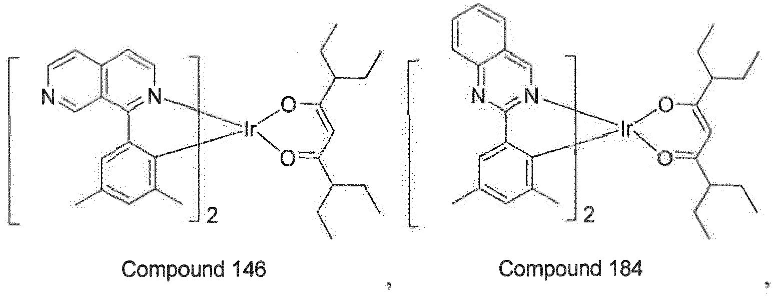 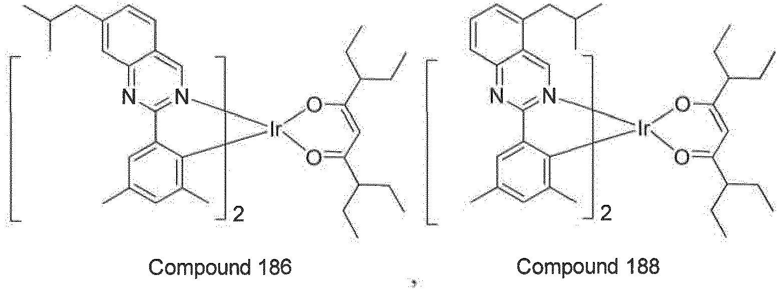 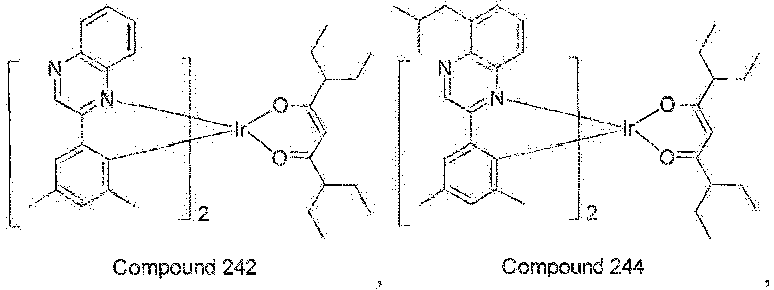 and

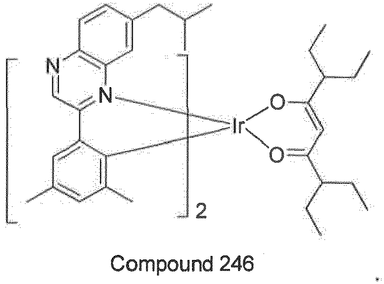

16. The device of any one of the previous claims, wherein the host is selected from the group consisting of a metal complex, a triphenylene containing benzo-fused thiophene or benzo-fused furan, wherein any substituent in the host can be an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡C-CₙH₂ₙ₊₁, Ar₁, Ar₁-Ar₂, CₙH₂ₙ-Ar₁, or no substitution, with n = 1 to 10; and Ar₁ and Ar₂ can be independently selected from the group consisting of benzene, biphenyl, naphthalene, triphenylene, carbazole, and heteroaromatic analogs thereof.

17. The device of any one of claims 1 to 15, wherein the host is selected from the group consisting of carbazole, dibenzothiphene, dibenzofuran, dibenzoselenophene, azacarbazole, aza-dibenzothiophene, aza-dibenzofuran, and aza-dibenzoselenophene.

18. The device of claim 17, wherein the host is selected from the group consisting of: 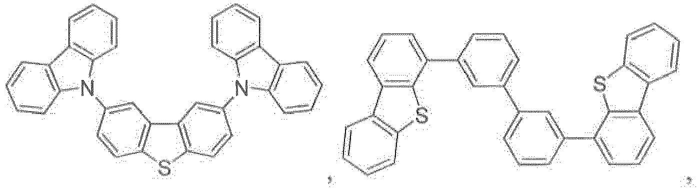 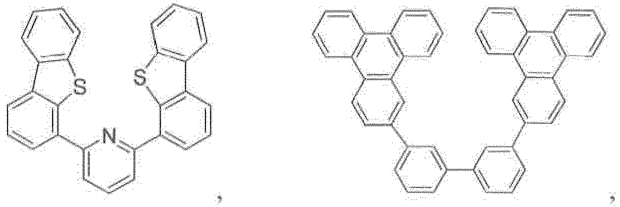 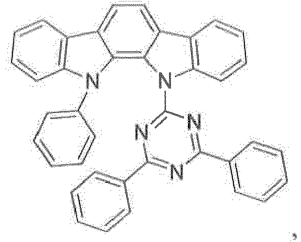 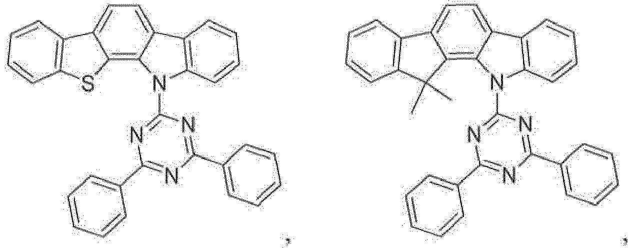 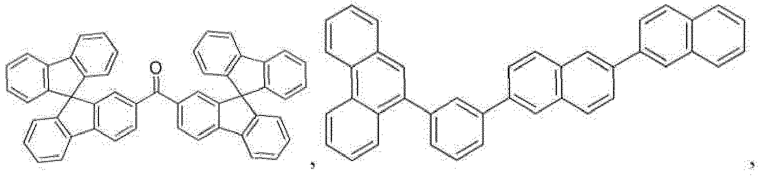 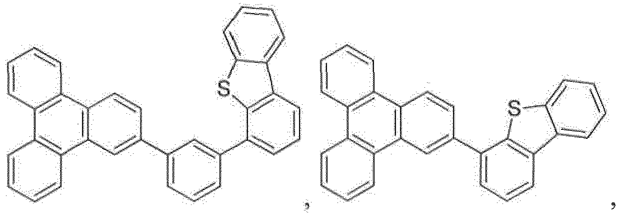 and combinations thereof.

19. A consumer product including the device of any one of claims 1 to 18.

20. The consumer product of claim 19, being selected from one of flat panel displays, fully transparent displays, and flexible displays.

21. The consumer product of claim 19, being selected from one of computer monitors, medical monitors, televisions, laser printers, heads up displays, laptop computers and flat panel displays.

22. The consumer product of claim 19, being selected from one of telephones, cell phones, personal digital assistants (PDAs), digital cameras, camcorders, viewfinders, micro-displays, and 3-D displays.

23. The consumer product of claim 19, being selected from one of billboards, a large area wall, theater or stadium screen, and a sign.

24. The consumer product of claim 19, being selected from one of lights for interior or exterior illumination.

25. The consumer product of claim 19, being selected from one of a signaling device and vehicles.

26. The consumer product of claim 19, being selected from one of optoelectronic devices such as organic solar cells and organic photodetectors.

27. The use of a compound as defined in claim 1 in an organic light emitting device.

## Patentansprüche

1. Eine organische lichtemittierende Vorrichtung umfassend:
eine Anode;
eine Kathode; und
mindestens eine organische Schicht, angeordnet zwischen der Anode und der Kathode, die organische Schicht umfassend einen Wirt und einen Dotierstoff, der Dotierstoff umfassend eine Verbindung mit der Formel M(L_{A})ₓ(L_{B})_{y}(L_{C})_{z}:
wobei der Ligand L_{A} 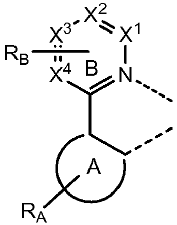 ist;
wobei der Ligand L_{B} 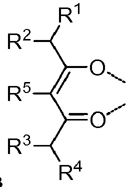 ist;
wobei der Ligand L_{C} 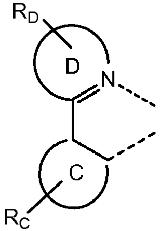 ist;
wobei M ein Metall mit einer Atomzahl von mehr als 40 ist;
wobei x für 1 oder 2 steht;
wobei y für 1 oder 2 steht;
wobei z für 0, 1 oder 2 steht,
wobei x+y+z die Oxidationsstufe des Metalls M ist;
wobei X¹, X², X³ und X⁴ C oder N sind;
wobei R¹, R², R³ und R⁴ unabhängig ausgewählt sind aus der Gruppe bestehend aus Alkyl, Cycloalkyl, Aryl und Heteroaryl;
wobei mindestens einer von R¹, R², R³ und R⁴ mindestens zwei C-Atome aufweist;
wobei R⁵ ausgewählt ist aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkinyl, Aryl, Heteroaryl, Acyl, Carbonyl, Karbonsäuren, Ester, Nitril, Isonitril, Sulfanyl, Sulfinyl, Sulfonyl, Phosphino und deren Kombinationen;
wobei die Ringe A, C und D jeweils unabhängig für einen 5- oder 6-gliedrigen carbozyklischen oder heterozyklischen Ring stehen;
wobei R_{A}, R_{C} und R_{D} jeweils unabhängig stehen für Mono-, Di-, Tri- oder Tetrasubstitution oder keine Substitution;
wobei R_{B} für Di-, Tri- oder Tetrasubstitution steht;
wobei zwei benachbarte R_{B} einen sechsgliedrigen carbozyklischen oder heterozyklischen Ring E fusioniert an Ring B bilden; wobei, wenn der Ring E heterozyklisch ist, das einzige Heteroatom Stickstoff ist; und wobei der Ring E weiter substituiert sein kann;
wobei
(a) mindestens eines von X¹, X², X³ und X⁴ N ist,
(b) Ring E ist heterozyklisch, oder
(c) beides;
wobei jeder von R_{A}, R_{B}, R_{C} und R_{D} unabhängig ausgewählt ist aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkinyl, Aryl, Heteroaryl, Acyl, Carbonyl, Karbonsäuren, Ester, Nitril, Isonitril, Sulfanyl, Sulfinyl, Sulfonyl, Phosphino und deren Kombinationen; und
wobei beliebige benachbarte Substituenten aus R_{A}, R_{B}, R_{C} und R_{D} gegebenenfalls miteinander verknüpft sind, um einen anellierten Ring zu bilden.

2. Die Vorrichtung nach Anspruch 1, wobei die organische Schicht eine emittierende Schicht ist, und die Verbindung ein emittierender Dotierstoff ist.

3. Die Vorrichtung nach Anspruch 1, wobei die Verbindung ein nichtemittierender Dotierstoff ist.

4. Die Vorrichtung nach einem der Ansprüche 1 bis 3, wobei M ausgewählt ist aus der Gruppe bestehend aus Ir, Rh, Re, Ru, Os, Pt, Au und Cu, vorzugsweise
wobei M gleich Ir ist.

5. Die Vorrichtung nach Anspruch 1, wobei der Ring A Benzol ist, und/oder wobei der Ring C Benzol ist, und der Ring D Pyridin ist.

6. Die Vorrichtung nach Anspruch 1, wobei R⁵ ausgewählt ist aus der Gruppe bestehend aus Wasserstoff, Deuterium, Alkyl, Cycloalkyl und Kombinationen davon, vorzugsweise wobei R⁵ Wasserstoff ist.

7. Die Vorrichtung nach Anspruch 1, wobei R¹, R², R³ und R⁴ Alkyl oder Cycloalkyl sind, vorzugsweise
wobei R¹, R², R³ und R⁴ unabhängig ausgewählt sind aus der Gruppe bestehend aus Methyl, Ethyl, Propyl, 1-Methylethyl, Butyl, 1-Methylpropyl, 2-Methylpropyl, Pentyl, 1-Methylbutyl, 2-Methylbutyl, 3-Methylbutyl, 1,1-Dimethylpropyl, 1,2-Dimethylpropyl, 2,2-Dimethylpropyl, Cyclobutyl, Cyclopentyl, Cyclohexyl, teilweise oder vollständig deuterierte Varianten davon, und Kombinationen davon.

8. Die Vorrichtung nach Anspruch 1, wobei die Verbindung ausgewählt ist aus der Gruppe bestehend aus: 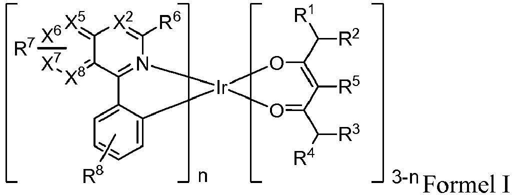 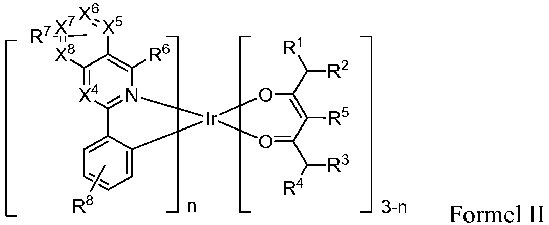 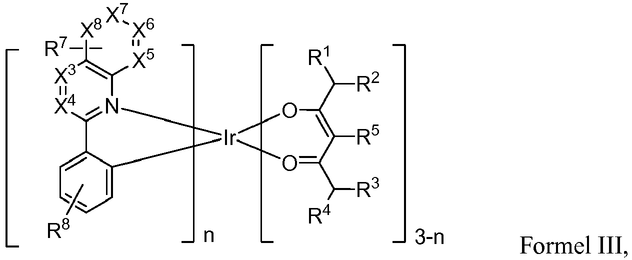
wobei X⁵, X⁶, X⁷ und X⁸ C oder N sind;
wobei R⁷ und R⁸ jeweils unabhängig für Mono-, Di-, Tri- oder Tetrasubstitution oder keine Substitution stehen;
wobei R⁶, R⁷ und R⁸ unabhängig ausgewählt sind aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkinyl, Aryl, Heteroaryl, Acyl, Carbonyl, Karbonsäuren, Ester, Nitril, Isonitril, Sulfanyl, Sulfinyl, Sulfonyl, Phosphino und deren Kombinationen; und
wobei n für 1 oder 2 steht, vorzugsweise wobei n 2 ist.

9. Die Vorrichtung nach Anspruch 8, wobei R⁶ und R⁷ unabhängig ausgewählt sind aus der Gruppe bestehend aus Wasserstoff, Deuterium, Alkyl, Cycloalkyl und deren Kombinationen.

10. Die Vorrichtung nach Anspruch 8, wobei R⁸ ausgewählt ist aus der Gruppe bestehend aus Wasserstoff, Deuterium, Alkyl, Cycloalkyl, Halogen und deren Kombinationen.

11. Die Vorrichtung nach Anspruch 1, wobei die Verbindung ausgewählt ist aus der Gruppe bestehend aus: 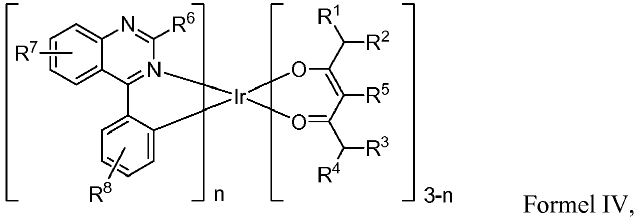 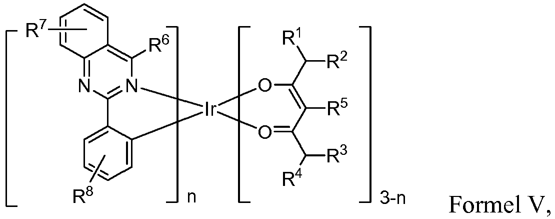 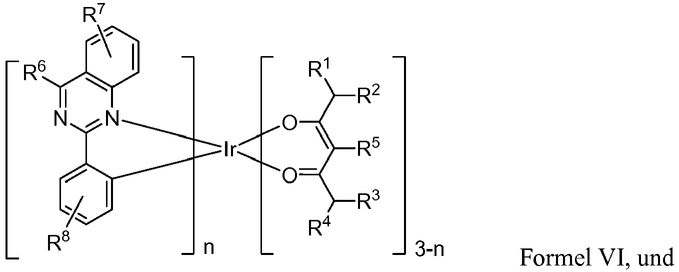 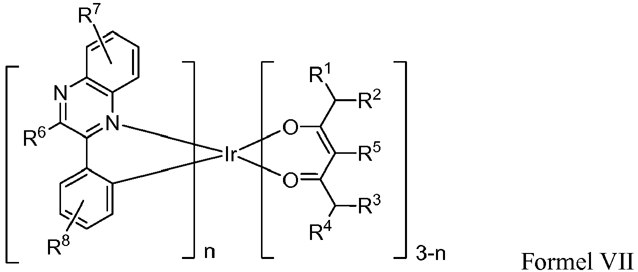
wobei R⁷ und R⁸ jeweils unabhängig stehen für Mono-, Di-, Tri- oder Tetrasubstitution oder keine Substitution;
wobei R⁶, R⁷ und R⁸ unabhängig ausgewählt sind aus der Gruppe bestehend aus Wasserstoff, Deuterium, Halogen, Alkyl, Cycloalkyl, Heteroalkyl, Arylalkyl, Alkoxy, Aryloxy, Amino, Silyl, Alkenyl, Cycloalkenyl, Heteroalkenyl, Alkinyl, Aryl, Heteroaryl, Acyl, Carbonyl, Karbonsäuren, Ester, Nitril, Isonitril, Sulfanyl, Sulfinyl, Sulfonyl, Phosphino und deren Kombinationen; und
wobei n gleich 1 oder 2 ist.

12. Die Vorrichtung nach Anspruch 1, wobei L_{A} ausgewählt ist aus der Gruppe bestehend aus L_{A1} bis L_{A270}, wie unten aufgelistet:

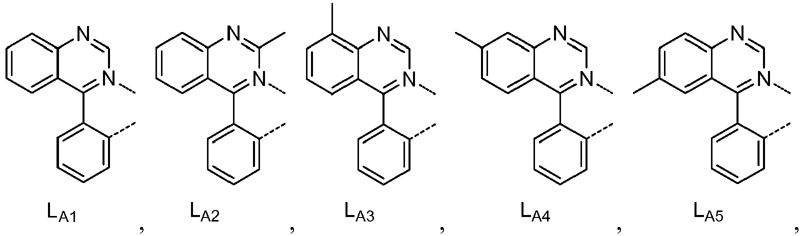

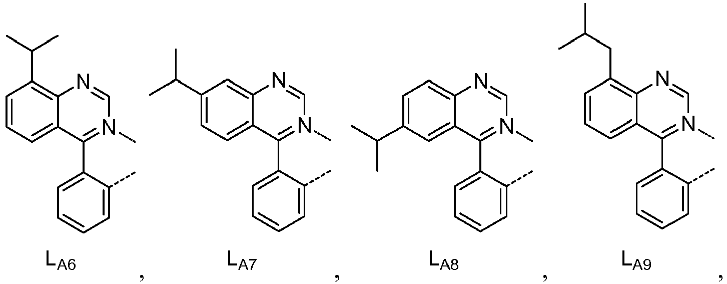

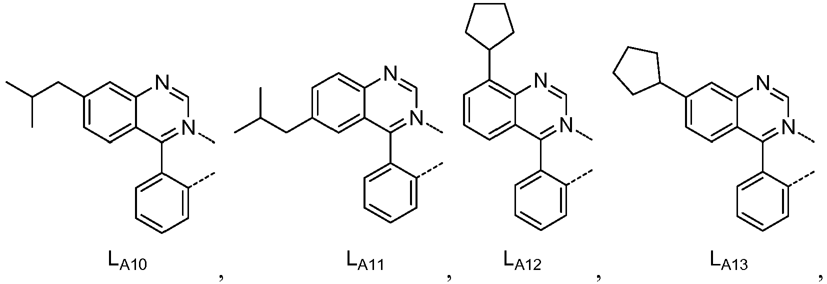

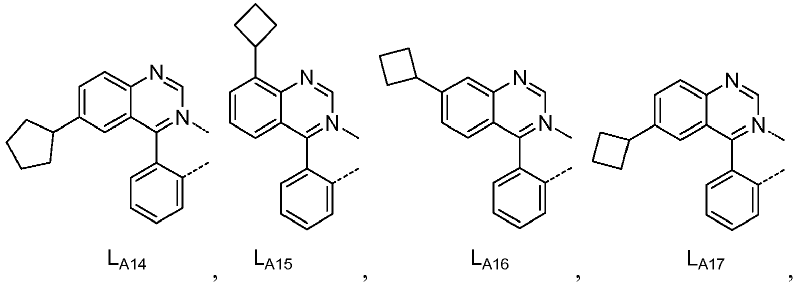

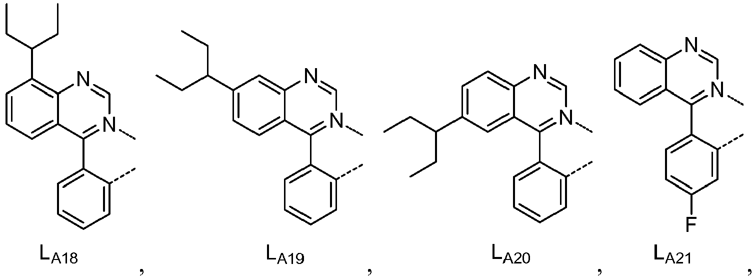

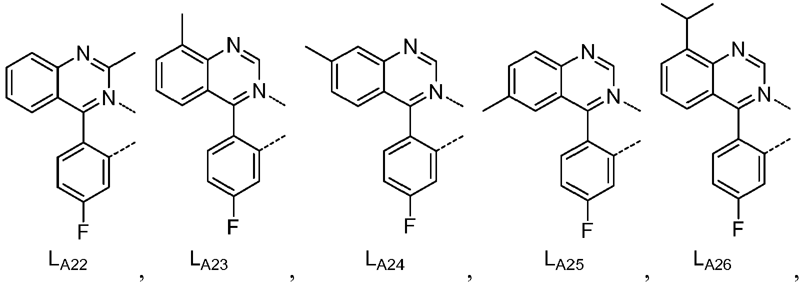

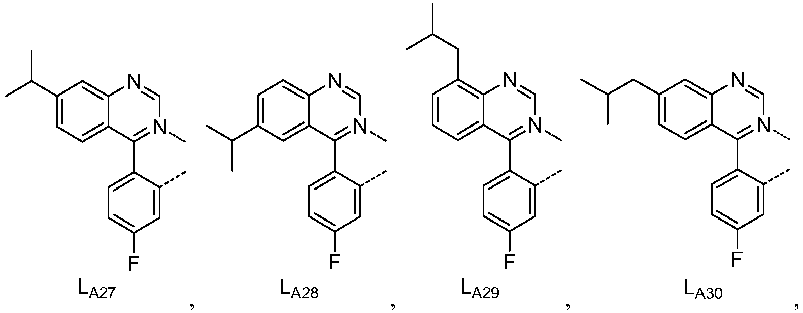

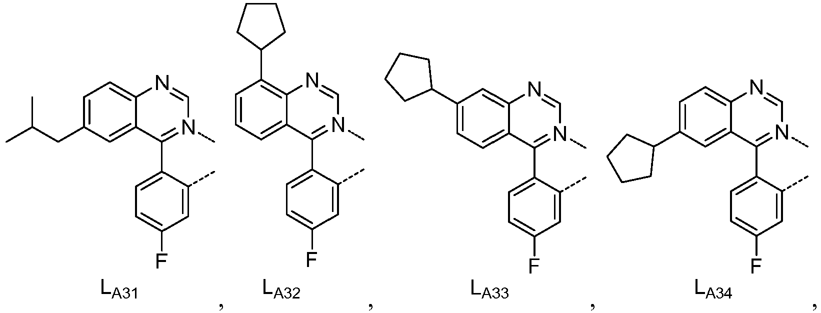

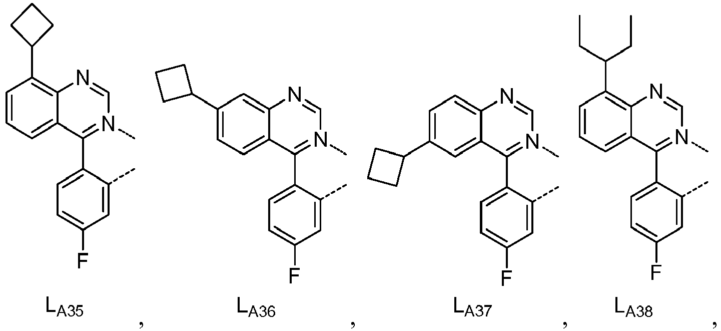

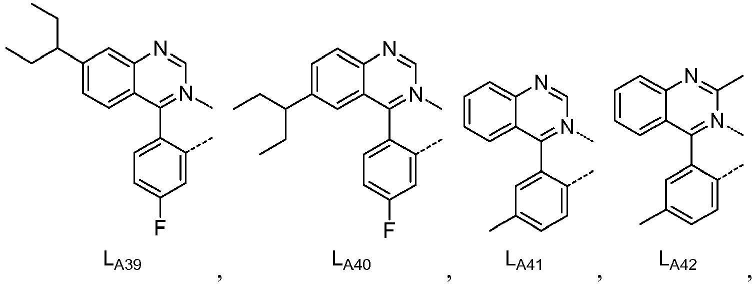

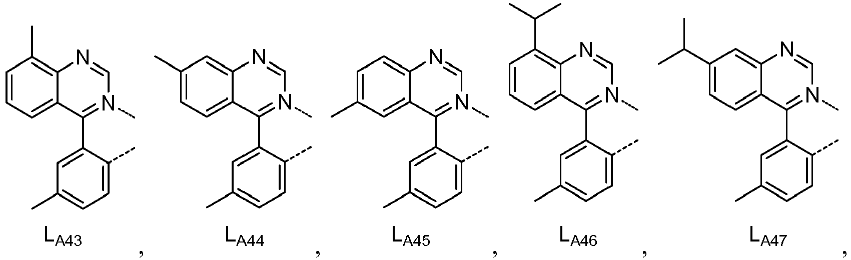

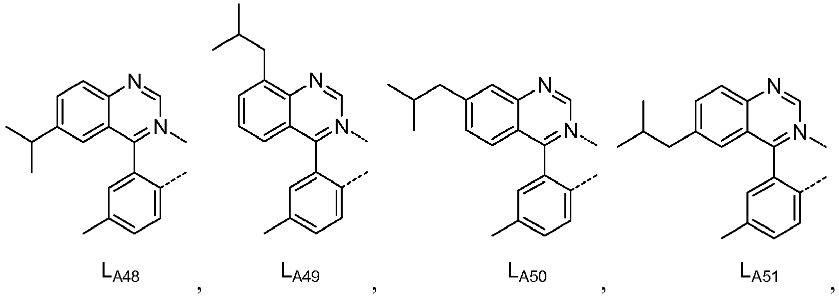

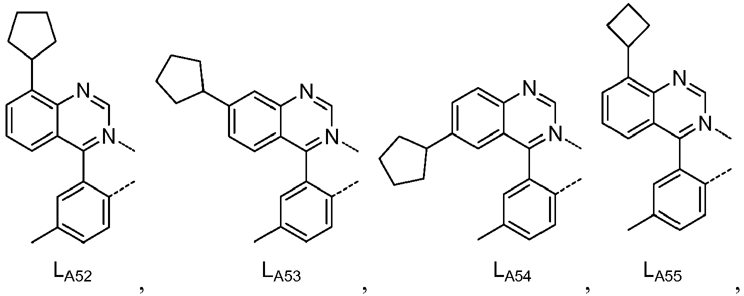

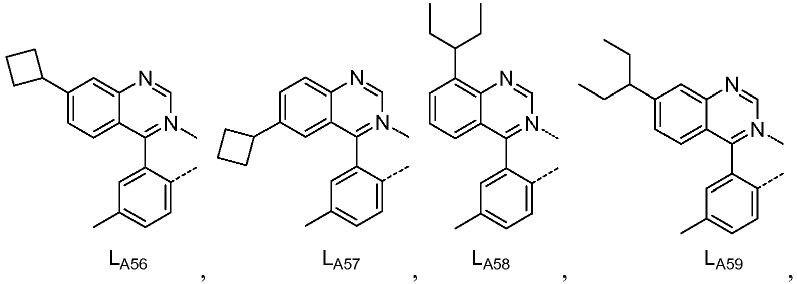

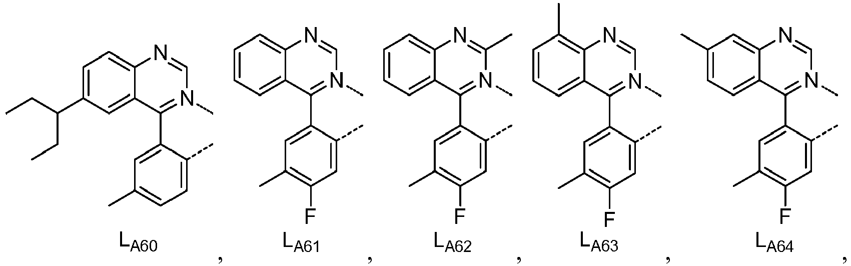

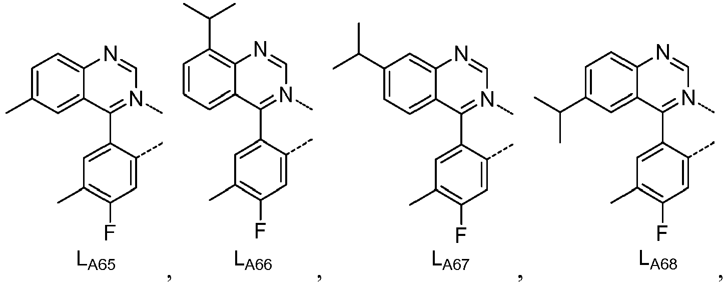

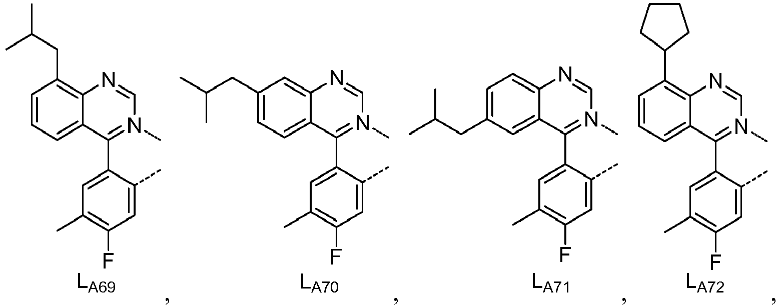

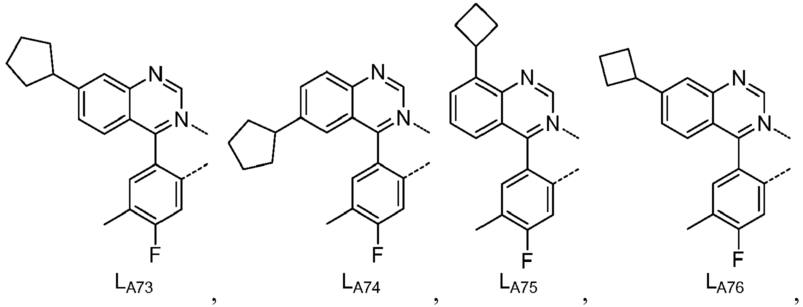

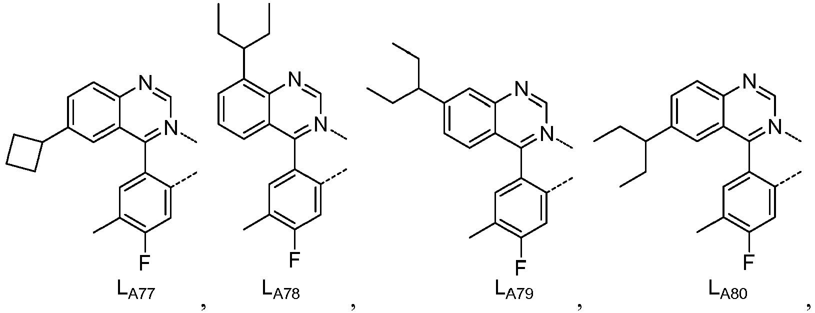

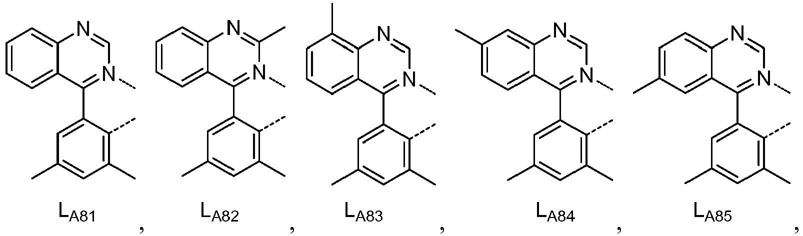

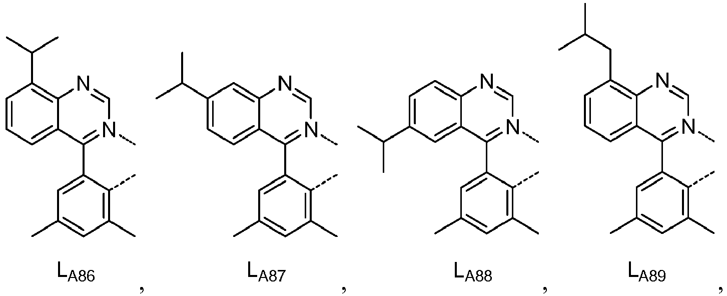

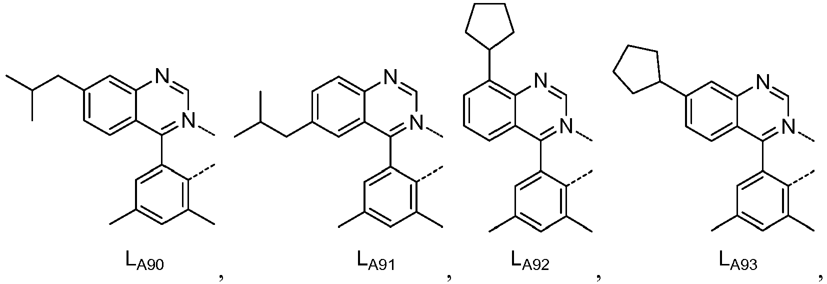

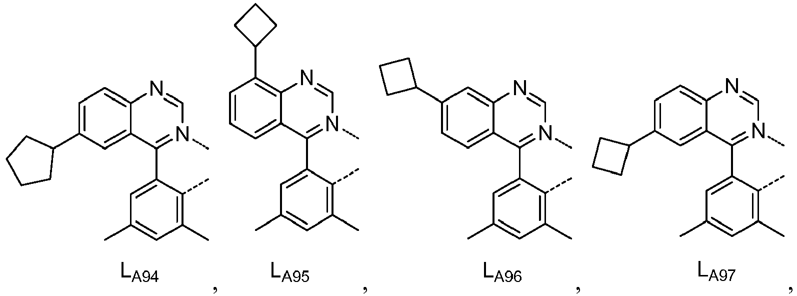

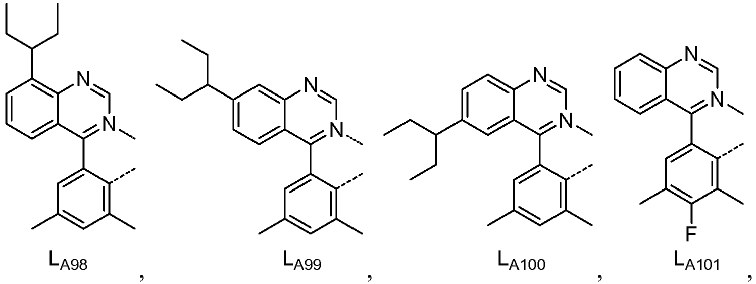

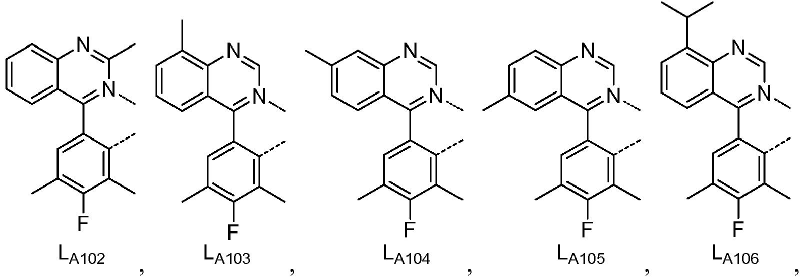

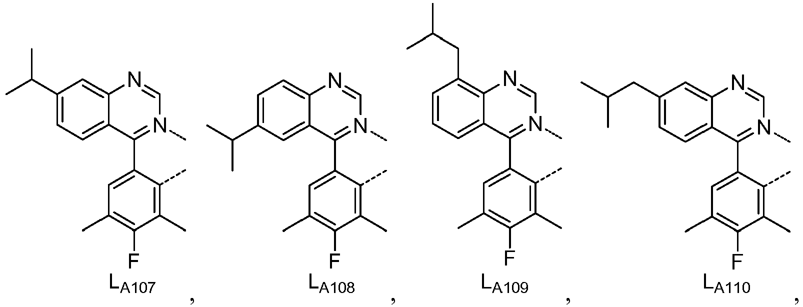

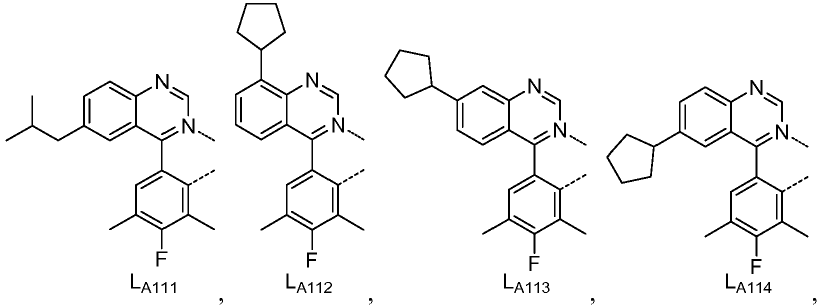

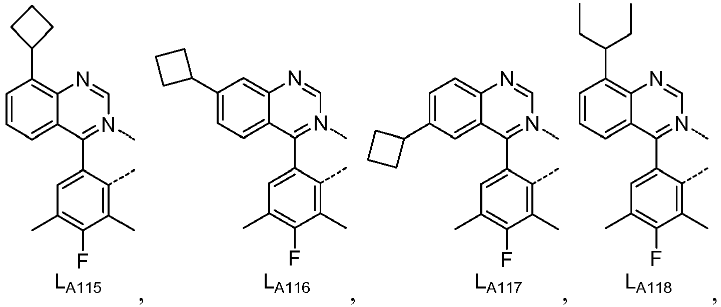

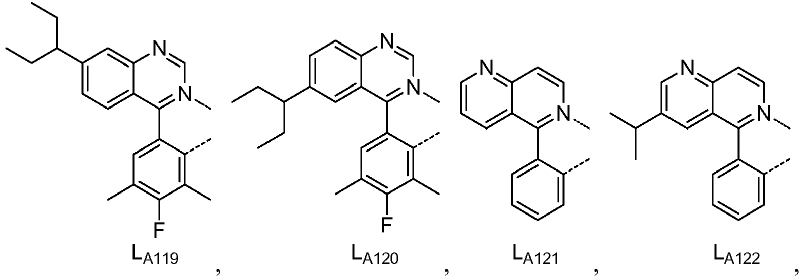

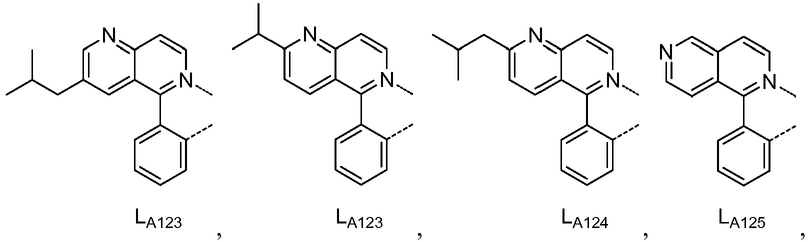

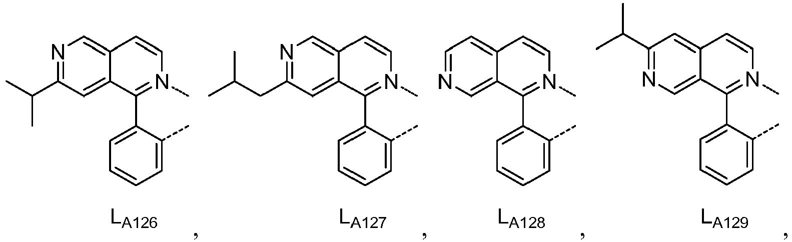

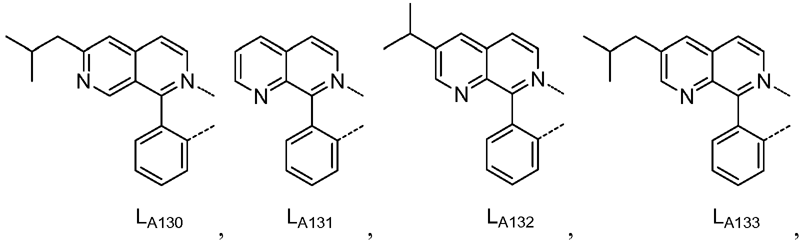

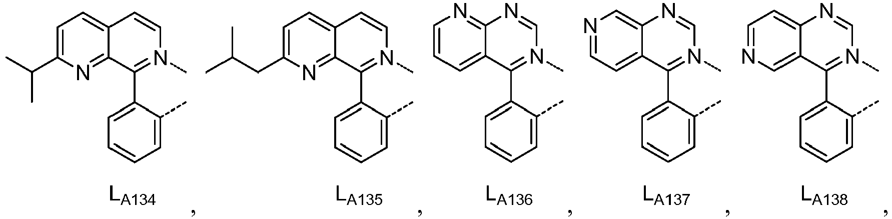

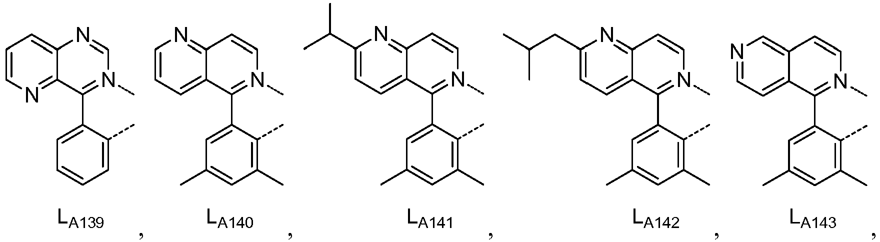

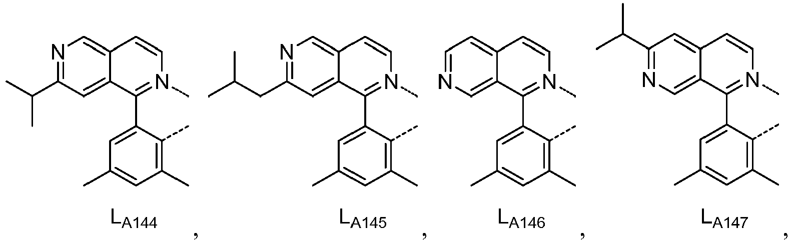

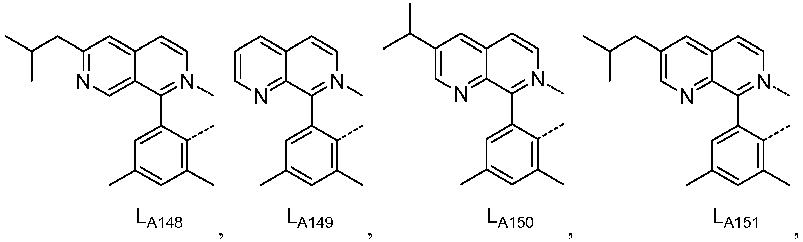

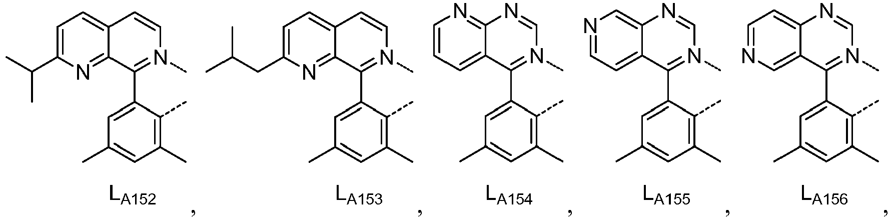

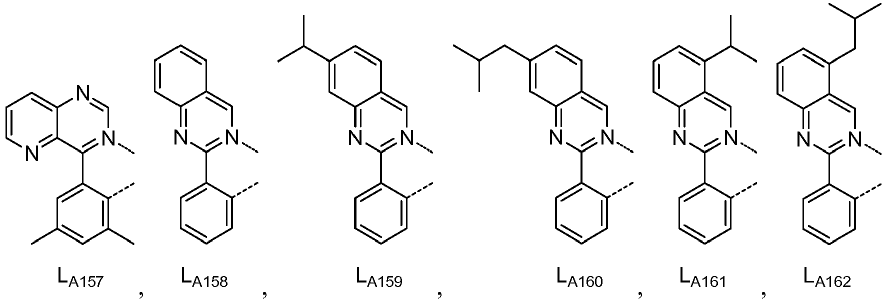

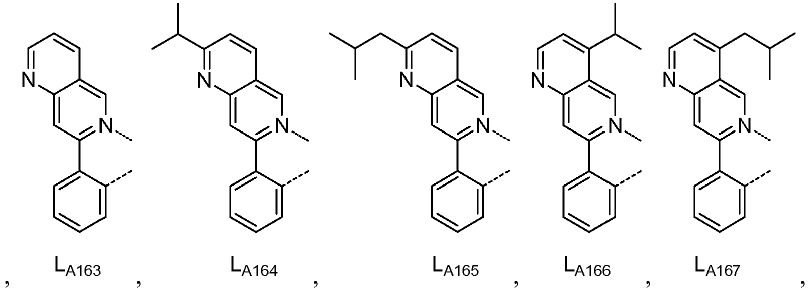

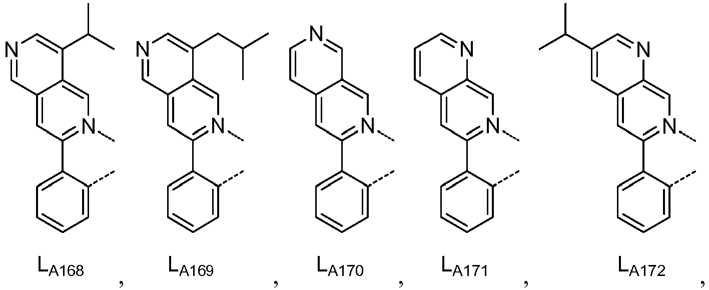

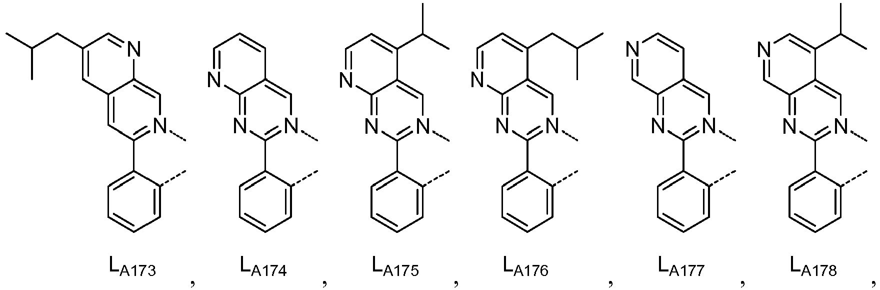

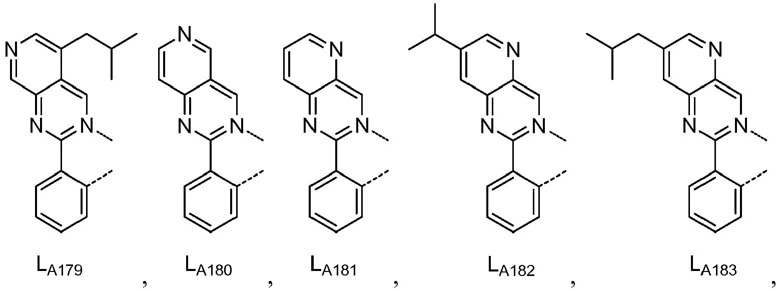

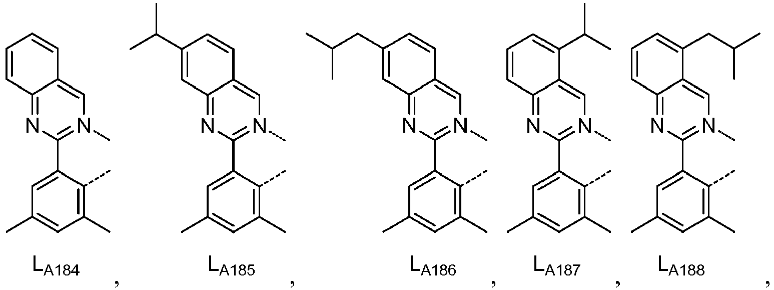

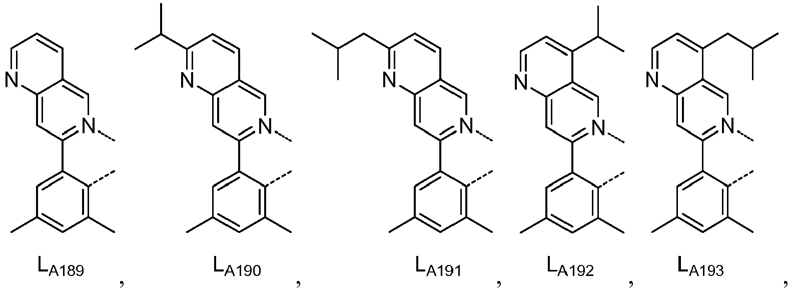

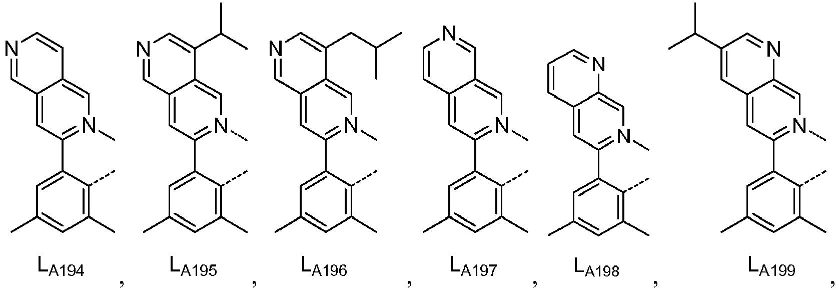

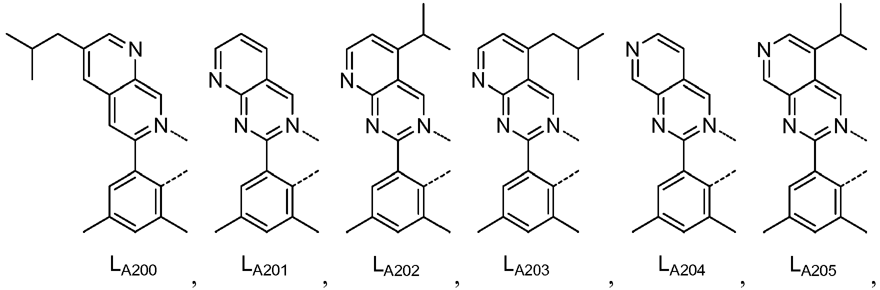

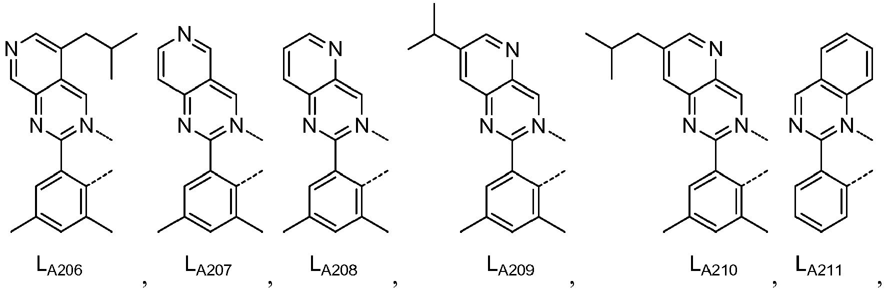

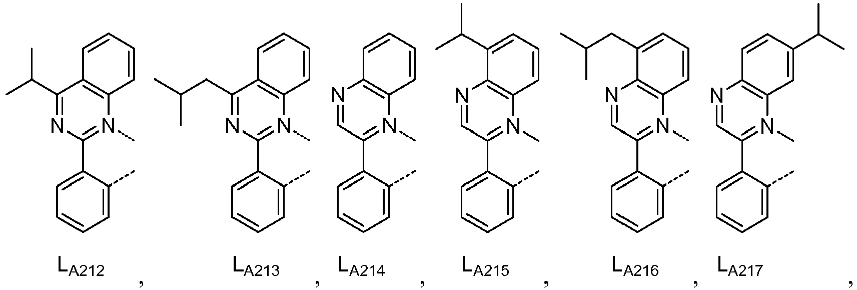

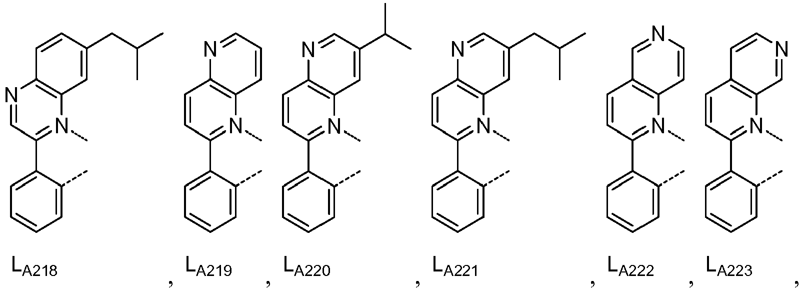

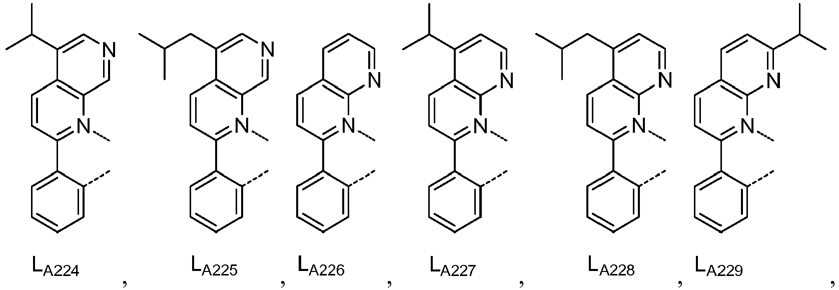

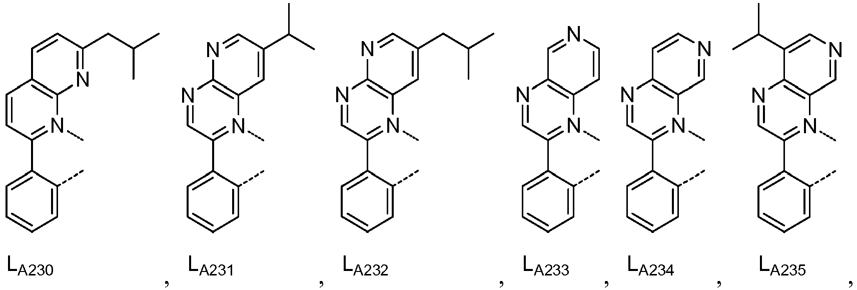

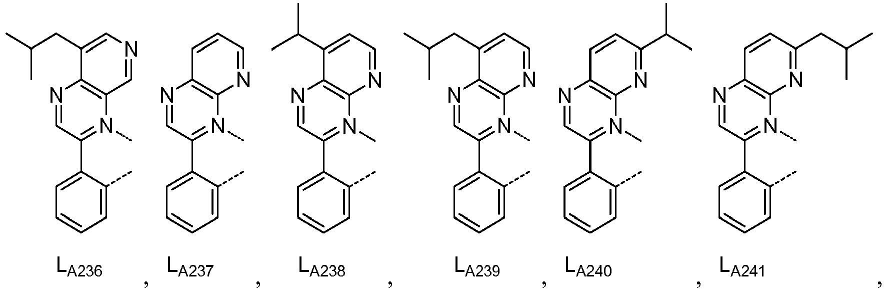

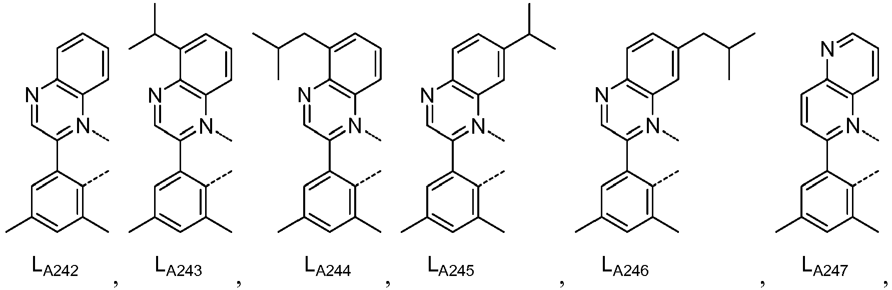

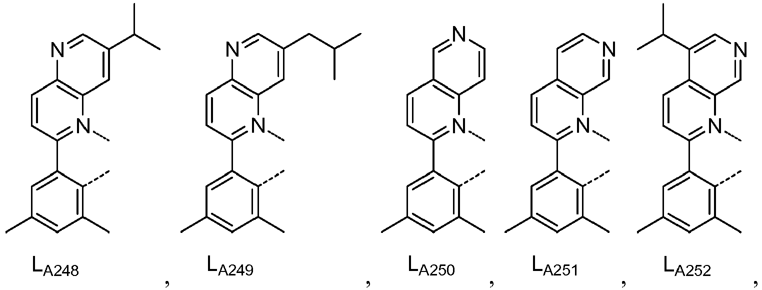

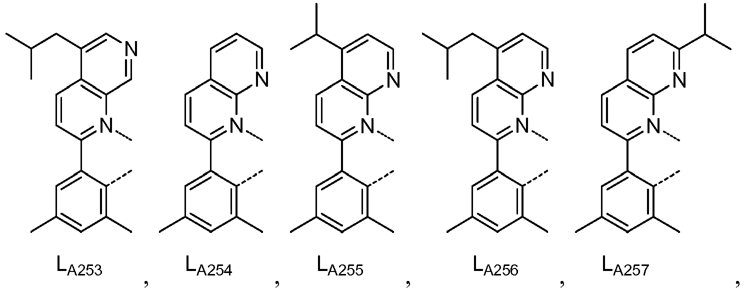

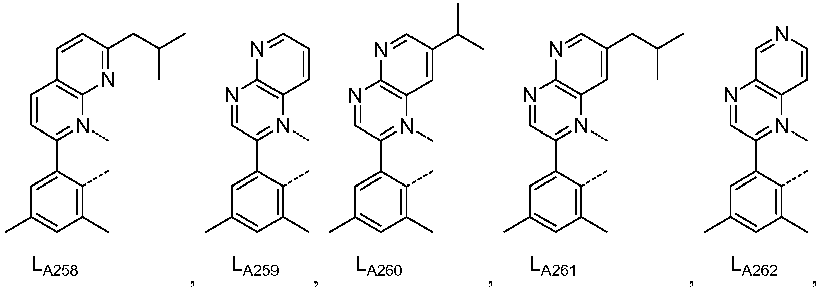

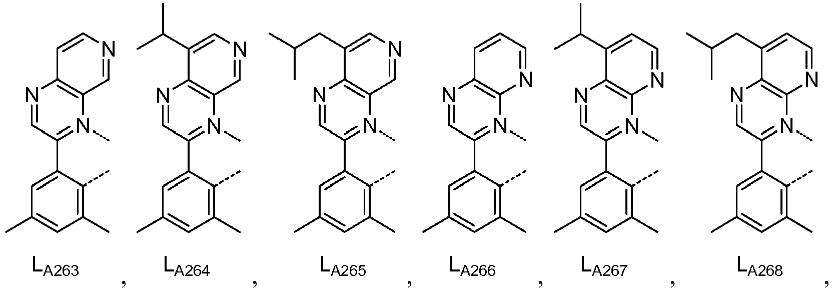

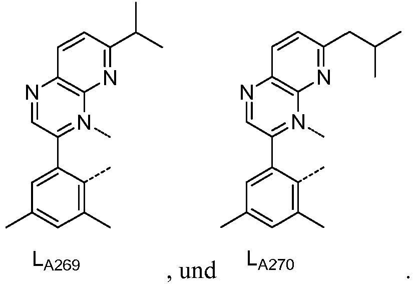

13. Die Vorrichtung nach Anspruch 12, wobei x=1 oder 2, y=1 oder 2 und z=0, und wobei L_{B} ausgewählt ist aus der Gruppe bestehend aus L_{B1}-L_{B13}, wie unten aufgeführt: 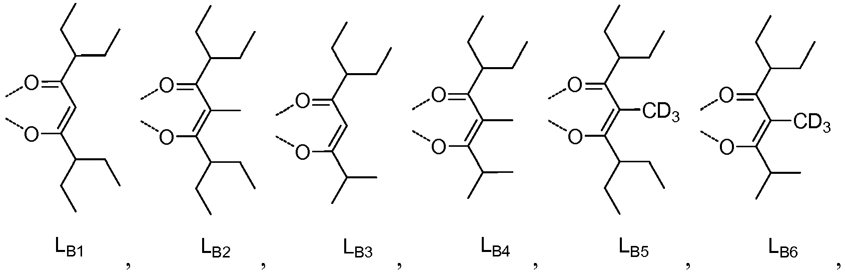 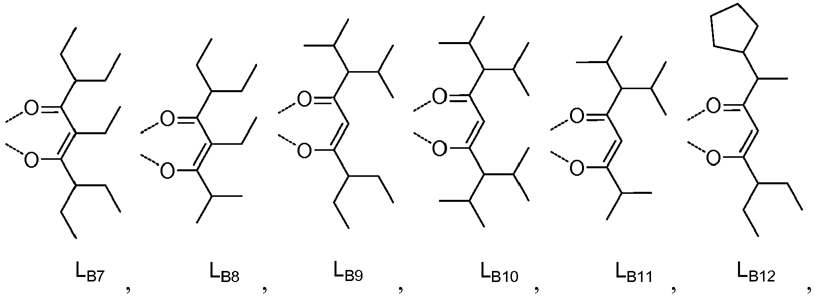 und

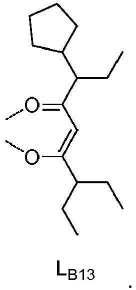

14. Die Vorrichtung nach Anspruch 1, wobei L_{B} ausgewählt ist aus der Gruppe bestehend aus L_{B1}-L_{B13}, wie unten aufgeführt: 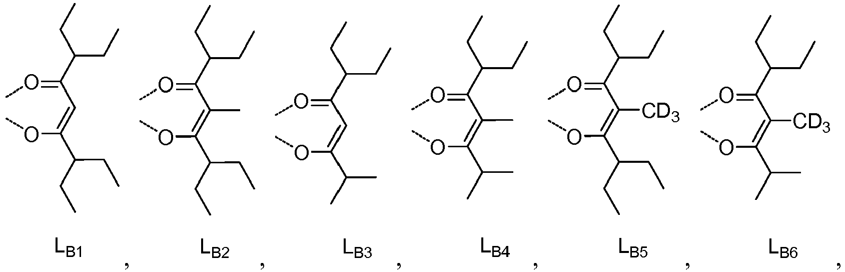 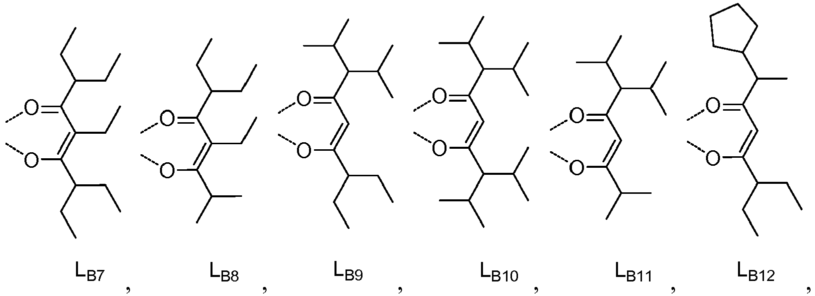 und

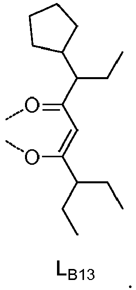

15. Die Vorrichtung nach Anspruch 1, wobei die Verbindung ausgewählt ist aus der Gruppe bestehend aus:

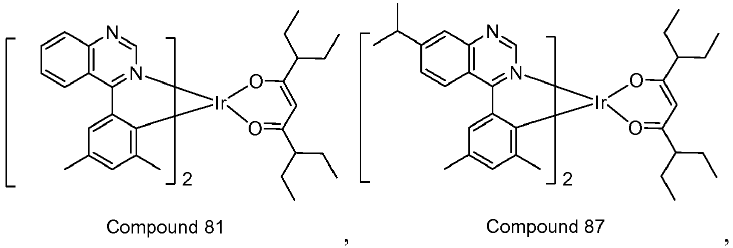

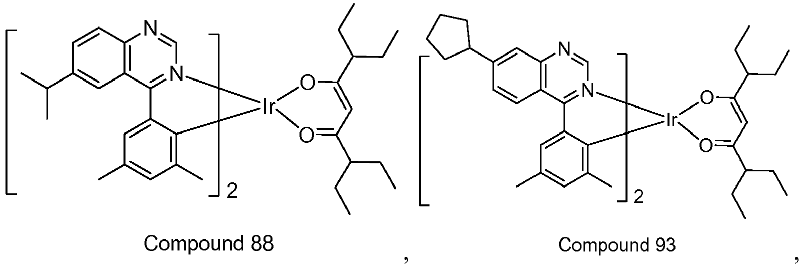

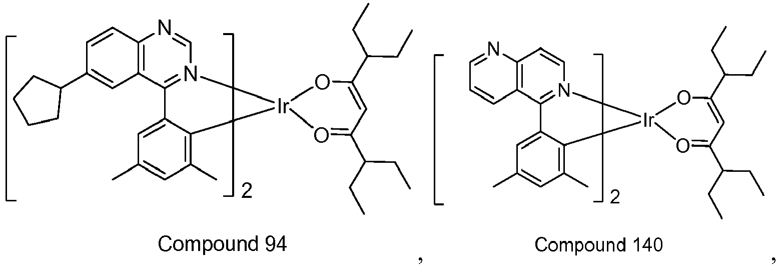

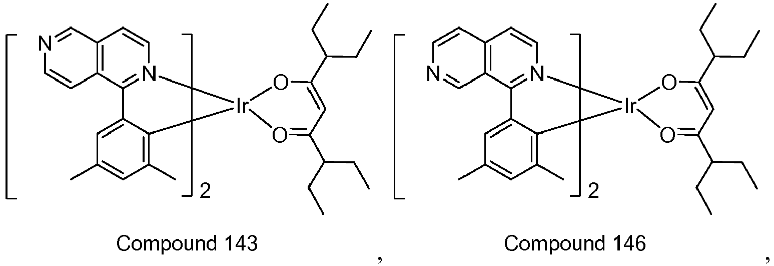

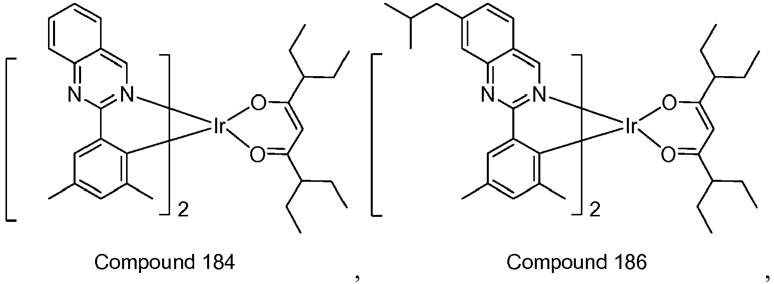

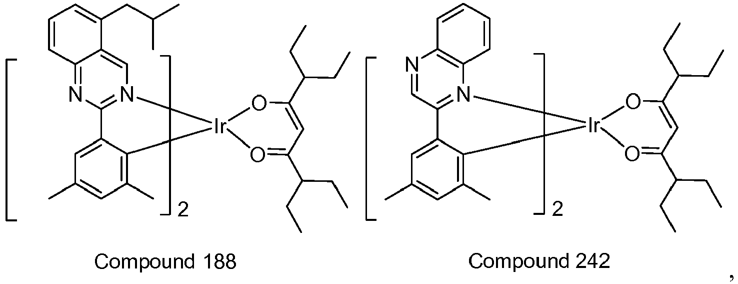

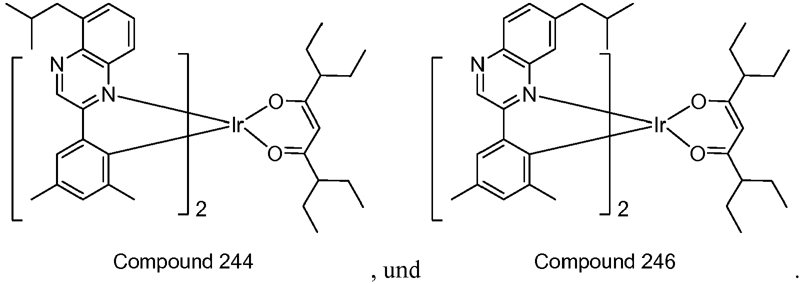

16. Die Vorrichtung nach einem der vorhergehenden Ansprüche, wobei der Wirt ausgewählt ist aus der Gruppe bestehend aus einem Metallkomplex, Triphenylen enthaltendem Benzo-fusionierten Thiophen oder Benzo-fusionierten Furan, wobei jeder Substituent in dem Wirt ein nicht-fusionierter Substituent sein kann, der unabhängig ausgewählt ist aus der Gruppe bestehend aus CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡C-CₙH₂ₙ₊₁, Ar₁, Ar₁-Ar₂, CₙH₂ₙ-Ar₁, oder keine Substitution, mit n = 1 bis 10; und Ar₁ und Ar₂ können unabhängig ausgewählt sein aus der Gruppe bestehend aus Benzol, Biphenyl, Naphthalin, Triphenylen, Carbazol and heteroaromatischen Analoga davon.

17. Die Vorrichtung nach einem der Ansprüche 1 bis 15, wobei der Wirt ausgewählt ist aus der Gruppe bestehend aus Carbazol, Dibenzothiophen, Dibenzofuran, Dibenzoselenophen, Azacarbazol, Aza-dibenzothiophen, Aza-dibenzofuran und Azadibenzoselenophen.

18. Die Vorrichtung nach Anspruch 17, wobei der Wirt ausgewählt ist aus der Gruppe bestehend aus: 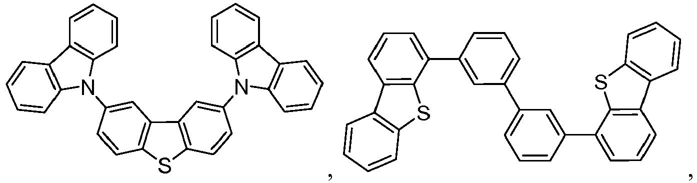 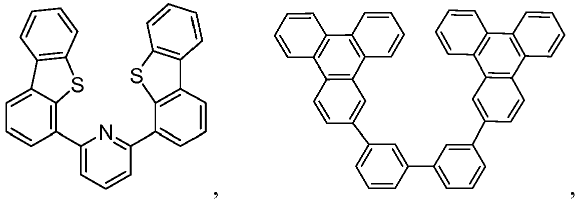 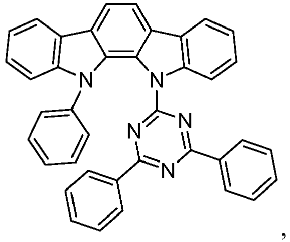 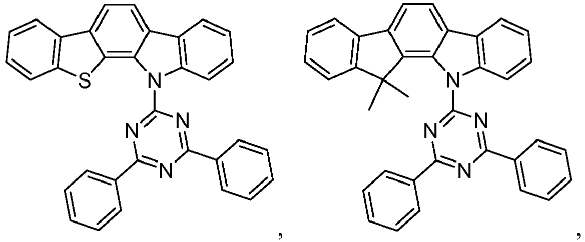 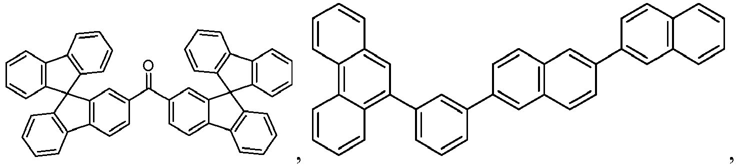 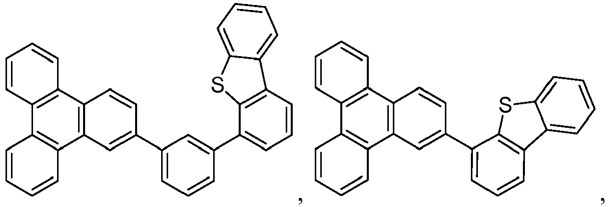 und deren Kombinationen.

19. Ein Konsumentenprodukt umfassend die Vorrichtung nach einem der Ansprüche 1 bis 18.

20. Das Konsumentenprodukt nach Anspruch 19, ausgewählt aus einem aus Flachbildschirmen, vollständig transparenten Bildschirmen und flexiblen Bildschirmen.

21. Das Konsumentenprodukt nach Anspruch 19, ausgewählt aus einem aus Computermonitoren, medizinischen Monitoren, Fernsehern, Laserdruckern, Heads-up-Displays, Laptop-Computern und Flachbildschirmen.

22. Das Konsumentenprodukt nach Anspruch 19, ausgewählt aus einem aus Telefonen, Mobiltelefonen, Persönliche Digitale Assistenten (PDAs), Digitalkameras, Camcorder, Sucher, Mikrobildschirmen und 3D-Bildschirmen.

23. Das Konsumentenprodukt nach Anspruch 19, ausgewählt aus einem aus Reklametafeln, großflächigen Wänden, Theater- oder Stadien-Bildschirmen, und einem Zeichen.

24. Das Konsumentenprodukt nach Anspruch 19, ausgewählt aus einem von Lichtern für interne oder externe Beleuchtung.

25. Das Konsumentenprodukt nach Anspruch 19, ausgewählt aus einem aus einem Signalgerät und Fahrzeugen.

26. Das Konsumentenprodukt nach Anspruch 19, ausgewählt aus einem von optoelektronischen Vorrichtungen, wie etwa organischen Solarzellen und organischen Fotodetektoren.

27. Die Verwendung einer Verbindung, wie in Anspruch 1 definiert, in einer organischen lichtemittierenden Vorrichtung.

## Revendications

1. Dispositif électroluminescent organique comprenant :
une anode ;
une cathode ; et
au moins une couche organique, disposée entre l'anode et la cathode, la couche organique comprenant un hôte et un dopant, le dopant comprenant un composé ayant une formule M(L_{A})ₓ(L_{B})_{y}(L_{C})_{z} :
où le ligand L_{A} est 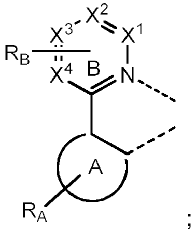
où le ligand L_{B} est 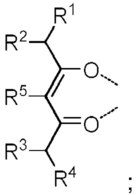
où le ligand L_{C} est 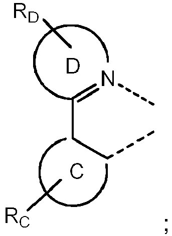
où M est un métal ayant un numéro atomique supérieur à 40 ;
où x est 1 ou 2 ;
où y est 1 ou 2 ;
où z est 0, 1 ou 2 ;
où x+y+z est l'état d'oxydation du métal M ;
où X¹, X², X³ et X⁴ sont C ou N ;
où R¹, R², R³ et R⁴ sont indépendamment choisis dans le groupe constitué par alkyle, cycloalkyle, aryle et hétéroaryle ;
où au moins l'un parmi R¹, R², R³ et R⁴ a au moins deux atomes de C ;
où R⁵ est choisi dans le groupe constitué par hydrogène, deutérium, halogénure, alkyle, cycloalkyle, hétéroalkyle, arylalkyle, alcoxy, aryloxy, amino, silyle, alcényle, cycloalcényle, hétéroalcényle, alcynyle, aryle, hétéroaryle, acyle, carbonyle, acides carboxyliques, ester, nitrile, isonitrile, sulfanyle, sulfinyle, sulfonyle, phosphino, et leurs combinaisons ;
où les cycles A, C et D sont chacun indépendamment un cycle carbocyclique ou hétérocyclique à 5 ou 6 chaînons ;
où R_{A}, R_{C} et R_{D} représentent chacun indépendamment une mono-, di-, tri ou tétra-substitution, ou aucune substitution ;
où R_{B} représente une di-, tri- ou tétra-substitution ;
où deux R_{B} adjacents forment un cycle E carbocyclique ou hétérocyclique à six chaînons fusionné au cycle B ; où, lorsque le cycle E est hétérocyclique, le seul hétéroatome est l'azote ; et où le cycle E peut en outre être substitué ;
où
(a) au moins l'un parmi X¹, X², X³ et X⁴ est N,
(b) le cycle E est hétérocyclique, ou
(c) les deux ;
où R_{A}, R_{B}, R_{C} et R_{D} sont chacun indépendamment choisis dans le groupe constitué par hydrogène, deutérium, halogénure, alkyle, cycloalkyle, hétéroalkyle, arylalkyle, alcoxy, aryloxy, amino, silyle, alcényle, cycloalcényle, hétéroalcényle, alcynyle, aryle, hétéroaryle, acyle, carbonyle, acides carboxyliques, ester, nitrile, isonitrile, sulfanyle, sulfinyle, sulfonyle, phosphino, et leurs combinaisons ; et
où tous substituants adjacents de R_{A}, R_{B}, R_{C} et R_{D} sont facultativement attachés pour former un cycle fusionné.

2. Dispositif selon la revendication 1, où la couche organique est une couche émissive et le composé est un dopant émissif.

3. Dispositif selon la revendication 1, où le composé est un dopant non émissif.

4. Dispositif selon l'une quelconque des revendications 1 à 3, où M est choisi dans le groupe constitué par Ir, Rh, Re, Ru, Os, Pt, Au et Cu, de préférence
où M est Ir.

5. Dispositif selon la revendication 1, où le cycle A est le benzène, et/ou où le cycle C est le benzène, et le cycle D est la pyridine.

6. Dispositif selon la revendication 1, où R⁵ est choisi dans le groupe constitué par hydrogène, deutérium, alkyle, cycloalkyle, et leurs combinaisons, de préférence où R⁵ est l'hydrogène.

7. Dispositif selon la revendication 1, où R¹, R², R³ et R⁴ sont alkyle ou cycloalkyle, de préférence
où R¹, R², R³ et R⁴ sont indépendamment choisis dans le groupe constitué par méthyle, éthyle, propyle, 1-méthyléthyle, butyle, 1-méthylpropyle, 2-méthylpropyle, pentyle, 1-méthylbutyle, 2-méthylbutyle, 3-méthylbutyle, 1,1-diméthylpropyle, 1,2-diméthylpropyle, 2,2-diméthylpropyle, cyclobutyle, cyclopentyle, cyclohexyle, leurs variantes partiellement ou entièrement deutérées, et leurs combinaisons.

8. Dispositif selon la revendication 1, où le composé est choisi dans le groupe constitué par : 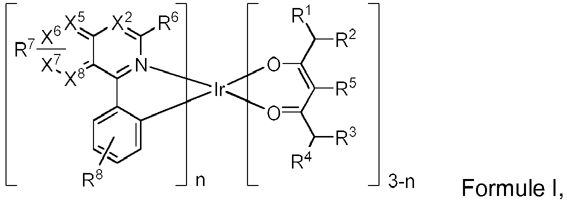 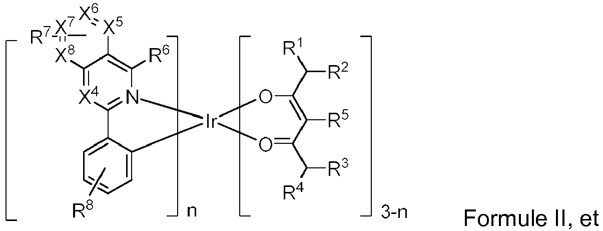 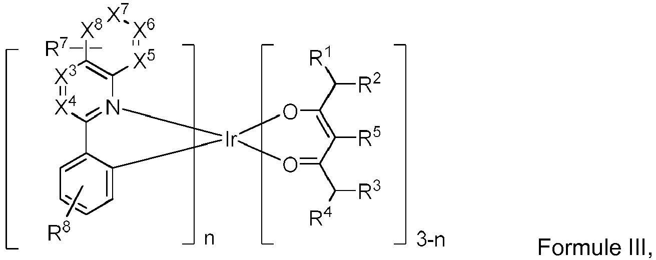
où X⁵, X⁶, X⁷ et X⁸ sont C ou N ;
où R⁷ et R⁸ représentent chacun indépendamment une mono-, di-, tri ou tétra-substitution, ou aucune substitution ;
où R⁶, R⁷ et R⁸ sont indépendamment choisis dans le groupe constitué par hydrogène, deutérium, halogénure, alkyle, cycloalkyle, hétéroalkyle, arylalkyle, alcoxy, aryloxy, amino, silyle, alcényle, cycloalcényle, hétéroalcényle, alcynyle, aryle, hétéroaryle, acyle, carbonyle, acides carboxyliques, ester, nitrile, isonitrile, sulfanyle, sulfinyle, sulfonyle, phosphino, et leurs combinaisons ; et
où n est 1ou 2, de préférence où n est 2.

9. Dispositif selon la revendication 8, où R⁶ et R⁷ sont indépendamment choisis dans le groupe constitué par hydrogène, deutérium, alkyle, cycloalkyle, et leurs combinaisons.

10. Dispositif selon la revendication 8, où R⁸ est choisi dans le groupe constitué par hydrogène, deutérium, alkyle, cycloalkyle, halogénure, et leurs combinaisons.

11. Dispositif selon la revendication 1, où le composé est choisi dans le groupe constitué par : 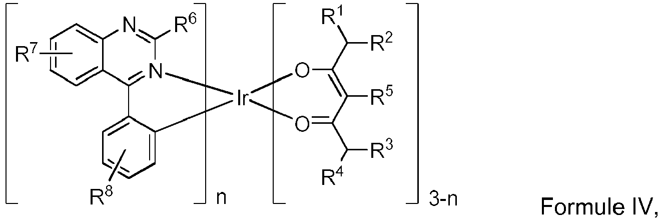 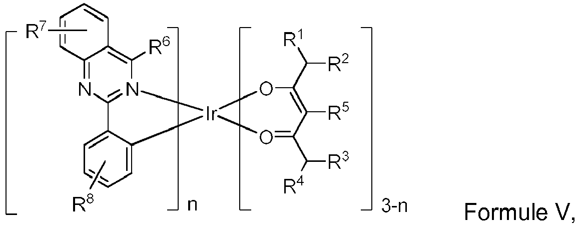 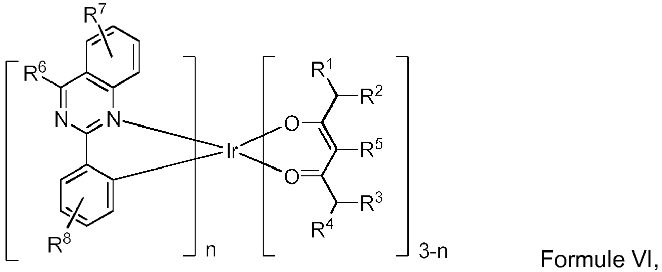 et 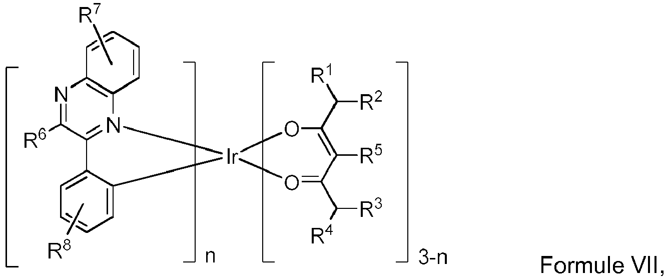
où R⁷ et R⁸ représentent chacun indépendamment une mono-, di-, tri ou tétra-substitution, ou aucune substitution ;
où R⁶, R⁷ et R⁸ sont indépendamment choisis dans le groupe constitué par hydrogène, deutérium, halogénure, alkyle, cycloalkyle, hétéroalkyle, arylalkyle, alcoxy, aryloxy, amino, silyle, alcényle, cycloalcényle, hétéroalcényle, alcynyle, aryle, hétéroaryle, acyle, carbonyle, acides carboxyliques, ester, nitrile, isonitrile, sulfanyle, sulfinyle, sulfonyle, phosphino, et leurs combinaisons ; et
où n est 1 ou 2.

12. Dispositif selon la revendication 1, où L_{A} est choisi dans le groupe constitué par L_{A1} à L_{A270} indiqué ci-après :

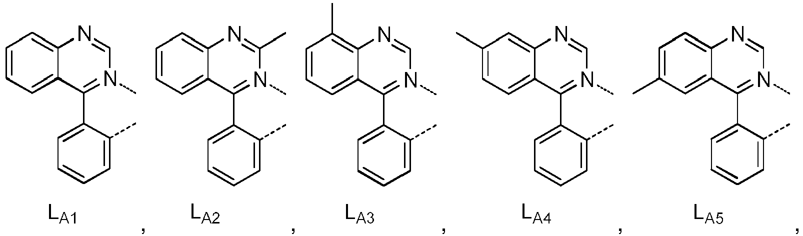

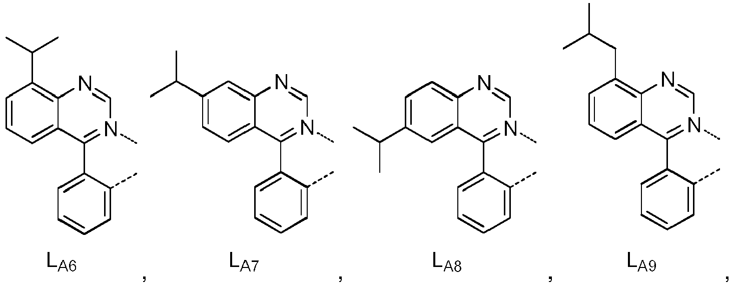

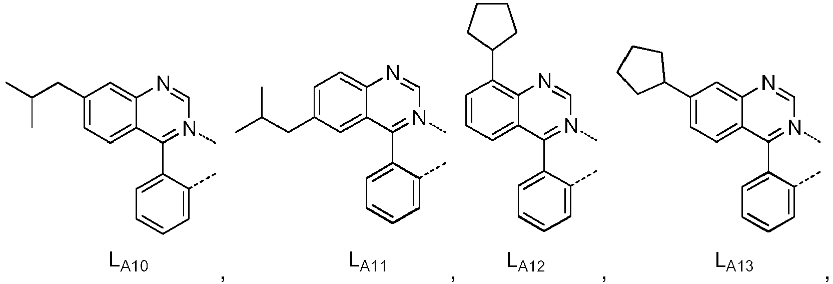

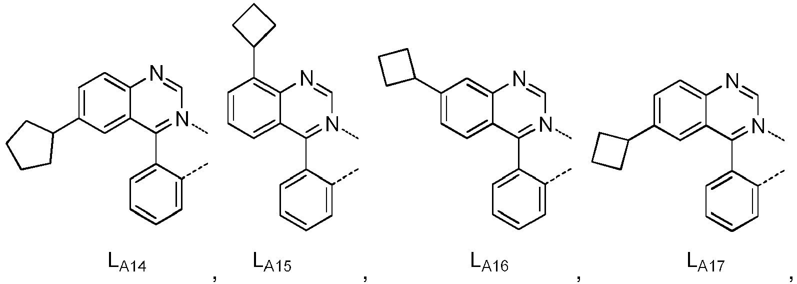

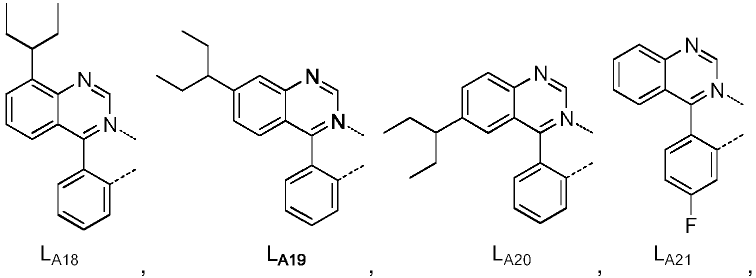

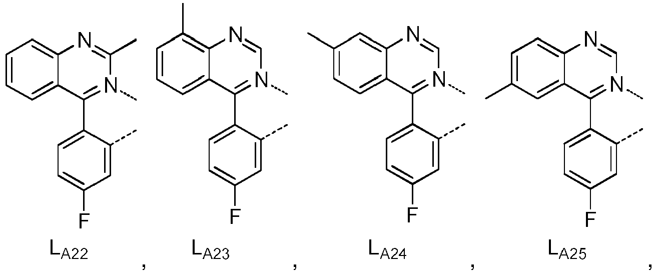

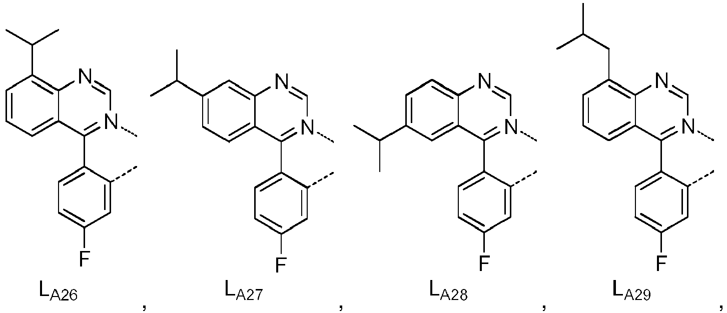

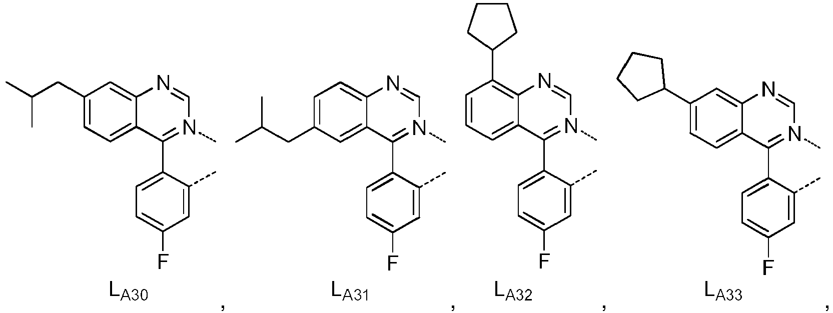

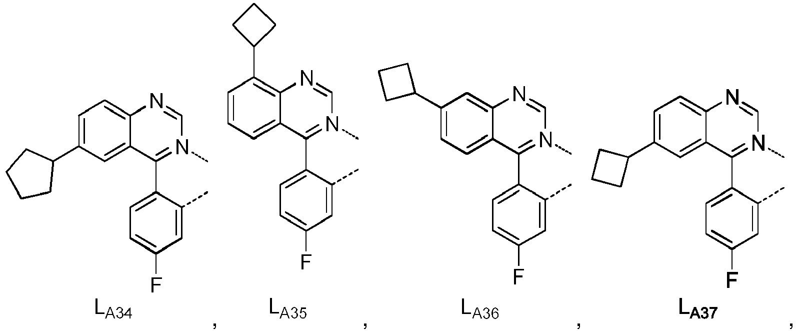

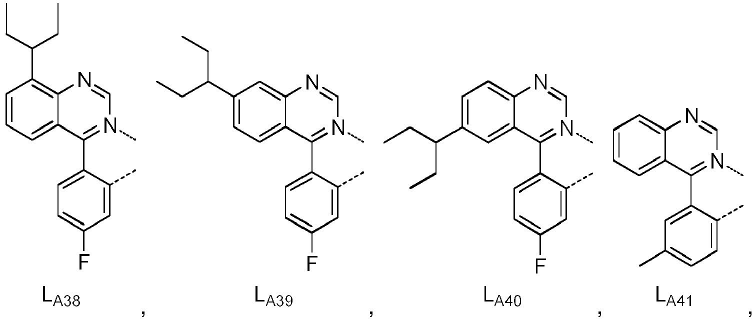

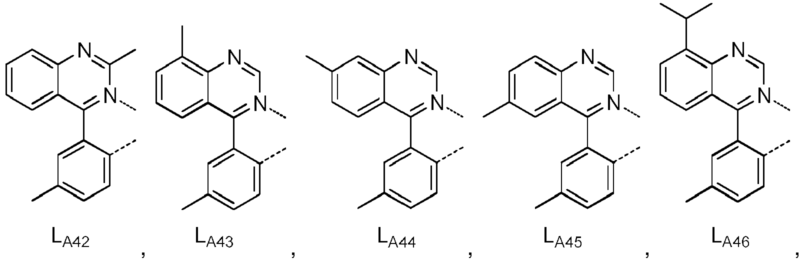

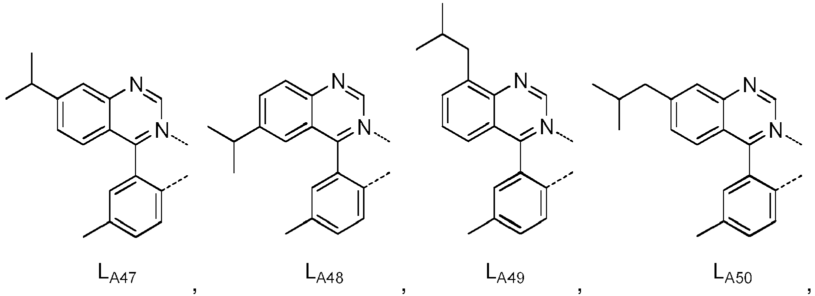

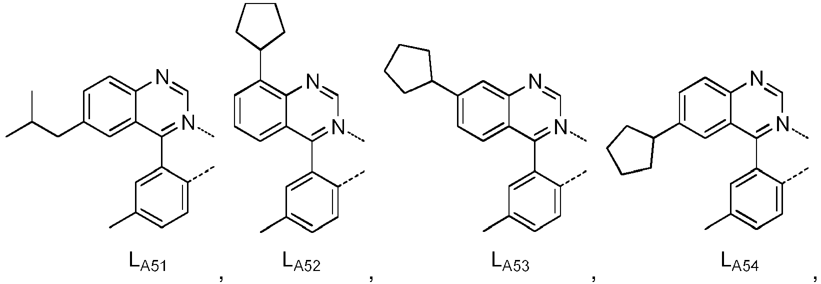

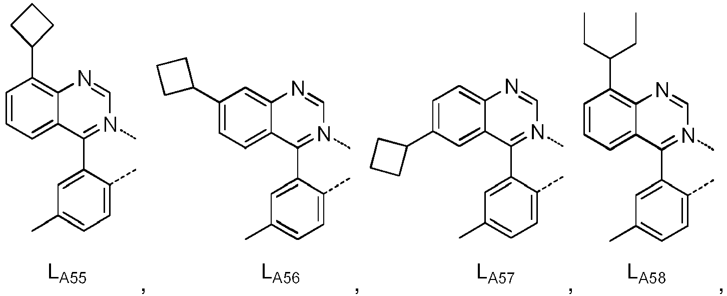

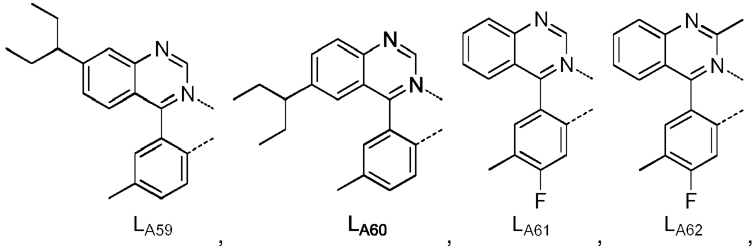

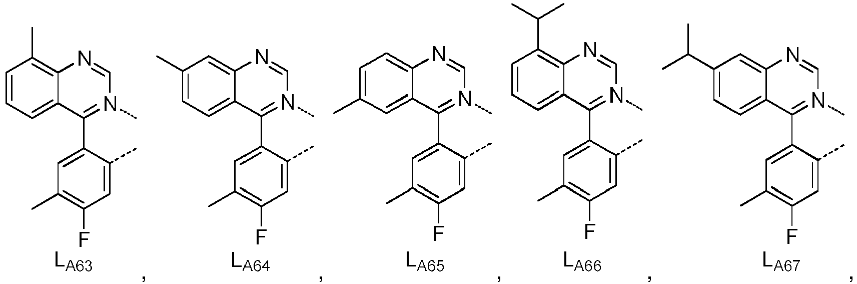

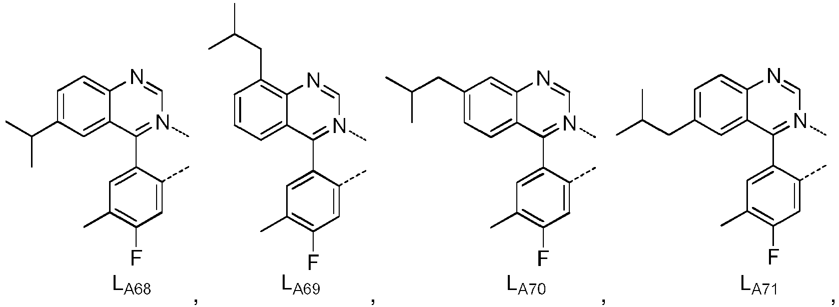

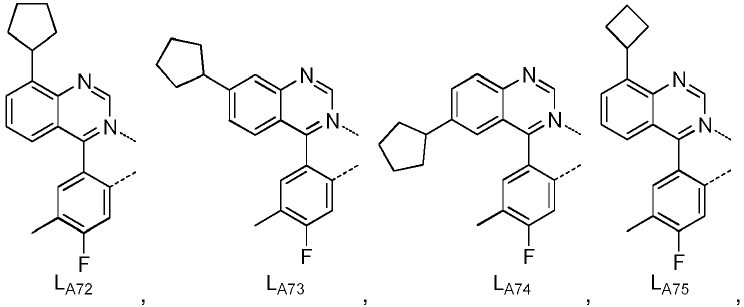

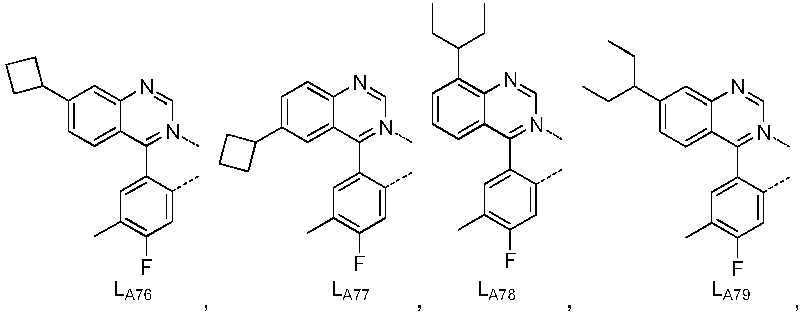

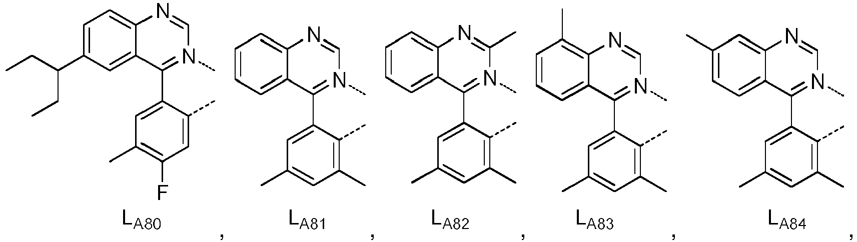

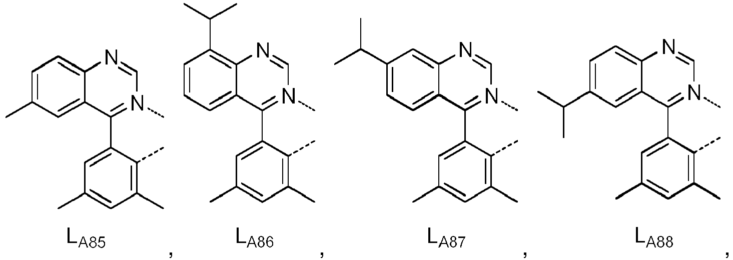

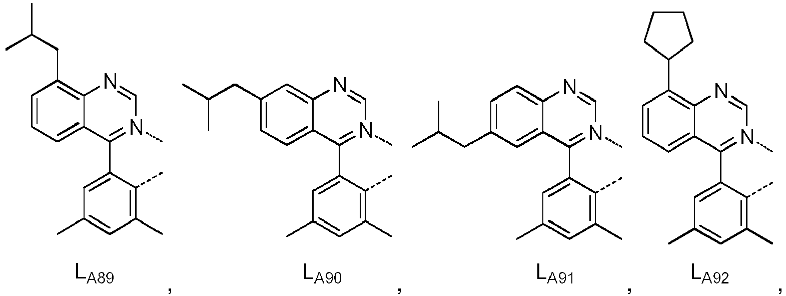

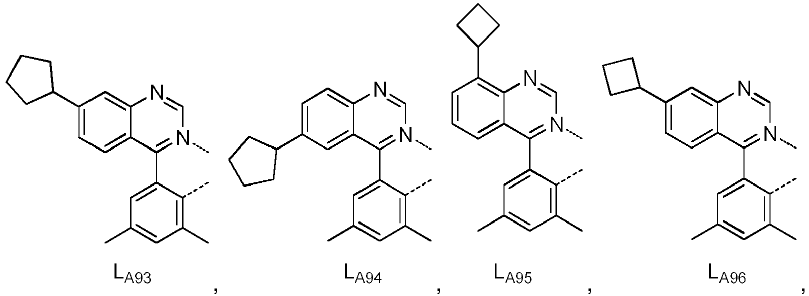

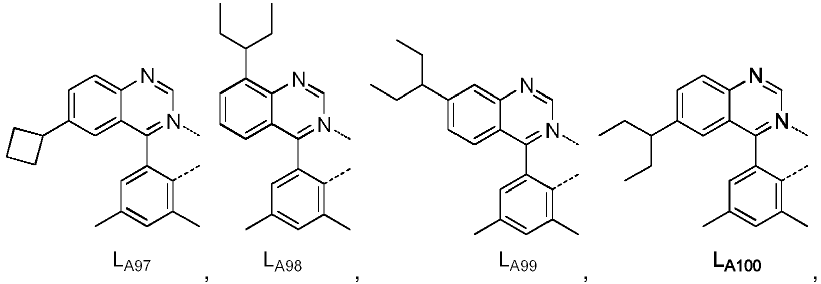

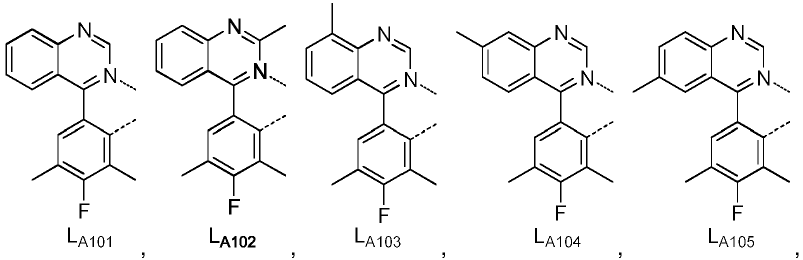

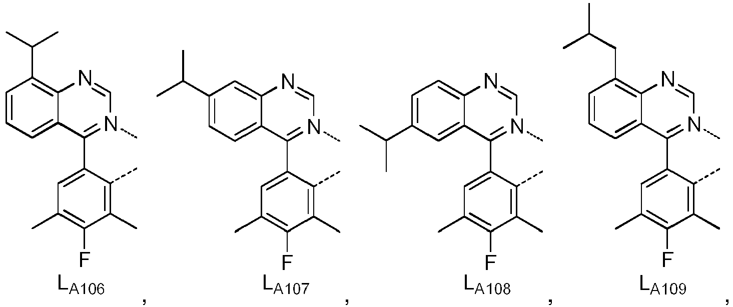

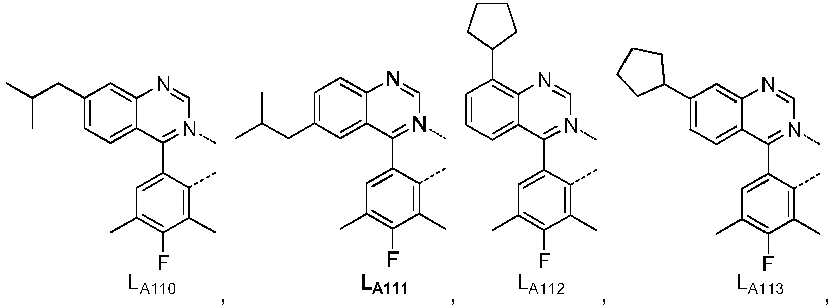

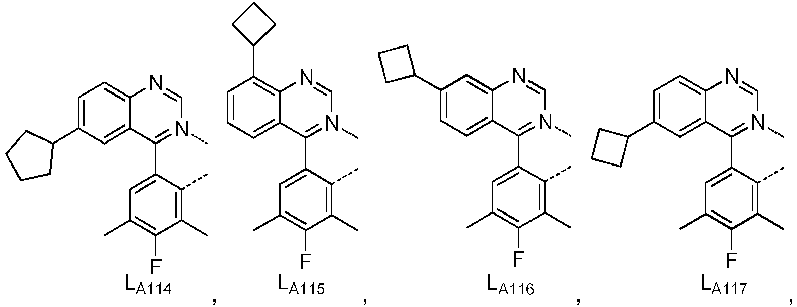

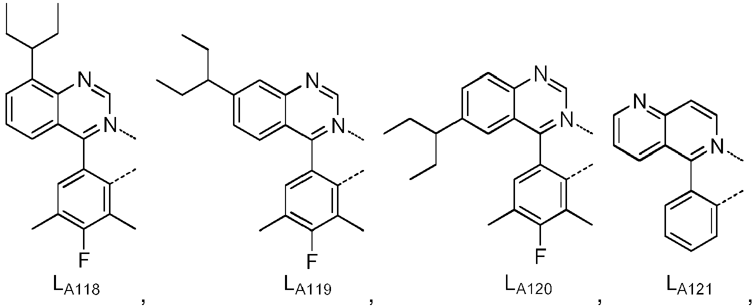

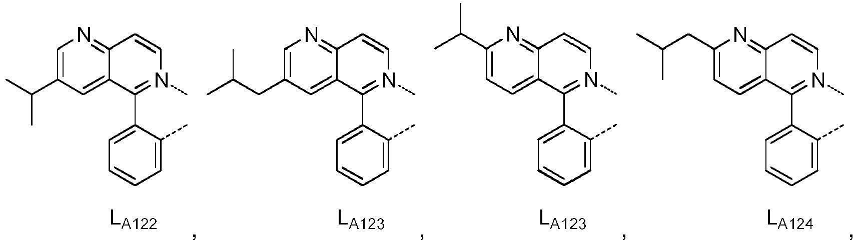

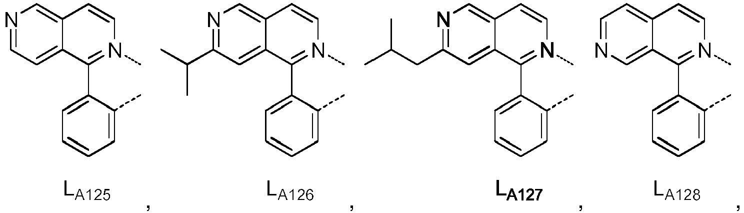

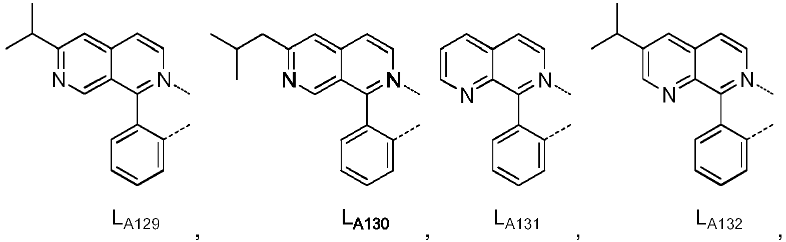

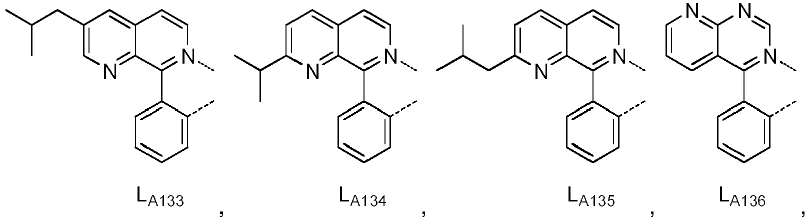

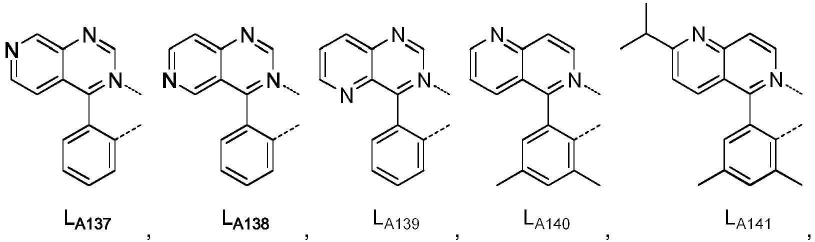

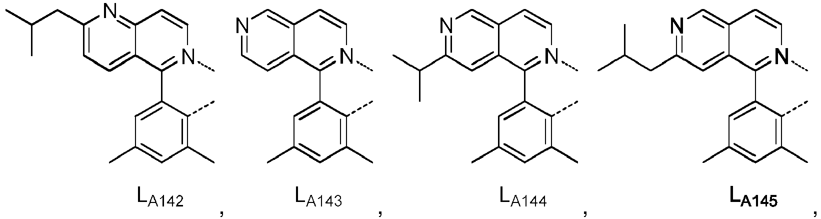

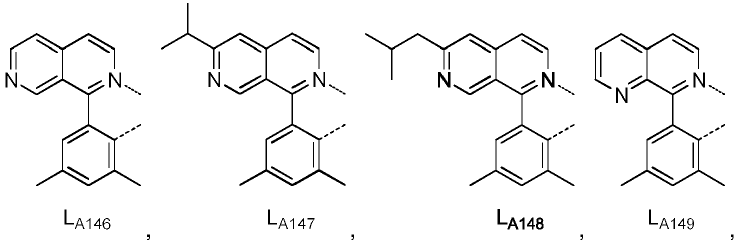

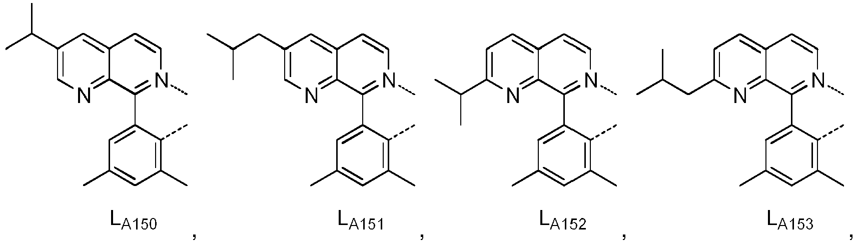

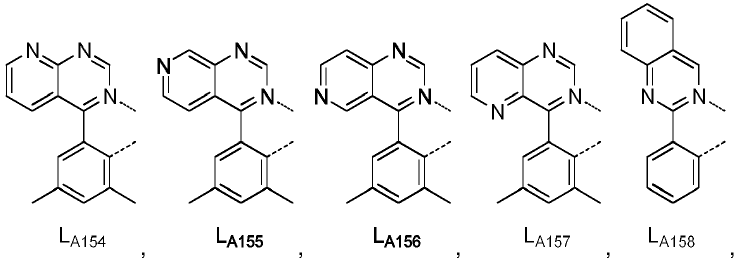

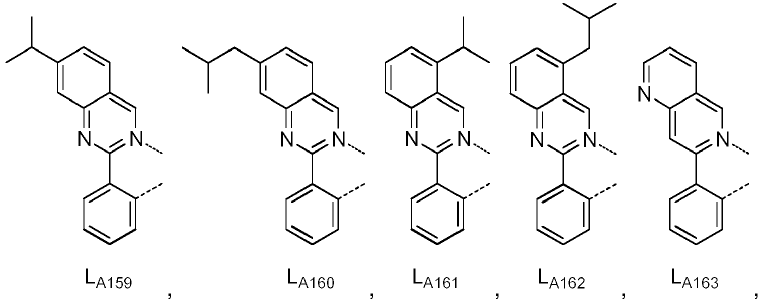

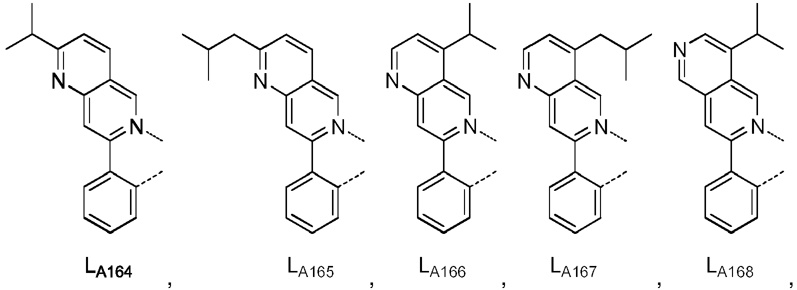

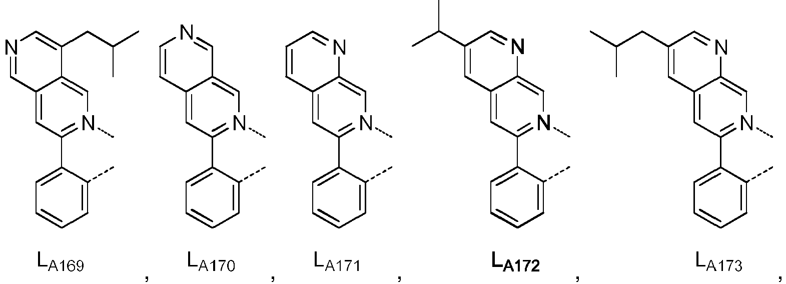

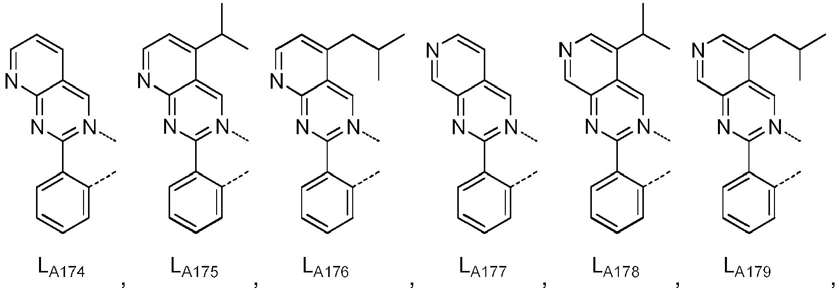

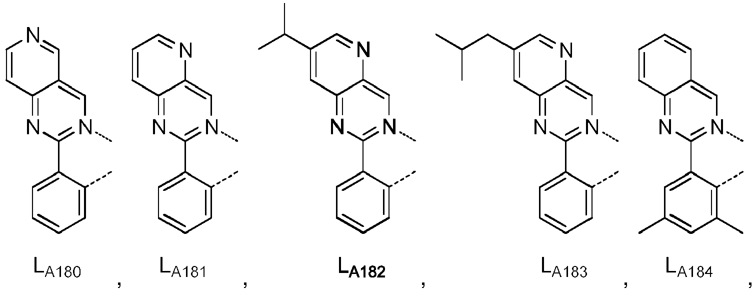

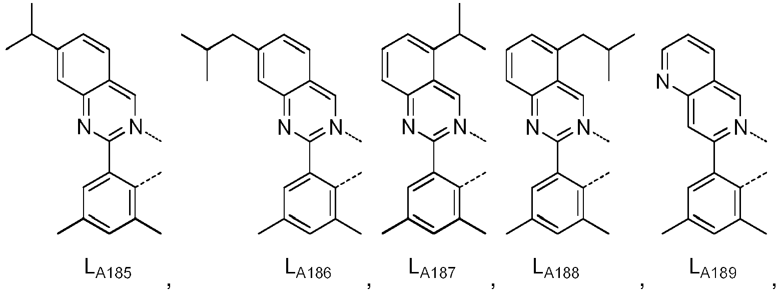

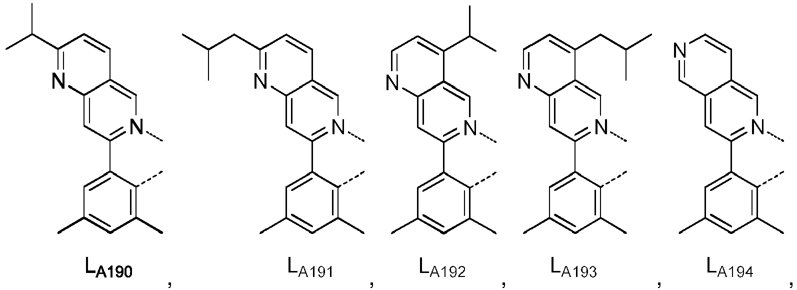

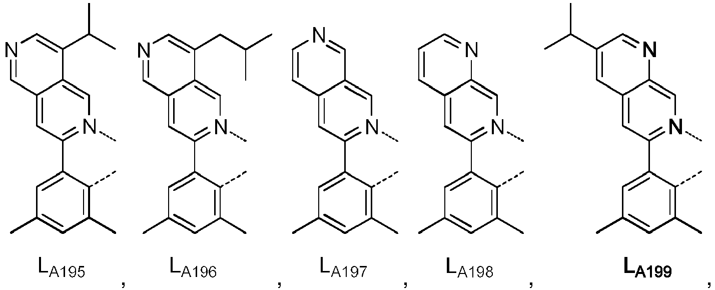

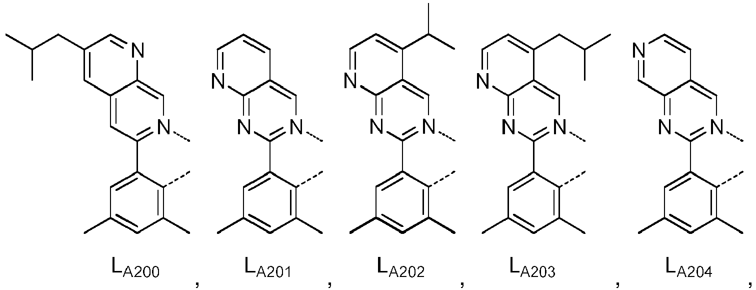

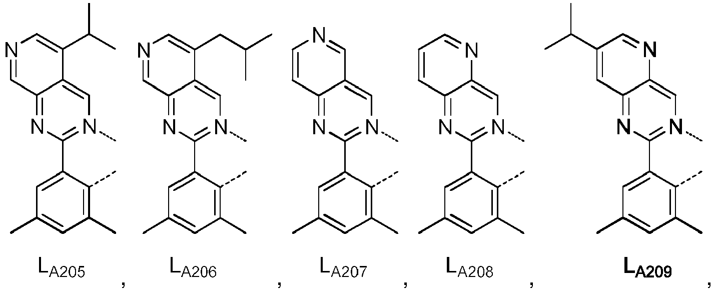

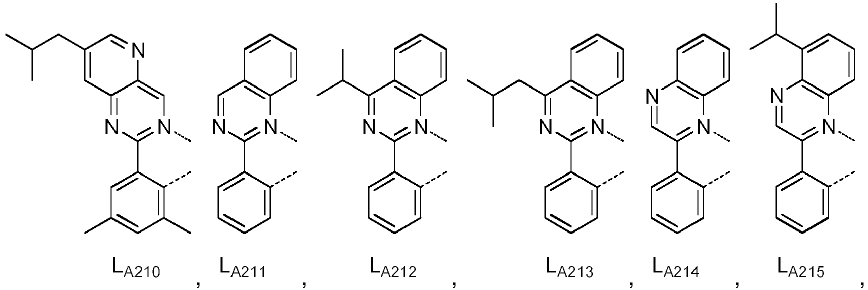

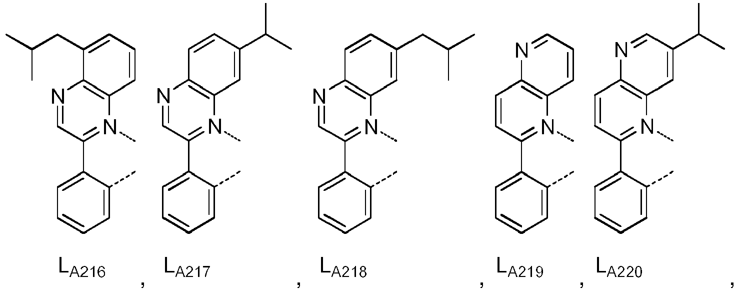

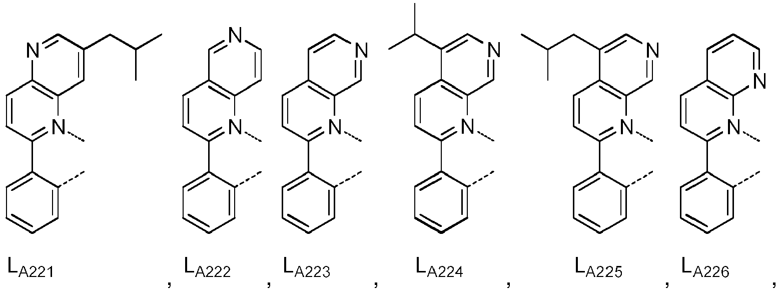

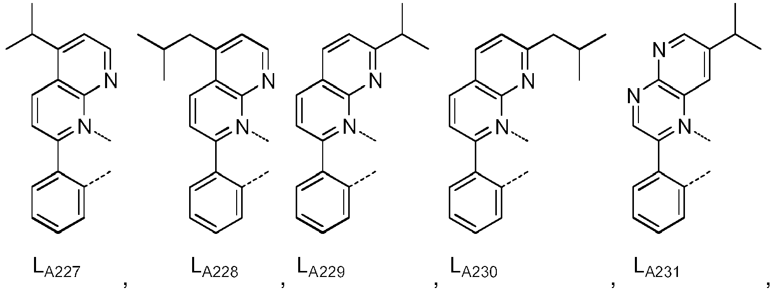

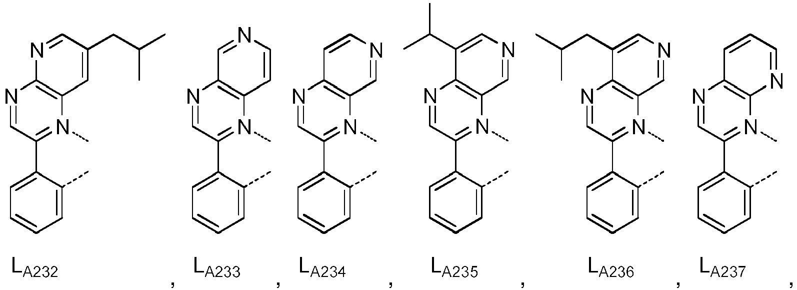

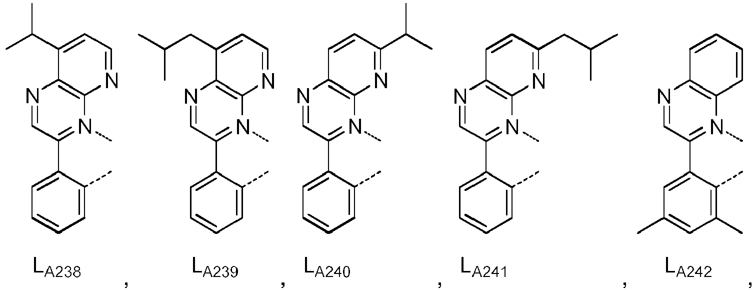

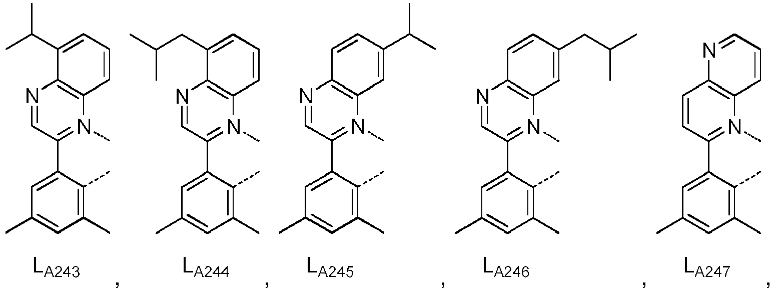

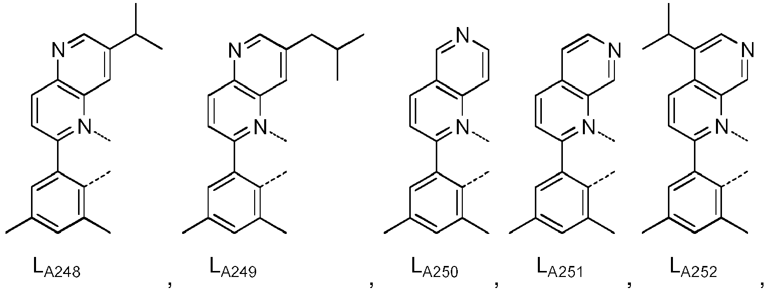

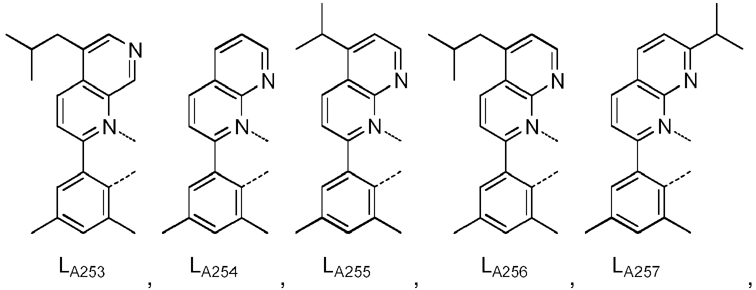

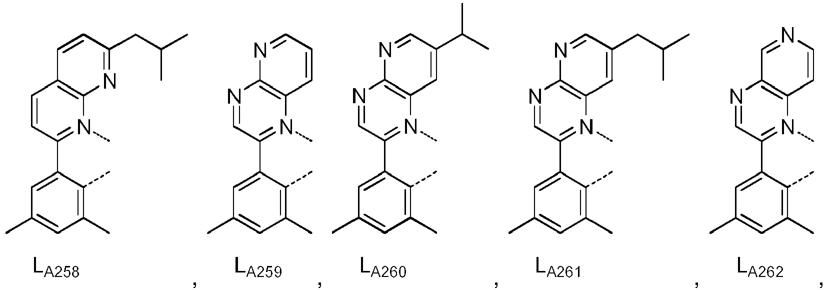

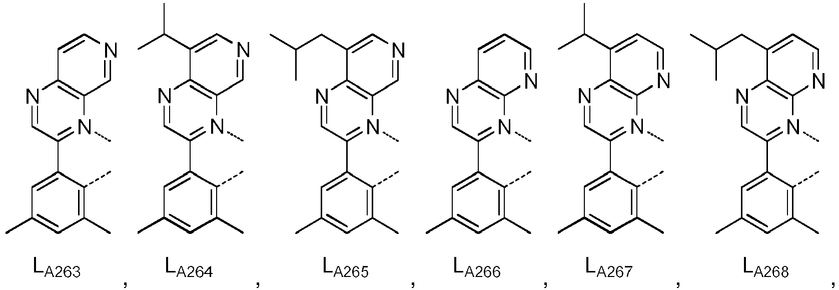

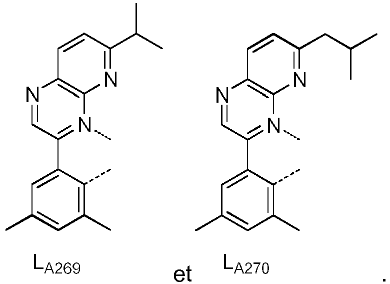

13. Dispositif selon la revendication 12, où x=1 ou 2, y=1 ou 2, et z=0, et où L_{B} est choisi dans le groupe constitué par L_{B1} à L_{B13} indiqué ci-après : 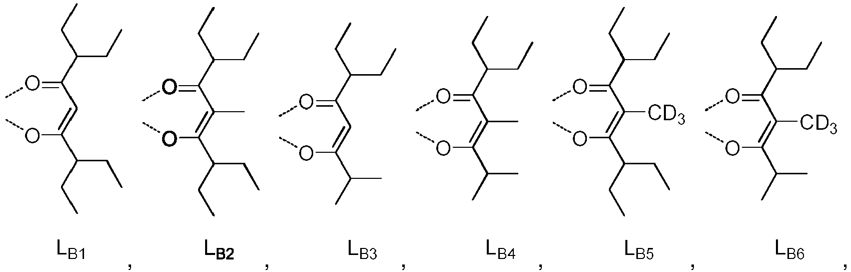 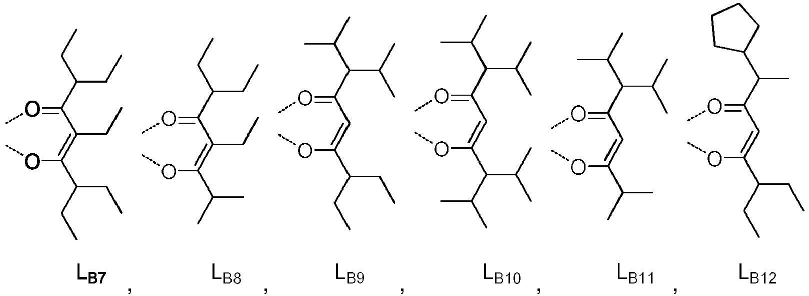 et

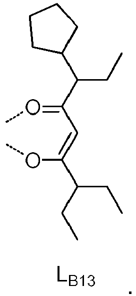

14. Dispositif selon la revendication 1, où L_{B} est choisi dans le groupe constitué par L_{B1} à L_{B13} indiqué ci-après : 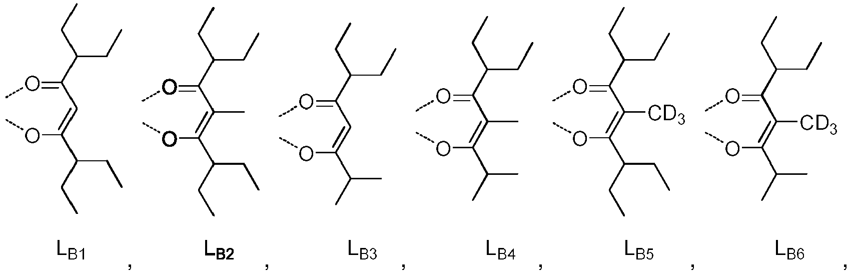 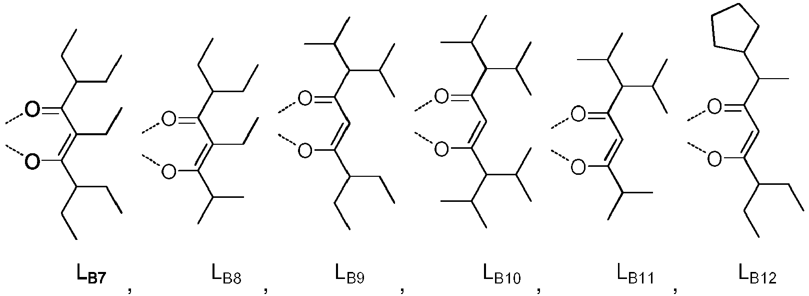 et

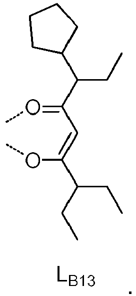

15. Dispositif selon la revendication 1, où le composé est choisi dans le groupe constitué par : 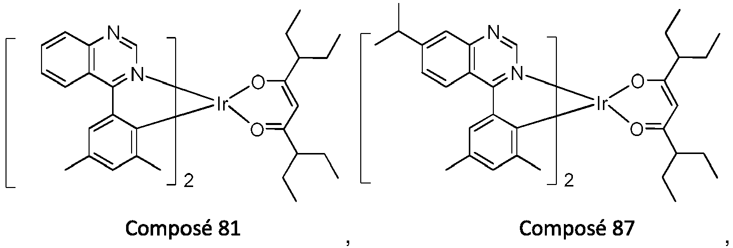 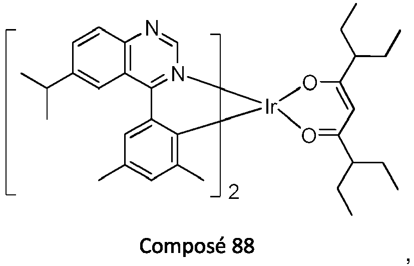 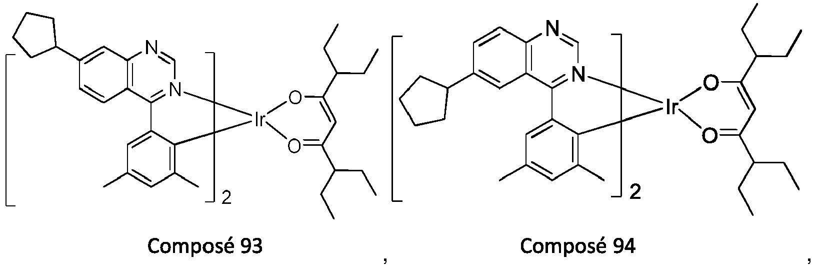 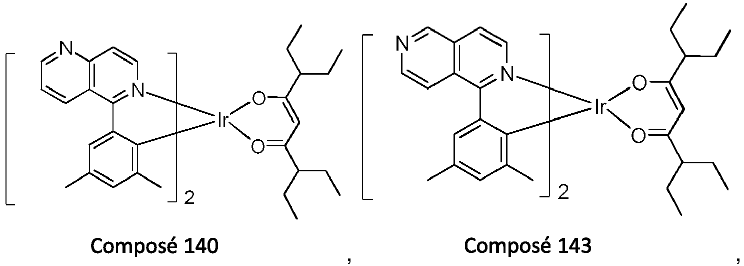 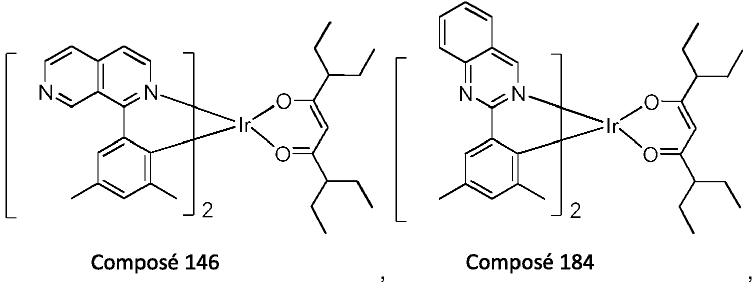 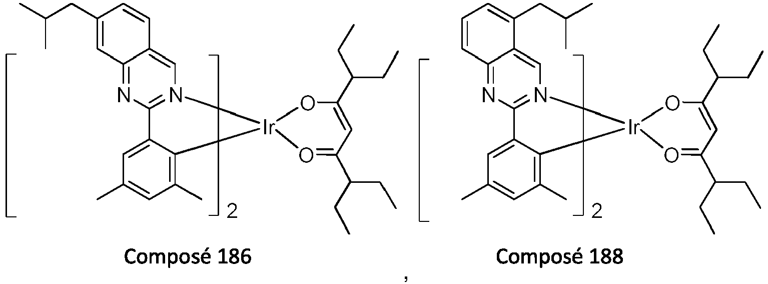 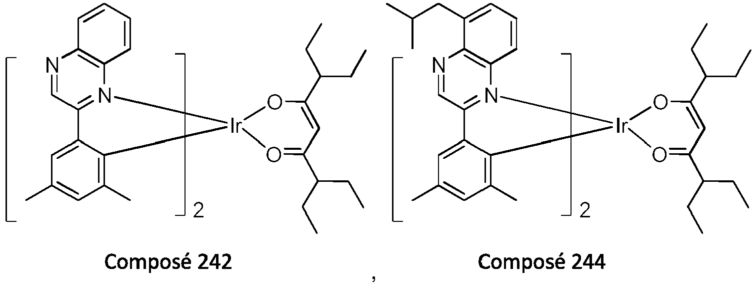 et

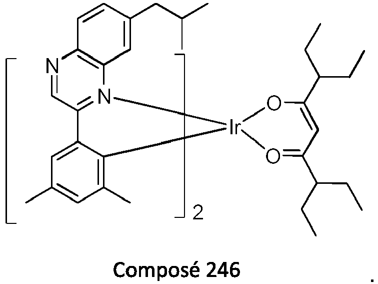

16. Dispositif selon l'une quelconque des revendications précédentes, où l'hôte est choisi dans le groupe constitué par un complexe métallique, un thiophène benzo-fusionné ou furane benzo-fusionné contenant du triphénylène, où tout substituant dans l'hôte peut être un substituant non fusionné indépendamment choisi dans le groupe constitué par CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡C-CₙH₂ₙ₊₁, Ar₁, Ar₁-Ar₂, CₙH₂ₙ-Ar₁, ou aucune substitution, avec n = 1 à 10 ; Ar₁ et Ar₂ peuvent être indépendamment choisis dans le groupe constitué par benzène, biphényle, naphtalène, triphénylène, carbazole, et leurs analogues hétéroaromatiques.

17. Dispositif selon l'une quelconque des revendications 1 à 15, où l'hôte est choisi dans le groupe constitué par carbazole, dibenzothiophène, dibenzofurane, dibenzosélénophène, azacarbazole, aza-dibenzothiophène, aza-dibenzofurane et aza-dibenzosélénophène.

18. Dispositif selon la revendication 17, où l'hôte est choisi dans le groupe constitué par : 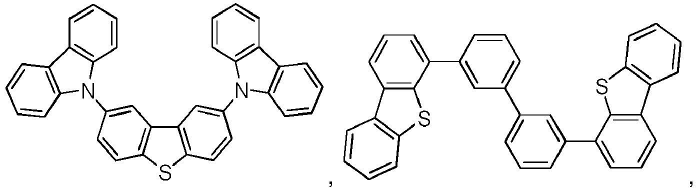 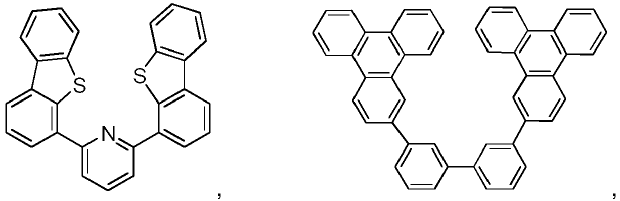 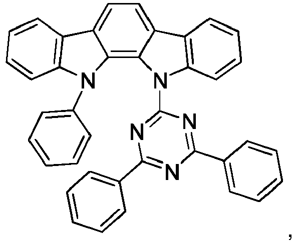 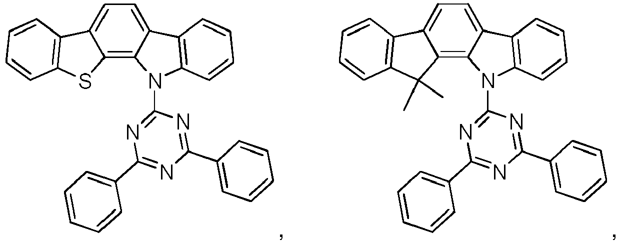 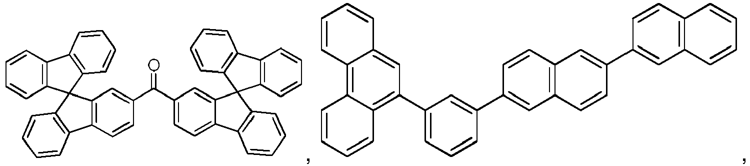 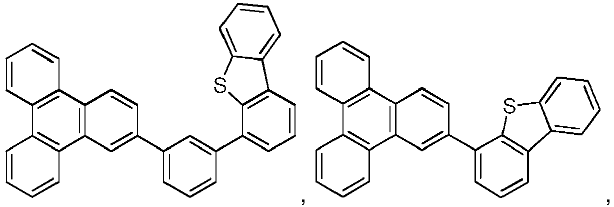 et leurs combinaisons.

19. Produit de consommation incluant le dispositif selon l'une quelconque des revendications 1 à 18.

20. Produit de consommation selon la revendication 19, qui est l'un choisi parmi des écrans plats, des écrans entièrement transparents et des écrans souples.

21. Produit de consommation selon la revendication 19, qui est l'un choisi parmi des moniteurs d'ordinateur, des moniteurs médicaux, des téléviseurs, des imprimantes laser, des affichages tête haute, des ordinateurs portables et des écrans plats.

22. Produit de consommation selon la revendication 19, qui est l'un choisi parmi des téléphones, des téléphones cellulaires, des assistants numériques personnels (PDA), des appareils photo numériques, des caméscopes, des viseurs, des micro-écrans et des écrans 3-D.

23. Produit de consommation selon la revendication 19, qui est l'un choisi parmi des panneaux d'affichage, une paroi de grande taille, un écran de théâtre ou de stade et une enseigne.

24. Produit de consommation selon la revendication 19, qui est l'un choisi parmi des lumières pour éclairage d'intérieur ou d'extérieur.

25. Produit de consommation selon la revendication 19, qui est l'un choisi parmi un dispositif de signalisation et des véhicules.

26. Produit de consommation selon la revendication 19, qui est l'un choisi parmi des dispositifs optoélectroniques tels que des cellules solaires et des photodétecteurs organiques.

27. Utilisation d'un composé tel que défini dans la revendication 1 dans un dispositif électroluminescent organique.
